# EUROPEAN PATENT APPLICATION

(11) **EP 4 776 795 A1**
(43) Date of publication of application: **15.07.2026**
(21) Application number: 24862785.3
(22) Date of filing: 03.09.2024
(51) Int. Cl.: H10F 39/12, H01L 23/02

(54) **ELECTRONIC DEVICE AND METHOD FOR MANUFACTURING ELECTRONIC DEVICE**

(30) Priority: 05.09.2023 JP 2023143323; 22.11.2023 WO PCT/JP2023/041923
(71) Applicant: Sony Semiconductor Solutions Corporation, Atsugi-shi, Kanagawa 243-0014 (JP)
(72) Inventor: FURUHASHI, Takahisa, Atsugi-shi, Kanagawa 243-0014 (JP); KUWAE, Hiroyuki, Atsugi-shi, Kanagawa 243-0014 (JP); SUGIZAKI, Junji, Atsugi-shi, Kanagawa 243-0014 (JP); YAMAGUCHI, Ryohei, Atsugi-shi, Kanagawa 243-0014 (JP); KOBAYASHI, Hideki, Atsugi-shi, Kanagawa 243-0014 (JP); SAKAMOTO, Akihisa, Atsugi-shi, Kanagawa 243-0014 (JP); TANAKA, Keishi, Atsugi-shi, Kanagawa 243-0014 (JP); FUKUSUMI, Takanori, Kikuchi-gun, Kumamoto 869-1102 (JP); ITO, Daisuke, Atsugi-shi, Kanagawa 243-0014 (JP); HANEDA, Masaki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/031567
(87) International publication number: WO 2025/053133

(57) **Abstract**

To improve the joining strength between chips without increasing the planar size of the chips. An electronic device includes a first chip including a first joining region and a first recess formed in a part of the first joining region, and a second chip joined to the first chip through a second joining region facing the first joining region. A first recess may be discretely disposed at a periphery of the first chip. The first recess may be a groove continuously formed at the periphery of the first chip. The second chip may include a second recess formed in a part of the second joining region. The second chip may include a device region located inside the second joining region.

## Description

### Technical Field

The present technology relates to an electronic device and a manufacturing method for the electronic device. Specifically, the present technology relates to an electronic device in which a recess is provided in a joining region and a manufacturing method for the electronic device.

### Background Art

As the planar size of chips joined to each other decreases, it becomes difficult to ensure sufficient joining strength between the chips. For example, a configuration has been proposed in which, in order to improve adhesion to a package accommodating a solid-state imaging element, a bonding surface of a cover glass installed in the package accommodating the solid-state imaging element is made rougher than an optical effective surface (see, for example, PTL 1).

### Citation List

### Patent Literature

PTL 1: JP2015-211190A

### Summary

### Technical Problem

In the above-described known technology, however, as the planar size of the chips joined to each other decreases, the planar size of the joining surface also decreases, which may make it difficult to ensure sufficient joining strength between chips.

In view of the above-described circumstance, an object of the present technology is to improve the joining strength between chips without increasing the planar size of the chips.

### Solution to Problem

To solve the above-described problems, a first aspect of the present technology is an electronic device including: a first chip including a first joining region, and a first recess formed in a part of the first joining region; and a second chip joined to the first chip through a second joining region facing the first joining region. This achieves an effect in which conduction of the heat generated at the periphery of the first chip is suppressed at the position of the first recess.

In the first aspect, the first recess may be discretely disposed at a periphery of the first chip. This achieves an effect in which the thermal conductivity is reduced at the periphery of the chip.

In the first aspect, the first recess may be a groove continuously formed at a periphery of the first chip. This achieves an effect in which the thermal conductivity is reduced in the entirety of the periphery of the chip.

The first aspect may further include a bonding layer interposed between the first chip and the second chip. This achieves an effect in which the first chip and the second chip are joined while enabling the device to be formed at a position higher than the first joining region.

The first aspect may further include a hard layer formed at a surface of the bonding layer in a manner corresponding to an opening position of the first recess. This achieves an effect in which penetration of the bonding layer to the first recess is prevented.

In the first aspect, the first chip and the second chip may be directly joined. This achieves an effect in which the first chip and the second chip are joined without interposing a bonding layer between the first chip and the second chip.

The first aspect may further include a light-shielding film formed at an inner surface of the first recess. This achieves an effect in which entry of light into the inside from the periphery of the chip is suppressed.

In the first aspect, a pressure inside the first recess may be lower than atmospheric pressure. This achieves an effect in which the joining strength between the first chip and the second chip is increased.

The first aspect may further include gas sealed inside the first recess. This achieves an effect in which the optical properties at the periphery of the chip are adjusted.

In the first aspect, a transparent substrate may be used for the first chip, and a semiconductor substrate may be used for the second chip. This achieves an effect in which light is allowed to enter the second chip through the first chip while sealing the second chip with the first chip, and heat conduction is suppressed at the position of the recess formed at the transparent substrate.

The first aspect may further include a filter layer formed on the first chip. This achieves an effect in which a specific wavelength band is extracted at the filter layer, and is incident on the second chip.

The first aspect may further include a cavity formed inside the second joining region. This achieves an effect in which the device region formed inside the first joining region is thinned while ensuring the film thickness of the first joining region.

In the first aspect, the second chip may include a second recess formed in a part of the second joining region. This achieves an effect in which conduction of the heat generated at the periphery of the second chip is suppressed at the position of the second recess.

In the first aspect, the second chip may include a device region located inside the first joining region. This achieves an effect in which the device is formed in the first chip while reducing the influence of the heat generated at the periphery of the first chip.

In the first aspect, the second chip may include: a third chip in which a first wiring layer is formed on a first semiconductor substrate; a fourth chip in which a second wiring layer is formed on a second semiconductor substrate, the fourth chip being layered on the third chip with the first wiring layer and the second wiring layer facing each other; and a through electrode extending through the first semiconductor substrate and connected to the first wiring layer. This achieves an effect in which the electrode is pulled out from the opposite side of the second joining region while suppressing conduction of the heat generated at the periphery of the first chip at the position of the first recess.

In the first aspect, the second recess extends through the fourth chip and the first wiring layer and may be formed at the first semiconductor substrate. This achieves an effect in which conduction of the heat generated at the periphery of the first chip and the second chip is suppressed at the positions of the first recess and second recess.

In the first aspect, the through electrode may be provided at a position different from a position of the second recess in a horizontal direction. This achieves an effect in which the second recess and the through electrode are formed in the first semiconductor substrate.

In the first aspect, the second chip may include: a third chip in which a first wiring layer is formed on a first semiconductor substrate; a fourth chip in which a second wiring layer is formed on a second semiconductor substrate, the fourth chip being layered on the third chip with the first wiring layer and the second wiring layer facing each other; and a through electrode extending through the first semiconductor substrate and connected to the first wiring layer, and the through electrode may be formed so as to at least partially overlap the first recess. This achieves an effect in which conduction of the heat generated at the periphery of the first chip can be suppressed at the position of the first recess while suppressing an increase in the area of the second joining region, and the electrode is pulled out from the opposite side of the second joining region.

A second aspect is an electronic device including: an optical chip provided with an optical system; and a sensor chip provided with a sensor element, in which the optical chip and the sensor chip are joined through a joining surface including a plurality of surfaces. This achieves an effect in which the joining area of the joining surface of the optical chip and the sensor chip is increased.

In the second aspect, the optical chip may include a transparent substrate layered on the sensor chip, and a groove continuously provided from a first end portion to a second end portion of a layered structure of the sensor chip and the transparent substrate between the sensor chip and the transparent substrate may be provided. This achieves an effect in which the joining area of a sensor chip and a transparent substrate is increased while ensuring the continuity of the path to the end portion of the layered chip of the sensor chip and the transparent substrate.

In the second aspect, the groove may be provided at the transparent substrate. This achieves an effect in which the joining area of a sensor chip and a transparent substrate is increased while ensuring the continuity of the groove provided in the transparent substrate.

In the second aspect, a transparent resin layer configured to join the optical chip and the sensor chip; and an intermediate resin layer provided between the transparent substrate and the transparent resin layer or between the transparent resin layer and the sensor chip may be further provided. This achieves an effect in which the joining area of the transparent resin layer is increased while allowing the transparent resin to flow along the groove provided in the intermediate resin layer.

In the second aspect, a refractive index of the transparent resin layer and a refractive index of the intermediate resin layer may be equal to each other. This achieves an effect in which the groove is disposed on the effective pixel region of the sensor chip without degrading the image quality.

In the second aspect, the groove may be disposed at a position capable of traversing a wafer before the layered chip of the sensor chip and the transparent substrate is singulated. This achieves an effect in which the joining area of the transparent resin layer is increased while ensuring the flow path of the transparent resin to the end portion of the layered wafer.

In the second aspect, one or a plurality of the grooves may be provided at the layered chip of the sensor chip and the transparent substrate. This achieves an effect in which the joining strength of the sensor chip and the transparent substrate is improved.

In the second aspect, the groove may be disposed on an effective pixel region, or on a peripheral region, or, on both the effective pixel region and the peripheral region of the sensor chip. This achieves an effect in which the region where the groove can be arranged is enlarged.

In the second aspect, a depth of the groove may be equal to or less than a thickness of the transparent resin layer. This achieves an effect in which voids can be prevented from remaining in the groove.

In the second aspect, the optical chip may be packaged based on wafer level optics, and the sensor chip may be packaged based on a wafer level chip size package. This achieves an effect in which the sensor chip and the optical chip are downsized while suppressing a decrease in the joining strength of the sensor chip and the optical chip.

In the second aspect, the optical system may include a lens. This achieves an effect in which the lens is disposed on the sensor chip while downsizing the optical chip.

In the second aspect, the optical system may include a layered structure of a plurality of lens-equipped substrates. This achieves an effect in which a plurality of lenses are disposed on the sensor chip while downsizing the optical chip.

In the second aspect, the plurality of lens-equipped substrates may include: a lens; and a substrate at which the lens is formed, and the lens and the substrate may be composed of the same material or different materials. This achieves an effect in which the diversity of the lens disposed on the sensor chip is improved.

In the second aspect, the optical system may include at least one of an aperture, a light-shielding film, a spacer, and an optical filter. This achieves an effect in which the function of the optical system is diversified while suppressing an increase in the chip size of an optical chip.

In the second aspect, a joining layer configured to join the optical chip and the sensor chip may be further provided. This achieves an effect in which the optical chip and the sensor chip are joined with the joining layer interposed therebetween.

In the second aspect, the joining layer may be composed of one or a plurality of materials. This achieves an effect in which the optical properties are adjusted while suppressing a decrease in the joining strength.

In the second aspect, the joining surface may include at least one of a recess, a protrusion, and a rough surface. This achieves an effect in which the joining area of the joining surface of the sensor chip and the optical chip is increased.

In the second aspect, the at least one of a recess, a protrusion, and a rough surface may be located on a sensor surface of the sensor chip. This achieves an effect in which the limitation on the arrangement positions of the recess, protrusion, and rough surface is relaxed.

In the second aspect, the joining surface including the plurality of surfaces may be provided at least at one of the optical chip and the sensor chip. This achieves an effect in which the joining area of the joining surface of the sensor chip and the optical chip is increased while relaxing the limitation on the arrangement positions of the plurality of surfaces.

In the second aspect, the sensor element may be a photoelectric conversion element. This achieves an effect in which the sensor element is used as the imaging element.

In the second aspect, the sensor chip may include: a semiconductor substrate at which the sensor element is formed; and a transparent sealing substrate joined to the semiconductor substrate. This achieves an effect in which the sensor element is sealed while suppressing an increase in chip size.

In the second aspect, the optical chip may include a transparent supporting substrate configured to support the optical system, and the joining surface including the plurality of surfaces may be provided at least at one of the transparent sealing substrate and the transparent supporting substrate. This achieves an effect in which the joining strength of the sensor chip and the optical chip is improved without affecting the optical properties of the optical system.

In the second aspect, the plurality of surfaces may include surfaces having different wettabilities. This achieves an effect in which the joining properties of the joining surface of the optical chip and the sensor chip are controlled.

In the second aspect, the optical chip may include a transparent substrate layered on the sensor chip through a transparent resin layer, the transparent substrate may include: an opposing region facing a sensor region of the sensor chip; and an adjacent region adjacent to the opposing region, and a wettability of the opposing region may be higher than a wettability of the adjacent region. This achieves an effect in which the voids generated at the transparent resin layer during the joining of the sensor chip and the transparent substrate are expelled from above the sensor region.

In the second aspect, the opposing region may include a deposited film layer, a surface modification layer, or an ion-implanted layer with a higher wettability than a surface of the adjacent region. This achieves an effect in which the wettability of the opposing region is improved while ensuring transparency of the opposing region of the transparent substrate.

In the second aspect, the adjacent region may include a deposited film layer, a surface modification layer, an ion-implanted layer, or a rough surface layer with a lower wettability than a surface of the opposing region. This achieves an effect in which the wettability of the opposing region is made higher relative to the adjacent region without reducing the transparency of the opposing region of the transparent substrate.

In the second aspect, the sensor chip may include: a sensor region; and an adjacent region adjacent to the sensor region, and a wettability of the sensor region may be higher than a wettability of the adjacent region. This achieves an effect in which the voids generated at the transparent resin layer during the joining of the sensor chip and the transparent substrate are expelled to the periphery of the sensor region.

In the second aspect, the sensor region may include a deposited film layer, a surface modification layer, or an ion-implanted layer with a higher wettability than a surface of the adjacent region. This achieves an effect in which the wettability of the sensor region is improved while suppressing an influence on the optical properties of the sensor region.

In the second aspect, the adjacent region may include a deposited film layer, a surface modification layer, an ion-implanted layer, or a rough surface layer with a lower wettability than a surface of the sensor region. This achieves an effect in which the wettability of the sensor region is made higher relative to the adjacent region without affecting the optical properties of the sensor region.

A third aspect is a manufacturing method for an electronic device, including: forming a first recess in a first joining region provided for each divided region of a first wafer; joining a second wafer to the first wafer through a second joining region provided at a position facing the first joining region; and singulating a layered structure in which the first wafer and the second wafer are joined for each divided region. This achieves an effect in which conduction of the heat generated during cutting of the layered wafer of the first wafer and the second wafer is suppressed at the position of the first recess.

In the third aspect, the second wafer may be joined to the first wafer under reduced pressure or in an atmospheric gas environment. This achieves an effect in which the pressure inside the first recess is made lower than atmospheric pressure, and gas is sealed inside the first recess.

### Brief Description of Drawings

[Fig. 1]

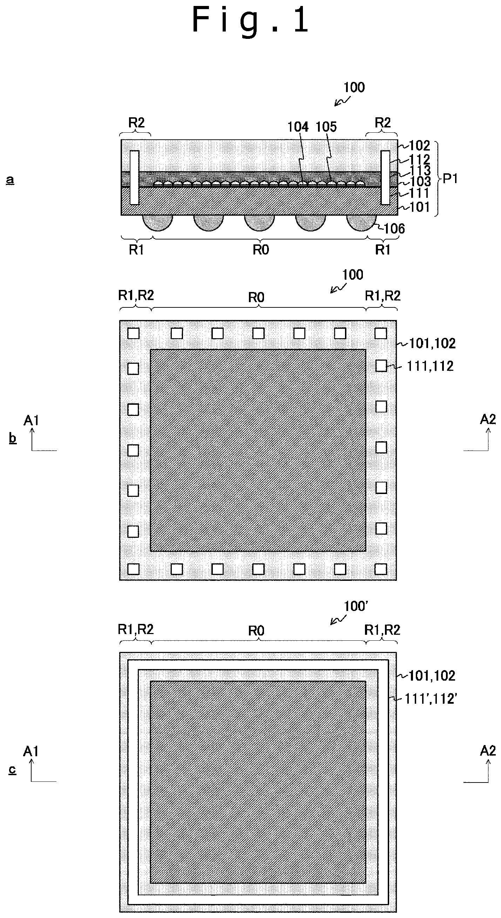

   Fig. 1 is a diagram depicting a configuration example of an electronic device according to a first embodiment.
[Fig. 2]

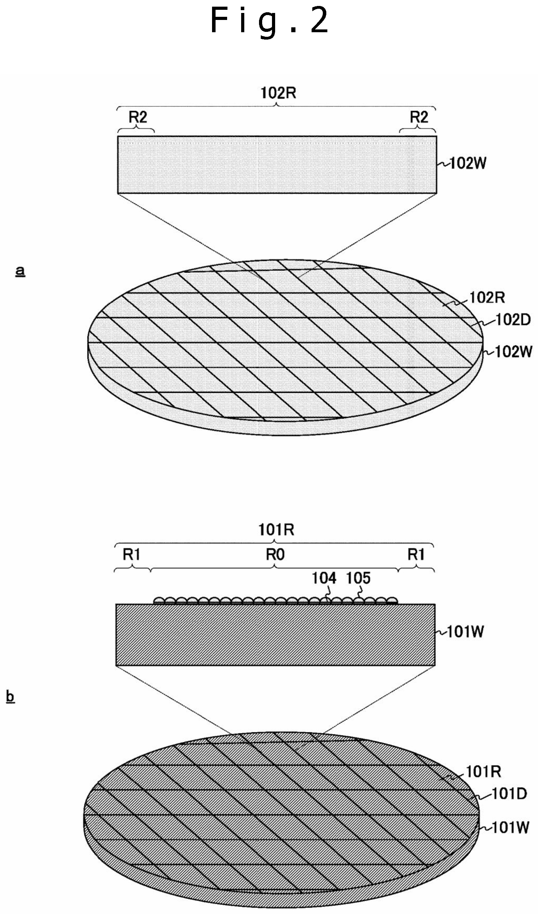

   Fig. 2 is a first diagram depicting an example of a manufacturing method for the electronic device according to the first embodiment.
[Fig. 3]

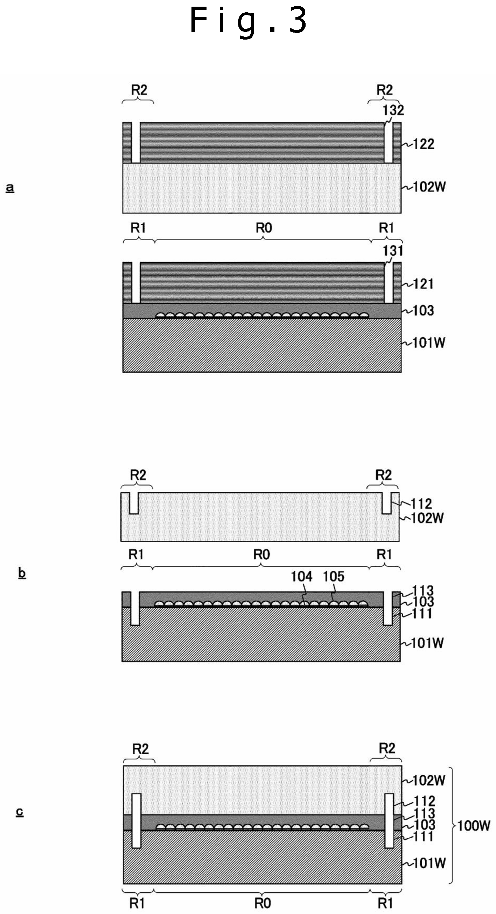

   Fig. 3 is a second diagram depicting an example of a manufacturing method for the electronic device according to the first embodiment.
[Fig. 4]

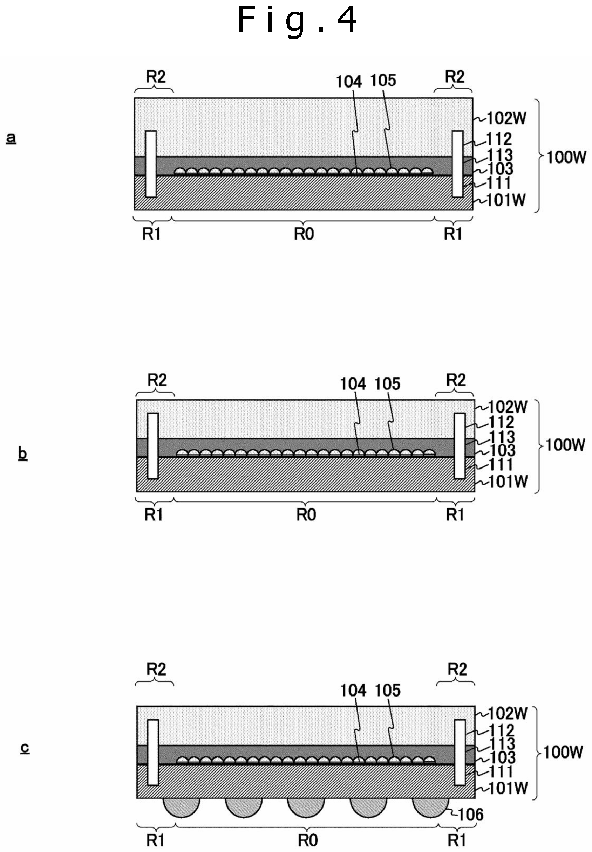

   Fig. 4 is a third diagram depicting an example of a manufacturing method for the electronic device according to the first embodiment.
[Fig. 5]

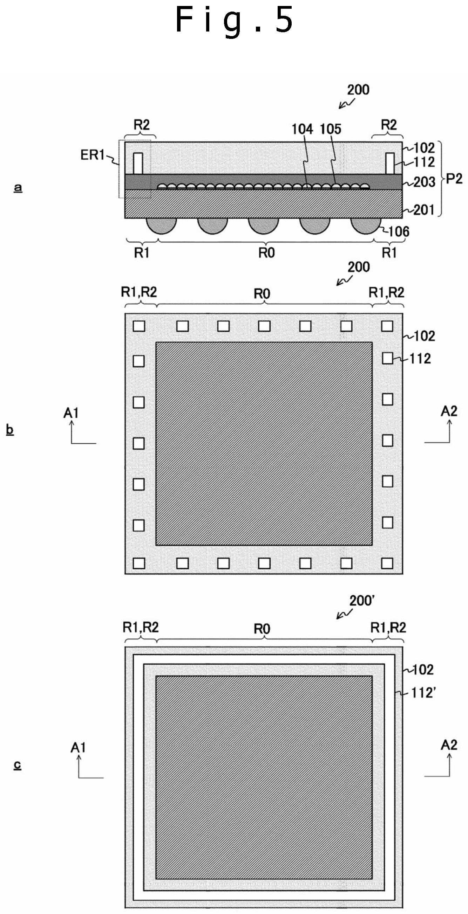

   Fig. 5 is a diagram depicting a configuration example of an electronic device according to a second embodiment.
[Fig. 6]

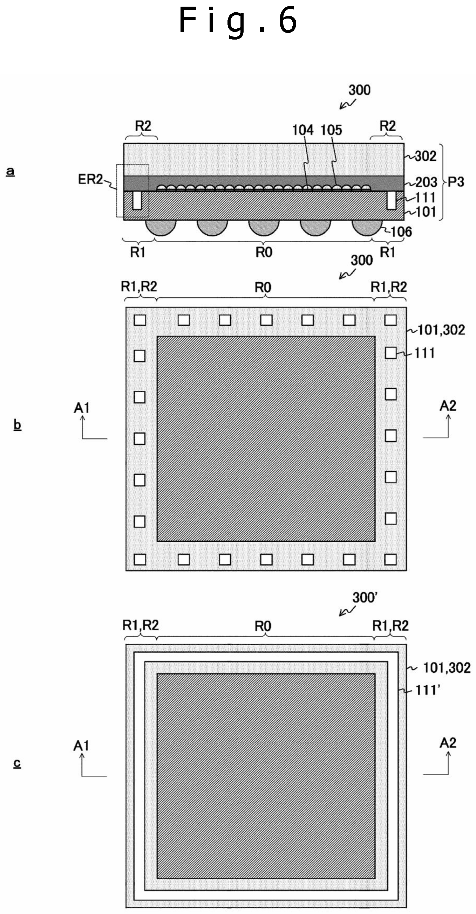

   Fig. 6 is a diagram depicting a configuration example of an electronic device according to a third embodiment.
[Fig. 7]

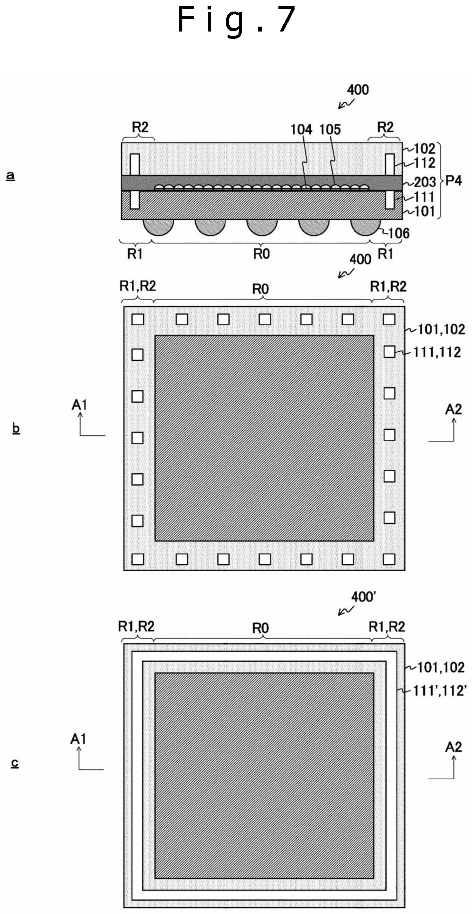

   Fig. 7 is a diagram depicting a configuration example of an electronic device according to a fourth embodiment.
[Fig. 8]

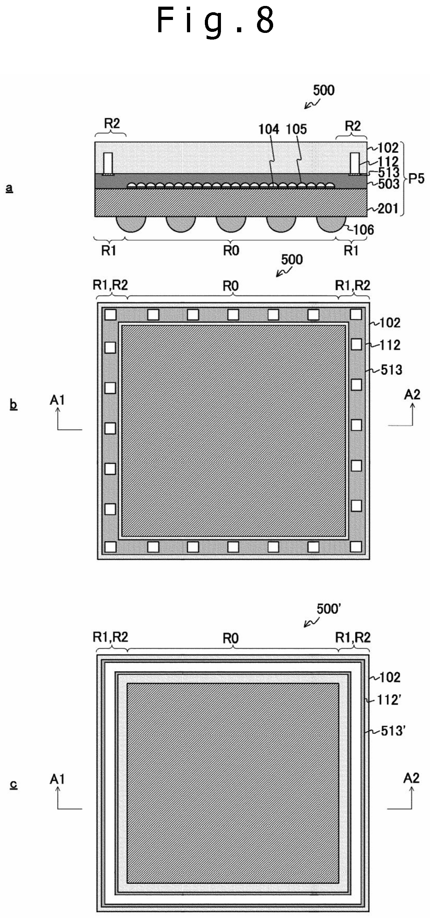

   Fig. 8 is a diagram depicting a configuration example of an electronic device according to a fifth embodiment.
[Fig. 9]

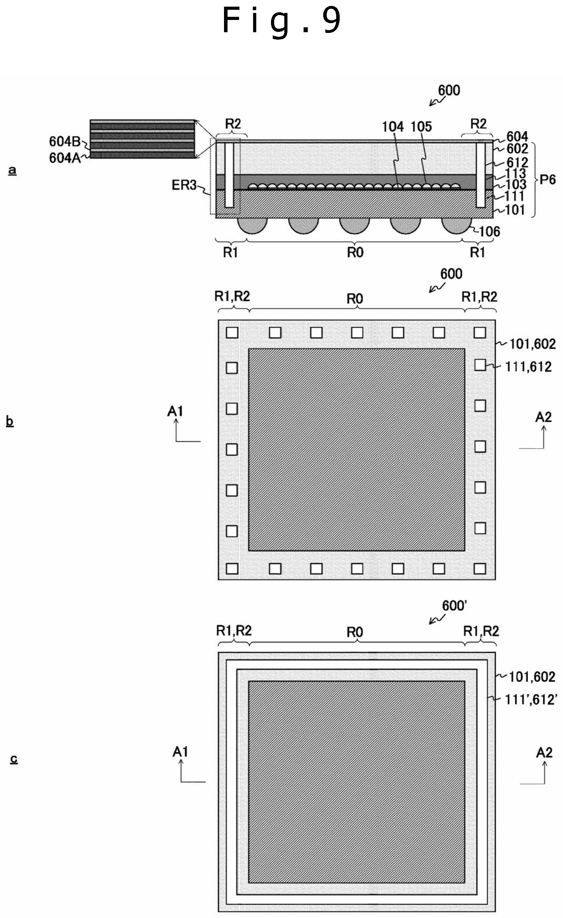

   Fig. 9 is a diagram depicting a configuration example of an electronic device according to a sixth embodiment.
[Fig. 10]

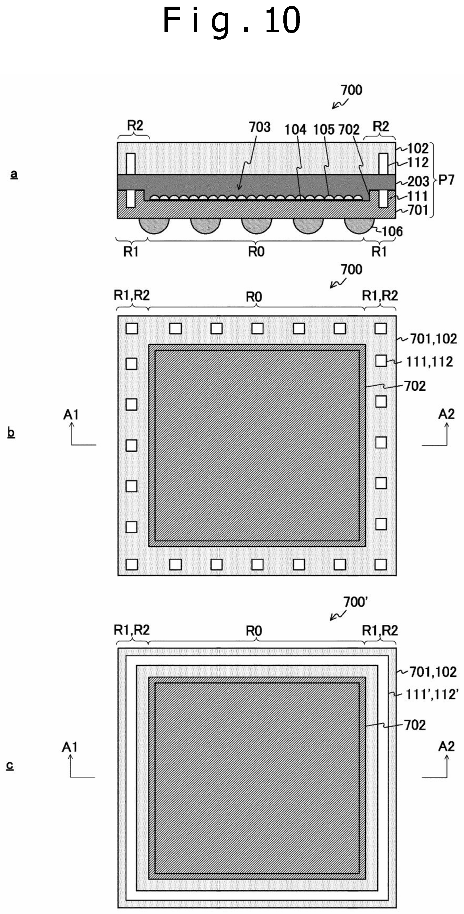

   Fig. 10 is a diagram depicting a configuration example of an electronic device according to a seventh embodiment.
[Fig. 11]

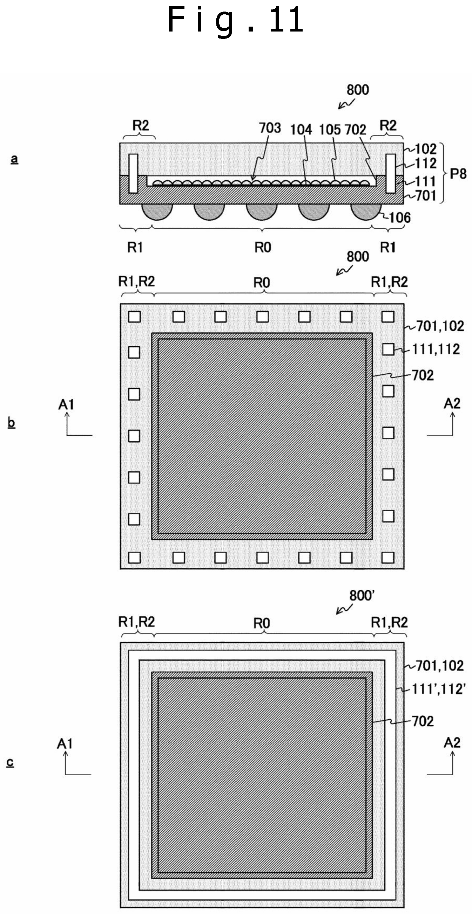

   Fig. 11 is a diagram depicting a configuration example of an electronic device according to an eighth embodiment.
[Fig. 12]

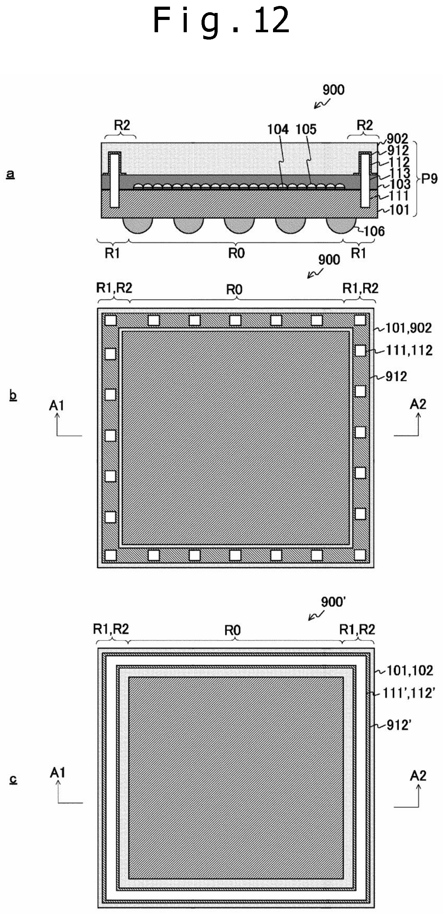

   Fig. 12 is a diagram depicting a configuration example of an electronic device according to a ninth embodiment.
[Fig. 13]

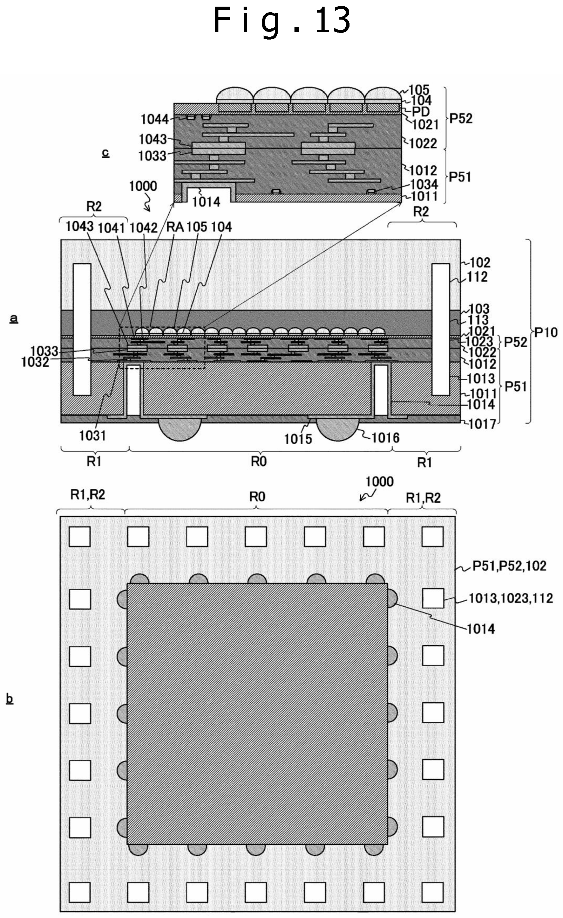

   Fig. 13 is a diagram depicting a configuration example of an electronic device according to a tenth embodiment.
[Fig. 14]

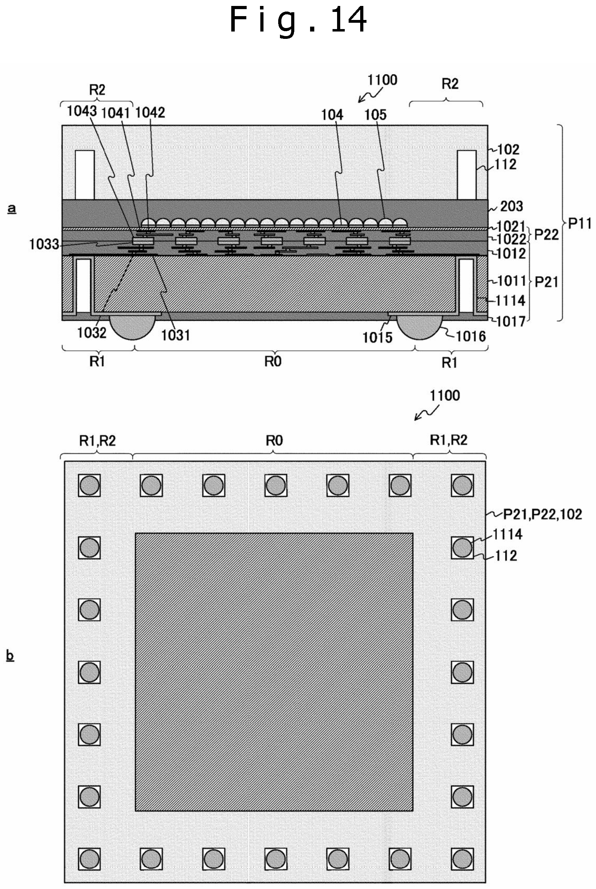

   Fig. 14 is a diagram depicting a configuration example of an electronic device according to an eleventh embodiment.
[Fig. 15]

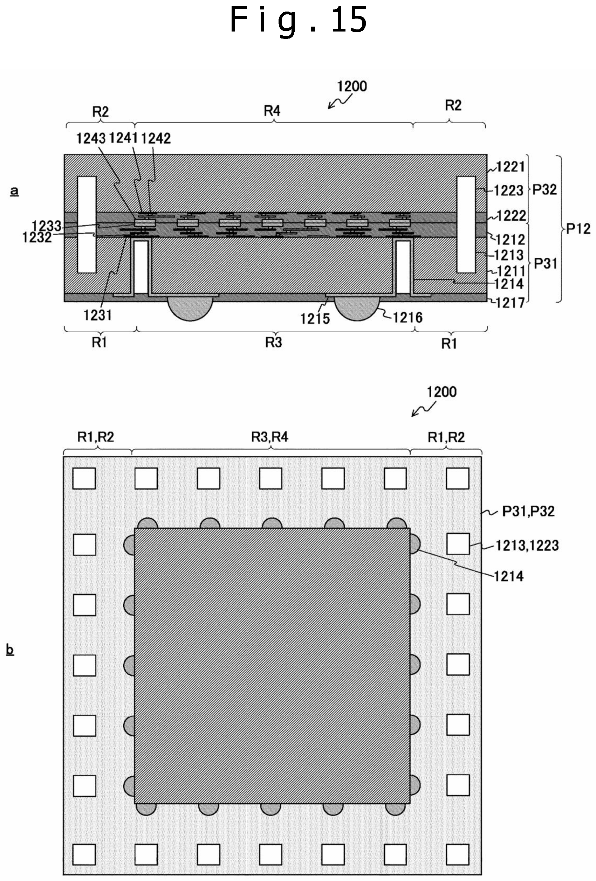

   Fig. 15 is a diagram depicting a configuration example of an electronic device according to a twelfth embodiment.
[Fig. 16]

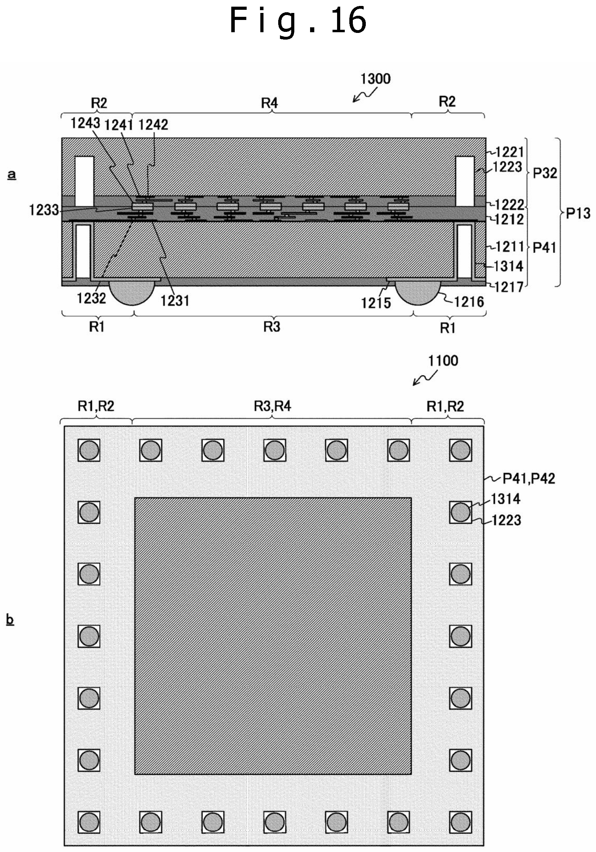

   Fig. 16 is a diagram depicting a configuration example of an electronic device according to a thirteenth embodiment.
[Fig. 17]

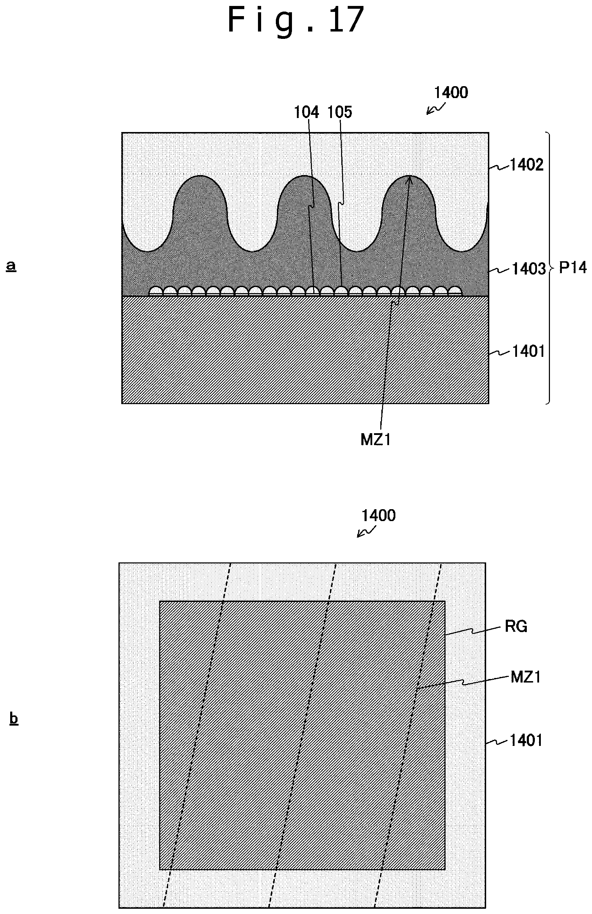

   Fig. 17 is a diagram depicting a configuration example of an electronic device according to a fourteenth embodiment.
[Fig. 18]

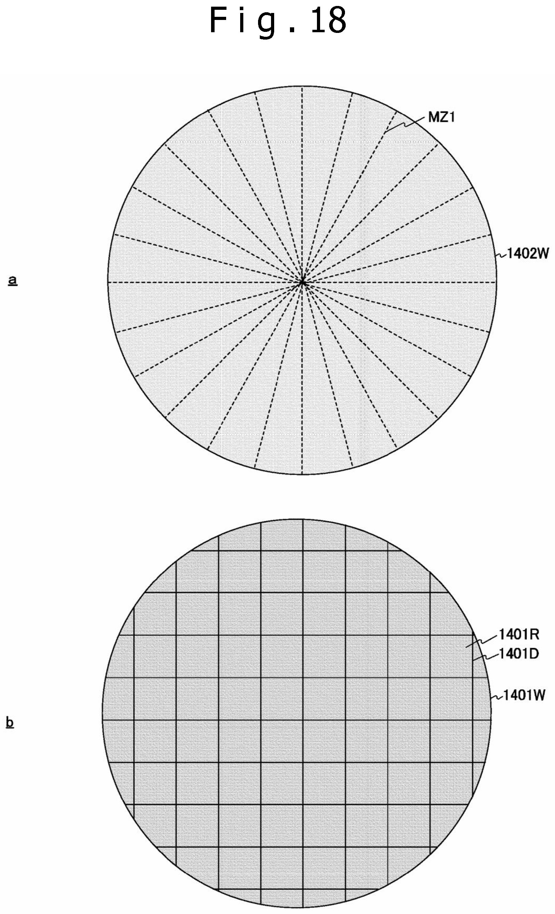

   Fig. 18 is a plan view depicting a configuration example of a wafer state of the electronic device according to the fourteenth embodiment.
[Fig. 19]

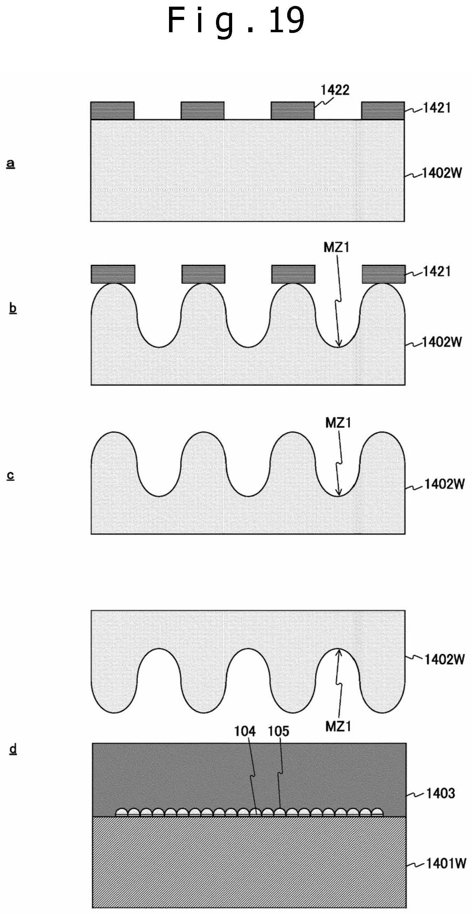

   Fig. 19 is a sectional view depicting an example of a manufacturing method for the electronic device according to the fourteenth embodiment.
[Fig. 20]

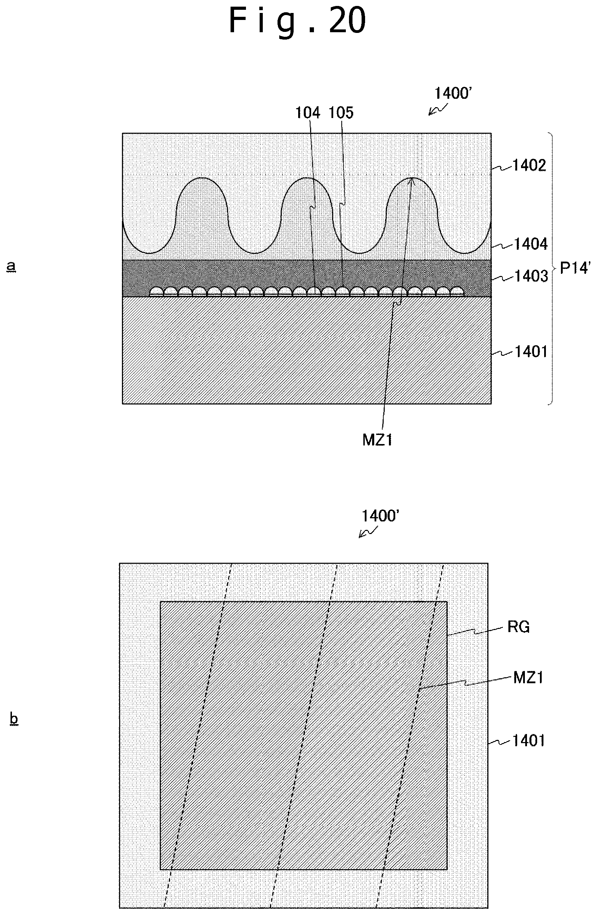

   Fig. 20 is a diagram depicting another configuration example of the electronic device according to the fourteenth embodiment.
[Fig. 21]

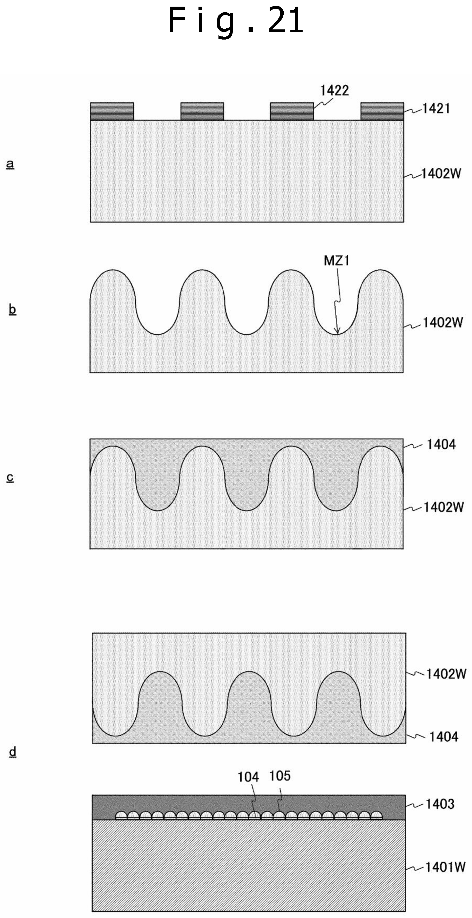

   Fig. 21 is a sectional view depicting another example of the manufacturing method for the electronic device according to the fourteenth embodiment.
[Fig. 22]

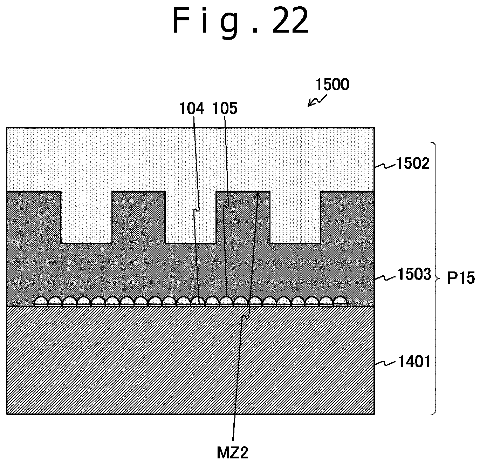

   Fig. 22 is a sectional view depicting a configuration example of an electronic device according to a fifteenth embodiment.
[Fig. 23]

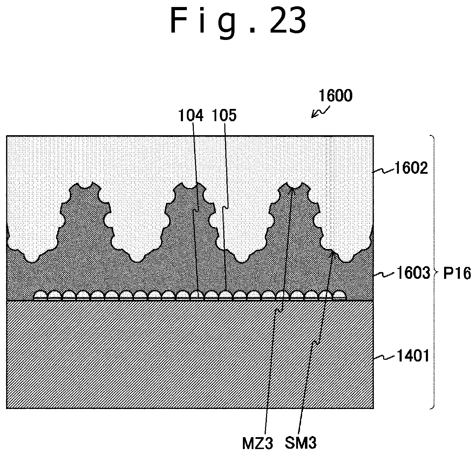

   Fig. 23 is a sectional view depicting a configuration example of an electronic device according to a sixteenth embodiment.
[Fig. 24]

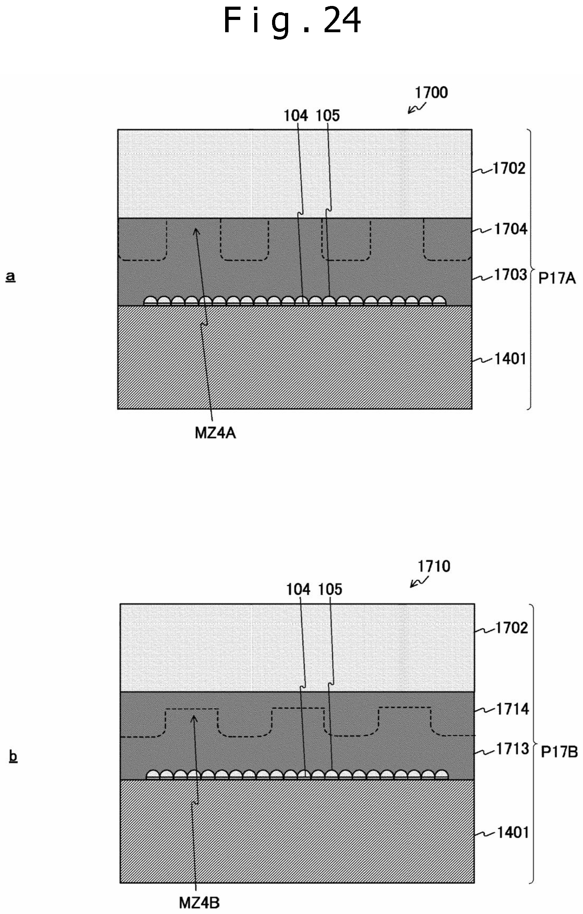

   Fig. 24 is a sectional view depicting a configuration example of an electronic device according to a seventeenth embodiment.
[Fig. 25]

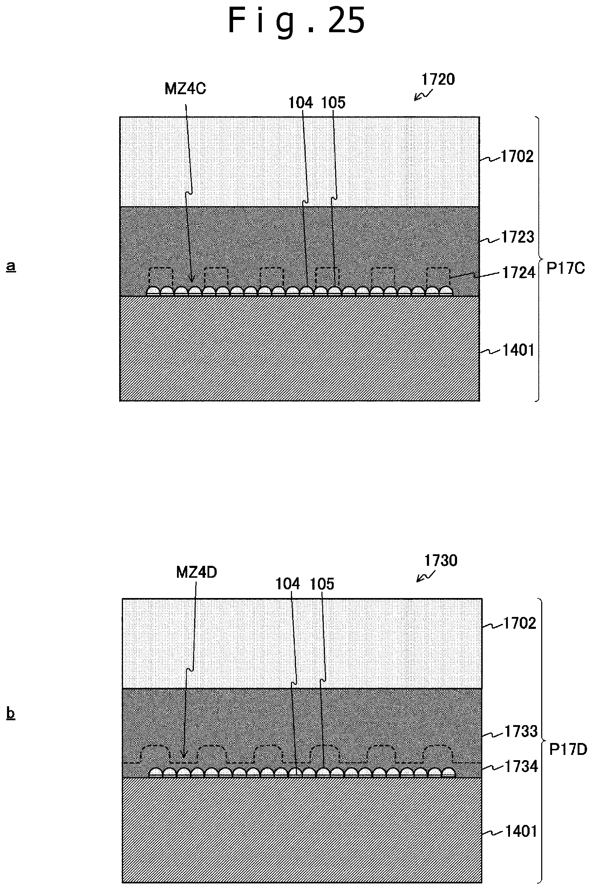

   Fig. 25 is a sectional view depicting another example of the configuration of the electronic device according to the seventeenth embodiment.
[Fig. 26]

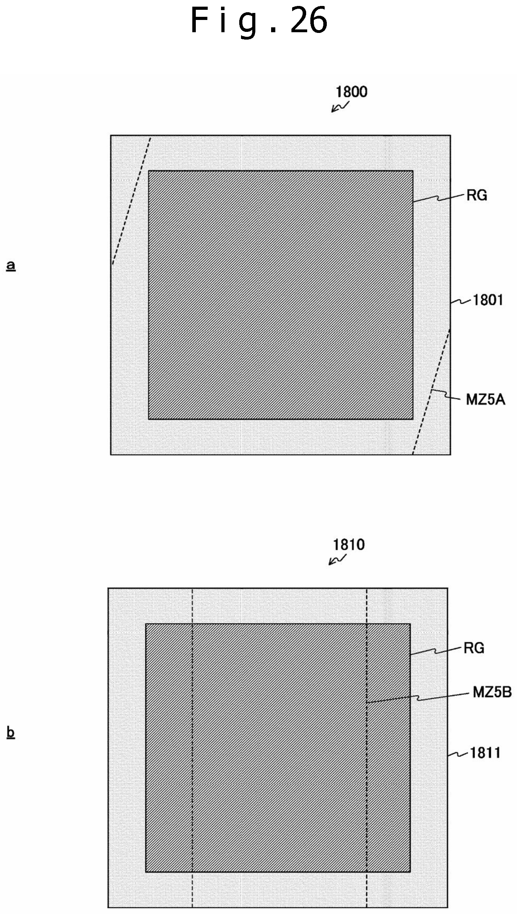

   Fig. 26 is a plan view depicting a configuration example of an electronic device according to an eighteenth embodiment.
[Fig. 27]

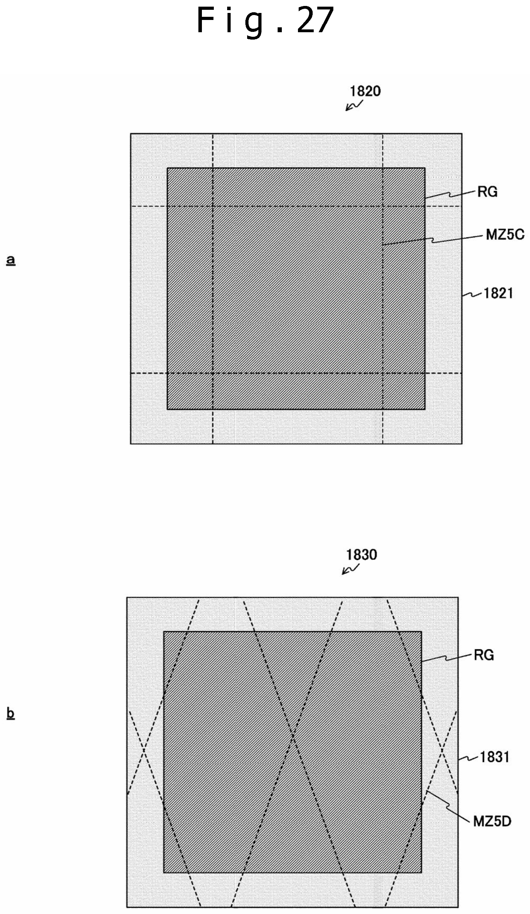

   Fig. 27 is a plan view depicting another example of the configuration of the electronic device according to the eighteenth embodiment.
[Fig. 28]

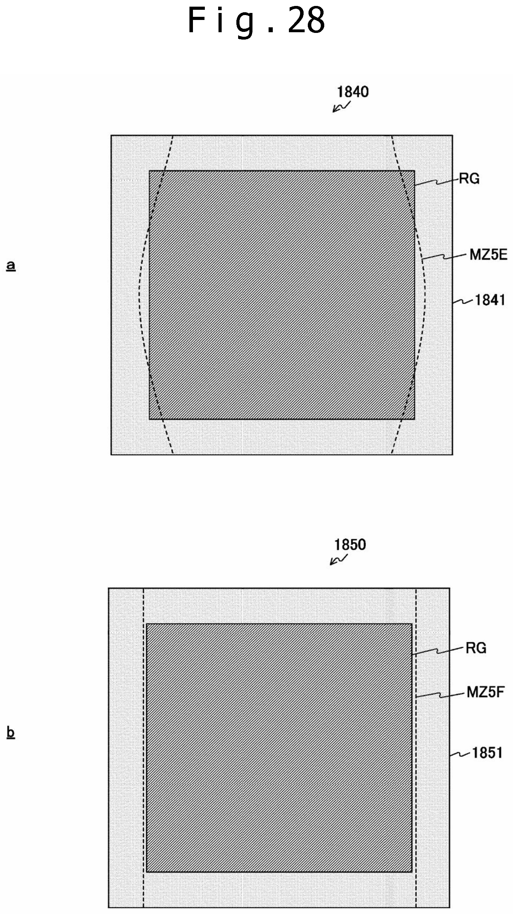

   Fig. 28 is a plan view depicting still another example of the configuration of the electronic device according to the eighteenth embodiment.
[Fig. 29]

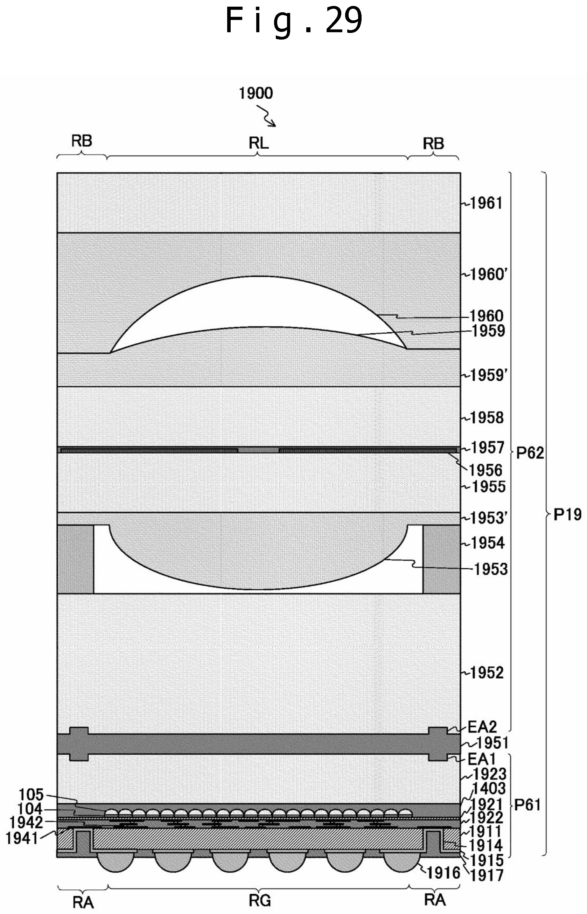

   Fig. 29 is a sectional view depicting a configuration example of an electronic device according to a nineteenth embodiment.
[Fig. 30]

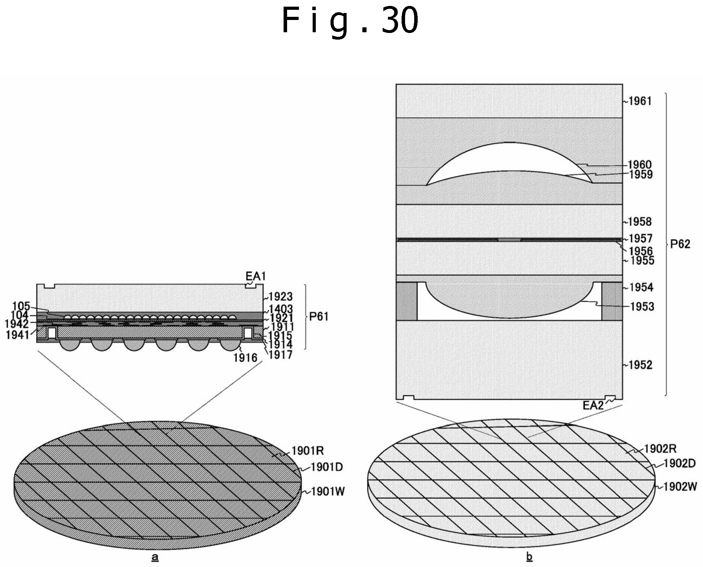

   Fig. 30 is a sectional view depicting an example of a manufacturing method for the electronic device according to the nineteenth embodiment.
[Fig. 31]

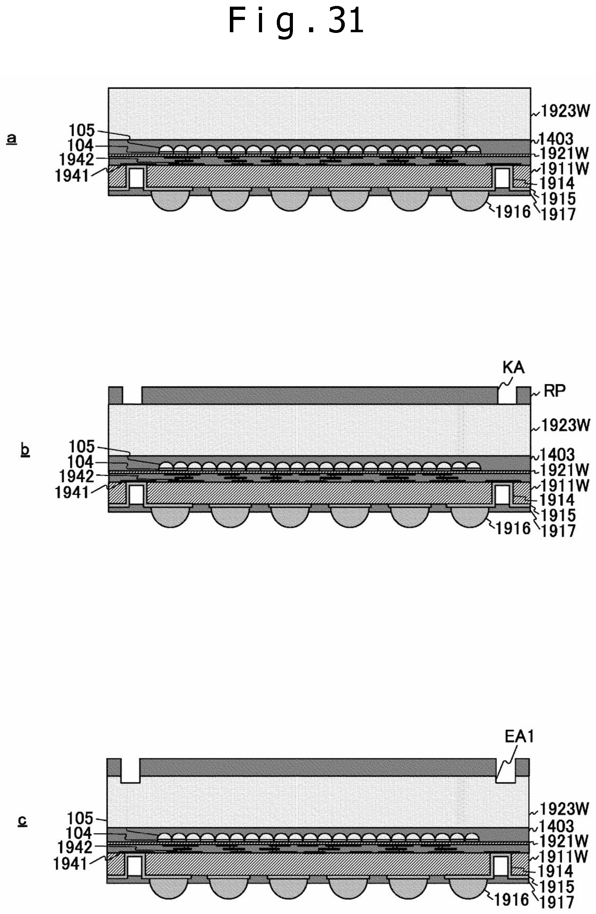

   Fig. 31 is a sectional view depicting an example of a manufacturing method for the electronic device according to the nineteenth embodiment.
[Fig. 32]

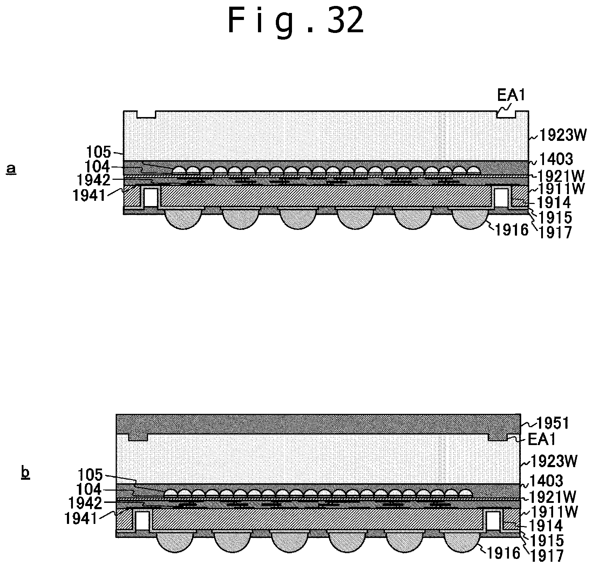

   Fig. 32 is a sectional view depicting an example of a manufacturing method for the electronic device according to the nineteenth embodiment.
[Fig. 33]

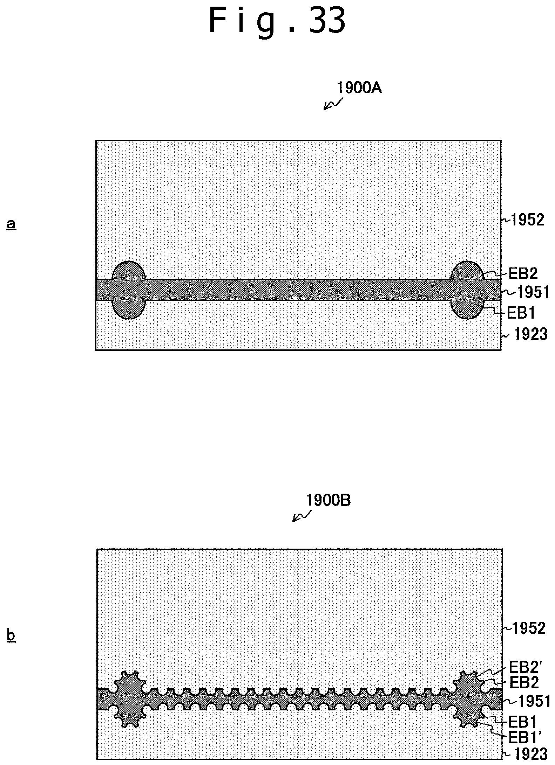

   Fig. 33 is a sectional view depicting another example of the configuration of the electronic device according to the nineteenth embodiment.
[Fig. 34]

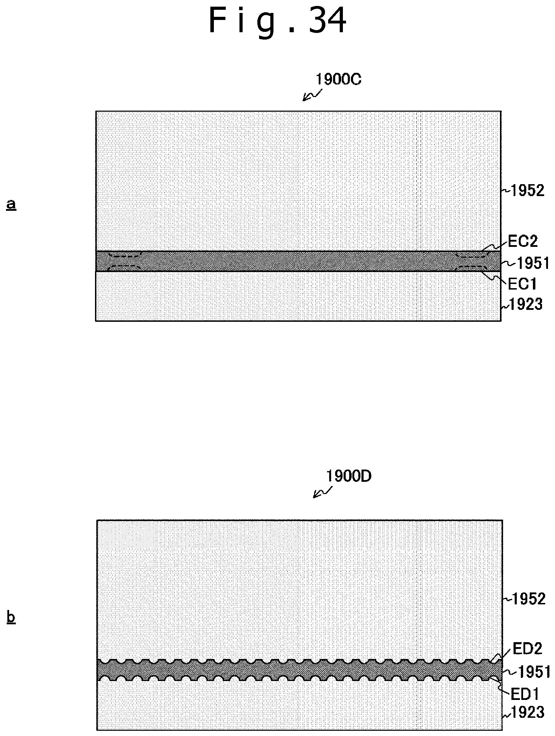

   Fig. 34 is a sectional view depicting still another example of the configuration of the electronic device according to the nineteenth embodiment.
[Fig. 35]

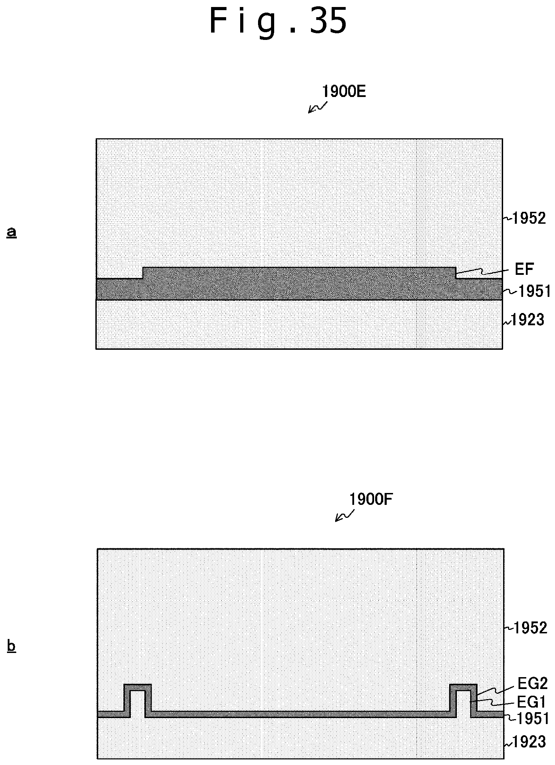

   Fig. 35 is a sectional view depicting still another example of the configuration of the electronic device according to the nineteenth embodiment.
[Fig. 36]

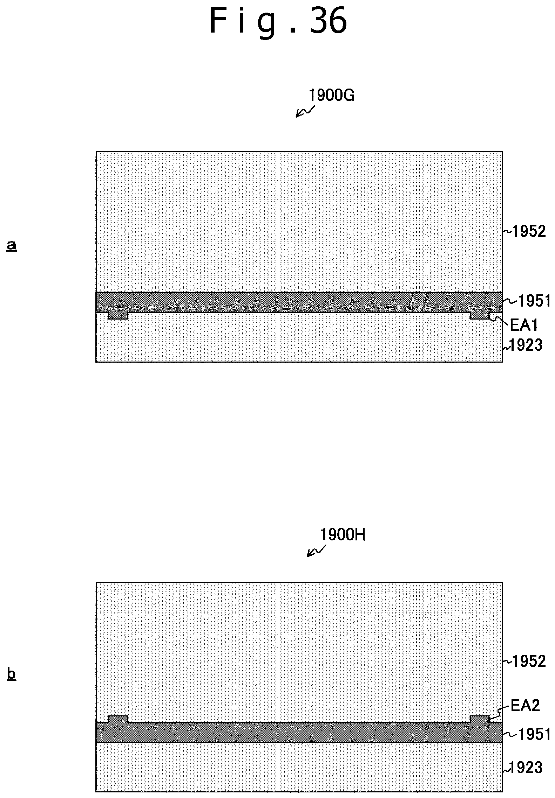

   Fig. 36 is a sectional view depicting still another example of the configuration of the electronic device according to the nineteenth embodiment.
[Fig. 37]

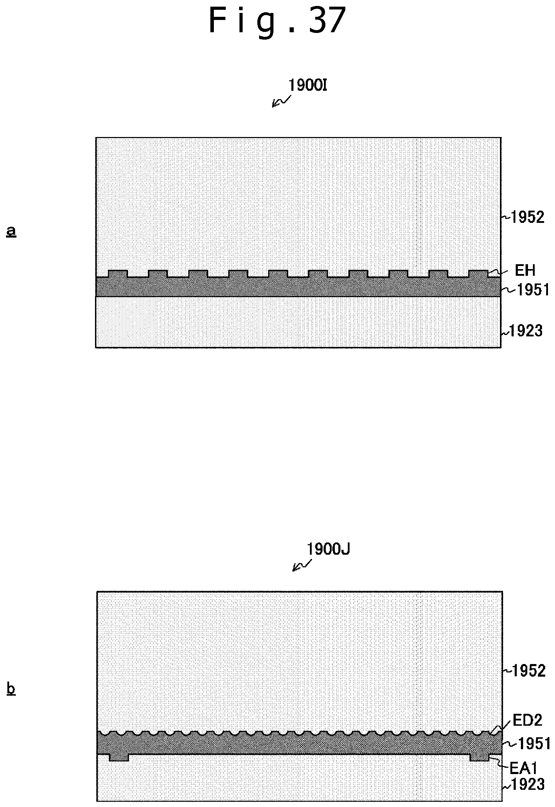

   Fig. 37 is a sectional view depicting still another example of the configuration of the electronic device according to the nineteenth embodiment.
[Fig. 38]

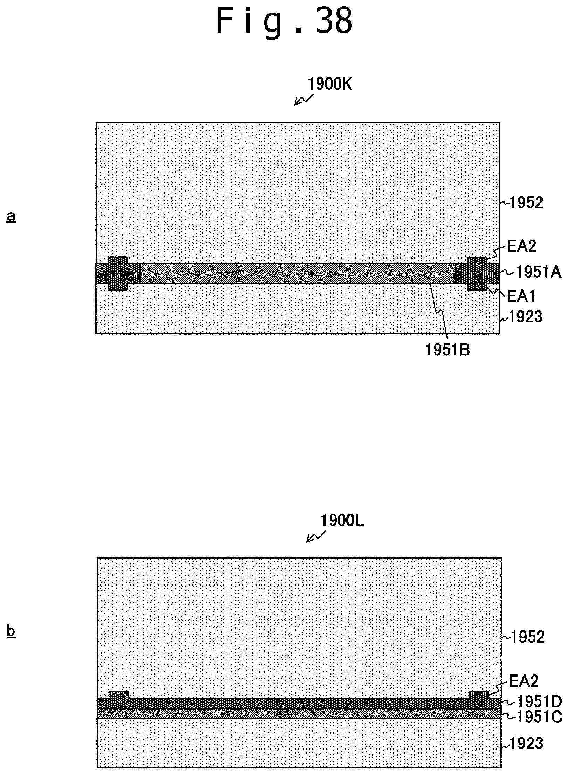

   Fig. 38 is a sectional view depicting still another example of the configuration of the electronic device according to the nineteenth embodiment.
[Fig. 39]

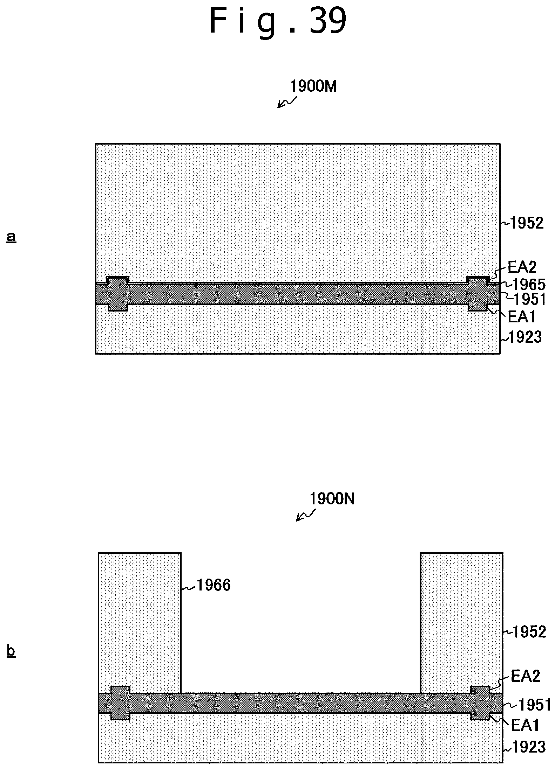

   Fig. 39 is a sectional view depicting still another example of the configuration of the electronic device according to the nineteenth embodiment.
[Fig. 40]

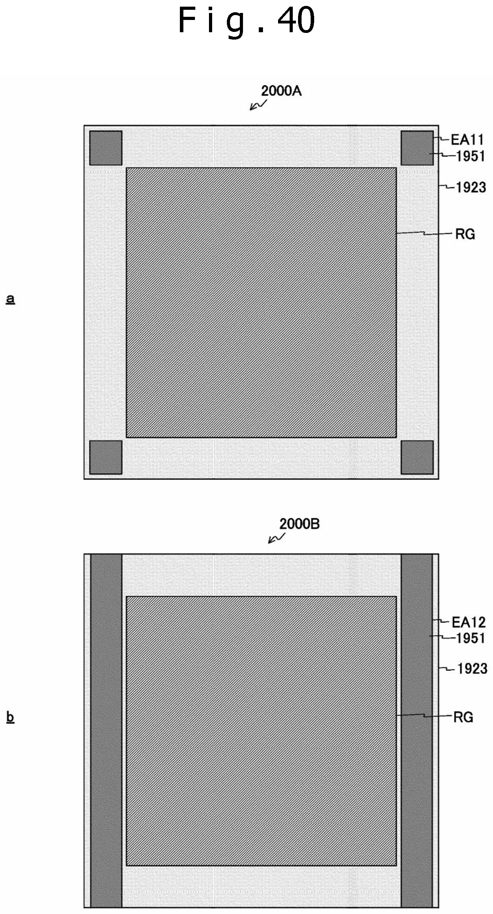

   Fig. 40 is a plan view depicting a configuration example of an electronic device according to a twentieth embodiment.
[Fig. 41]

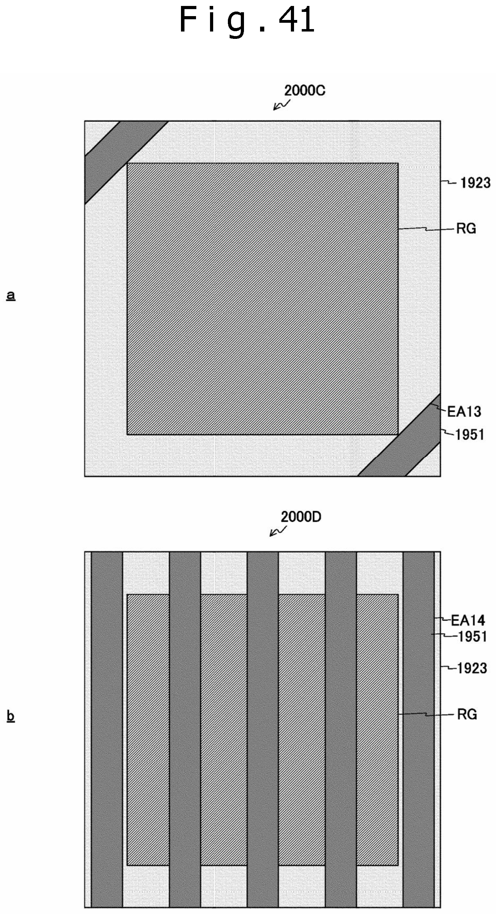

   Fig. 41 is a plan view depicting another example of the configuration of the electronic device according to the twentieth embodiment.
[Fig. 42]

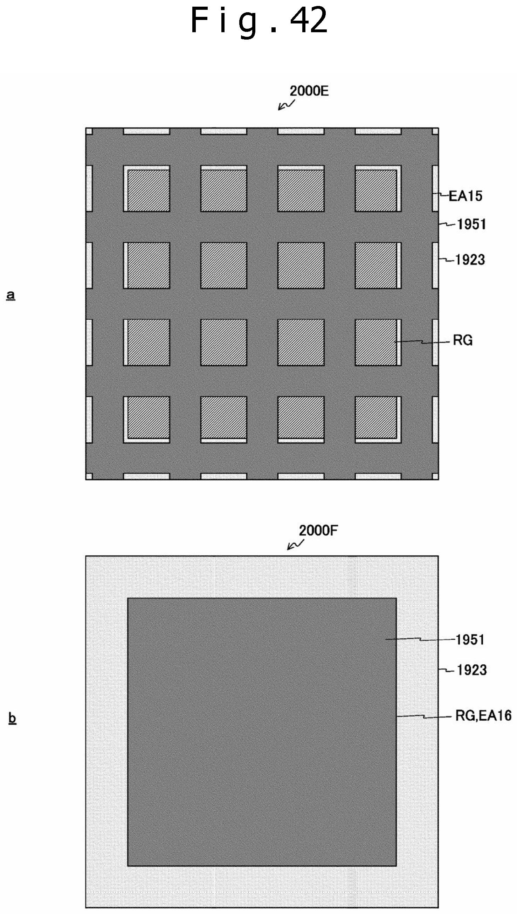

   Fig. 42 is a plan view depicting still another example of the configuration of the electronic device according to the twentieth embodiment.
[Fig. 43]

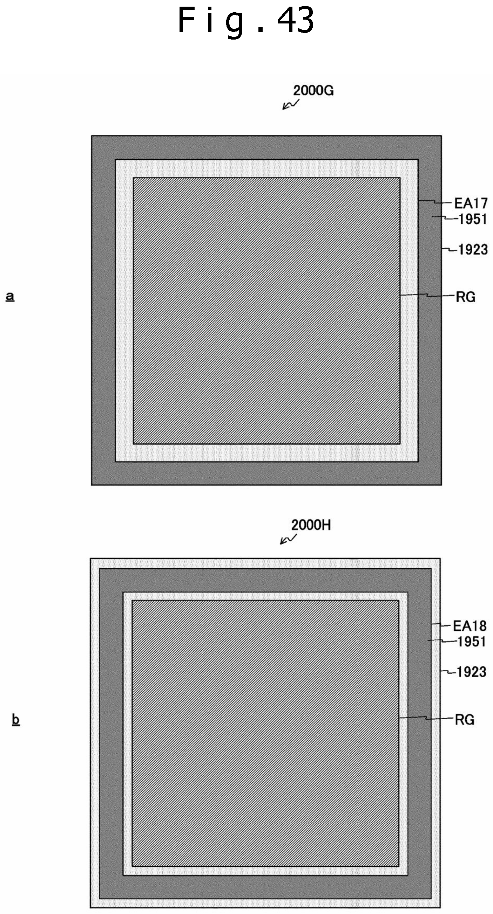

   Fig. 43 is a plan view depicting still another example of the configuration of the electronic device according to the twentieth embodiment.
[Fig. 44]

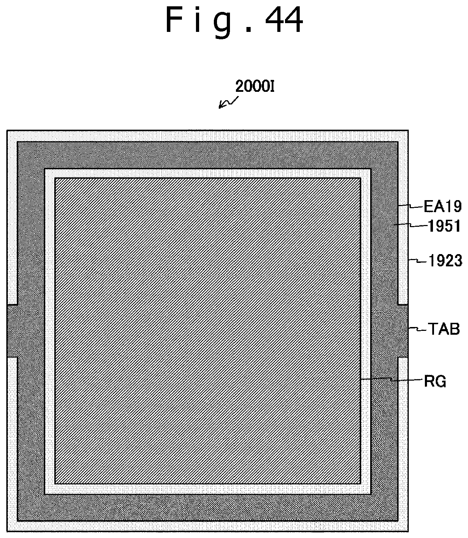

   Fig. 44 is a plan view depicting still another example of the configuration of the electronic device according to the twentieth embodiment.
[Fig. 45]

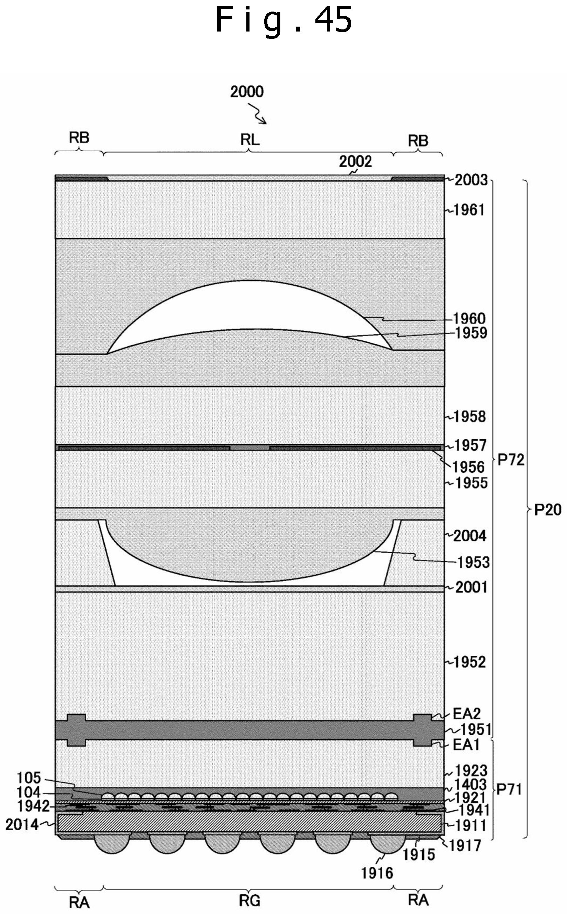

   Fig. 45 is a sectional view depicting a configuration example of an electronic device according to a twenty-first embodiment.
[Fig. 46]

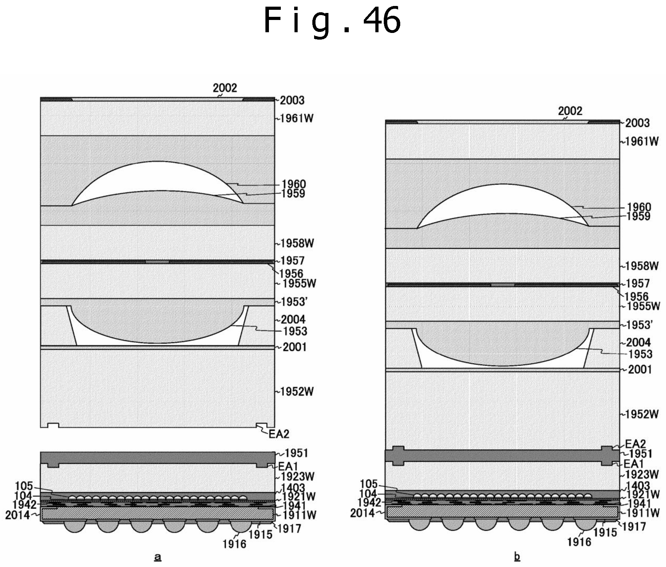

   Fig. 46 is a sectional view depicting an example of a manufacturing method for the electronic device according to the twenty-first embodiment.
[Fig. 47]

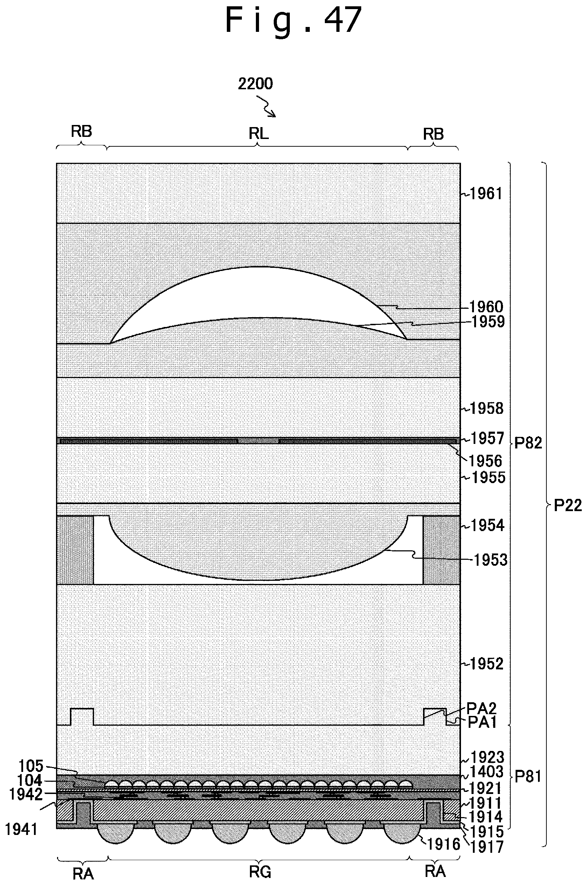

   Fig. 47 is a sectional view depicting a configuration example of an electronic device according to a twenty-second embodiment.
[Fig. 48]

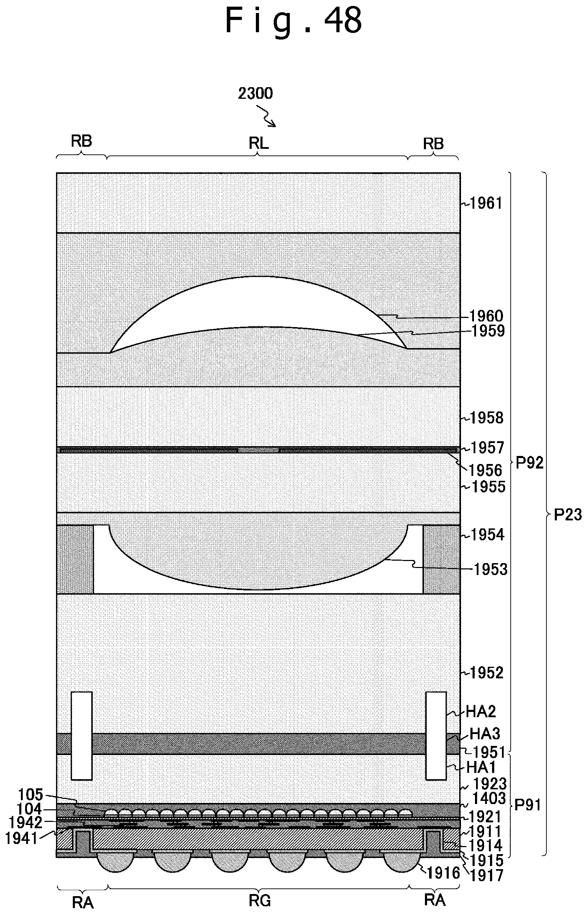

   Fig. 48 is a sectional view depicting a configuration example of an electronic device according to a twenty-third embodiment.
[Fig. 49]

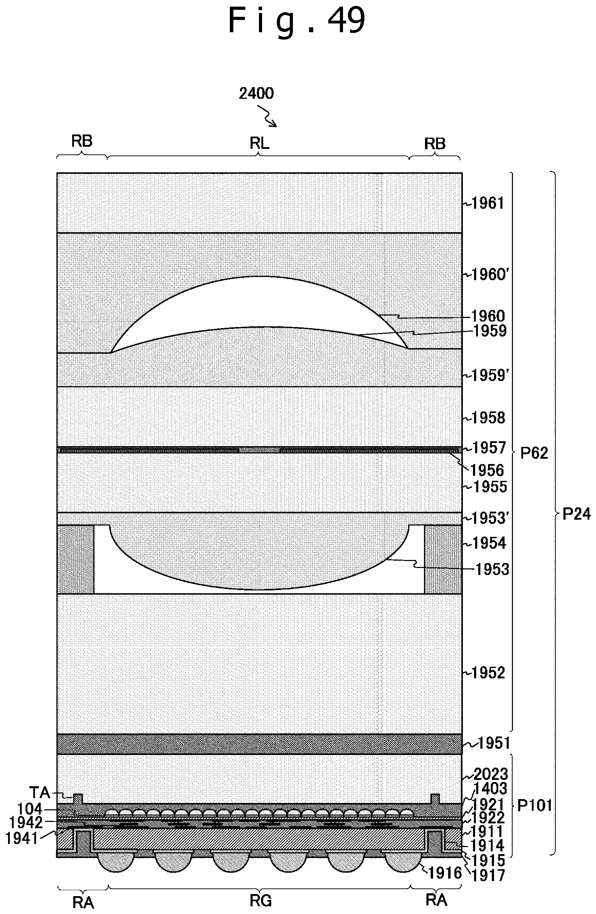

   Fig. 49 is a sectional view depicting a configuration example of an electronic device according to a twenty-fourth embodiment.
[Fig. 50]

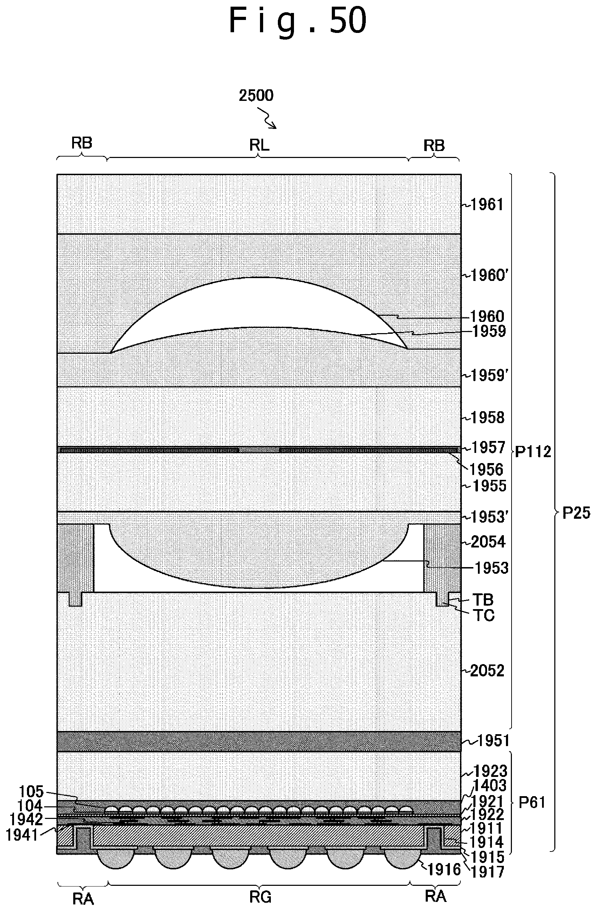

   Fig. 50 is a sectional view depicting a configuration example of an electronic device according to a twenty-fifth embodiment.
[Fig. 51]

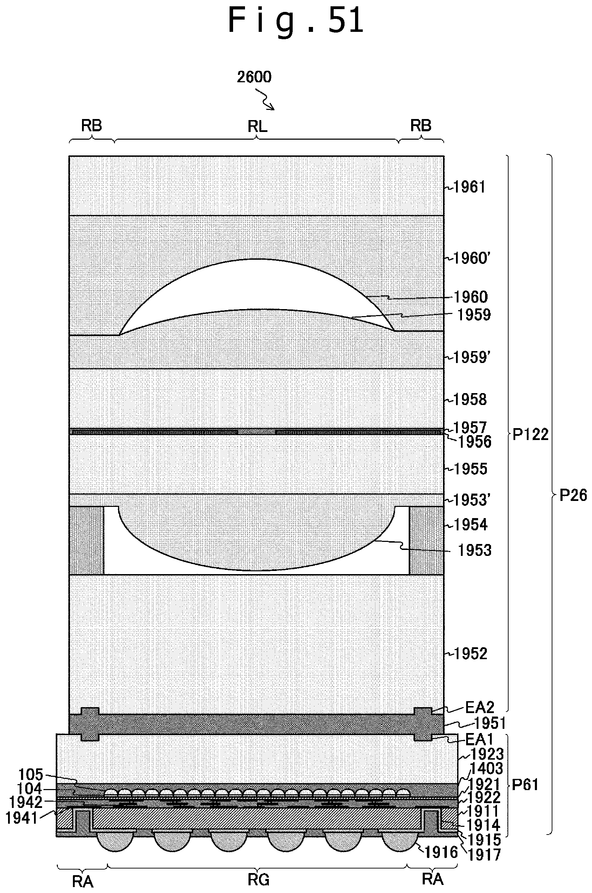

   Fig. 51 is a sectional view depicting a configuration example of an electronic device according to a twenty-sixth embodiment.
[Fig. 52]

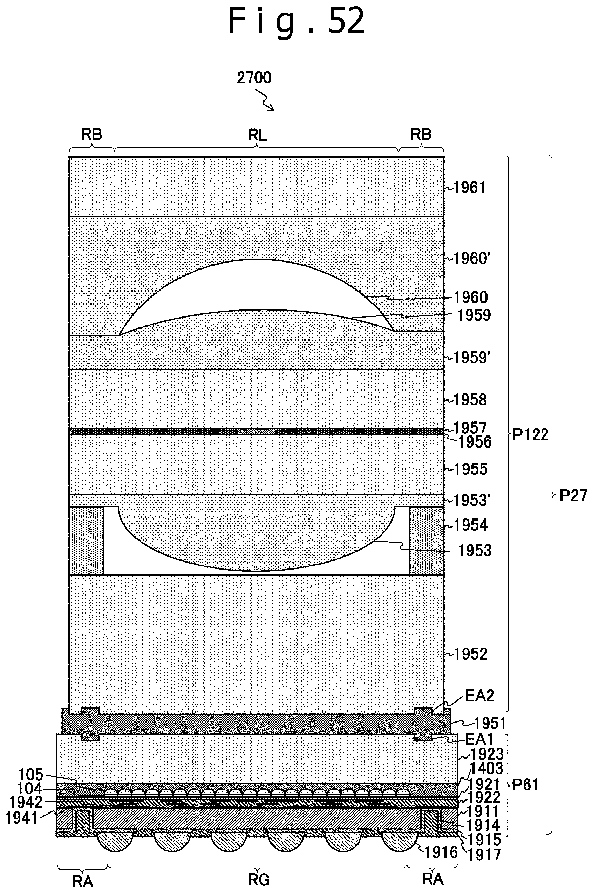

   Fig. 52 is a sectional view depicting a configuration example of an electronic device according to a twenty-seventh embodiment.
[Fig. 53]

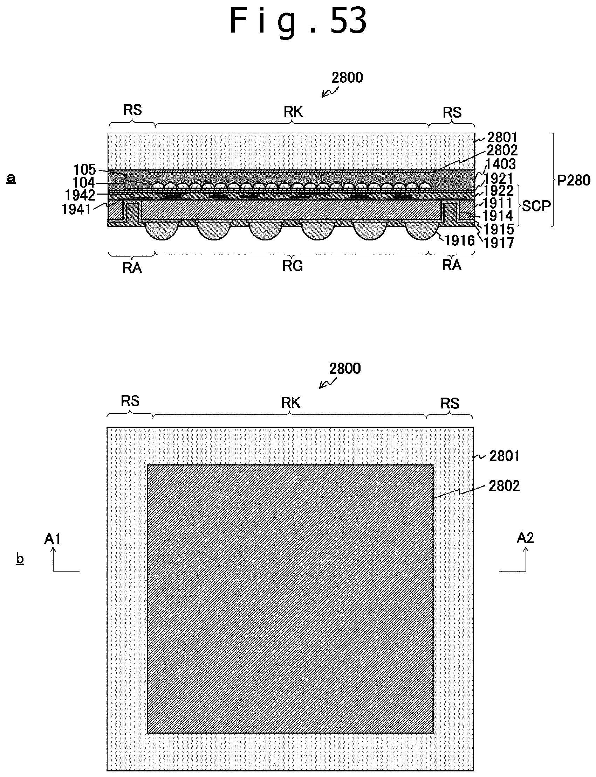

   Fig. 53 is a diagram depicting a configuration example of an electronic device according to a twenty-eighth embodiment.
[Fig. 54]

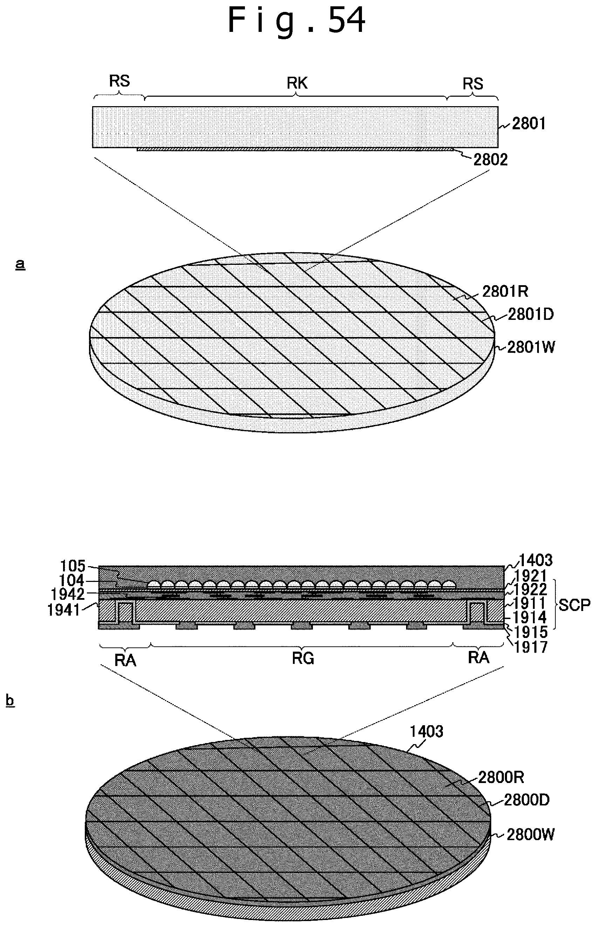

   Fig. 54 is a diagram depicting an example of a manufacturing method for the electronic device according to the twenty-eighth embodiment.
[Fig. 55]

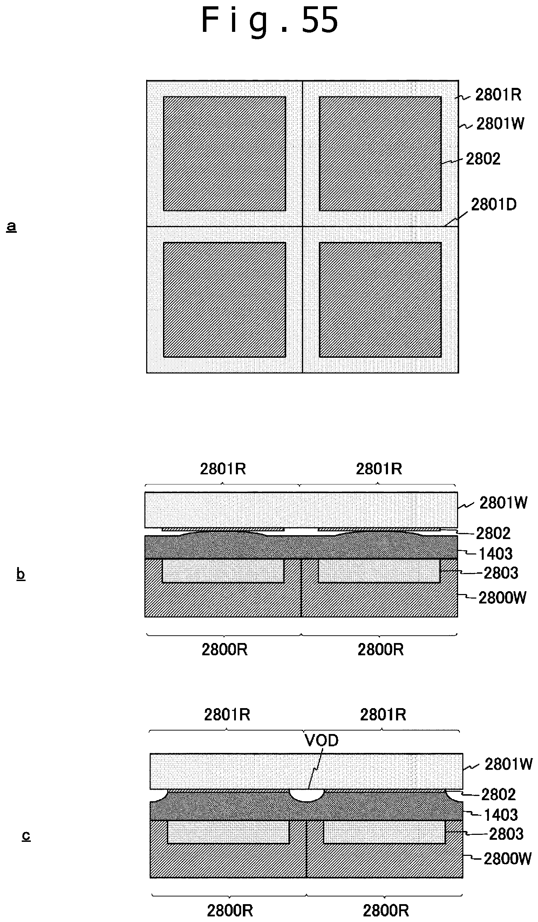

   Fig. 55 is a diagram depicting an example of a manufacturing method for the electronic device according to the twenty-eighth embodiment.
[Fig. 56]

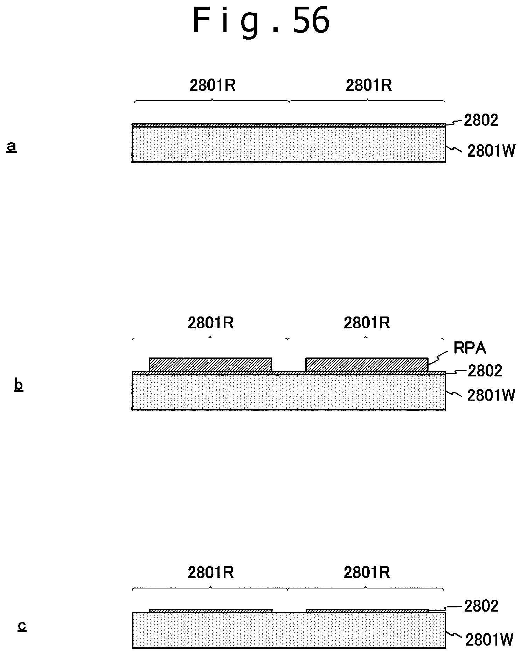

   Fig. 56 is a sectional view depicting an example of a manufacturing method for the electronic device according to the twenty-eighth embodiment.
[Fig. 57]

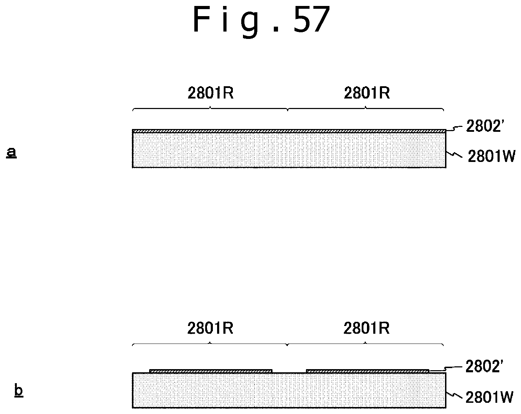

   Fig. 57 is a sectional view depicting another example of the manufacturing method for the electronic device according to the twenty-eighth embodiment.
[Fig. 58]

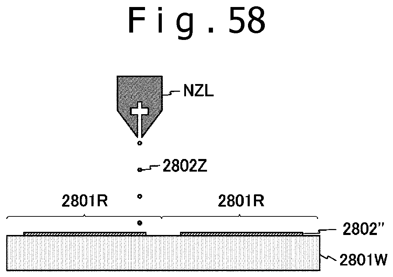

   Fig. 58 is a sectional view depicting still another example of the manufacturing method for the electronic device according to the twenty-eighth embodiment.
[Fig. 59]

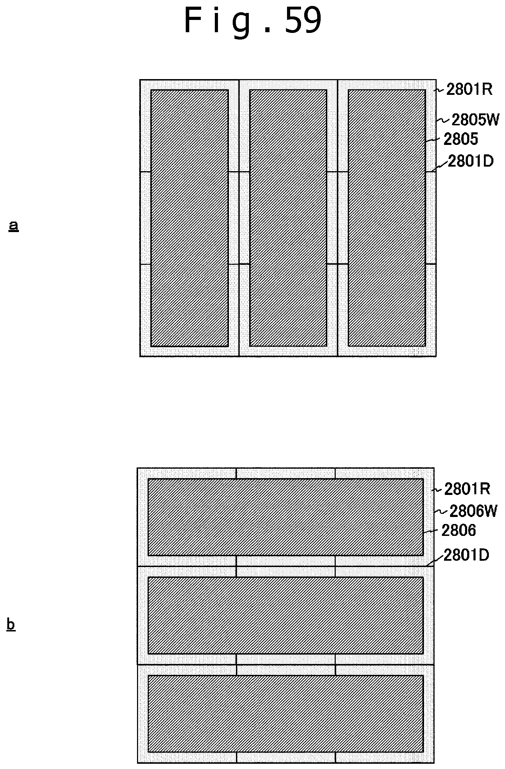

   Fig. 59 is a plan view depicting another configuration example of the electronic device according to the twenty-eighth embodiment.
[Fig. 60]

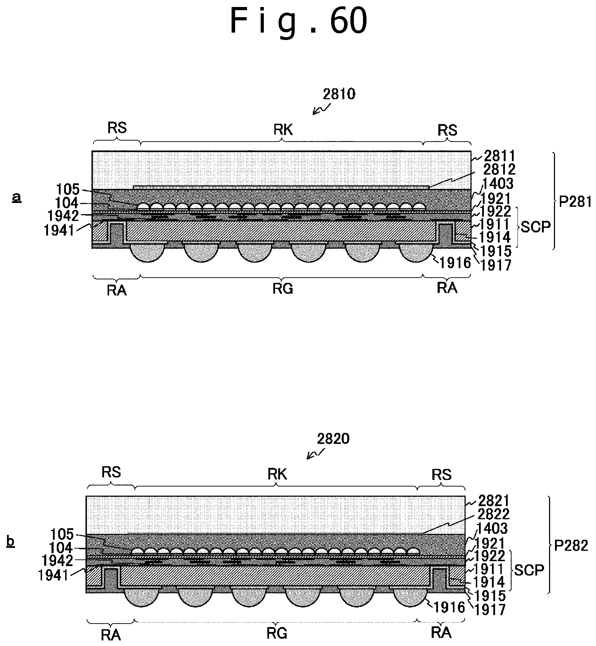

   Fig. 60 is a sectional view depicting still another configuration example of the electronic device according to the twenty-eighth embodiment.
[Fig. 61]

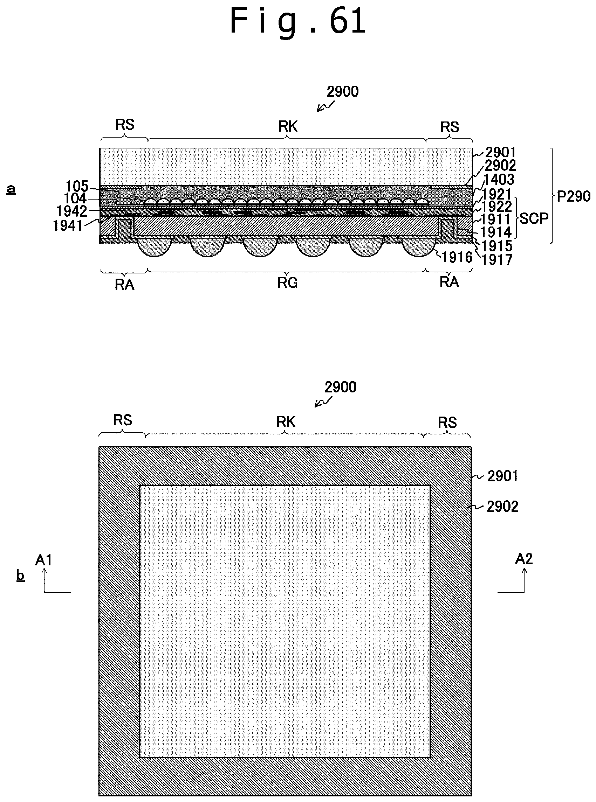

   Fig. 61 is a diagram depicting a configuration example of an electronic device according to a twenty-ninth embodiment.
[Fig. 62]

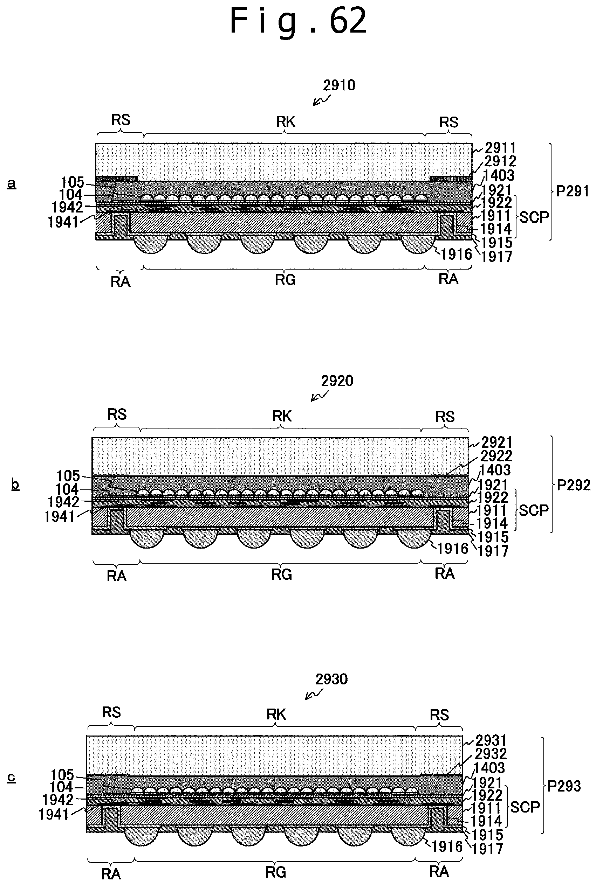

   Fig. 62 is a sectional view depicting another configuration example of the electronic device according to the twenty-ninth embodiment.
[Fig. 63]

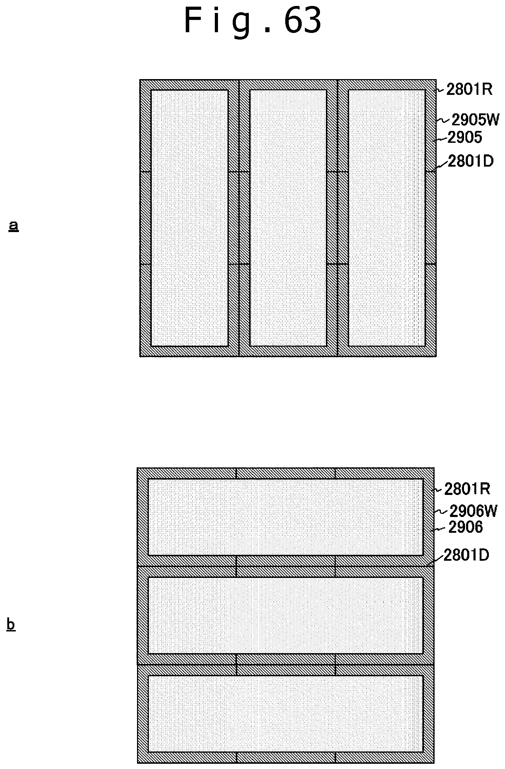

   Fig. 63 is a plan view depicting still another configuration example of the electronic device according to the twenty-ninth embodiment.
[Fig. 64]

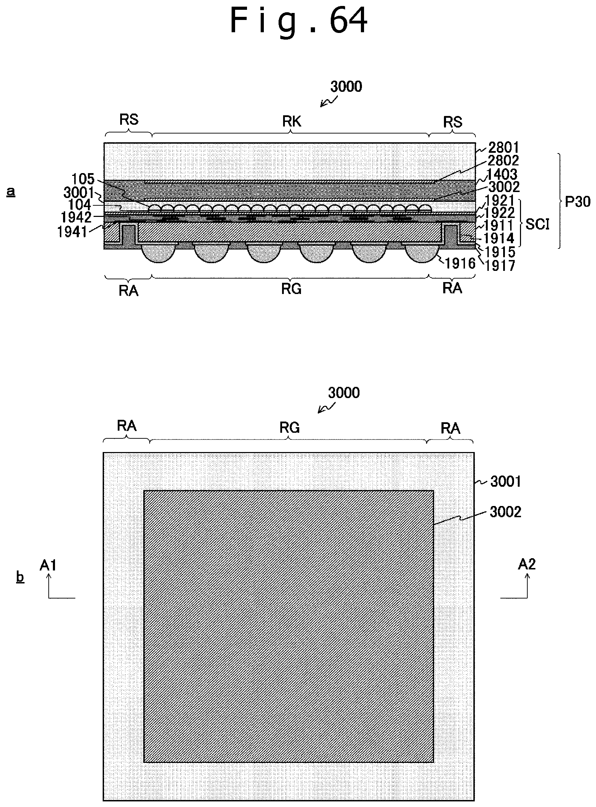

   Fig. 64 is a diagram depicting a configuration example of an electronic device according to a thirtieth embodiment.
[Fig. 65]

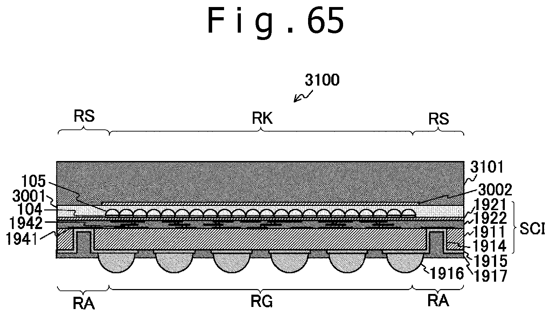

   Fig. 65 is a sectional view depicting a configuration example of an electronic device according to a thirty-first embodiment.
[Fig. 66]

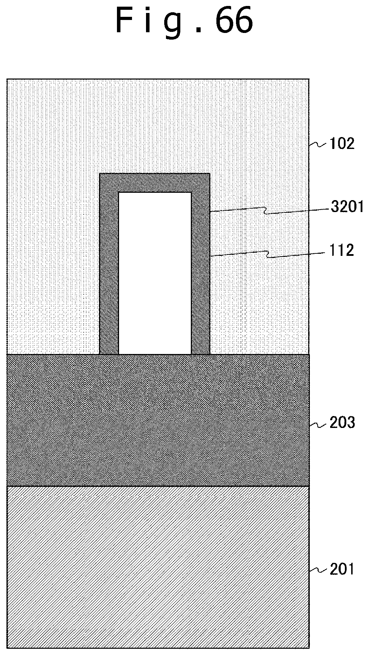

   Fig. 66 is a sectional view depicting a configuration example of a recess of an electronic device according to a thirty-second embodiment.
[Fig. 67]

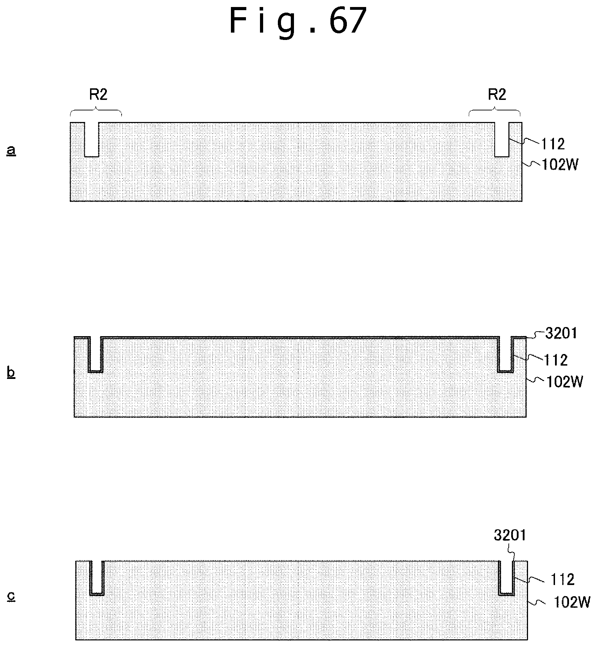

   Fig. 67 is a sectional view depicting an example of a manufacturing method for a recess of the electronic device according to the thirty-second embodiment.
[Fig. 68]

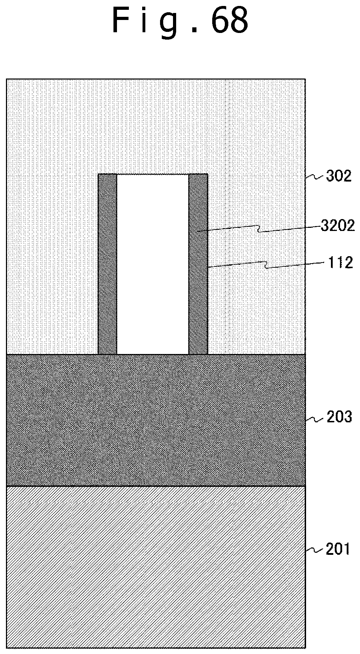

   Fig. 68 is a sectional view depicting another configuration example of a recess of the electronic device according to the thirty-second embodiment.
[Fig. 69]

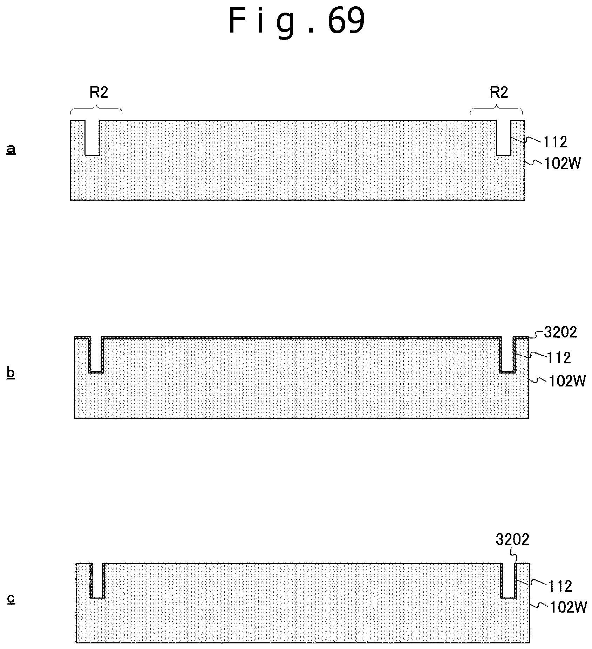

   Fig. 69 is a sectional view depicting another example of the manufacturing method for a recess of the electronic device according to the thirty-second embodiment.
[Fig. 70]

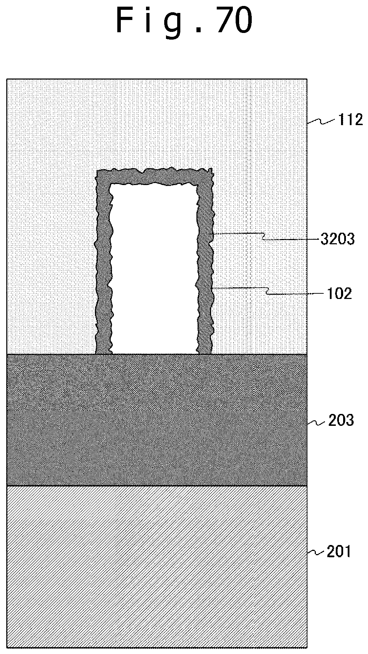

   Fig. 70 is a sectional view depicting still another configuration example of a recess of the electronic device according to the thirty-second embodiment.
[Fig. 71]

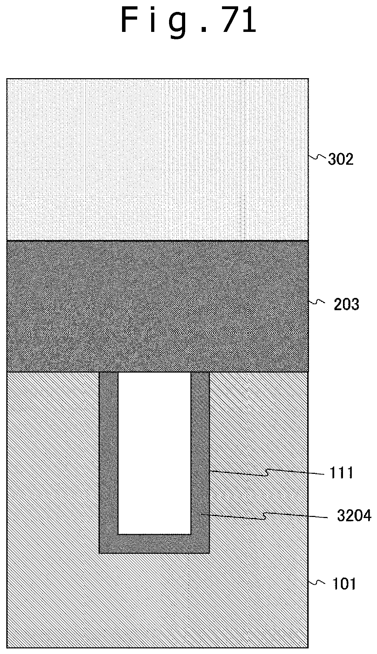

   Fig. 71 is a sectional view depicting still another configuration example of a recess of the electronic device according to the thirty-second embodiment.
[Fig. 72]

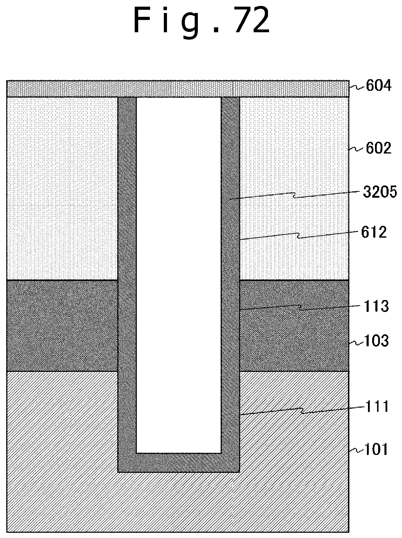

   Fig. 72 is a sectional view depicting still another configuration example of a recess of the electronic device according to the thirty-second embodiment.
[Fig. 73]

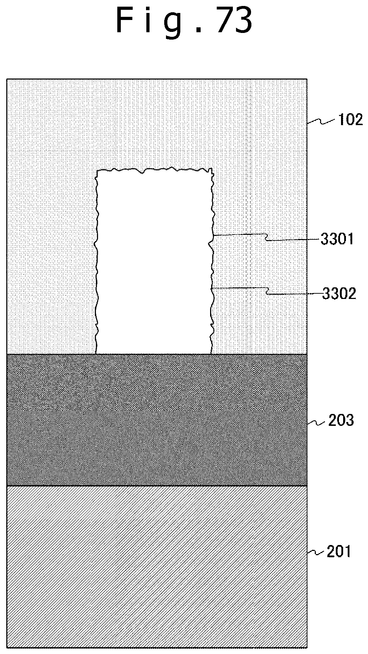

   Fig. 73 is a sectional view depicting a configuration example of a recess of an electronic device according to a thirty-third embodiment.
[Fig. 74]

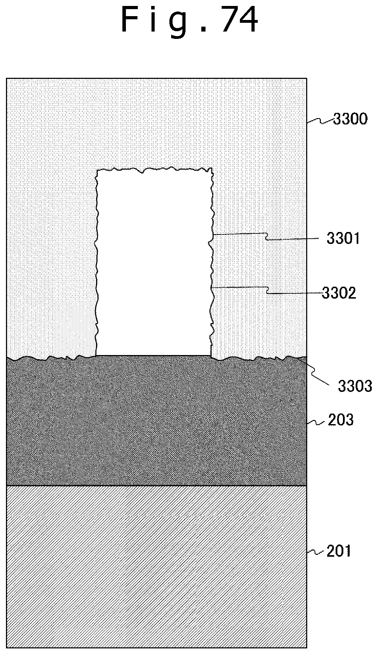

   Fig. 74 is a sectional view depicting another configuration example of a recess of the electronic device according to the thirty-third embodiment.
[Fig. 75]

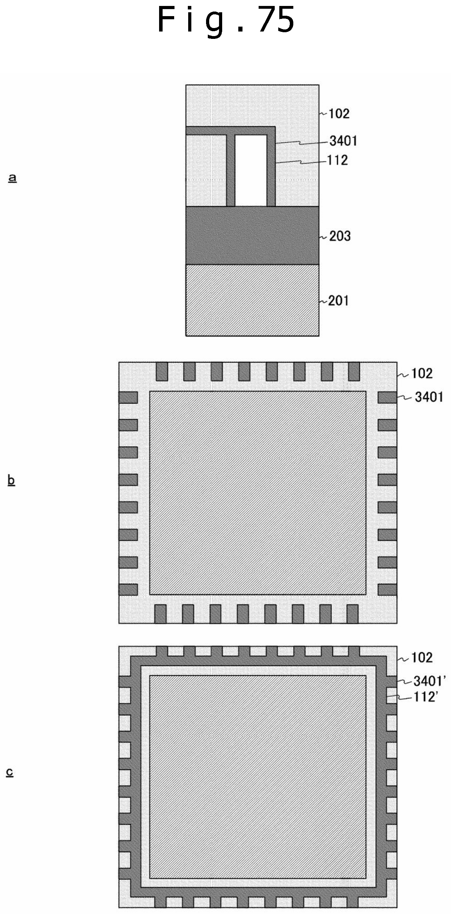

   Fig. 75 is a diagram depicting a configuration example of a recess of an electronic device according to a thirty-fourth embodiment.
[Fig. 76]

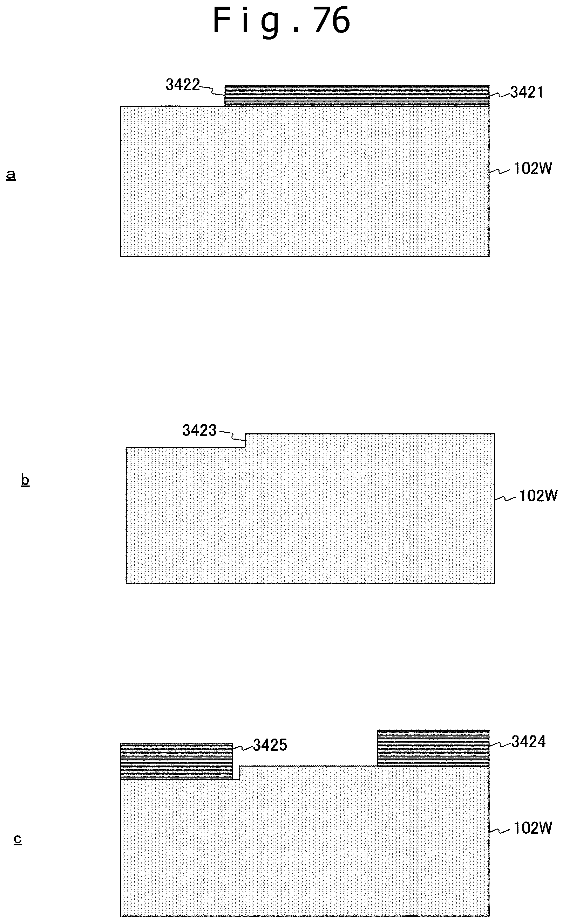

   Fig. 76 is a sectional view depicting an example of a manufacturing method for a recess of the electronic device according to the thirty-fourth embodiment.
[Fig. 77]

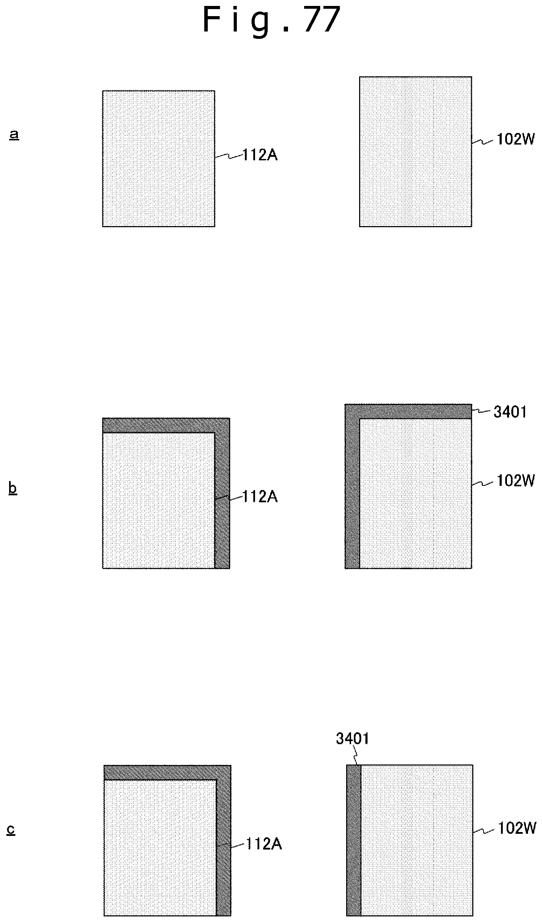

   Fig. 77 is a sectional view depicting an example of a manufacturing method for a recess of the electronic device according to the thirty-fourth embodiment.
[Fig. 78]

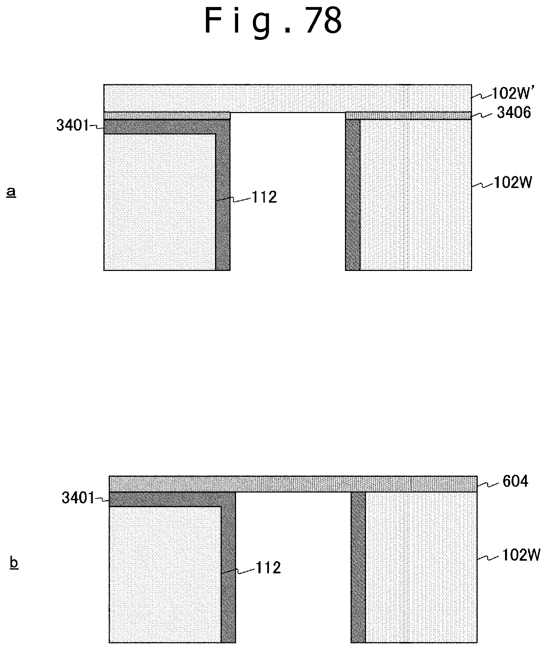

   Fig. 78 is a sectional view depicting an example of a manufacturing method for a recess of the electronic device according to the thirty-fourth embodiment.
[Fig. 79]

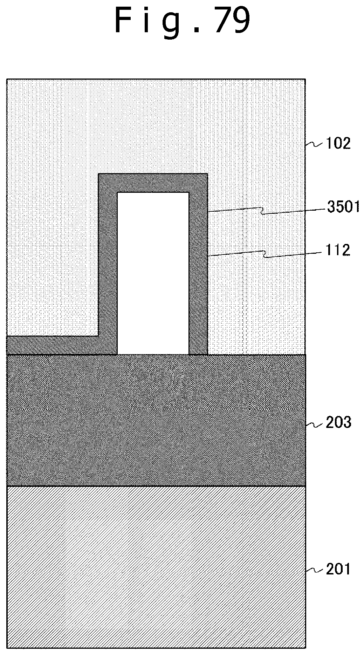

   Fig. 79 is a sectional view depicting a configuration example of a recess of an electronic device according to a thirty-fifth embodiment.
[Fig. 80]

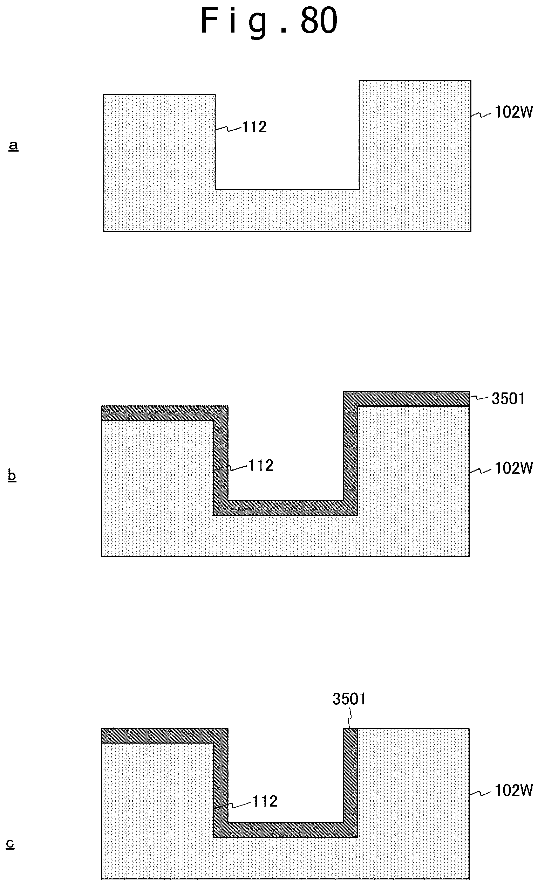

   Fig. 80 is a sectional view depicting an example of a manufacturing method for a recess of the electronic device according to the thirty-fifth embodiment.
[Fig. 81]

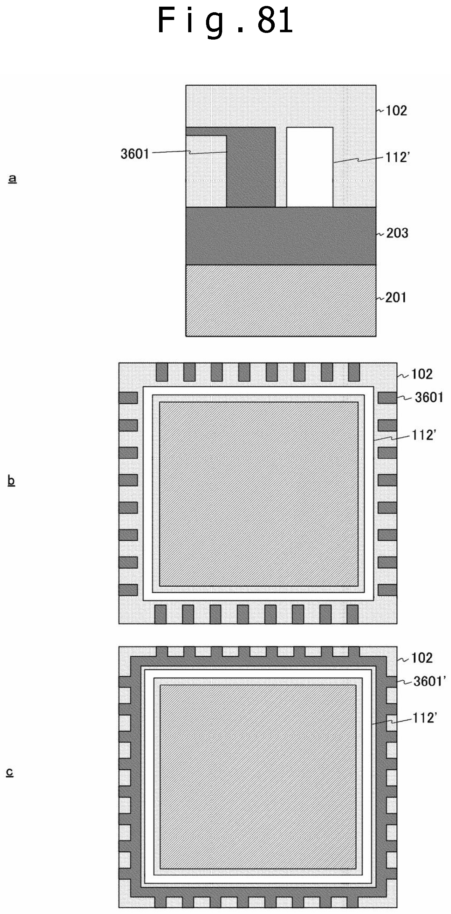

   Fig. 81 is a diagram depicting a configuration example of a recess of an electronic device according to a thirty-sixth embodiment.
[Fig. 82]

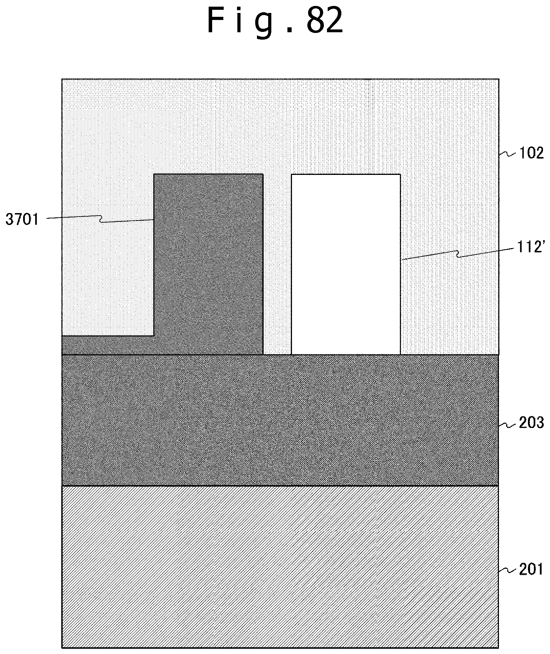

   Fig. 82 is a sectional view depicting a configuration example of a recess of an electronic device according to a thirty-seventh embodiment.
[Fig. 83]

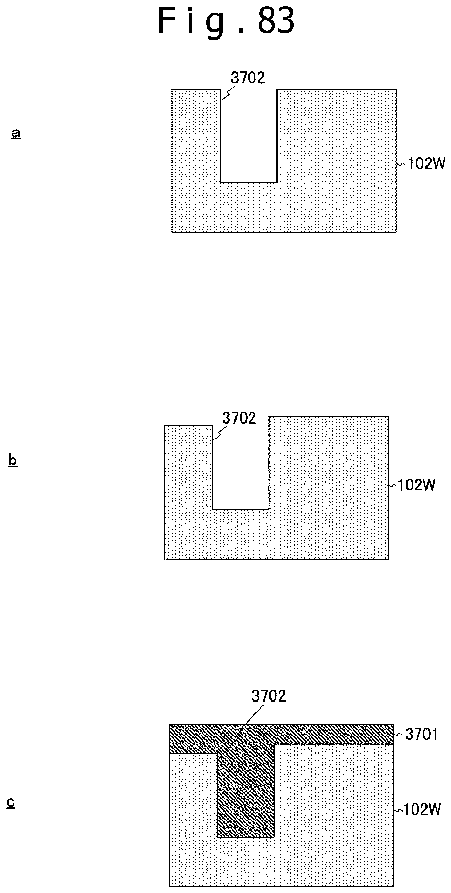

   Fig. 83 is a sectional view depicting an example of a manufacturing method for a recess of the electronic device according to the thirty-seventh embodiment.
[Fig. 84]

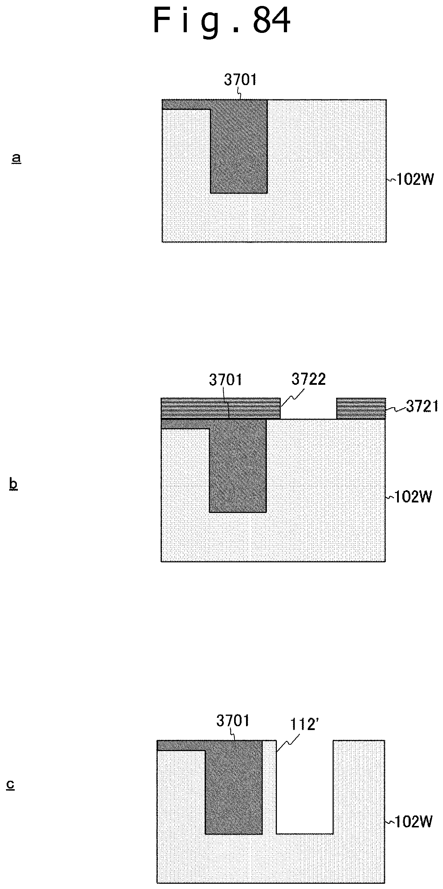

   Fig. 84 is a sectional view depicting an example of a manufacturing method for a recess of the electronic device according to the thirty-seventh embodiment.
[Fig. 85]

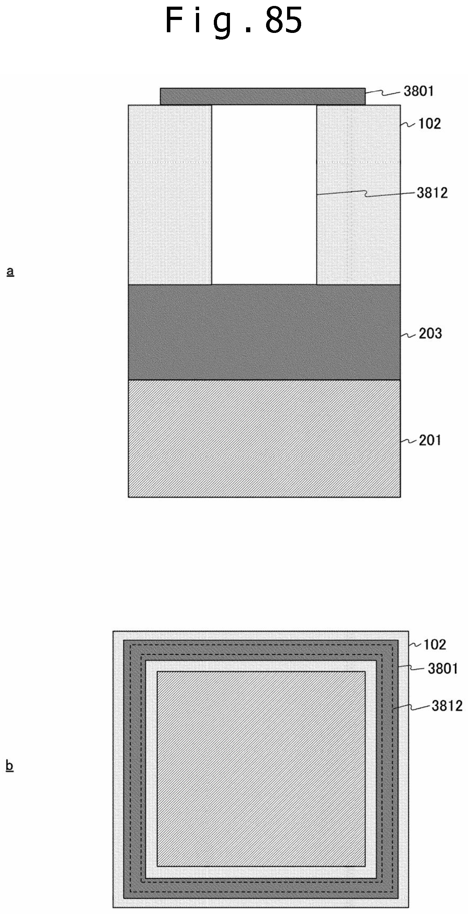

   Fig. 85 is a diagram depicting a configuration example of a recess of an electronic device according to a thirty-eighth embodiment.
[Fig. 86]

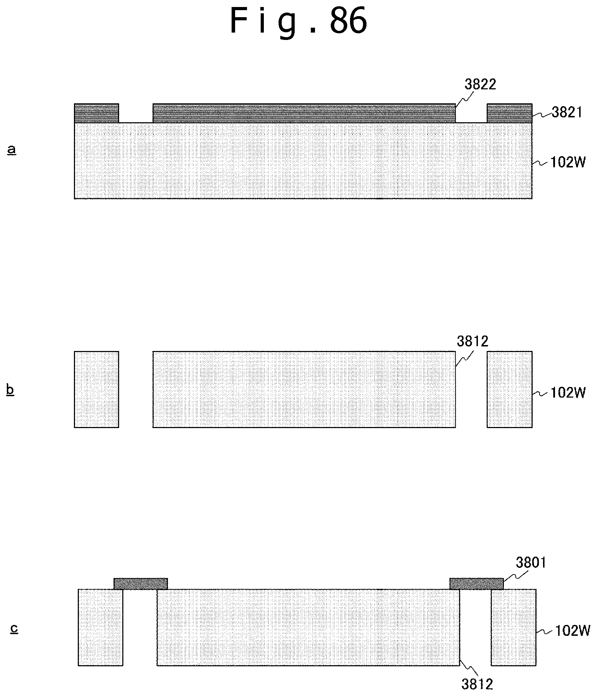

   Fig. 86 is a sectional view depicting an example of a manufacturing method for a recess of the electronic device according to the thirty-eighth embodiment.
[Fig. 87]

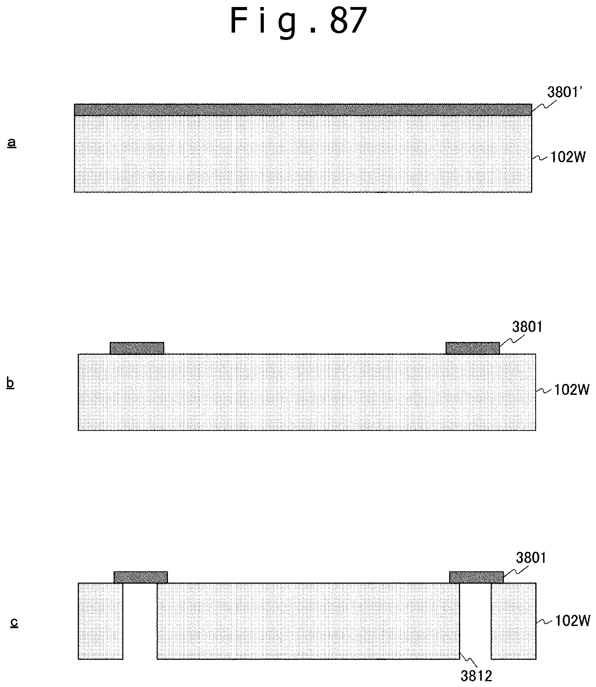

   Fig. 87 is a sectional view depicting an example of a manufacturing method for a recess of the electronic device according to the thirty-eighth embodiment.
[Fig. 88]

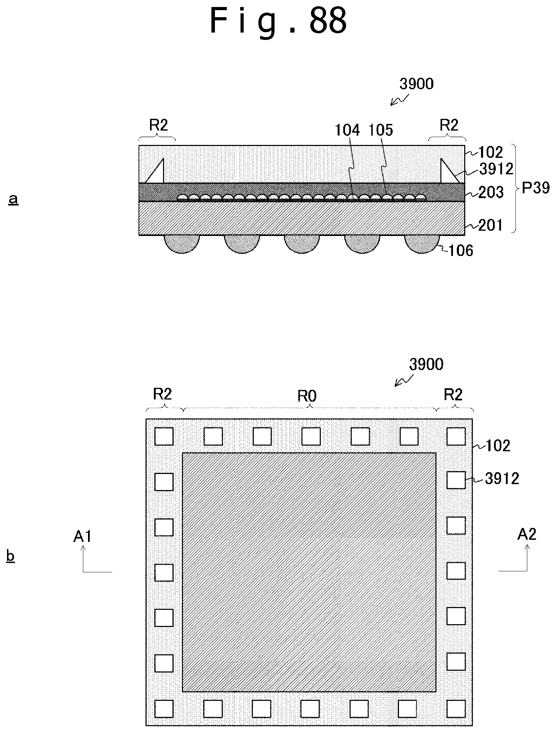

   Fig. 88 is a diagram depicting a configuration example of an electronic device according to a thirty-ninth embodiment.
[Fig. 89]

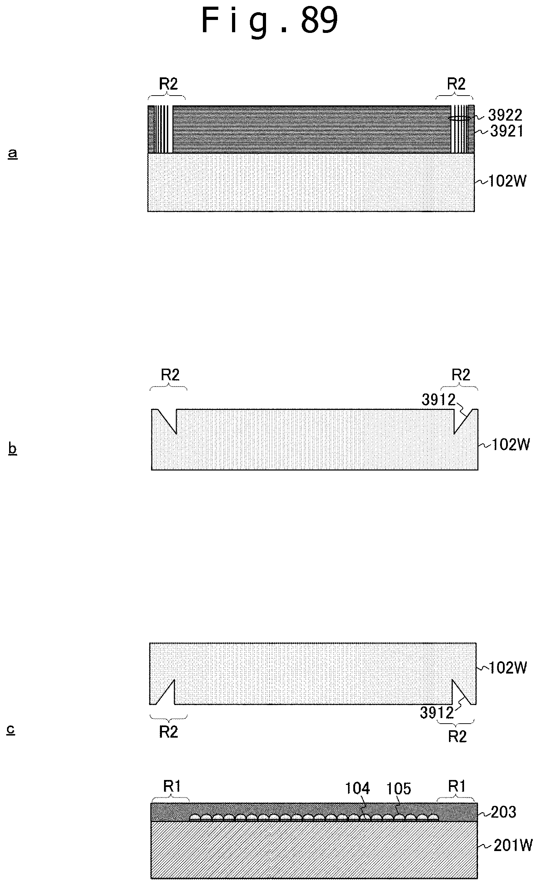

   Fig. 89 is a sectional view depicting an example of a manufacturing method for the electronic device according to the thirty-ninth embodiment.
[Fig. 90]

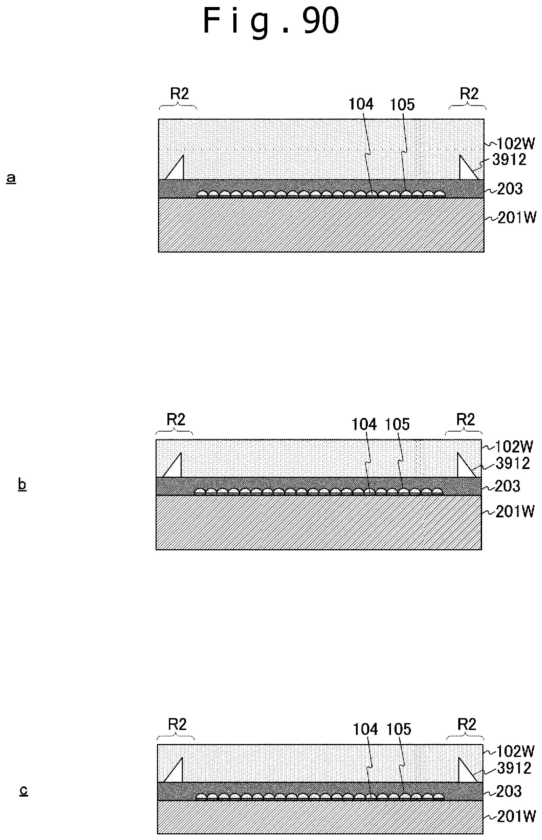

   Fig. 90 is a sectional view depicting an example of a manufacturing method for the electronic device according to the thirty-ninth embodiment.
[Fig. 91]

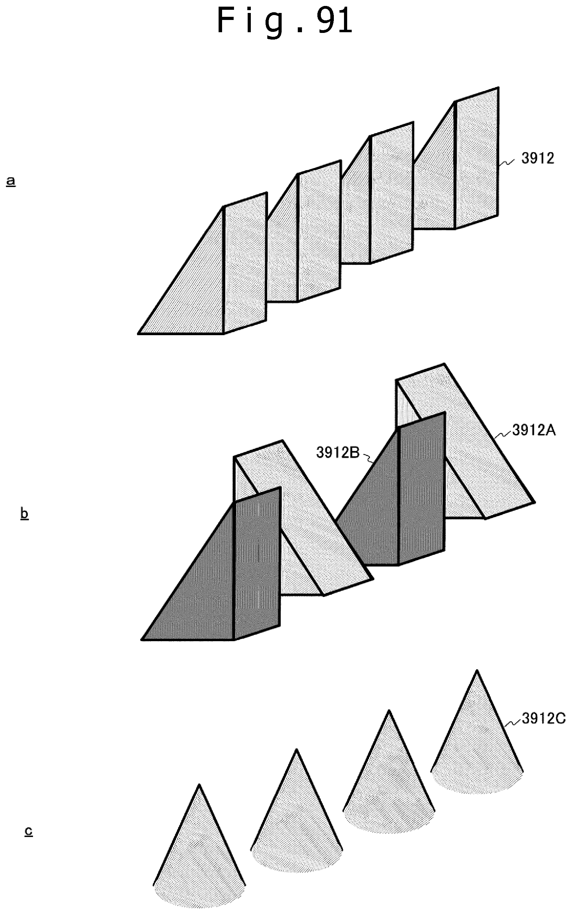

   Fig. 91 is a perspective view depicting a configuration example of a recess of the electronic device according to the thirty-ninth embodiment.
[Fig. 92]

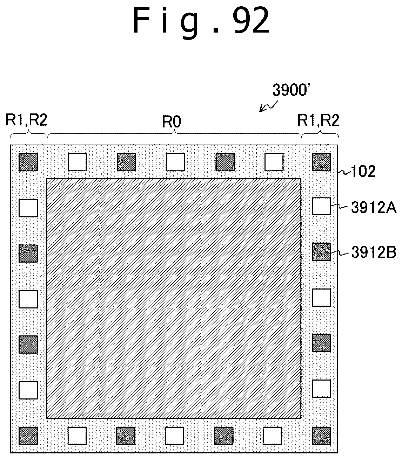

   Fig. 92 is a plan view depicting a configuration example of an electronic device according to the thirty-ninth embodiment.
[Fig. 93]

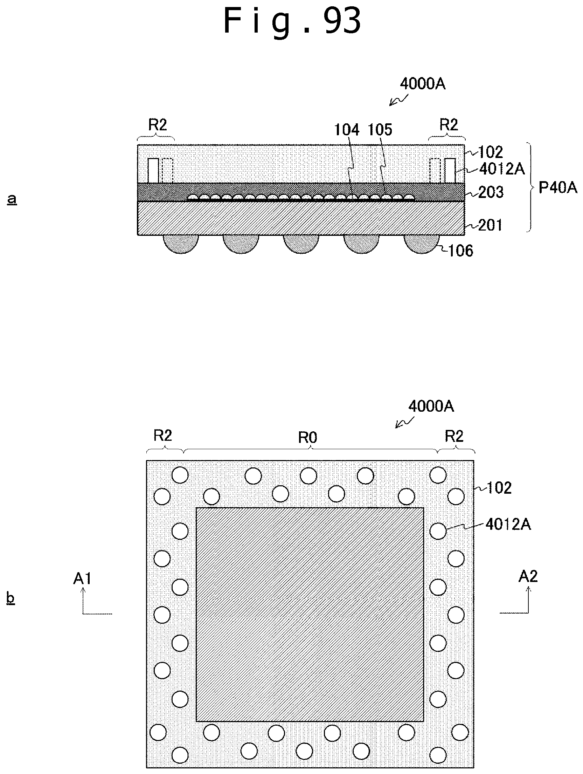

   Fig. 93 is a diagram depicting a configuration example of an electronic device according to a fortieth embodiment.
[Fig. 94]

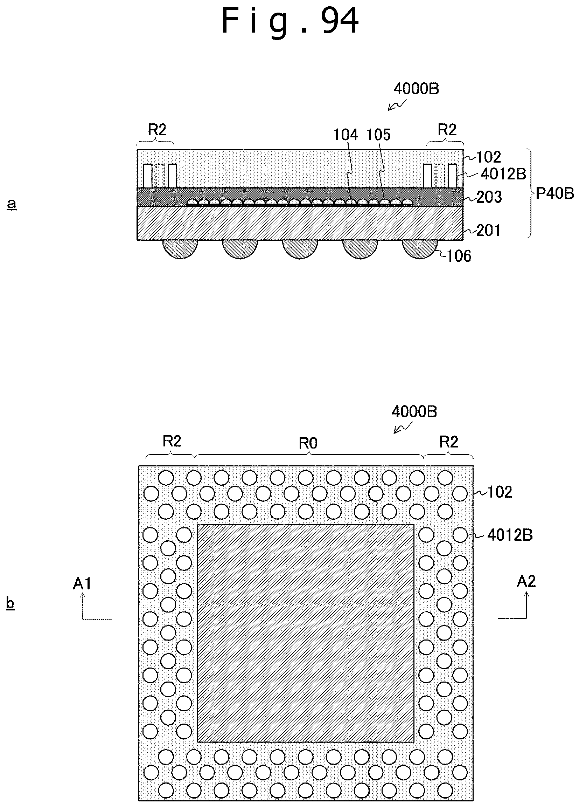

   Fig. 94 is a diagram depicting another configuration example of the electronic device according to the fortieth embodiment.
[Fig. 95]

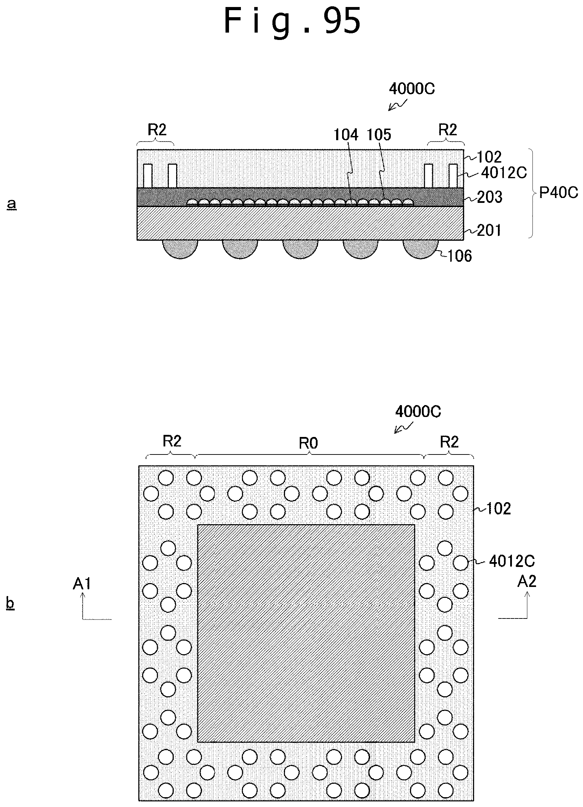

   Fig. 95 is a diagram depicting still another configuration example of the electronic device according to the fortieth embodiment.
[Fig. 96]

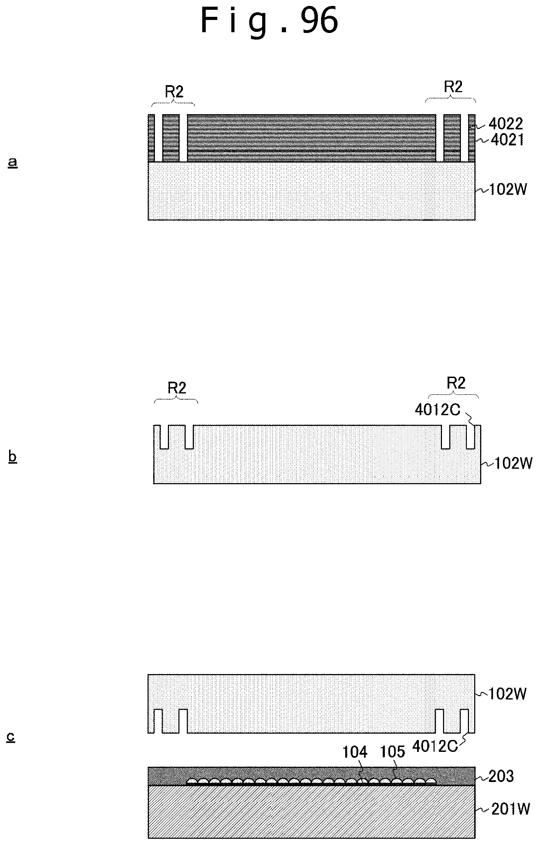

   Fig. 96 is a sectional view depicting an example of a manufacturing method for the electronic device according to the fortieth embodiment.
[Fig. 97]

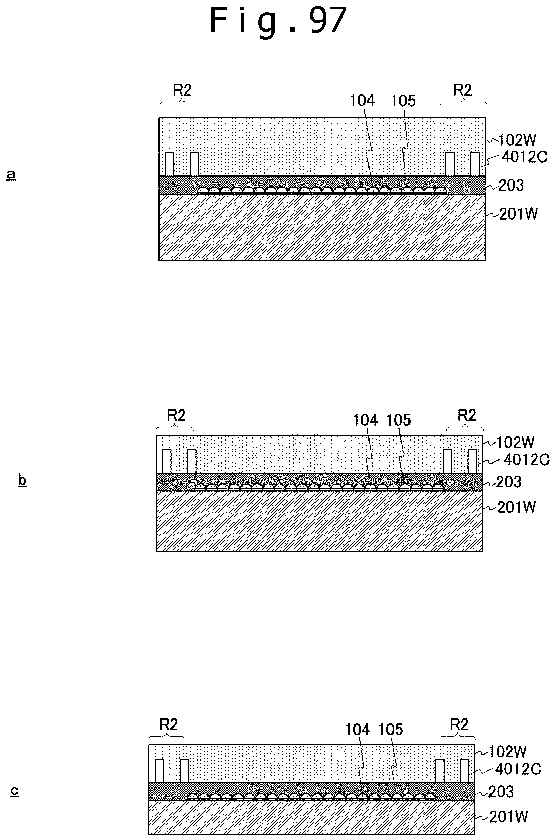

   Fig. 97 is a sectional view depicting an example of a manufacturing method for the electronic device according to the fortieth embodiment.
[Fig. 98]

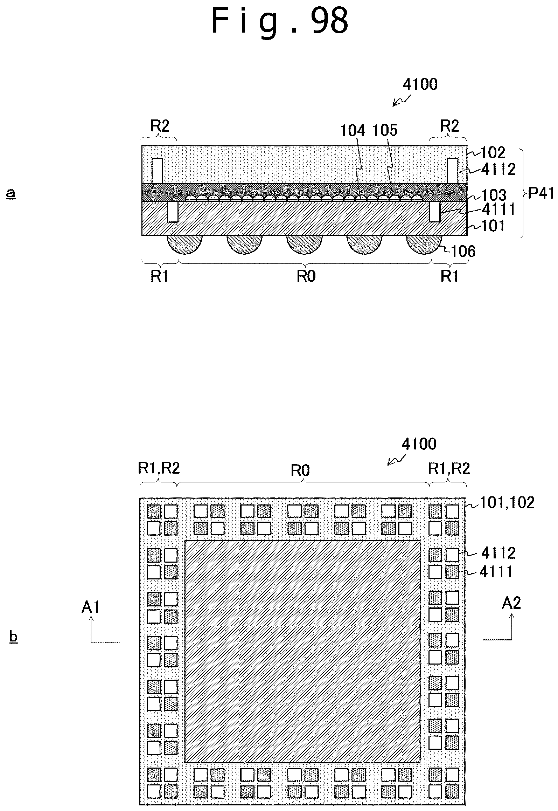

   Fig. 98 is a diagram depicting a configuration example of an electronic device according to a forty-first embodiment.
[Fig. 99]

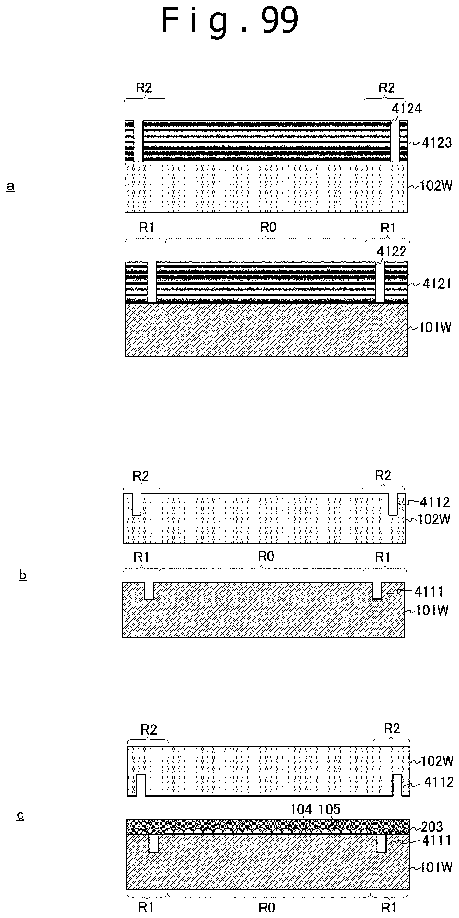

   Fig. 99 is a sectional view depicting an example of a manufacturing method for the electronic device according to the forty-first embodiment.
[Fig. 100]

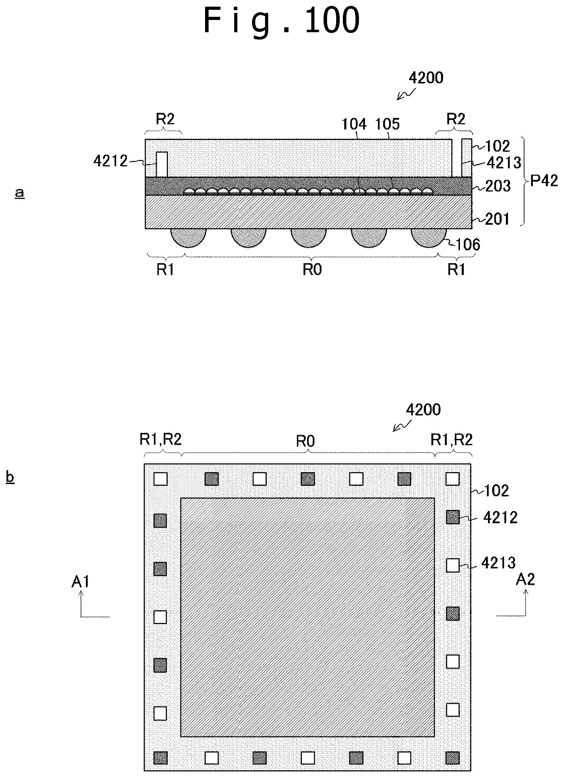

   Fig. 100 is a diagram depicting a configuration example of an electronic device according to a forty-second embodiment.
[Fig. 101]

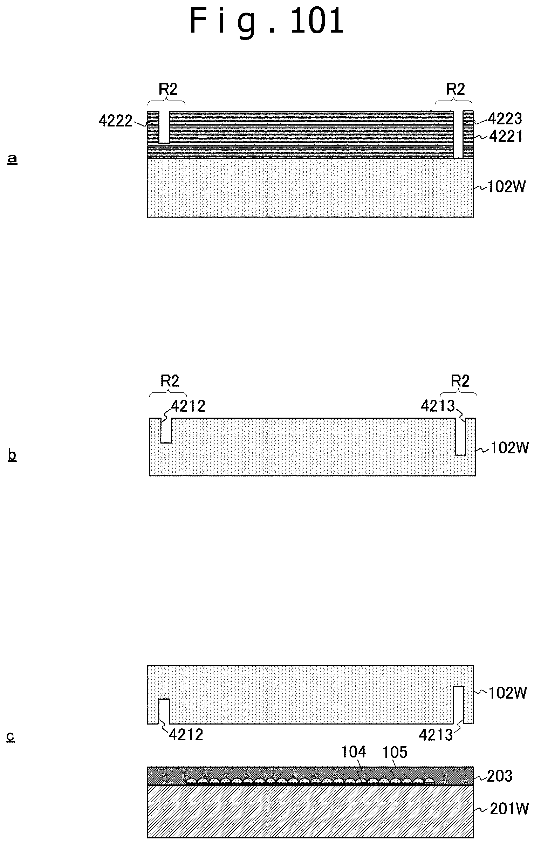

   Fig. 101 is a sectional view depicting an example of a manufacturing method for the electronic device according to the forty-second embodiment.
[Fig. 102]

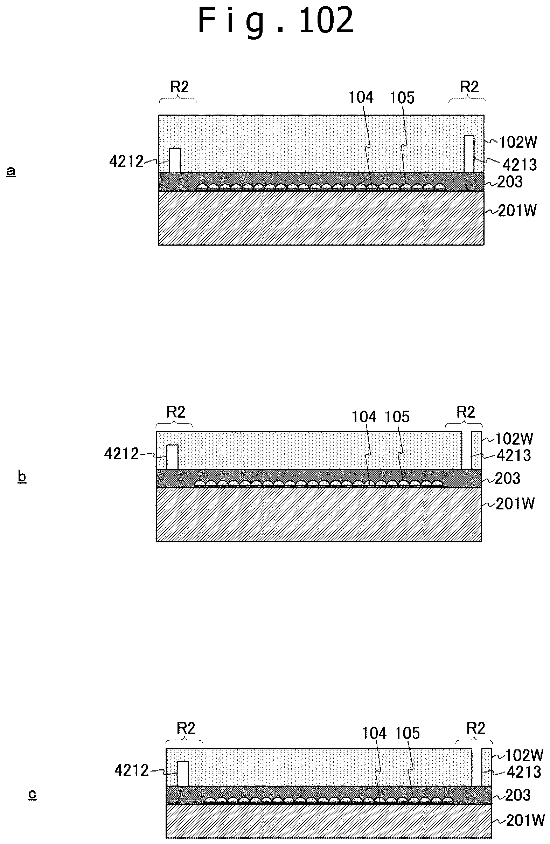

   Fig. 102 is a sectional view depicting an example of a manufacturing method for the electronic device according to the forty-second embodiment.
[Fig. 103]

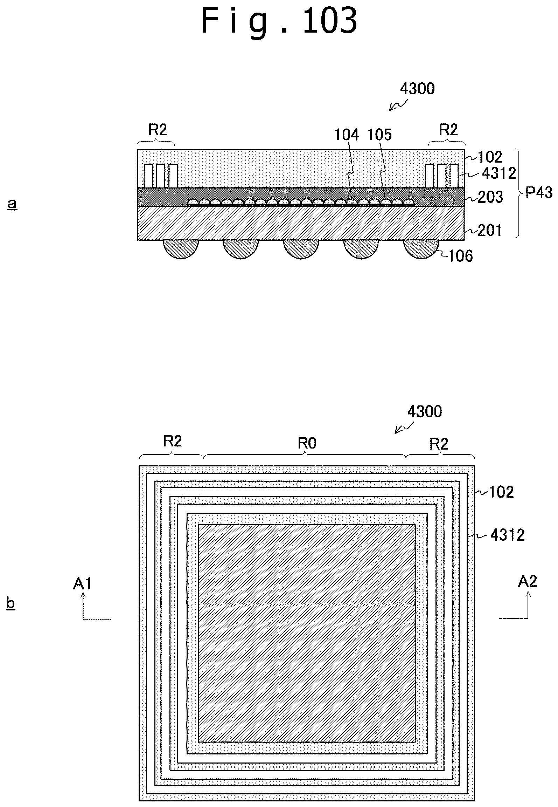

   Fig. 103 is a diagram depicting a configuration example of an electronic device according to a forty-third embodiment.
[Fig. 104]

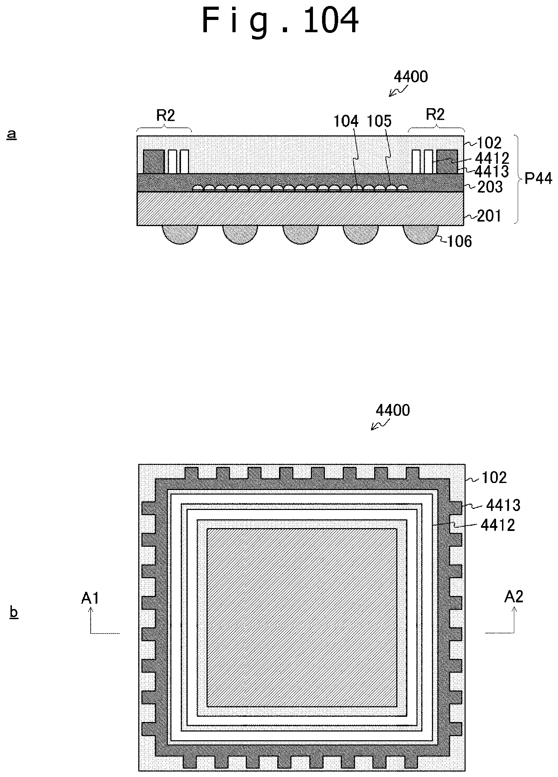

   Fig. 104 is a diagram depicting a configuration example of an electronic device according to a forty-fourth embodiment.
[Fig. 105]

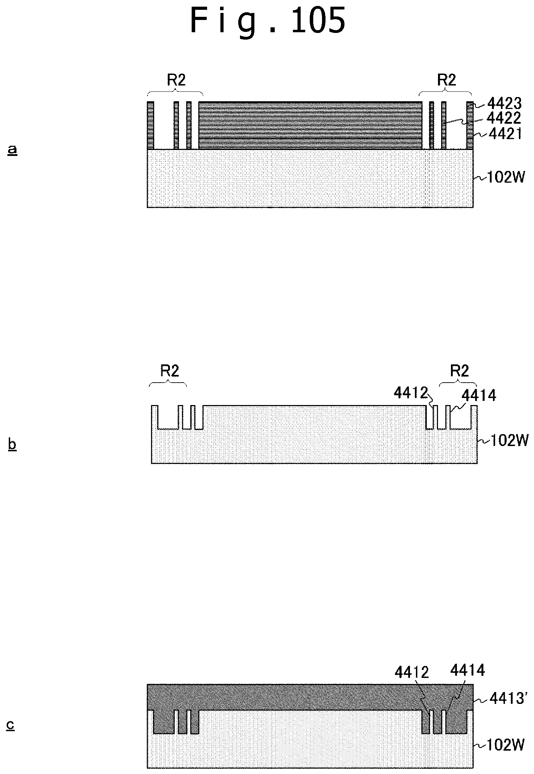

   Fig. 105 is a sectional view depicting an example of a manufacturing method for the electronic device according to the forty-fourth embodiment.
[Fig. 106]

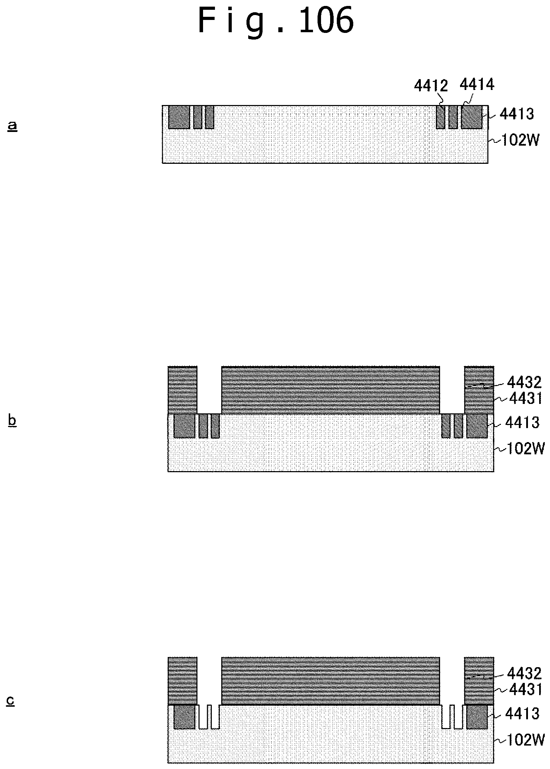

   Fig. 106 is a sectional view depicting an example of a manufacturing method for the electronic device according to the forty-fourth embodiment.
[Fig. 107]

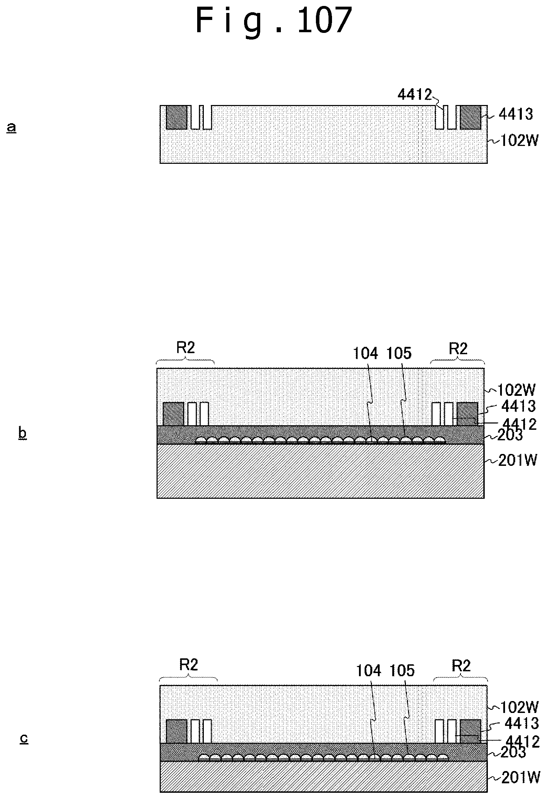

   Fig. 107 is a sectional view depicting an example of a manufacturing method for the electronic device according to the forty-fourth embodiment.
[Fig. 108]

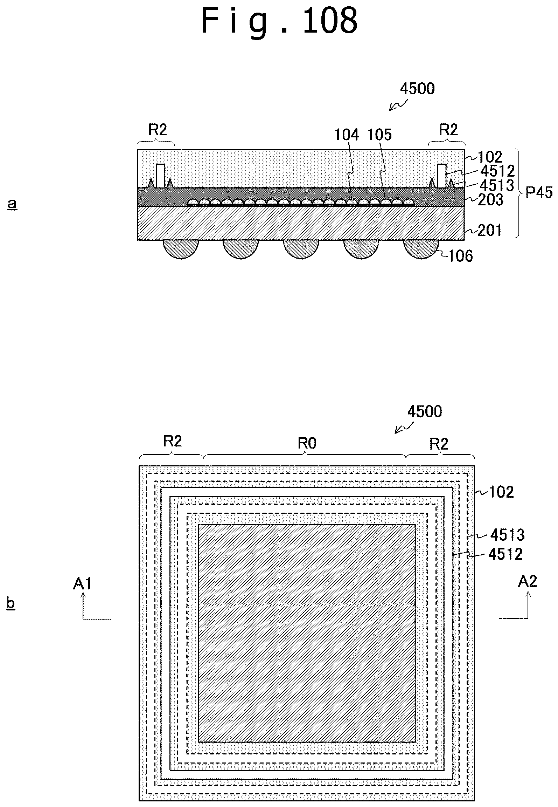

   Fig. 108 is a diagram depicting a configuration example of an electronic device according to a forty-fifth embodiment.
[Fig. 109]

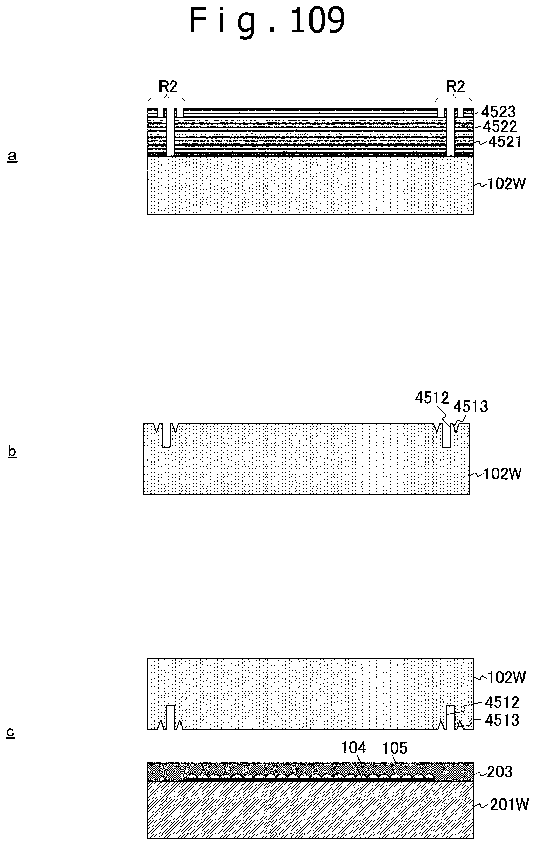

   Fig. 109 is a sectional view depicting an example of a manufacturing method for the electronic device according to the forty-fifth embodiment.
[Fig. 110]

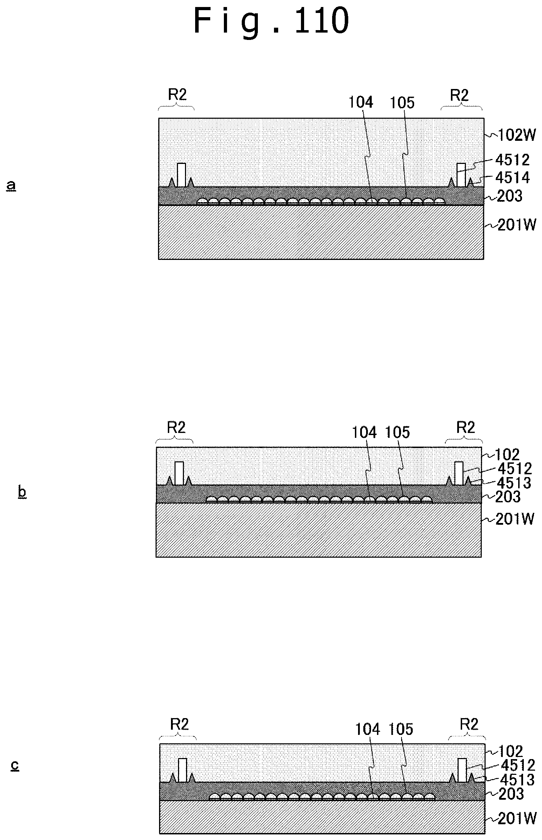

   Fig. 110 is a sectional view depicting an example of a manufacturing method for the electronic device according to the forty-fifth embodiment.
[Fig. 111]

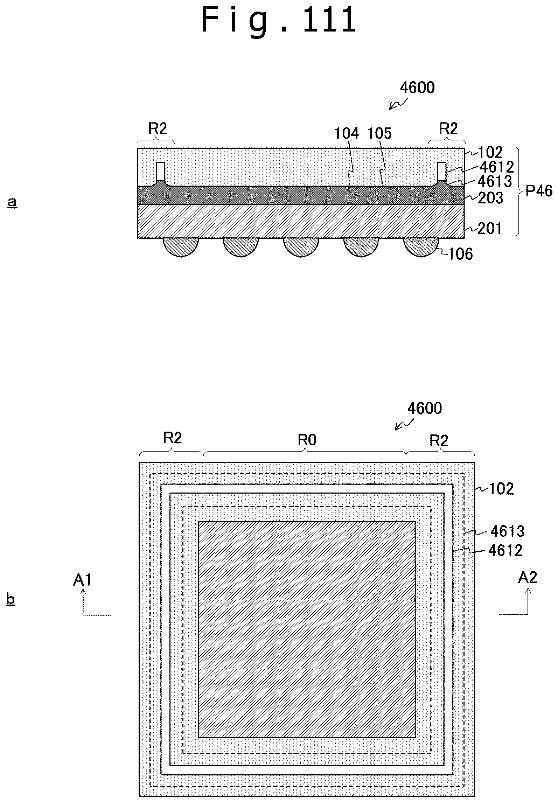

   Fig. 111 is a diagram depicting a configuration example of an electronic device according to a forty-sixth embodiment.
[Fig. 112]

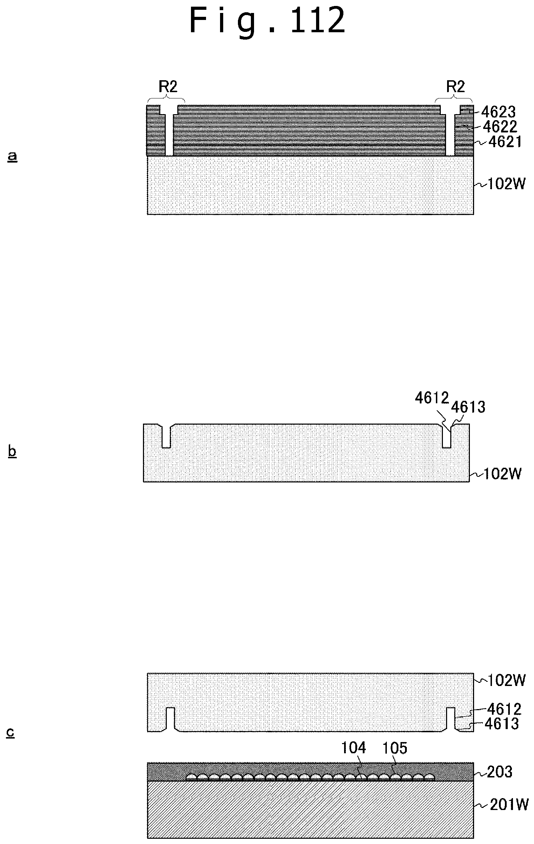

   Fig. 112 is a sectional view depicting an example of a manufacturing method for the electronic device according to the forty-sixth embodiment.
[Fig. 113]

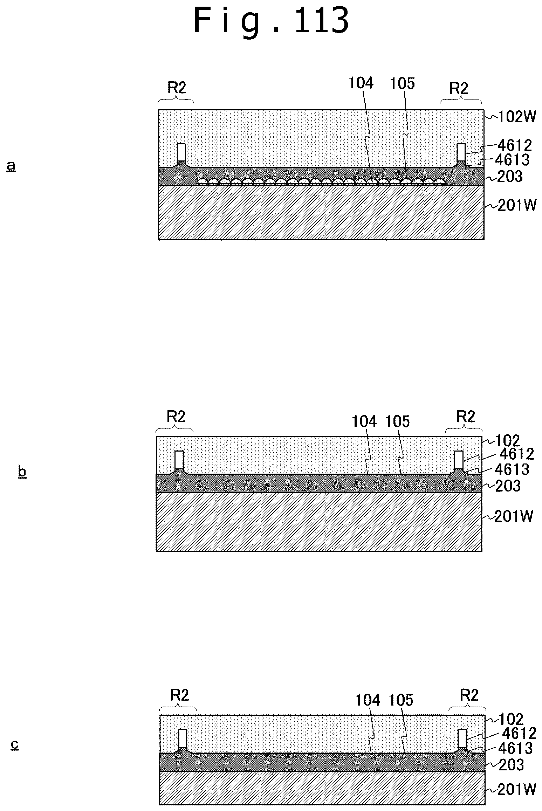

   Fig. 113 is a sectional view depicting an example of a manufacturing method for the electronic device according to the forty-sixth embodiment.
[Fig. 114]

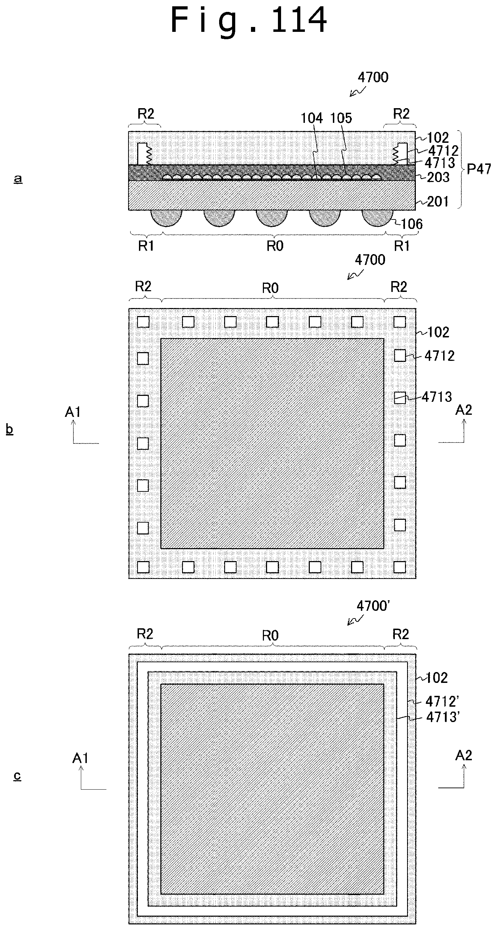

   Fig. 114 is a diagram depicting a configuration example of an electronic device according to a forty-seventh embodiment.
[Fig. 115]

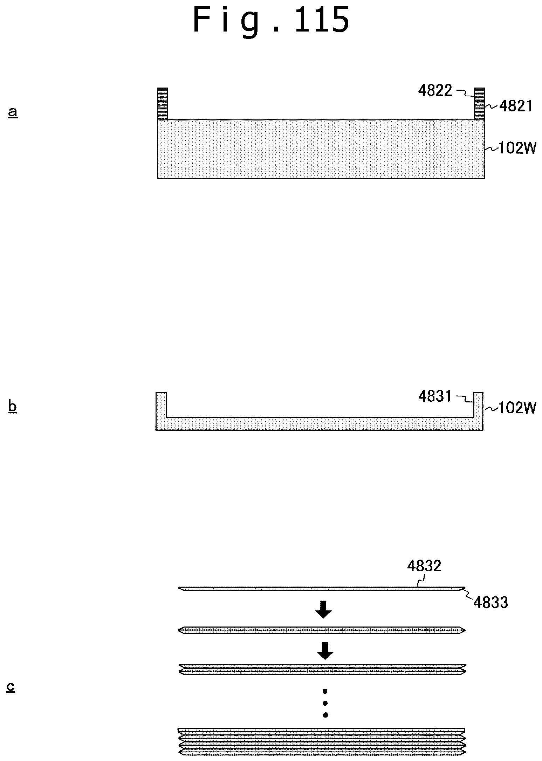

   Fig. 115 is a sectional view depicting an example of a manufacturing method for the electronic device according to the forty-seventh embodiment.
[Fig. 116]

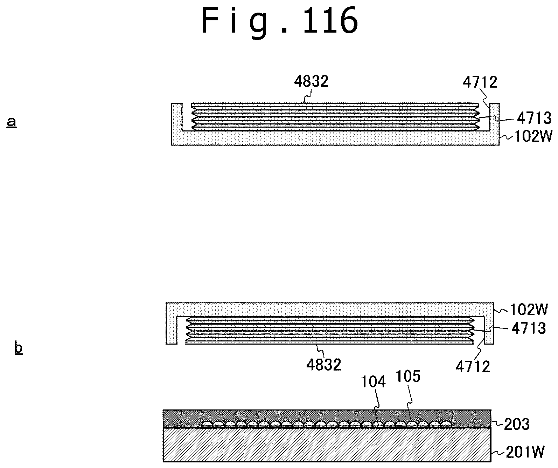

   Fig. 116 is a sectional view depicting an example of a manufacturing method for the electronic device according to the forty-seventh embodiment.
[Fig. 117]

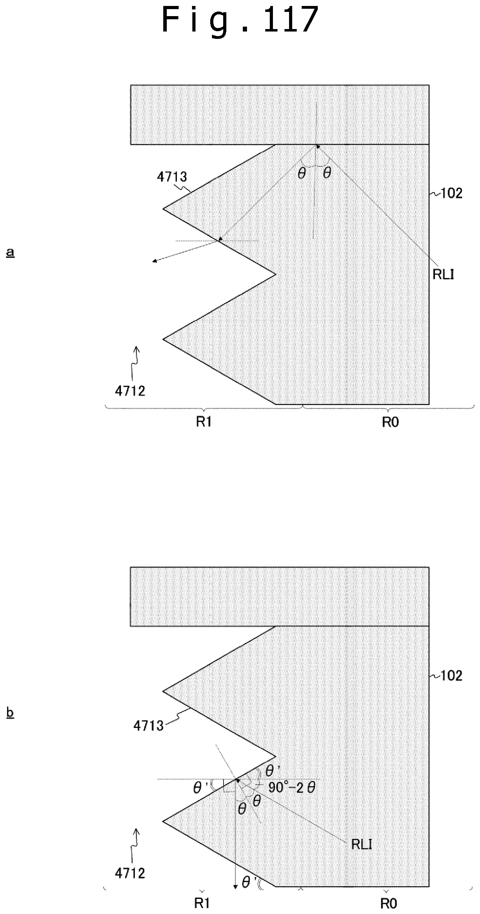

   Fig. 117 is a sectional view depicting a configuration example of a jaggy of the electronic device according to the forty-seventh embodiment.
[Fig. 118]

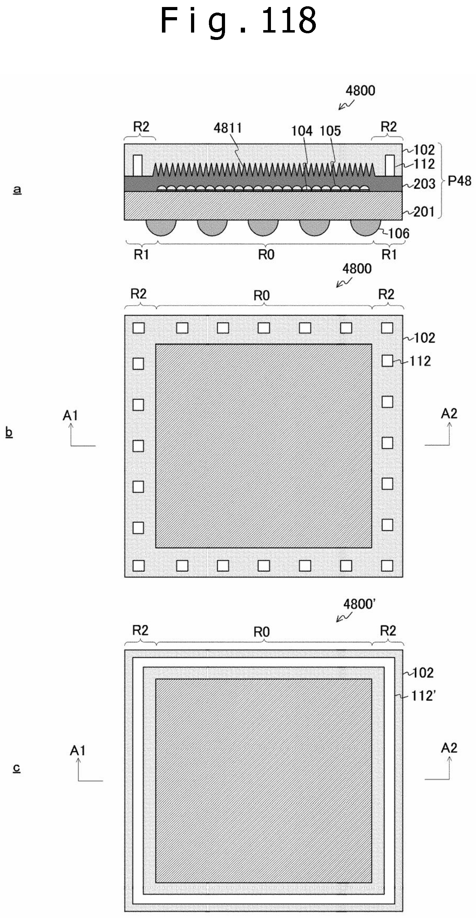

   Fig. 118 is a diagram depicting a configuration example of an electronic device according to a forty-eighth embodiment.
[Fig. 119]

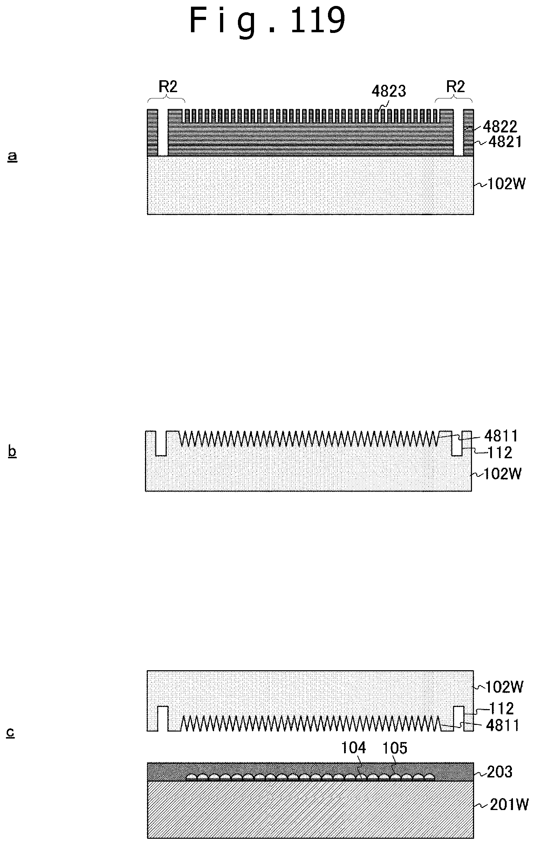

   Fig. 119 is a sectional view depicting an example of a manufacturing method for the electronic device according to the forty-eighth embodiment.
[Fig. 120]

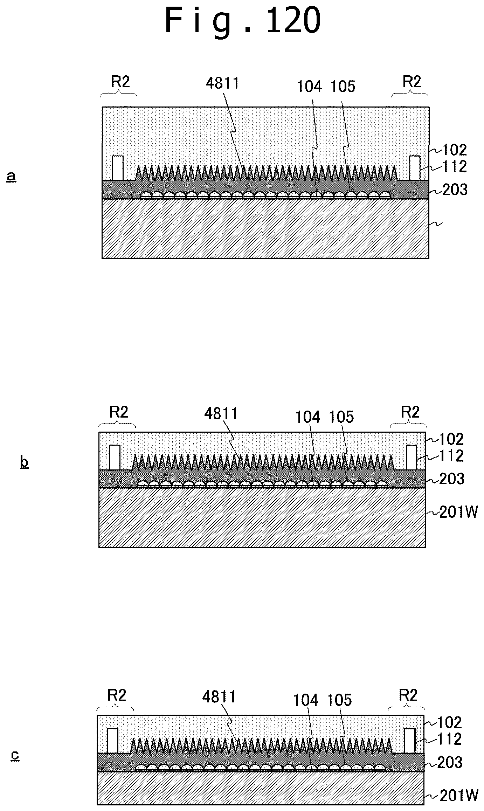

   Fig. 120 is a sectional view depicting an example of a manufacturing method for the electronic device according to the forty-eighth embodiment.
[Fig. 121]

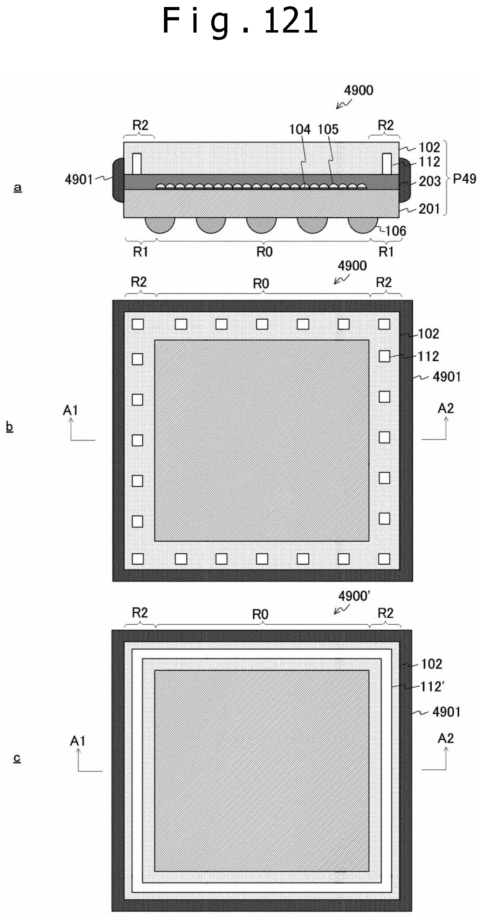

   Fig. 121 is a diagram depicting a configuration example of an electronic device according to a forty-ninth embodiment.
[Fig. 122]

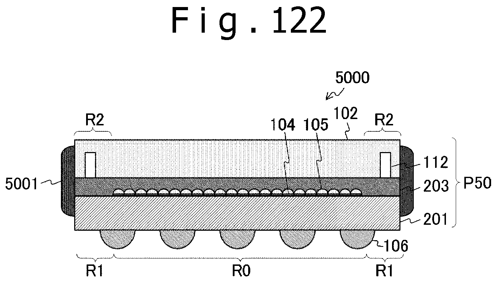

   Fig. 122 is a sectional view depicting a configuration example of an electronic device according to a fiftieth embodiment.
[Fig. 123]

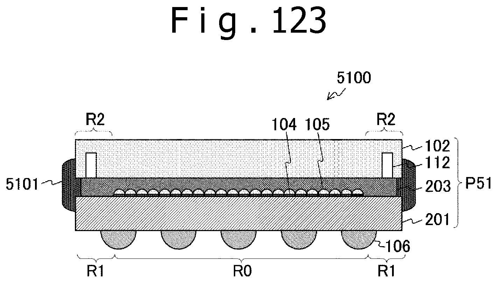

   Fig. 123 is a sectional view depicting a configuration example of an electronic device according to a fifty-first embodiment.
[Fig. 124]

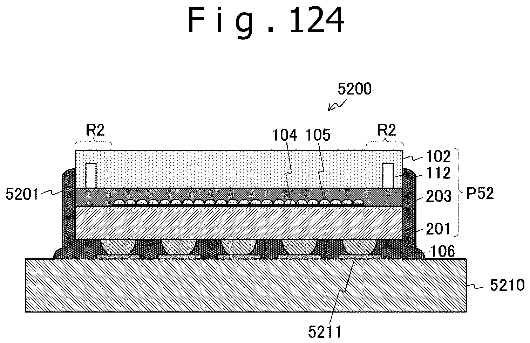

   Fig. 124 is a sectional view depicting a configuration example of an electronic device according to a fifty-second embodiment.
[Fig. 125]

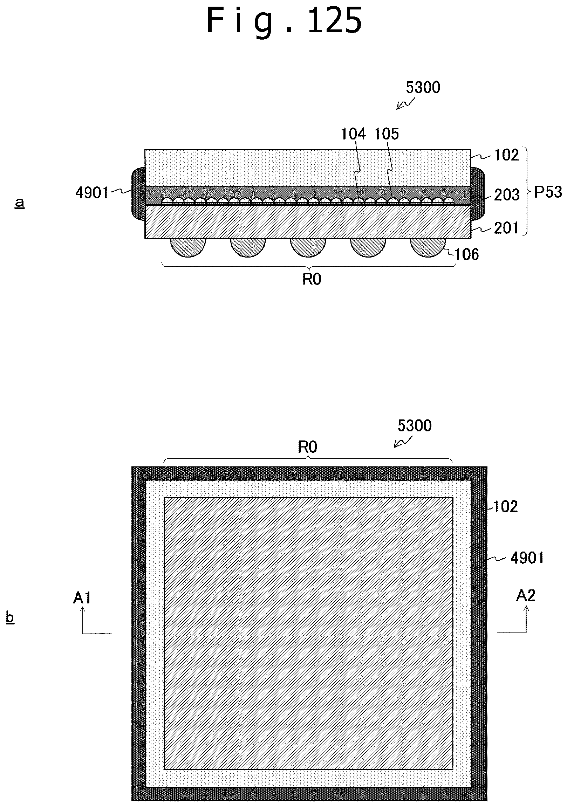

   Fig. 125 is a diagram depicting a configuration example of an electronic device according to a fifty-third embodiment.
[Fig. 126]

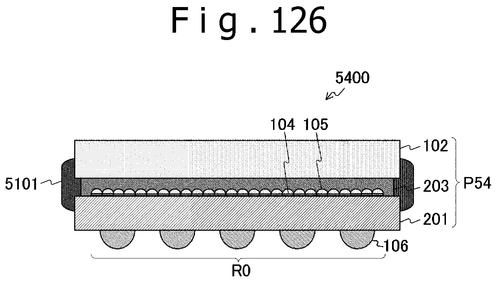

   Fig. 126 is a sectional view depicting a configuration example of an electronic device according to a fifty-fourth embodiment.
[Fig. 127]

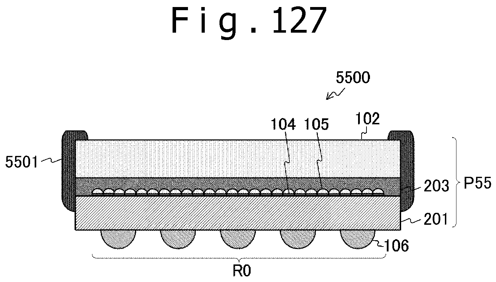

   Fig. 127 is a sectional view depicting a configuration example of an electronic device according to a fifty-fifth embodiment.
[Fig. 128]

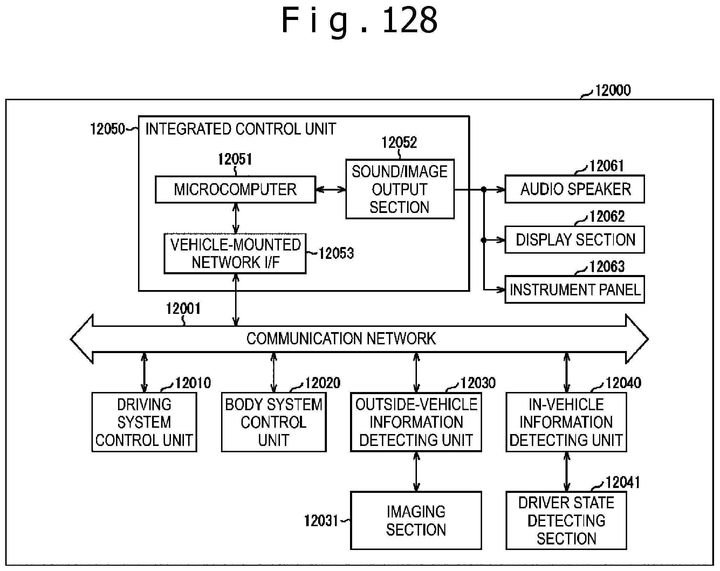

   Fig. 128 is a block diagram depicting an example of schematic configuration of a vehicle control system.
[Fig. 129]

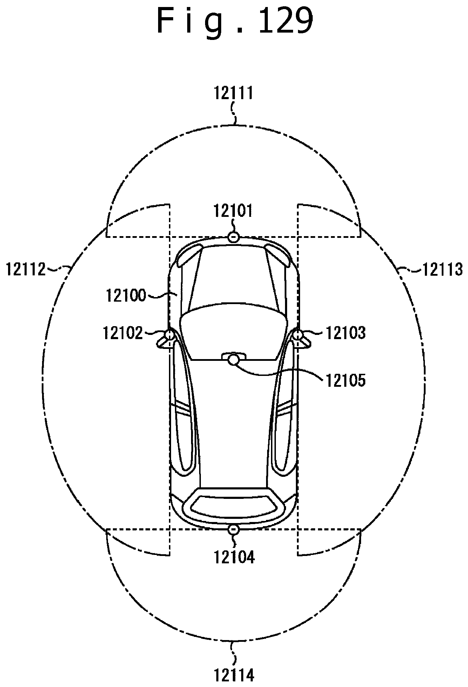

   Fig. 129 is a diagram of assistance in explaining an example of installation positions of an imaging section.

### Description of Embodiments

Hereinafter, modes (hereinafter, referred to as embodiments) for implementing the present technology will be described. The description will be made in the following order.
1. First Embodiment (an example in which a recess is provided at each of a joining surface of a semiconductor chip and a joining surface of a transparent substrate, and the transparent substrate is joined to the semiconductor chip through a bonding layer provided with a through hole)
2. Second Embodiment (an example in which a recess is provided at a joining surface of a transparent substrate, and the transparent substrate is joined to the semiconductor chip through a bonding layer)
3. Third Embodiment (an example in which a recess is provided at a joining surface of a semiconductor chip, and a transparent substrate is joined to the semiconductor chip through a bonding layer
4. Fourth Embodiment (an example in which a recess is provided at each of a joining surface of a semiconductor chip and a joining surface of a transparent substrate, and the transparent substrate is joined to the semiconductor chip through a bonding layer)
5. Fifth Embodiment (an example in which a recess is provided at a joining surface of a transparent substrate, and the transparent substrate is joined to the semiconductor chip through a bonding layer provided with a hard layer at a surface)
6. Sixth Embodiment (an example in which a recess is provided at each of a joining surface of a semiconductor chip and a joining surface of a transparent substrate, the transparent substrate is joined to the semiconductor chip through a bonding layer provided with a through hole, and a filter layer is formed at a surface of the transparent substrate)
7. Seventh Embodiment (an example in which a recess is provided at each of a joining surface of a semiconductor chip in which a cavity is formed and a joining surface of a transparent substrate, and the transparent substrate is joined to the semiconductor chip through a bonding layer)
8. Eighth Embodiment (an example in which a recess is provided at each of a joining surface of a semiconductor chip in which a cavity is formed and a joining surface of a transparent substrate, and the transparent substrate is directly joined to the semiconductor chip)
9. Ninth Embodiment (an example in which a recess is provided at each of a joining surface of a semiconductor chip and a joining surface of a transparent substrate, a light-shielding film is provided at the inner surface of the recess of the joining surface of the transparent substrate, and the transparent substrate is joined to the semiconductor chip through a bonding layer provided with a through hole)
10. Tenth Embodiment (an example in which a through electrode is provided at a position different from the position of a recess provided at each of a joining surface of a semiconductor chip and a joining surface of a transparent substrate in the horizontal direction)
11. Eleventh Embodiment (an example in which a through electrode is provided at a position coinciding with the position of a recess provided at a joining surface of a transparent substrate in the horizontal direction)
12. Twelfth Embodiment (an example in which a recess is provided at each of joining surfaces of semiconductor chips layered together, and these semiconductor chips are directly joined)
13. Thirteenth Embodiment (an example in which a first semiconductor chip and a second semiconductor chip are directly joined such that the position of a recess formed at a joining surface of the first semiconductor chip in the horizontal direction and the position of a through electrode formed at the second semiconductor chip in the horizontal direction coincide with each other)
14. Fourteenth Embodiment (an example in which a groove is provided to traverse a transparent substrate joined to a sensor chip through a transparent resin layer)
15. Fifteenth Embodiment (an example in which a rectangular groove is provided to traverse a transparent substrate joined to a sensor chip through a transparent resin layer)
16. Sixteenth Embodiment (an example in which a minute groove is provided at the surface of a groove provided to traverse a transparent substrate joined to a sensor chip through a transparent resin layer)
17. Seventeenth Embodiment (an example in which a groove is provided to traverse an intermediate resin layer that is interposed in joining of a sensor chip and a transparent substrate through a transparent resin layer)
18. Eighteenth Embodiment (an example in which the number or orientation of a groove provided to traverse a transparent substrate joined to a sensor chip through a transparent resin layer is varied)
19. Nineteenth Embodiment (an example in which a sensor chip and an optical chip where a joining surface including a plurality of surfaces is formed are joined through a joining layer, and a through electrode is formed in the sensor chip)
20. Twentieth Embodiment (an example in which the number, size, shape, or orientation of recesses or protrusions provided at a joining surface is varied)
21. Twenty-First Embodiment (an example in which a sensor chip and an optical chip where a joining surface including a plurality of surfaces is formed are joined through a joining layer, and a side contact is formed in the sensor chip)
22. Twenty-Second Embodiment (an example in which a sensor chip and an optical chip are directly joined through a joining surface including a plurality of surfaces)
23. Twenty-Third Embodiment (an example in which a recess is provided at each of a joining surface of a sensor chip and a joining surface of an optical chip, and the optical chip is joined to the sensor chip through a joining layer provided with a through hole)
24. Twenty-Fourth Embodiment (an example in which a recess is provided at a joining surface of a transparent sealing substrate of a sensor chip)
25. Twenty-Fifth Embodiment (an example in which a recess is provided at a support surface of a transparent supporting substrate of an optical chip)
26. Twenty-Sixth Embodiment (an example in which the chip size of an optical chip is smaller than the chip size of a sensor chip)
27. Twenty-Seventh Embodiment (an example in which the chip size of an optical chip is smaller than the chip size of a sensor chip, and a joining layer protrudes to the side surface of the optical chip)
28. Twenty-Eighth Embodiment (an example in which in a transparent substrate joined to a sensor chip through a transparent resin, the wettability of an opposing region facing a sensor region of the sensor chip is higher than the wettability of an adjacent region adjacent to the opposing region)
29. Twenty-Ninth Embodiment (an example in which in a transparent substrate joined to a sensor chip through a transparent resin, the wettability of an adjacent region adjacent to an opposing region facing a sensor region of the sensor chip is lower than the wettability of the opposing region)
30. Thirtieth Embodiment (an example in which in a sensor chip joined to a transparent substrate through a transparent resin, the wettability of a sensor region of the sensor chip is higher than the wettability of an adjacent region adjacent to the sensor region)
31. Thirty-First Embodiment (an example in which in a sensor chip in which a sensor region is sealed with a transparent resin, the wettability of the sensor region of the sensor chip is higher than the wettability of an adjacent region adjacent to the sensor region)
32. Thirty-Second Embodiment (an example in which a film is formed at the inner surface of a recess provided at a joining surface of a transparent substrate)
33. Thirty-Third Embodiment (an example in which irregularities are formed at the inner surface of a recess provided at a joining surface of a transparent substrate)
34. Thirty-Fourth Embodiment (an example in which a film formed at the inner surface of a recess provided at a joining surface of a transparent substrate is extended to the outside of the bottom surface of the recess)
35. Thirty-Fifth Embodiment (an example in which a film formed at the inner surface of a recess provided at a joining surface of a transparent substrate is extended to the outside of the opening of the recess)
36. Thirty-Sixth Embodiment (an example in which a recess is provided at a joining surface of a transparent substrate, and an embedded layer embedded outside the recess is extended to the outside of the bottom surface of the recess)
37. Thirty-Seventh Embodiment (an example in which a recess is provided at a joining surface of a transparent substrate, and an embedded layer embedded outside the recess is extended to the outside of the opening of the recess)
38. Thirty-Eighth Embodiment (an example in which a lid that closes the bottom surface a recess formed at a joining surface of a transparent substrate is provided)
39. Thirty-Ninth Embodiment (an example in which a tapered recess is provided at a joining surface of a transparent substrate)
40. Fortieth Embodiment (an example in which a recess disposed in a shifted manner is provided at a joining surface of a transparent substrate)
41. Forty-First Embodiment (an example in which a recess provided at each of a joining surface of a semiconductor chip and a joining surface of a transparent substrate is disposed in a non-overlapping manner)
42. Forty-Second Embodiment (an example in which a recess and a through hole disposed at a joining surface of a transparent substrate are alternately provided)
43. Forty-Third Embodiment (an example in which a recess is disposed in a multiple ring pattern at a joining surface of a transparent substrate)
44. Forty-Fourth Embodiment (an example in which a recess is provided at a joining surface of a transparent substrate, and an embedded layer is embedded outside the recess)
45. Forty-Fifth Embodiment (an example in which a recess is provided at a joining surface of a transparent substrate, and a minute groove is provided on both sides of the recess)
46. Forty-Sixth Embodiment (an example in which a recess with a widened end is provided at a joining surface of a transparent substrate)
47. Forty-Seventh Embodiment (an example in which a recess is provided at a joining surface of a transparent substrate, and a jaggy is provided on the inside at the inner surface of the recess)
48. Forty-Eighth Embodiment (an example in which a recess is provided at a joining surface of a transparent substrate, and a moth-eye structure is provided further inward than the recess)
49. Forty-Ninth Embodiment (an example in which a recess is provided at a joining surface of a transparent substrate, and a sealing layer is formed from the side surface of a semiconductor chip to the side surface of the transparent substrate through the side surface of a bonding layer)
50. Fiftieth Embodiment (an example in which a recess is provided at a joining surface of a transparent substrate, and a sealing layer is formed from the side surface of a semiconductor chip to the side surface of the transparent substrate through the side surface of a bonding layer, up to a position higher than the recess)
51. Fifty-First Embodiment (an example in which a recess is provided at a joining surface of a transparent substrate, a sealing layer is formed from the side surface of a semiconductor chip to the side surface of the transparent substrate through the side surface of a bonding layer, and the sealing layer is caused to penetrate inward from the side surface of the bonding layer)
52. Fifty-Second Embodiment (an example in which a recess is provided at a joining surface of a transparent substrate, a sealing layer is formed from the side surface of a semiconductor chip to the side surface of the transparent substrate through the side surface of a bonding layer, and the sealing layer is used also as an underfill)
53. Fifty-Third Embodiment (an example in which a sealing layer is formed from the side surface of a semiconductor chip to the side surface of a transparent substrate through the side surface of a bonding layer)
54. Fifty-Fourth Embodiment (an example in which a sealing layer is formed from the side surface of a semiconductor chip to the side surface of a transparent substrate through the side surface of a bonding layer, and the sealing layer is caused to penetrate inward from the side surface of the bonding layer)
55. Fifty-Fifth Embodiment (an example in which a sealing layer is formed from the side surface of a semiconductor chip to the side surface of a transparent substrate through the side surface of a bonding layer so as to cover an end portion of the top surface of the transparent substrate)
56. Application Examples to Mobile Body

### 1. First Embodiment

Fig. 1 is a diagram depicting a configuration example of an electronic device according to a first embodiment. Note that a in the drawing is a sectional view depicting a configuration example of an electronic device 100 taken along the vertical direction, b in the drawing is a plan view depicting a configuration example of the electronic device 100, and c in the drawing is a plan view depicting a configuration example of an electronic device 100'. a in the drawing is a view taken along line A1-A2 in b and c in the drawing. Note that the drawings used in the following description may differ in scale, shape, and the like from the actual structures, for the sake of clarity of the respective configurations.

In the drawing, the electronic device 100 includes a layered chip P1. The layered chip P1 includes a chip 101 and a transparent substrate 102. The transparent substrate 102 is layered on the chip 101. In this case, the transparent substrate 102 is joined to the chip 101 through a bonding layer 103. Here, the transparent substrate 102 is diced into a chip so as to have a size equivalent to that of the chip 101. In this case, the position of the end portion of the transparent substrate 102 in the horizontal direction may be set to coincide with the position of the end portion of the chip 101 in the horizontal direction. As a result, the layered chip P1 can make up a wafer level chip size package (WLCSP) packaged at the wafer level. Note that the transparent substrate 102 is an example of the first chip recited in claims. The chip 101 is an example of the second chip recited in claims.

In the chip 101, semiconductor elements, optical elements, or micro electro mechanical systems (MEMS) may be formed. The substrate used for the chip 101 may be a semiconductor substrate, a dielectric substrate, or an organic substrate.

The optical element may be an image sensor such as a charged coupled device (CCD) sensor, a complementary metal oxide semiconductor (CMOS) sensor, or a single photon avalanche diode (SPAD) sensor. The light received by the image sensor may be visible light, near-infrared (NIR) light, short wavelength InfraRed (SWIR) light, ultraviolet light, X rays, or the like. The optical element may be a lightreceiving element such as a photo diode (PD), or may be an optical element such as a laser diode (LD), a light emitting diode (LED), and a vertical cavity surface emitting laser (VCSEL). The optical element may be a light switch, a digital micromirror device (DMD), or the like. The material used for the optical element may be a semiconductor such as Si, GaAs, and InGaAs, or a dielectric such as LiNbO₃, glass, and a transparent resin.

The semiconductor element may include a transistor, a resistor, a capacitor, and the like. As the semiconductor element, a memory may be formed, a processor may be formed, a signal processing circuit may be formed, a data processing circuit may be formed, and an interface circuit may be formed. As the semiconductor element, for example, a hardware circuit such as a field-programmable gate array (FPGA) or an application specific integrated circuit (ASIC) may be formed. The material used for the semiconductor element may be Si, GaAs, SiC, GaN, InGaAsP or the like.

The transparent substrate 102 may be a glass substrate, a quartz substrate, or an acrylic or polycarbonate transparent resin substrate. For the transparent substrate 102, Al₂O₃, CaF₂, MgF₂, LiF, or the like may be used in accordance with the wavelength detected by the optical element formed in the chip 101.

In the following description, a case will be taken as an example in which a back-irradiation solid-state imaging element is formed in the chip 101. In this case, in the chip 101, a CMOS sensor may be formed, or a CCD sensor may be formed.

Here, the chip 101 is provided with a light reception region R0 and a joining region R1. In the light reception region R0, pixels and pixel transistors arranged in a matrix along the row direction and the column direction are disposed. A photodiode may be formed in the pixel. The pixel transistor may include a reset transistor for resetting the pixel, a selection transistor for selecting the pixel, a transfer transistor for transferring charge accumulated in the pixel, and an amplifier transistor for forming a source follower with the pixel.

The joining region R1 is used to join the chip 101 and the transparent substrate 102. In this case, the joining strength of the chip 101 can be ensured through the joining region R1. In a back-irradiation solid-state imaging element, the joining region R1 is provided on the rear surface side of the chip 101. In the joining region R1, a recess 111 is formed. The three-dimensional shape of the recess 111 may be a rectangular column, a cylindrical column, or a truncated cone. It should be noted that in order to uniformize the stress applied to the outer periphery of the recess 111, the three-dimensional shape of the recess 111 is desirably a cylindrical column or a truncated cone. The depth of the recess 111 may be set so as to prevent cracks from occurring in the chip 101.

Over the light reception region R0, a color filter 104 is formed for each pixel. On the color filter 104, the on-chip lens 105 is formed for each pixel. As the material of the color filter 104 and the on-chip lens 105, for example, an insulating film composed of SiO₂, SiN, SiCN or the like, or an acrylic or polycarbonate transparent resin may be used. The color filter 104 may contain pigment. The color filter 104 may be configured in a Bayer array or a quad Bayer array, for example. The color filter 104 may include an RGB filter, a complementary color filter, or a white filter.

On the front surface side of the chip 101, a protruding electrode 106 is formed. The protruding electrode 106 can be electrically connected to the wiring formed on the front surface side of the chip 101. The protruding electrode 106 may be used as an external connection terminal for connecting the chip 101 to a mother board and the like. The protruding electrode 106 may be, for example, a ball electrode such as a solder ball, or a pillar electrode made of a conductive material.

The transparent substrate 102 is provided with a joining region R2. The joining region R2 may be provided at a position facing the joining region R1. The joining region R2 is used to join the chip 101 and the transparent substrate 102. In the joining region R2, a recess 112 is formed. The three-dimensional shape of the recess 112 may be a rectangular column, a cylindrical column, or a truncated cone. It should be noted that in order to uniformize the stress applied to the outer periphery of the recess 112, the three-dimensional shape of the recess 112 is desirably a cylindrical column or a truncated cone. The three-dimensional shape of the recess 112 may be the same as or different from the three-dimensional shape of the recess 111. The opening size of the recess 111 may be the same as or different from the opening size of the recess 112. In addition, the position of the recess 112 in the horizontal direction may be shifted from the position of the recess 111 in the horizontal direction. It should be noted that in order to suppress an increase in layout area when forming the recesses 111 and 112, it is desirable to align the position of the recess 112 in the horizontal direction with the position of the recess 111 in the horizontal direction. The depth of the recess 112 may be set so as to prevent cracks from occurring in the transparent substrate 102.

The bonding layer 103 is located between the chip 101 and the transparent substrate 102. In this case, the position of the end portion of the bonding layer 103 in the horizontal direction may be set to coincide with the position of the end portion of the chip 101 in the horizontal direction. In addition, the bonding layer 103 may be cured so as not to penetrate into the recesses 111 and 112. In addition, a through hole 113 is formed in the bonding layer 103. The position of the through hole 113 in the horizontal direction may be set to coincide with the position of the recess 111 in the horizontal direction. The planar shape of the through hole 113 may be set to coincide with the planar shape of the recess 111. The material of the bonding layer 103 may be a transparent resin such as acrylic. In this case, the material of the bonding layer 103 may be selected such that a refractive index difference is ensured between the bonding layer 103 and the on-chip lens 105.

Here, in the electronic device 100, as depicted in b in the drawing, the recess 111 may be discretely disposed at the periphery of the chip 101, and the recess 112 may be discretely disposed at the periphery of the transparent substrate 102. With the recess 112 discretely disposed at the periphery of the transparent substrate 102, the thermal conductivity at the periphery of the chip 101 can be reduced while suppressing a decrease in the strength at the periphery of the chip 101.

Alternatively, in the electronic device 100', as depicted in c in the drawing, a recess 111' may be continuously disposed at the periphery of the chip 101, and a recess 112' may be continuously disposed at the periphery of the transparent substrate 102. In this case, the recesses 111' and 112' may be grooves. With the recess 112' continuously disposed at the periphery of the transparent substrate 102, the thermal conductivity at the periphery of the chip 101 can be reduced while uniformizing the thermal conductivity at the periphery of the chip 101.

In the layered chip P1, the insides of the recesses 111 and 112 and the inside of the through hole 113 are hollowed. In this case, the pressure inside the recesses 111 and 112 and the through hole 113 may be set lower than atmospheric pressure. For example, the pressure inside the recesses 111 and 112 and the through hole 113 may be 1 × 10-⁵ Pa or less. In this case, the components inside the recesses 111 and 112 and the through hole 113 may be the same as or different from the components exposed to the atmosphere. The insides of the recesses 111 and 112 and the inside of the through hole 113 may be filled with gas such as O₃. The gas filled into the recesses 111 and 112 and the through hole 113 may be selected as necessary in accordance with the use of the electronic device 100. In this case, the gas pressure inside the recesses 111 and 112 and the through hole 113 may be 1 × 10^{- 2} Pa or less. Here, by filling the recesses 111 and 112 and the through hole 113 with O₃, light having a wavelength of 300 nm can be absorbed. Thus, reflection light from the interface between the transparent substrate 102 and the bonding layer 103, the surface of the chip 101, and the like can be suppressed, thereby reducing flare.

Note that the dimension of each part of the electronic device 100 may be set as follows, for example.
·The planar size of the chip 101 and the transparent substrate 102: 1.0 × 1.0 mm
·The thickness of the chip 101: 85 µm
·The thickness of the transparent substrate 102: 300 µm
·The thickness of the bonding layer 103: 50 µm
·The planar size of the light reception region R0: 700 × 700 µm
·The width of each of the joining regions R1 and R2: 150 µm
·The height of the protruding electrode 106: 150 µm
·The planar size of the recesses 111 and 112: 50 × 50 µm
·The total height of the recesses 111 and 112 and the through hole 113: 270 µm
·The distance between the recess 112 and the transparent substrate 102 in the horizontal direction: 20 µm
·The distance between the recess 112 and the light reception region R0 in the horizontal direction: 80 µm
·The width of each of the recesses 111' and 112': 50 × 50 µm
·The total height of the recesses 111' and 112' and the through hole 113': 270 µm

In this case, the bonding strength between the chip 101 and the transparent substrate 102 where the recesses 111 and 112 are not provided is 0.5 kgf. The bonding strength between the chip 101 and the transparent substrate 102 where 24 recesses 111 and 112 are formed is 60.5 kgf. The bonding strength between the chip 101' and the transparent substrate 102' where the recesses 111' and 112' are formed is 182.4 kgf. It should be noted that the pressure inside the recesses 111, 112, 111' and 112' is set to 1 × 10⁻⁵ Pa. As a result, by providing the recesses 111 and 112, the strength ratio can be increased by a factor of 121. By providing the recesses 111' and 112', the strength ratio can be increased by a factor of 365.

In addition, the thermal conductivity when the inside of the recesses 111 and 112 are a vacuum is 0.002 W/m·K, and the thermal conductivity when the inside of the recesses 111 and 112 is filled with air is 0.02 W/m·K. On the other hand, the thermal conductivity of the bonding layer 103 is 0.2 W/m·K, the thermal conductivity of glass is 1.0 W/m·K, and the thermal conductivity of Si is 50 W/m·K. Thus, by hollowing the insides of the recesses 111 and 112, the thermal conductivity at the positions of the recesses 111 and 112 can be reduced.

Figs. 2 to 4 are diagrams depicting examples of a manufacturing method for the electronic device according to the first embodiment.

In a in Fig. 2, a divided region 102R is provided in a transparent substrate wafer 102W. The transparent substrate 102 is cut out from each divided region 102R. Each divided region 102R is defined along a scribe line 102D. The joining region R2 is provided in each divided region 102R.

In b in Fig. 2, a divided region 101R is provided in a semiconductor wafer 101W. In this case, the divided regions 101R and 102R may be superimposed on each other. The chip 101 is cut out from each divided region 101R. Each divided region 101R is defined along a scribe line 101D. A solid-state imaging element is formed in each divided region 101R. In this case each divided region 101R is provided with the light reception region R0 and the joining region R1. In addition, in the light reception region R0, the color filter 104 and the on-chip lens 105 are formed for each pixel. In addition, in the semiconductor wafer 101W, a wiring layer and a through electrode connected to the protruding electrode 106 are formed.

Next, as depicted in a in Fig. 3, a resist pattern 122 is formed on the transparent substrate wafer 102W by lithography. In the resist pattern 122, an opening portion 132 is formed for each divided region 102R. The opening portion 132 can be disposed at the formation position of the recess 112.

In addition, the bonding layer 103 is formed on the semiconductor wafer 101W. In this case, the bonding layer 103 can be uniformly formed on the semiconductor wafer 101W such that the on-chip lens 105 is covered. The bonding layer 103 may be formed by coating. Then, a resist pattern 121 is formed on the bonding layer 103 by lithography. In the resist pattern 121, an opening portion 131 is formed for each divided region 101R. In the opening portion 131 can be disposed at the formation position of the recess 111.

Next, as depicted in b in Fig. 3, with the resist pattern 122 used as an etching mask, the transparent substrate wafer 102W is etched in the depth direction, and the recess 112 is formed in the transparent substrate wafer 102W for each divided region 102R.

In addition, with the resist pattern 121 used as an etching mask, the bonding layer 103 and the semiconductor wafer 101W are etched in the depth direction, the through hole 113 is formed in the bonding layer 103, and the recess 111 is formed in the semiconductor wafer 101W for each divided region 101R.

Next, as depicted in c in Fig. 3, the transparent substrate wafer 102W and the semiconductor wafer 101W are joined, with the joining regions R1 and R2 facing each other through the bonding layer 103, thereby forming a layered wafer 100W. Note that the bonding layer 103 may be a thermosetting resin, or an ultraviolet curable resin. In the case where the bonding layer 103 is a thermosetting resin, the bonding layer 103 can be cured by thermal treatment. In the case where the bonding layer 103 is an ultraviolet curable resin, the bonding layer 103 can be cured by ultraviolet irradiation.

In this case, the positions of the recesses 111 and 112 and the through hole 113 in the horizontal direction may be aligned with each other. In addition, the scribe lines 101D and 102D may overlap each other. The transparent substrate wafer 102W and the semiconductor wafer 101W may be joined under a reduced pressure. In this case, the pressure inside the recesses 111 and 112 and the through hole 113 may be set to 1 × 10⁻⁵ Pa or less. Alternatively, the transparent substrate wafer 102W and the semiconductor wafer 101W may be joined in an atmospheric gas environment. The atmospheric gas may be, for example, O₃. In this case, the pressure inside the recesses 111 and 112 and the through hole 113 may be set to 1 × 10⁻² Pa or less.

Next, as depicted in a in Fig. 4, the semiconductor wafer 101W serving as a lower layer of the layered wafer 100W is thinned from the front surface side. The semiconductor wafer 101W may be thinned by chemical mechanical polishing (CMP) or etch back.

Next, as depicted in b in Fig. 4, the transparent substrate wafer 102W serving as an upper layer of the layered wafer 100W is thinned from the front surface side. The transparent substrate wafer 102W may be thinned by CMP or etch back.

Next, as depicted in c in Fig. 4, the protruding electrode 106 is formed for each divided region 101R on the front surface side of the semiconductor wafer 101W serving as a lower layer of the layered wafer 100W.

Next, as depicted in a in Fig. 1, the layered wafer 100W is cut along the scribe lines 101D and 102D, thereby cutting out the layered chip P1 in which the chip 101 and the transparent substrate 102 are layered. The layered wafer 100W may be cut by dicing or by using a laser cutter. During the cutting of the layered wafer 100W, heat is generated at the cut surface. Here, the insides of the recesses 111 and 112 and the inside of the through hole 113 are maintained in a vacuum or under low pressure, and the thermal conductivity of the recesses 111 and 112 and the through hole 113 is lower than that of a semiconductor or glass. Thus, conduction of the heat generated at the cut surface of the layered chip P1 can be suppressed at the positions of the recesses 111 and 112 and the through hole 113.

In this manner, in the above-described first embodiment, the recess 111 is provided in the joining region R1 of the chip 101, and the recess 112 is provided in the joining region R2 of the transparent substrate 102. As a result, conduction of the heat generated at the periphery of the chip 101 and the transparent substrate 102 can be suppressed at the positions of the recesses 111 and 112 and the through hole 113, thereby making it difficult for heat to be transmitted to the light reception region R0. Thus, thermal damage to the light reception region R0 can be suppressed, and alteration of the color filter 104 and the on-chip lens 105 can be prevented.

In addition, by maintaining the insides of the recesses 111 and 112 and the inside of the through hole 113 in a vacuum or under low pressure, the transparent substrate 102 can be pressed against the chip 101 by atmospheric pressure. Thus, the joining strength of the transparent substrate 102 and the chip 101 can be improved, and the reliability of the electronic device 100 can be ensured while reducing the chip size. In addition, the moisture that has entered through the interface between the transparent substrate 102 and the bonding layer 103 and the interface between the chip 101 and the bonding layer 103 can be vaporized at the positions of the insides of the recesses 111 and 112 and the through hole 113, thereby suppressing entry of moisture into the layered chip P1.

Here, by disposing the through hole 113 formed in the bonding layer 103 between the recesses 111 and 112, the penetration of the bonding layer 103 into the recesses 111 and 112 can be suppressed, and the thermal conductivity of the recesses 111 and 112 can be maintained at a low level. Note that in order to suppress the penetration of the bonding layer 103 into the recesses 111 and 112, the diameter of the through hole 113 may be set greater than the diameter of each of the recesses 111 and 112.

In addition, the recesses 111 and 112 and the through hole 113 can deform in accordance with the difference in thermal expansion coefficients of the chip 101, the transparent substrate 102 and the bonding layer 103. Thus, the stress of the layered chip P1 can be relaxed, and the reliability of the electronic device 100 can be improved.

### 2. Second Embodiment

In the above-described first embodiment, the recess 111 is provided in the joining region R1 of the chip 101, and the recess 112 is provided in the joining region R2 of the transparent substrate 102. In the second embodiment, the recess 112 is provided in the joining region R2 of the transparent substrate 102.

Fig. 5 is a diagram depicting a configuration example of an electronic device according to the second embodiment. Note that a in the drawing is a sectional view depicting a configuration example of an electronic device 200 taken along the vertical direction, b in the drawing is a plan view depicting a configuration example of the electronic device 200, and c in the drawing is a plan view depicting a configuration example of an electronic device 200'.

In the drawing, the electronic device 200 includes a layered chip P2 instead of the layered chip P1 of the above-described first embodiment. Other configurations of the electronic device 200 of the second embodiment are the same as the configurations of the electronic device 100 of the above-described first embodiment.

The layered chip P2 includes a chip 201 and a bonding layer 203 instead of the chip 101 and the bonding layer 103 of the above-described first embodiment. Other configurations of the layered chip P2 of the second embodiment are the same as the configurations of the layered chip P1 of the above-described first embodiment.

In the chip 201, the recess 111 is omitted from the chip 101 of the above-described first embodiment. Other configurations of the chip 201 of the second embodiment are the same as the configurations of the chip 101 of the above-described first embodiment.

In the bonding layer 203, the through hole 113 is omitted from the bonding layer 103 of the above-described first embodiment. In this case, it is possible to eliminate the need to form the through hole 113 in the bonding layer 203 before curing of the bonding layer 203, and use a material that is difficult to process before curing as the bonding layer 203. Other configurations of the bonding layer 203 of the second embodiment are the same as the configurations of the bonding layer 103 of the above-described first embodiment.

In this case, in the electronic device 200, as depicted in b in the drawing, the recess 112 may be discretely disposed at the periphery of the transparent substrate 102.

Alternatively, in the electronic device 200', as depicted in c in the drawing, the recess 112' may be continuously disposed at the periphery of the transparent substrate 102.

In this manner, in the above-described second embodiment, the recess 112 is provided in the joining region R2 of the transparent substrate 102. As a result, conduction of the heat generated at the periphery of the transparent substrate 102 can be suppressed at the position of the recess 112, thereby making it difficult for heat to be transmitted to the light reception region R0. Thus, thermal damage to the light reception region R0 can be suppressed, and alteration of the color filter 104 and the on-chip lens 105 can be prevented.

In addition, by maintaining the inside of the recess 112 in a vacuum or under low pressure, the transparent substrate 102 can be pressed against the chip 201 by atmospheric pressure. Thus, the joining strength of the transparent substrate 102 and the chip 201 can be improved, and the reliability of the electronic device 200 can be ensured while reducing the chip size.

Note that fine particles may be suspended in at least one of the recesses 111 and 112. The diameter of the fine particles may be set so as to be suspended inside the recesses 111 and 112. The fine particles may have reactivity with the degassed gas released from the bonding layer 103, or may have light-shielding properties, wavelength selectivity, or adsorptivity. For example, pigment fine particles can impart light-shielding properties without reducing adhesion. Metal fine particles can react with the degassed gas and maintain vacuum strength.

### 3. Third Embodiment

In the above-described first embodiment, the recess 111 is provided in the joining region R1 of the chip 101, and the recess 112 is provided in the joining region R2 of the transparent substrate 102. In the third embodiment, the recess 111 is provided in the joining region R1 of the chip 101.

Fig. 6 is a diagram depicting a configuration example of an electronic device according to the third embodiment. Note that a in the drawing is a sectional view depicting a configuration example of an electronic device 300 taken along the vertical direction, b in the drawing is a plan view depicting a configuration example of the electronic device 300, and c in the drawing is a plan view depicting a configuration example of an electronic device 300'.

In the drawing, the electronic device 300 includes a layered chip P3 instead of the layered chip P1 of the above-described first embodiment. Other configurations of the electronic device 300 of the third embodiment are the same as the configurations of the electronic device 100 of the above-described first embodiment.

The layered chip P3 includes a transparent substrate 302 and the bonding layer 203 instead of the transparent substrate 102 and the bonding layer 103 of the above-described first embodiment. Other configurations of the layered chip P3 of the third embodiment are the same as the configurations of the layered chip P1 of the above-described first embodiment.

In the transparent substrate 302, the recess 112 is omitted from the transparent substrate 102 of the above-described first embodiment. In this case, it is possible to eliminate the need to form the recess 112 at the transparent substrate 302, and use a material that is difficult to process for the transparent substrate 302. Other configurations of the transparent substrate 302 of the third embodiment are the same as the configurations of the transparent substrate 102 of the above-described first embodiment.

In this case, in the electronic device 300, as depicted in b in the drawing, the recess 111 may be discretely disposed at the periphery of the chip 101.

Alternatively, in the electronic device 300', as depicted in c in the drawing, the recess 111' may be continuously disposed at the periphery of the chip 101.

In this manner, in the above-described third embodiment, the recess 111 is provided in the joining region R1 of the chip 101. As a result, conduction of the heat generated at the periphery of the chip 101 can be suppressed at the position of the recess 111, thereby making it difficult for heat to be transmitted to the light reception region R0. Thus, thermal damage to the light reception region R0 can be suppressed, and alteration of the color filter 104 and the on-chip lens 105 can be prevented.

In addition, by maintaining the inside of the recess 111 in a vacuum or under low pressure, the chip 101 can be pressed against the transparent substrate 102 by atmospheric pressure. Thus, the joining strength of the transparent substrate 102 and the chip 101 can be improved, and the reliability of the electronic device 300 can be ensured while reducing the chip size.

### 4. Fourth Embodiment

In the above-described first embodiment, the through hole 113 between the recess 111 provided in the joining region R1 of the chip 101 and the recess 112 provided in the joining region R2 of the transparent substrate 102 is formed in the bonding layer 103. In the fourth embodiment, the through hole 113 between the recess 111 provided in the joining region R1 of the chip 101 and the recess 112 provided in the joining region R2 of the transparent substrate 102 is eliminated.

Fig. 7 is a diagram depicting a configuration example of an electronic device according to the fourth embodiment. Note that a in the drawing is a sectional view depicting a configuration example of an electronic device 400 taken along the vertical direction, b in the drawing is a plan view depicting a configuration example of the electronic device 400, and c in the drawing is a plan view depicting a configuration example of an electronic device 400'.

In the drawing, the electronic device 400 includes a layered chip P4 instead of the layered chip P1 of the above-described first embodiment. Other configurations of the electronic device 400 of the fourth embodiment are the same as the configurations of the electronic device 100 of the above-described first embodiment.

The layered chip P4 includes the bonding layer 203 of the above-described second embodiment instead of the bonding layer 103 of the above-described first embodiment. In this case, it is possible to enable vacuum suction of the chip 101 and the transparent substrate 102 to the bonding layer 203 through the recesses 111 and 112 while eliminating the need to form the through hole 113 in the bonding layer 203. Other configurations of the layered chip P4 of the fourth embodiment are the same as the configurations of the layered chip P1 of the above-described first embodiment.

In this case, in the electronic device 400, as depicted in b in the drawing, the recess 111 may be discretely disposed at the periphery of the chip 101, and the recess 112 may be discretely disposed at the periphery of the transparent substrate 102. In this case, the position of the recess 111 in the horizontal direction and the position of the recess 112 in the horizontal direction may be the same or different.

Alternatively, in the electronic device 400', as depicted in c in the drawing, the recess 111' may be continuously disposed at the periphery of the chip 101, and the recess 112' may be continuously disposed at the periphery of the transparent substrate 102.

In this manner, in the above-described fourth embodiment, the recess 111 is provided in the joining region R1 of the chip 101, and the recess 112 is provided in the joining region R2 of the transparent substrate 102. As a result, conduction of the heat generated at the periphery of the chip 101 and the transparent substrate 102 can be suppressed at the positions of the recesses 111 and 112, thereby making it difficult for heat to be transmitted to the light reception region R0. Thus, thermal damage to the light reception region R0 can be suppressed, and alteration of the color filter 104 and the on-chip lens 105 can be prevented.

In addition, by maintaining the insides of the recesses 111 and 112 in a vacuum or under low pressure, the transparent substrate 102 and the chip 101 can be pressed against the bonding layer 203 by atmospheric pressure. Thus, the joining strength of the transparent substrate 102 and the chip 101 through the bonding layer 203 can be improved, and the reliability of the electronic device 100 can be ensured while reducing the chip size.

### 5. Fifth Embodiment

In the above-described second embodiment, the recess 112 is provided in the joining region R2 of the transparent substrate 102. In the fifth embodiment, the recess 112 is provided in the joining region R2 of the transparent substrate 102, and the transparent substrate 102 is joined to the chip 201 through a bonding layer including a hard layer provided on its surface.

Fig. 8 is a diagram depicting a configuration example of an electronic device according to the fifth embodiment. Note that a in the drawing is a sectional view depicting a configuration example of an electronic device 500 taken along the vertical direction, b in the drawing is a plan view depicting a configuration example of the electronic device 500, and c in the drawing is a plan view depicting a configuration example of an electronic device 500'.

In the drawing, the electronic device 500 includes a layered chip P5 instead of the layered chip P2 of the above-described second embodiment. Other configurations of the electronic device 500 of the fifth embodiment are the same as the configurations of the electronic device 200 of the above-described fifth embodiment.

The layered chip P5 includes a bonding layer 503 instead of the bonding layer 103 of the above-described first embodiment. Other configurations of the layered chip P5 of the fifth embodiment are the same as the configurations of the layered chip P2 of the above-described second embodiment.

The bonding layer 503 includes a hard layer 513. The hard layer 513 may be formed at a surface of the bonding layer 503 in a manner corresponding to the opening position of the recess 112. The hard layer 513 may be a modified layer modified by heating. In this case, the hard layer 513 may be formed by laser irradiation at a surface of the bonding layer 503. Other configurations of the bonding layer 503 of the fifth embodiment are the same as the configurations of the bonding layer 203 of the above-described fifth embodiment.

In this case, in the electronic device 500, as depicted in b in the drawing, the recess 112 may be discretely disposed at the periphery of the transparent substrate 102. The hard layer 513 may be formed at the periphery of the light reception region R0 so as to surround the opening position of the recess 112.

Alternatively, in the electronic device 500', as depicted in c in the drawing, the recess 112' may be continuously disposed at the periphery of the transparent substrate 102. The hard layer 513' may be formed at the periphery of the light reception region R0 so as to surround the opening position of the recess 112'.

In this manner, in the above-described fifth embodiment, the recess 112 is provided in the joining region R2 of the transparent substrate 102, and the transparent substrate 102 is joined to the chip 201 through the bonding layer 503 provided with the hard layer 513 at its surface. As a result, the entry of the bonding layer 503 or outgas from the bonding layer 503 into the recess 112 can be prevented. Thus, a decrease in the degree of vacuum inside the recess 112 can be suppressed, and a decrease in the joining strength through the recess 112 can be suppressed while suppressing an increase in the thermal conductivity of the recess 112.

Note that in the above-described fifth embodiment, the hard layer 513 is formed at a surface of the bonding layer 503 in a manner corresponding to the opening position of the recess 112. In the above-described third or fourth embodiment, a hard layer may be formed at the bottom surface of the bonding layer 503 in a manner corresponding to the opening position of the recess 111.

### 6. Sixth Embodiment

In the above-described first embodiment, the recess 111 is provided in the joining region R1 of the chip 101, and the recess 112 is provided in the joining region R2 of the transparent substrate 102. In the sixth embodiment, a filter layer is formed on a transparent substrate provided with a recess in the joining region R2.

Fig. 9 is a diagram depicting a configuration example of an electronic device according to the sixth embodiment. Note that a in the drawing is a sectional view depicting a configuration example of an electronic device 600 taken along the vertical direction, b in the drawing is a plan view depicting a configuration example of the electronic device 600, and c in the drawing is a plan view depicting a configuration example of an electronic device 600'.

In the drawing, the electronic device 600 includes a layered chip P6 instead of the layered chip P1 of the above-described first embodiment. Other configurations of the electronic device 600 of the sixth embodiment are the same as the configurations of the electronic device 100 of the above-described first embodiment.

The layered chip P6 includes a transparent substrate 602 instead of the transparent substrate 102 of the above-described first embodiment. In addition, the layered chip P6 is additionally provided with a filter layer 604 in the layered chip P1 of the above-described first embodiment. Other configurations of the layered chip P6 of the sixth embodiment are the same as the configurations of the layered chip P1 of the above-described first embodiment.

The transparent substrate 602 includes a through hole 612 as the recess 112 of the above-described first embodiment. The through hole 612 extends through the transparent substrate 602, and is connected to the through hole 113. Other configurations of the transparent substrate 602 of the sixth embodiment are the same as the configurations of the transparent substrate 102 of the above-described first embodiment.

In this case, in the electronic device 600, as depicted in b in the drawing, the through hole 612 may be discretely disposed at the periphery of the transparent substrate 602.

Alternatively, in the electronic device 600', as depicted in c in the drawing, the through hole 612' may be continuously disposed at the periphery of the transparent substrate 602.

The filter layer 604 is formed on the transparent substrate 602. In this case, the filter layer 604 can close the opening of the through hole 612. In the case where the sensitivity of the light reception region R0 is set to the visible region, the filter layer 604 may be an infrared cut filter, or an ultraviolet cut filter. The filter layer 604 may be composed of a dielectric multilayer film. For example, the filter layer 604 may be configured by alternately layering a high-refractive-index dielectric layer 604A and a low-refractive-index dielectric layer 604B. The high-refractive-index dielectric layer 604A may be selected from materials such as TiO₂, Nb₂O₅ and Ta₂O₅, for example. The low-refractive-index dielectric layer 604B may be selected from materials such as SiO₂ and MgF₂, for example. The film thickness of the filter layer 604 may be set within a range of 100 to 500 µm. In this case, for example, four to fifteen layers may be layered by setting the film thickness of the high-refractive-index dielectric layer 604A to 20 µm, and the film thickness of the low-refractive-index dielectric layer 604B to 21 µm.

The filter layer 604 can be formed on the transparent substrate 602 without interposing a bonding layer. In this case, after the through hole 612 is formed in a transparent substrate wafer joined to the transparent substrate wafer 102W, the filter layer 604 may be bonded on the transparent substrate wafer under a reduced pressure. The filter layer 604 may be cut out in accordance with cutting out of the layered chip P6.

In this manner, in the above-described sixth embodiment, the filter layer 604 is formed on the transparent substrate 602 provided with the through hole 612 in the joining region R2. As a result, unnecessary incident light can be attenuated without increasing the chip size, thereby sharpening the imaged image.

Note that in the above-described sixth embodiment, the electronic device 600 includes the transparent substrate 602 in which the through hole 612 is formed. In any of the above-described first to fifth embodiments, the filter layer 604 may be formed on the transparent substrate 102. In this case, for example, after the process of b in Fig. 4, the filter layer 604 may be deposited on the transparent substrate wafer 102W. For the deposition of the filter layer 604, sputtering or chemical vapor deposition (CVD) may be used.

### 7. Seventh Embodiment

In the above-described fourth embodiment, the light reception region R0 is provided inside the joining region R1 where the recess 111 is formed. In a seventh embodiment, a cavity is provided inside the joining region R1 where the recess 111 is formed, and the light reception region R0 is formed at the cavity.

Fig. 10 is a diagram depicting a configuration example of an electronic device according to the seventh embodiment. Note that a in the drawing is a sectional view depicting a configuration example of an electronic device 700 taken along the vertical direction, b in the drawing is a plan view depicting a configuration example of the electronic device 700, and c in the drawing is a plan view depicting a configuration example of an electronic device 700'.

In the drawing, the electronic device 700 includes a layered chip P7 instead of the layered chip P4 of the above-described fourth embodiment. Other configurations of the electronic device 700 of the seventh embodiment are the same as the configurations of the electronic device 400 of the above-described fourth embodiment.

The layered chip P7 includes a chip 701 instead of the chip 101 of the above-described first embodiment. Other configurations of the layered chip P7 of the seventh embodiment are the same as the configurations of the layered chip P4 of the above-described fourth embodiment.

The chip 701 is additionally provided with a cavity 703 in the chip 101 of the above-described fourth embodiment. Other configurations of the chip 701 of the seventh embodiment are the same as the configurations of the chip 101 of the above-described fourth embodiment.

The cavity 703 is located inside the joining region R1. The light reception region R0 is formed at the cavity 703. Here, to form the cavity 703 in the chip 701, a step 702 located between the joining region R1 and the light reception region R0 may be formed in the chip 701. The inside of the cavity 703 may be filled with the bonding layer 103. In this case, the bonding layer 203 can be bonded also to the step 702, and thus a bonding area of the bonding layer 203 can be increased, thereby improving the bonding strength. In addition, the depth of the recess 111 can be increased in accordance with the step 702, and thus a decrease in the degree of vacuum inside the recess 111 can be suppressed.

The cavity 703 can be formed in the chip 701 before forming a photodiode. The cavity 703 may be formed by etching the chip 701 using a resist pattern formed by lithography as an etching mask.

In this case, in the electronic device 700, as depicted in b in the drawing, the recess 111 may be discretely disposed at the periphery of the chip 701, and the recess 112 may be discretely disposed at the periphery of the transparent substrate 102.

Alternatively, in the electronic device 700', as depicted in c in the drawing, the recess 111' may be continuously disposed at the periphery of the chip 701, and the recess 112' may be continuously disposed at the periphery of the transparent substrate 102.

In this manner, in the above-described seventh embodiment, the light reception region R0 is formed at the cavity 703 provided inside the joining region R1 where the recess 111 is formed. As a result, the light reception region R0 can be thinned while suppressing a decrease in the strength of the chip 101, and thus the through electrode can be easily formed in the light reception region R0.

Note that in the above-described seventh embodiment, the cavity 703 is additionally provided in the chip 101 of the above-described fourth embodiment. In any of the above-described first, second, third, fifth, and sixth embodiments, the cavity 703 may be additionally provided in the chip.

### 8. Eighth Embodiment

In the above-described seventh embodiment, the chip 701 and the transparent substrate 102 are joined through the bonding layer 103. In an eighth embodiment, the chip 701 and the transparent substrate 102 are directly joined without interposing the bonding layer 103.

Fig. 11 is a diagram depicting a configuration example of an electronic device according to the eighth embodiment. Note that a in the drawing is a sectional view depicting a configuration example of an electronic device 800 taken along the vertical direction, b in the drawing is a plan view depicting a configuration example of the electronic device 800, and c in the drawing is a plan view depicting a configuration example of an electronic device 800'.

In the drawing, the electronic device 800 includes a layered chip P8 instead of the layered chip P7 of the above-described seventh embodiment. Other configurations of the electronic device 800 of the eighth embodiment are the same as the configurations of the electronic device 700 of the above-described seventh embodiment.

In the layered chip P8, the bonding layer 203 is eliminated in the layered chip P7 of the above-described seventh embodiment. Here, the transparent substrate 102 and the chip 701 are directly joined through the joining regions R1 and R2. In this case, the depth of the cavity 703 (the height of the step 702) may be set such that the transparent substrate 102 does not make contact with the on-chip lens 105. Other configurations of the layered chip P8 of the eighth embodiment are the same as the configurations of the layered chip P7 of the above-described seventh embodiment. In this case, the inside of the cavity 703 may be under reduced pressure, or a gas may be sealed therein.

In the direct joining of the transparent substrate 102 and the chip 701, pressure joining may be used. In this pressure joining, for example, the joining may be carried out at a temperature of 250 °C or lower with the joining surface activated by plasma.

For example, in plasma activation using glass as the transparent substrate 102, oxygen plasma or nitrogen plasma may be applied to the joining surface to perform a hydrophilic treatment of the joining surface. Further, the joining surfaces may be brought into intimate contact with each other by hydrogen bonding between OH groups formed on the joining surface by adsorption of moisture in the air. Further, thermal treatment decomposes the OH groups and diffuses the generated hydrogen into the interfacial layer, thereby enabling direct joining based on Si-O-Si bonds mediated by oxygen. Here, by performing plasma activation of the joining surface before the thermal treatment, the moisture adsorption of the joining surface can be improved, and even with thermal treatment at a temperature of 250 °C or lower, joining strength sufficient to ensure the reliability of the electronic device 800 can be obtained.

In the direct joining of the transparent substrate 102 and the chip 701, oxide films may be joined to each other. Metals may be joined to each other. In this case, an oxide film may be formed on the joining surface of the transparent substrate 102 and on the joining surface of the chip 701, or a metal film may be formed thereon.

In the electronic device 800, as depicted in b in the drawing, the recess 111 may be discretely disposed at the periphery of the chip 701, and the recess 112 may be discretely disposed at the periphery of the transparent substrate 102.

Alternatively, in the electronic device 800', as depicted in c in the drawing, the recess 111' may be continuously disposed at the periphery of the chip 701, and the recess 112' may be continuously disposed at the periphery of the transparent substrate 102.

In this manner, in the above-described eighth embodiment, the chip 701 and the transparent substrate 102 are directly joined. As a result, entry of the outgas from the bonding layer 103 and the bonding layer 103 into the recesses 111 and 112 can be prevented, and a decrease in the joining strength of the chip 701 and the transparent substrate 102 can be suppressed.

Note that in the above-described eighth embodiment, the transparent substrate 102 and the chip 701 of the above-described seventh embodiment are directly joined. In any of the above-described second, third, and sixth embodiments, the cavity 703 may be additionally provided in the chip to directly join the chip and the transparent substrate.

### 9. Ninth Embodiment

In the above-described first embodiment, the recess 111 is provided in the joining region R1 of the chip 101, and the recess 112 is provided in the joining region R2 of the transparent substrate 102. In a ninth embodiment, a light-shielding film is provided at the inner surface of the recess 112 formed in the joining region R2 of the transparent substrate 102.

Fig. 12 is a diagram depicting a configuration example of an electronic device according to the ninth embodiment. Note that a in the drawing is a sectional view depicting a configuration example of an electronic device 900 taken along the vertical direction, b in the drawing is a plan view depicting a configuration example of the electronic device 900, and c in the drawing is a plan view depicting a configuration example of an electronic device 900'.

In the drawing, the electronic device 900 includes a layered chip P9 instead of the layered chip P1 of the above-described first embodiment. Other configurations of the electronic device 900 of the ninth embodiment are the same as the configurations of the electronic device 100 of the above-described first embodiment.

The layered chip P9 includes a transparent substrate 902 instead of the transparent substrate 102 of the above-described first embodiment. Other configurations of the layered chip P9 of the ninth embodiment are the same as the configurations of the layered chip P1 of the above-described first embodiment.

The transparent substrate 902 is additionally provided with a light-shielding film 912 in the transparent substrate 102 of the above-described first embodiment. Other configurations of the transparent substrate 902 of the ninth embodiment are the same as the configurations of the transparent substrate 102 of the above-described first embodiment.

The light-shielding film 912 may be formed at the inner surface of the recess 112. In this case, the light-shielding film 912 may cover the entirety of the inner surface of the recess 112. The material of the light-shielding film 912 may be metals such as Al, Cu, Ag, Ti, and W. The material of the light-shielding film 912 may also be a heat-absorbing material or a thermally conductive material. In this case, the light-shielding film 912 may be used as a heatdissipating material for releasing the heat generated inside the layered chip P9 to the outside.

In the electronic device 900, as depicted in b in the drawing, the recess 112 may be discretely disposed at the periphery of the transparent substrate 902. The light-shielding film 912 may be formed at the periphery of the light reception region R0 so as to cover the inner surface of the recess 112.

Alternatively, in the electronic device 900', as depicted in c in the drawing, the recess 112' may be continuously disposed at the periphery of the transparent substrate 902. In addition, the light-shielding film 912' may be formed at the periphery of the light reception region R0 so as to cover the inner surface of the recess 112'.

In this manner, in the above-described ninth embodiment, the light-shielding film 912 is provided at the inner surface of the recess 112 formed in the joining region R2 of the transparent substrate 102. As a result, while improving the joining strength between the chip 101 and the transparent substrate 102 by vacuum suction between the chip 101 and the transparent substrate 102, incidence of unnecessary light and reflection light from the interface between the transparent substrate 102 and the bonding layer 103 can be suppressed, thereby reducing flare.

Note that in the above-described ninth embodiment, the light-shielding film 912 is provided at the inner surface of the recess 112 formed in the joining region R2 of the transparent substrate 102 of the above-described first embodiment. In any of the above-described second to eighth embodiments, the light-shielding film 912 may be provided at the inner surface of the recess formed in the joining region R2 of the transparent substrate.

### 10. Tenth Embodiment

In the above-described first embodiment, the recess 111 is provided in the joining region R1 of the chip 101, and the recess 112 is provided in the joining region R2 of the transparent substrate 102. In a tenth embodiment, a through electrode disposed at a position different from the position of the recess 112 provided in the joining region R2 of the transparent substrate 102 in the horizontal direction is provided in a chip joined to the transparent substrate 102.

Fig. 13 is a diagram depicting a configuration example of an electronic device according to the tenth embodiment. Note that a in the drawing is a sectional view depicting a configuration example of an electronic device 1000 taken along the vertical direction, b in the drawing is a plan view depicting a configuration example of the electronic device 1000, and c in the drawing is a sectional view depicting a region RA of a in the drawing in an enlarged manner.

In the drawing, the electronic device 1000 includes a layered chip P10 instead of the layered chip P1 of the above-described first embodiment. Other configurations of the electronic device 1000 of the tenth embodiment are the same as the configurations of the electronic device 100 of the above-described first embodiment.

The layered chip P10 includes chips P51 and P52. The chip P52 is layered on the chip P51. The transparent substrate 102 is joined on the chip P52 through the bonding layer 103.

In each of the chips P51 and P52, semiconductor elements, optical elements, or MEMS may be formed. The substrate used for each of the chips P51 and P52 may be a semiconductor substrate, a dielectric substrate, or an organic substrate.

In the following description, a case will be taken as an example in which a semiconductor element is formed in the chip P51, and a back-irradiation solid-state imaging element is formed in the chip P52. As the semiconductor element of the chip P51, a logic circuit may be formed, a memory may be formed, a processor may be formed, a signal processing circuit may be formed, and an interface circuit may be formed.

The chip P51 includes a semiconductor substrate 1011, a wiring layer 1012 and a rear surface wiring layer 1017. The wiring layer 1012 is formed on the front surface side of the semiconductor substrate 1011, and the rear surface wiring layer 1017 is formed on the rear surface side of the semiconductor substrate 1011. The wiring layer 1012 is provided with a pad electrode 1033 and a wiring 1031 embedded in the insulating layer. In addition, the wiring layer 1012 is provided with a via 1032 used for interlayer connection. The pad electrode 1033 may be used for direct joining between the chips P51 and P52.

The rear surface wiring layer 1017 is provided with a rear surface wiring 1015 embedded in an insulating layer such as a solder resist is provided. A protruding electrode 1016 connected to the rear surface wiring 1015 is formed on the rear surface wiring layer 1017.

In addition, a gate electrode 1034 embedded in the insulating layer is formed on the front surface side of the semiconductor substrate 1011. In this case, in the semiconductor substrate 1011, a channel region located below the gate electrode 1034 and an impurity diffusion layer located on both sides of a channel region may be formed. In addition, in the semiconductor substrate 1011, a through electrode 1014 extending through the semiconductor substrate 1011 in the depth direction is formed. The through electrode 1014 is connected to the wiring 1031 and the rear surface wiring 1015.

The planar size and planar shape of the chip P52 may be set equal to the planar size and planar shape of the chip P51. The chip P52 includes a semiconductor substrate 1021 and a wiring layer 1022. The wiring layer 1022 is formed on the front surface side of the semiconductor substrate 1021. The wiring layer 1022 is provided with a pad electrode 1043 and a wiring 1041 embedded in the insulating layer. In addition, the wiring layer 1022 is provided with a via 1042 used for interlayer connection. The pad electrode 1043 may be used for direct joining between the chips P51 and P52. In direct joining between the chips P51 and P52, hybrid bonding may be used. In this case, the pad electrodes 1033 and 1043 are disposed at opposing positions. Further, the pad electrodes 1033 and 1043 may be joined to each other by metal bonding such as Cu-Cu bonding.

In addition, a gate electrode 1044 embedded in the insulating layer is formed on the front surface side of the semiconductor substrate 1021. In this case, in the semiconductor substrate 1021, a channel region located below the gate electrode 1044 and an impurity diffusion layer located on both sides of a channel region may be formed. In addition, a photodiode PD is formed for each pixel on the rear surface side of the semiconductor substrate 1021.

Here, the chip P52 is provided with the light reception region R0 and the joining region R1. In the light reception region R0, pixels and pixel transistors arranged in a matrix along the row direction and the column direction are disposed.

The joining region R1 is used to join the chip P52 and the transparent substrate 102. In the joining region R1, a through hole 1023 connected to a recess 1013 in the depth direction is formed. The through hole 1023 extends through the semiconductor substrate 1021 and the wiring layer 1022, and is connected to the recess 112 in the depth direction through the through hole 113. The recess 1013 extends through the wiring layer 1012, and is formed inside the semiconductor substrate 1011. The recess 1013 may be disposed at a position different from the position of the through electrode 1014 in the horizontal direction.

Over the light reception region R0, the color filter 104 is formed for each pixel. On the color filter 104, the on-chip lens 105 is formed for each pixel. In this case, the photodiode may be disposed on the rear surface side of the semiconductor substrate 1021.

The material of the insulating layer used for each of the wiring layers 1012 and 1022 and the rear surface wiring layer 1017 may be SiO2, SiN or SiCN, for example. The material of the wirings 1031 and 1041, the rear surface wiring 1015, the via 1032, 1042 and the pad electrodes 1033 and 1043 may be metals such as Al, Cu, AlCu, AlSiCu or Co, for example. The material of the through electrode 1014 may be metals such as Cu, Ti, Ta, Al, W, Ni, Ru, or Co, or a layered structure composed of a plurality of materials, for example.

In the electronic device 1000, as depicted in b in the drawing, the recess 1013 may be discretely disposed at the periphery of the chip P51, and the through hole 1023 may be discretely disposed at the periphery of the chip P52. In this case, the through electrode 1014 may be discretely disposed along the boundary of the light reception region R0 at a position shifted from the recess 1013 in the horizontal direction.

Note that the dimension of each part of the electronic device 100 may be set as follows, for example.
·The planar size of the chips P51 and P52 and the transparent substrate 102: 1.0 × 1.0 mm
·The thickness of the chip P51: 10 µm
·The thickness of the chip P52: 95 µm
·The thickness of the semiconductor substrate 1011: 85 µm
·The thickness of the wiring layer 1012: 10 µm
·The thickness of the transparent substrate 102: 300 µm
·The thickness of the bonding layer 103: 50 µm
·The planar size of the light reception region R0: 700 × 700 µm
·The width of each of the joining regions R1 and R2: 150 µm
·The height of the protruding electrode 106 from the semiconductor substrate 1011: 150 µm
·The planar size of the recesses 111 and 112: 50 × 50 µm
·The depth of the recess 111 inside the semiconductor substrate 1011: 50 µm
·The depth of the recess 112 inside the transparent substrate 102: 200 µm
·The distance between the recess 112 and the transparent substrate 102 in the horizontal direction: 20 µm
·The distance between the recess 112 and the light reception region R0 in the horizontal direction: 80 µm

In this manner, in the above-described tenth embodiment, the through electrode 1014 disposed at a position different from the position of the recess 112 provided in the joining region R2 of the transparent substrate 102 in the horizontal direction is provided in the chip P51. As a result, connection to the wiring layer 1012 from the rear surface side of the chip P51 can be achieved while suppressing conduction of the heat generated at the periphery of the transparent substrate 102 and the chips P51 and P52 at the positions of the recesses 112 and 1013.

Note that in the above-described tenth embodiment, the chip P52 is joined to the transparent substrate 102 of the above-described first embodiment through the bonding layer 103. In any of the above-described second to ninth embodiments, the layered chip provided with the through electrode 1014 may be joined to the transparent substrate.

### 11. Eleventh Embodiment

In the above-described tenth embodiment, the through electrode 1014 disposed at a position different from the position of the recess 112 provided in the joining region R2 of the transparent substrate 102 in the horizontal direction is provided in the chip P51. In an eleventh embodiment, a through electrode is provided at a position coinciding with the position of the recess 112 provided in the joining region R2 of the transparent substrate 102 in the horizontal direction.

Fig. 14 is a diagram depicting a configuration example of an electronic device according to the eleventh embodiment. Note that a in the drawing is a sectional view depicting a configuration example of an electronic device 1100 taken along the vertical direction, and b in the drawing is a plan view depicting a configuration example of the electronic device 1100.

In the drawing, the electronic device 1100 includes a layered chip P11 instead of the layered chip P10 and the bonding layer 103 of the above-described tenth embodiment. Other configurations of the electronic device 1100 of the eleventh embodiment are the same as the configurations of the electronic device 1000 of the above-described tenth embodiment.

The layered chip P11 includes chips P21 and P22. The chip P22 is layered on the chip P21. The transparent substrate 102 is joined on the chip P22 through the bonding layer 203.

In each of the chips P21 and P22, semiconductor elements, optical elements, or MEMS may be formed. The substrate used for each of the chips P21 and P22 may be a semiconductor substrate, a dielectric substrate, or an organic substrate.

In the following description, a case will be taken as an example in which a semiconductor element is formed in the chip P21, and a back-irradiation solid-state imaging element is formed in the chip P22. As the semiconductor element of the chip P21, a logic circuit may be formed, a memory may be formed, a processor may be formed, a signal processing circuit may be formed, and an interface circuit may be formed.

In the chip P21, the recess 1013 is eliminated in the chip P51 of the above-described tenth embodiment. In addition, the chip P21 is provided with a through electrode 1114 instead of the through electrode 1014 of the above-described tenth embodiment. Other configurations of the chip P21 of the eleventh embodiment are the same as the configurations of the chip P51 of the above-described tenth embodiment.

In the chip P22, the through hole 1023 is eliminated in the chip P52 of the above-described tenth embodiment. Other configurations of the chip P22 of the eleventh embodiment are the same as the configurations of the chip P52 of the above-described tenth embodiment.

As depicted in b in the drawing, the through electrode 1114 may be discretely disposed at the periphery of the chip P21. In this case, the through electrode 1114 may be disposed so as to coincide with the position of the recess 112 in the horizontal direction. Note that the through electrode 1114 may be disposed so as to partially coincide with the position of the recess 112 in the horizontal direction.

In this manner, in the above-described eleventh embodiment, the through electrode 1114 disposed at a position coinciding with the position of the recess 112 provided in the joining region R2 of the transparent substrate 102 in the horizontal direction is provided in the chip P21. As a result, conduction of the heat generated at the periphery of the transparent substrate 102 can be suppressed at the position of the recess 112 while suppressing an increase in the area of the joining region R1, and connection to the wiring layer 1012 from the rear surface side of the chip P21 can be achieved.

Note that in the above-described eleventh embodiment, the chip P22 is joined to the transparent substrate 102 of the above-described second embodiment through the bonding layer 203. It is also possible to employ the structures of the transparent substrates of the above-described fifth, sixth, and ninth embodiments.

### 12. Twelfth Embodiment

In the above-described first embodiment, the chip 101 in which the recess 111 is formed and the transparent substrate 102 in which the recess 112 is formed are joined through the bonding layer 103. In a twelfth embodiment, a recess is provided at the joining surface of each chip in which an electronic device is formed, and these chips are directly joined.

Fig. 15 is a diagram depicting a configuration example of an electronic device according to the twelfth embodiment. Note that a in the drawing is a sectional view depicting a configuration example of an electronic device 1200 taken along the vertical direction, and b in the drawing is a plan view depicting a configuration example of the electronic device 1200.

In the drawing, the electronic device 1200 includes a layered chip P12 instead of the layered chip P10 of the above-described tenth embodiment. Other configurations of the electronic device 1200 of the twelfth embodiment are the same as the configurations of the electronic device 1000 of the above-described tenth embodiment.

The layered chip P12 includes chips P31 and P32. The chip P32 is layered on the chip P31. The chip P32 is directly joined to the chip P31.

In each of the chips P31 and P32, semiconductor elements, optical elements, or MEMS may be formed. As the semiconductor element, a logic circuit may be formed, a memory may be formed, a processor may be formed, a signal processing circuit may be formed, and an interface circuit may be formed. The substrate used for each of the chips P31 and P32 may be a semiconductor substrate, a dielectric substrate, or an organic substrate.

In the following description, a case will be taken as an example in which a semiconductor element is formed in each of the chips P31 and P32.

The chip P31 includes a semiconductor substrate 1211, a wiring layer 1212 and a rear surface wiring layer 1217. The wiring layer 1212 is formed on the front surface side of the semiconductor substrate 1211, and the rear surface wiring layer 1217 is formed on the rear surface side of the semiconductor substrate 1211. The wiring layer 1212 is provided with a pad electrode 1233 and a wiring 1231 embedded in the insulating layer. In addition, the wiring layer 1212 is provided with a via 1232 used for interlayer connection. The pad electrode 1233 may be used for direct joining between the chips P31 and P32.

The rear surface wiring layer 1217 is provided with a rear surface wiring 1215 embedded in the insulating layer. A protruding electrode 1216 connected to the rear surface wiring 1215 is formed on the rear surface wiring layer 1217.

Here, the chip P31 is provided with a device region R3 and the joining region R1. In the device region R3, an impurity diffusion layer and a channel region used for a transistor may be formed.

The joining region R1 is used to join the chips P31 and P32. In the joining region R1, the recess 1123 is formed. The recess 1123 extends through the wiring layer 1212, and is formed in the semiconductor substrate 1211. In addition, in the semiconductor substrate 1211, a through electrode 1214 extending through the semiconductor substrate 1211 in the depth direction is formed. The through electrode 1214 is connected to the wiring 1231 and the rear surface wiring 1215.

The planar size and planar shape of the chip P32 may be set equal to the planar size and planar shape of the chip P31. The chip P32 includes a semiconductor substrate 1221 and a wiring layer 1222. The wiring layer 1222 is formed on the front surface side of the semiconductor substrate 1221. The wiring layer 1222 is provided with a pad electrode 1243 and a wiring 1241 embedded in the insulating layer. In addition, the wiring layer 1222 is provided with a via 1242 used for interlayer connection. The pad electrode 1243 may be used for direct joining between the chips P31 and P32. Hybrid bonding can be used for direct joining between the chips P31 and P32. In this case, the pad electrodes 1233 and 1243 are disposed at opposing positions. Further, the pad electrodes 1233 and 1243 may be joined to each other by metal bonding such as Cu-Cu bonding.

Here, the chip P32 is provided with a device region R4 and the joining region R2. In the device region R4, an impurity diffusion layer and a channel region used for a transistor may be formed.

The joining region R2 is used to join the chips P31 and P32. A recess 1223 is formed in the joining region R2. The recess 1223 extends through the wiring layer 1222, and is formed in the semiconductor substrate 1221.

In the electronic device 1200, as depicted in b in the drawing, the recess 1123 may be discretely disposed at the periphery of the chip P31, and the recess 1223 may be discretely disposed at the periphery of the chip P32. In this case, the through electrode 1214 may be discretely disposed along the boundary of the device region R3 at a position shifted from the recess 1123 in the horizontal direction.

In this manner, in the above-described twelfth embodiment, the through electrode 1214 disposed at a position different from the position of the recess 1223 provided in the joining region R2 of the chip P32 in the horizontal direction is provided in the chip P31. As a result, connection to the wiring layer 1212 from the rear surface side of the chip P31 can be achieved while suppressing conduction of the heat generated at the periphery of the chips P31 and P32 at the positions of the recesses 1123 and 1223.

### 13. Thirteenth Embodiment

In the above-described twelfth embodiment, the chip P31 in which the recess 1123 is formed and the chip P32 in which the recess 1223 is formed are directly joined. In a thirteenth embodiment, a first semiconductor chip and a second semiconductor chip are directly joined such that the position of a recess formed at a joining surface of the first semiconductor chip in the horizontal direction and the position of a through electrode formed at the second semiconductor chip in the horizontal direction coincide with each other.

Fig. 16 is a diagram depicting a configuration example of an electronic device according to the thirteenth embodiment. Note that a in the drawing is a sectional view depicting a configuration example of an electronic device 1300 taken along the vertical direction, and b in the drawing is a plan view depicting a configuration example of the electronic device 1300.

In the drawing, the electronic device 1300 includes a layered chip P13 instead of the layered chip P12 of the above-described twelfth embodiment. Other configurations of the electronic device 1300 of the thirteenth embodiment are the same as the configurations of the electronic device 1200 of the above-described twelfth embodiment.

The layered chip P13 includes chips P41 and P32. The chip P32 is layered on the chip P41. The chip P32 is directly joined to the chip P41.

In the chip P41, semiconductor elements, optical elements, or MEMS may be formed. As the semiconductor element, a logic circuit may be formed, a memory may be formed, a processor may be formed, a signal processing circuit may be formed, and an interface circuit may be formed. The substrate used for the chip P41 may be a semiconductor substrate, a dielectric substrate, or an organic substrate.

In the following description, a case will be taken as an example in which a semiconductor element is formed in the chip P41.

In the chip P41, the recess 1123 is eliminated in the chip P31 of the above-described twelfth embodiment. In addition, the chip P41 includes a through electrode 1314 instead of the through electrode 1214 of the above-described twelfth embodiment. Other configurations of the chip P41 of the thirteenth embodiment are the same as the configurations of the chip P31 of the above-described twelfth embodiment.

As depicted in b in the drawing, the through electrode 1314 may be discretely disposed at the periphery of the chip P41. In this case, the through electrode 1314 may be disposed so as to coincide with the position of the recess 1223 in the horizontal direction. Note that the through electrode 1314 may be disposed so as to partially coincide with the position of the recess 1223 in the horizontal direction.

In this manner, in the above-described thirteenth embodiment, the through electrode 1314 disposed at a position coinciding with the position of the recess 1223 provided in the joining region R2 of the chip P32 in the horizontal direction is provided in the chip P41. As a result, conduction of the heat generated at the periphery of the chip P32 can be suppressed at the position of the recess 1223 while suppressing an increase in the area of the joining regions R1 and R2, and connection to the wiring layer 1212 from the rear surface side of the chip P41 can be achieved.

### 14. Fourteenth Embodiment

In the above-described first embodiment, the recess 111 is provided in the joining region R1 of the chip 101, and the recess 112 is provided in the joining region R2 of the transparent substrate 102. In a fourteenth embodiment, a groove is provided to traverse a transparent substrate joined to a sensor chip through a transparent resin layer.

Fig. 17 is a diagram depicting a configuration example of an electronic device according to the fourteenth embodiment. Note that a in the drawing is a sectional view depicting a configuration example of an electronic device 1400 taken along the vertical direction, and b in the drawing is a plan view depicting a configuration example of the electronic device 1400.

In the drawing, the electronic device 1400 includes a layered chip P14. The layered chip P14 includes a sensor chip 1401 and a transparent substrate 1402. The transparent substrate 1402 is layered on the sensor chip 1401. In this case, the transparent substrate 1402 is joined to the sensor chip 1401 through a transparent resin layer 1403. Here, at least at one joining surface between the transparent substrate 1402 and the sensor chip 1401, a plurality of surfaces having different normal directions are formed. For example, a groove MZ1 is provided between the sensor chip 1401 and the transparent substrate 1402. The groove MZ1 may be continuously provided across different end portions of the layered chip P14. Here, the transparent substrate 1402 is diced into a chip so as to have a size equivalent to that of the sensor chip 1401. In this case, the position of the end portion of the transparent substrate 1402 in the horizontal direction may be set to coincide with the position of the end portion of the sensor chip 1401 in the horizontal direction. As a result, the layered chip P14 can configure a WLCSP. Note that the transparent substrate 1402 may be used as an optical system for transmitting light on the sensor chip 1401.

The transparent substrate 1402 includes the groove MZ1. The groove MZ1 is disposed on the joining surface side with the transparent resin layer 1403. The groove MZ1 is disposed to traverse the transparent substrate 1402. The groove MZ1 may be disposed at a position capable of traversing the wafer before the layered chip P14 is singulated. One or more grooves MZ1 may be provided in the transparent substrate 1402. In this case, the groove MZ1 may be disposed on a pixel region RG of the sensor chip 1401. The pixel region RG may include an effective pixel region and an ineffective pixel region. In this case, the groove MZ1 may be disposed on the effective pixel region of the sensor chip 1401, on the peripheral region at the periphery of the pixel region RG, or, on both the effective pixel region and the peripheral region. The width and depth of the groove MZ1 may be constant. By making the width and depth of the groove MZ1 constant, voids can be prevented from remaining in the groove MZ1. In this case, the depth of the groove MZ1 may be set to a value equal to or less than the thickness of the transparent resin layer 1403. More preferably, the depth of the groove MZ1 is set to 1/2 or less of the thickness of the transparent resin layer 1403. The width of the groove MZ1 is preferably set as narrow as possible within a range that allows penetration of the transparent resin layer 1403. The arrangement density of the groove MZ1 is preferably set as high as possible. The cross-sectional shape of the groove MZ1 may include a curve or may include a straight line. For example, the cross-sectional shape of the groove MZ1 may be wavy or rectangular. In addition, the planar shape of the groove MZ1 is preferably configured as a straight line or a smooth curve so as not to obstruct the flow of voids.

The transparent substrate 1402 may be a glass substrate, a quartz substrate, or an acrylic or polycarbonate transparent resin substrate. For the transparent substrate 1402, Al₂O₃, CaF₂, MgF₂, LiF or the like may be used in accordance with the wavelength detected by the sensor chip 1401.

The sensor chip 1401 includes the pixel region RG. A peripheral region is provided at the periphery of the pixel region RG. In the pixel region RG, pixels and pixel transistors arranged in a matrix along the row direction and the column direction are disposed. A photodiode may be formed in the pixel. In the peripheral region, a dynamic random access memory (DRAM) may be provided, or a signal processing circuit that performs signal processing on a pixel signal output from the effective pixel region may be provided. The sensor chip 1401 may be a back-irradiation solid-state imaging element. Over the pixel region RG, the color filter 104 is formed for each pixel. On the color filter 104, the on-chip lens 105 is formed for each pixel.

The transparent resin layer 1403 is located between the sensor chip 1401 and the transparent substrate 1402. In this case, the position of the end portion of the transparent resin layer 1403 in the horizontal direction may be set to coincide with the position of the end portion of the sensor chip 1401 in the horizontal direction. The transparent resin layer 1403 can join the sensor chip 1401 and the transparent substrate 1402 while penetrating into the groove MZ1 of the transparent substrate 1402. In this case, by penetrating into the groove MZ1 of the transparent substrate 1402, the transparent resin layer 1403 can increase the joining area of the transparent substrate 1402, thereby increasing the joining strength. Here, by disposing the groove MZ1 on the pixel region RG of the sensor chip 1401, the limitation on the arrangement position of the groove MZ1 can be relaxed in comparison with a method in which the groove MZ1 is disposed only at the periphery of the pixel region RG. Thus, the joining area of the transparent substrate 1402 can be increased while accommodating a reduction in the chip size of the layered chip P14.

In addition, by disposing the groove MZ1 to traverse the transparent substrate 1402, the sensor chip 1401 and the transparent substrate 1402 can be joined through the transparent resin layer 1403 while ensuring the flow path of the transparent resin layer 1403 extending from the center to end portion of the layered chip P14. Thus, the transparent resin layer 1403 can uniformly spread through the flow path, thereby joining the sensor chip 1401 and the transparent substrate 1402 and preventing voids from remaining in the transparent resin layer 1403.

The material of the transparent resin layer 1403 may be transparent resins such as a siloxane resin, an acrylic resin, and an epoxy resin. In this case, the material of the transparent resin layer 1403 may be selected such that a refractive index difference is ensured with the on-chip lens 105. The transparent resin layer 1403 may contain a filler made of an inorganic or organic material to improve reliability. For the transparent resin layer 1403, a resin material whose optical properties (such as the refractive index and extinction coefficient) are adjusted may be selected to favorably receive light in the effective pixel region. In particular, for the refractive index of the transparent resin layer 1403, for example, a material having a refractive index of approximately 0.5 to 3.0 may be used, but more preferably the refractive index is close to that of the transparent substrate 1402. Additionally, a lower extinction coefficient of the transparent resin layer 1403 is preferable, but more preferably the extinction coefficient is close to zero. For example, in the case where the groove MZ1 is disposed on the effective pixel region, it is preferable to set the refractive index difference between the transparent substrate 1402 and the transparent resin layer 1403 such that the quality of the image generated by the sensor chip 1401 is not degraded. In this case, the refractive index of the transparent substrate 1402 and the refractive index of the transparent resin layer 1403 may be equal to each other.

Fig. 18 is a plan view depicting a configuration example of a wafer state of the electronic device according to the fourteenth embodiment.

In the drawing, a transparent substrate wafer 1402W is cut out in the state where it is layered on a semiconductor wafer 1401W through the transparent resin layer 1403, and singulated into the layered chip P14.

The groove MZ1 is formed in the transparent substrate wafer 1402W. The groove MZ1 may be disposed to traverse the transparent substrate wafer 1402W. As a result, the transparent resin layer 1403 can uniformly spread through the flow path, thereby joining the transparent substrate wafer 1402W and the semiconductor wafer 1401W through the transparent resin layer 1403. The groove MZ1 may be radially formed in the transparent substrate wafer 1402W. Here, by radially forming the groove MZ1 at the transparent substrate wafer 1402W, the center and end portion of the transparent substrate wafer 1402W can be connected by the shortest path, thereby enabling efficient movement of voids from the center to end portion of the transparent substrate wafer 1402W. The arrangement density of the groove MZ1 may be set such that one or more grooves MZ1 are provided in the layered chip P14.

A divided region 1401R is provided in the semiconductor wafer 1401W. The sensor chip 1401 is cut out from each divided region 1401R. Each divided region 1401R is defined along a scribe line 1401D. In each divided region 1401R, the color filter 104 and the on-chip lens 105 are disposed for each pixel.

Fig. 19 is a sectional view depicting an example of a manufacturing method for the electronic device according to the fourteenth embodiment.

In a in the drawing, a resist pattern 1421 is formed on the transparent substrate wafer 1402W by lithography. In the resist pattern 1421, an opening portion 1422 is formed at the formation position of the groove MZ1.

Next, as depicted in b in the drawing, with the resist pattern 1421 used as an etching mask, the transparent substrate wafer 1402W is etched in the depth direction, thereby forming the groove MZ1 traversing the transparent substrate wafer 1402W. In the etching of the transparent substrate wafer 1402W, isotropic etching such as plasma etching or wet etching may be used. Note that the groove MZ1 may be formed by machining.

Next, as depicted in c in the drawing, the resist pattern 1421 is removed from the transparent substrate wafer 1402W by a method such as ashing.

Next, as depicted in d in the drawing, the transparent resin layer 1403 is formed on the semiconductor wafer 1401W so as to cover the on-chip lens 105. The transparent resin layer 1403 may be formed on the semiconductor wafer 1401W by a method such as coating. Then, before the transparent resin layer 1403 is cured, the transparent substrate wafer 1402W is positioned such that the groove MZ1 faces the transparent resin layer 1403.

Next, as depicted in a in Fig. 17, the transparent substrate wafer 1402W is brought into contact with the transparent resin layer 1403 in such a manner that the transparent resin layer 1403 is embedded in the groove MZ1. Then, the transparent resin layer 1403 is cured, thereby joining the transparent substrate wafer 1402W onto the semiconductor wafer 1401W. In this case, for the transparent resin layer 1403, an ultraviolet curing resin or a thermosetting resin may be used. The joining of the transparent substrate wafer 1402W and the semiconductor wafer 1401W may be performed in a vacuum environment. Then, the layered structure of the transparent substrate wafer 1402W and the semiconductor wafer 1401W is cut along the scribe line 1401D, thereby cutting out the layered chip P14.

Fig. 20 is a diagram depicting another configuration example of the electronic device according to the fourteenth embodiment. Note that a in Fig. 20 is a sectional view depicting a configuration example of an electronic device 1400' taken along the vertical direction, and b in Fig. 20 is a plan view depicting a configuration example of the electronic device 1400'.

In Fig. 20, the electronic device 1400' includes a layered chip P14'. The layered chip P14' is additionally provided with an intermediate layer 1404 in the layered chip P14' of Fig. 17. Other configurations of the layered chip P14' are the same as the configurations of the electronic device 1400 of Fig. 17.

The intermediate layer 1404 has a refractive index between the refractive index of the transparent substrate 1402 and the refractive index of the transparent resin layer 1403. The refractive index of the intermediate layer 1404 may be equal to the refractive index of the transparent substrate 1402. The intermediate layer 1404 is located between the transparent substrate 1402 and the transparent resin layer 1403. In this case, the intermediate layer 1404 may be embedded in the groove MZ1. The surface of the intermediate layer 1404 may be planarized. The intermediate layer 1404 may be composed of organic materials such as a transparent resin.

In this case, the refractive index of the intermediate layer 1404 is close to the refractive index of the transparent substrate 1402. Thus, in comparison with the case where the transparent resin layer 1403 is directly joined to the transparent substrate 1402, the stress or strain applied to the transparent substrate 1402 can be reduced, and the intermediate layer 1404 can more easily penetrate into the groove MZ1 than the transparent resin layer 1403. Thus, the occurrence of voids in the groove MZ1 can be suppressed, and the joining strength can be improved by the anchor effect.

Fig. 21 is a sectional view depicting another example of the manufacturing method for the electronic device according to the fourteenth embodiment.

In a in the drawing, the resist pattern 1421 is formed on the transparent substrate wafer 1402W by lithography. In the resist pattern 1421, the opening portion 1422 is formed at the formation position of the groove MZ1.

Next, as depicted in b in the drawing, with the resist pattern 1421 used as an etching mask, the transparent substrate wafer 1402W is etched in the depth direction, thereby forming the groove MZ1 traversing the transparent substrate wafer 1402W.

Next, as depicted in c in the drawing, the resist pattern 1421 is removed from the transparent substrate wafer 1402W by a method such as ashing. Then, the intermediate layer 1404 is formed on the transparent substrate wafer 1402W so as to fill the groove MZ1. In this case, the surface of the intermediate layer 1404 may be planarized. The intermediate layer 1404 may be formed by coating, spin coating, or dispensing.

Next, as depicted in d in the drawing, the transparent resin layer 1403 is formed on the semiconductor wafer 1401W so as to cover the on-chip lens 105. Then, the transparent substrate wafer 1402W is positioned such that the intermediate layer 1404 faces the transparent resin layer 1403.

Next, as depicted in a in Fig. 20, the intermediate layer 1404 is brought into contact with the transparent resin layer 1403. Then, the transparent resin layer 1403 and the intermediate layer 1404 are cured, thereby joining the transparent substrate wafer 1402W onto the semiconductor wafer 1401W. Then, the layered structure of the transparent substrate wafer 1402W and the semiconductor wafer 1401W is cut along the scribe line 1401D, thereby cutting out the layered chip P14'.

In this manner, in the above-described fourteenth embodiment, the groove MZ1 is provided to traverse the transparent substrate 1402 joined to the sensor chip 1401 through the transparent resin layer 1403. As a result, the joining area of the transparent substrate 1402 and the transparent resin layer 1403 can be increased while allowing the transparent resin layer 1403 to flow to the end portion of the layered chip P41 along the groove MZ1 provided in the transparent substrate 1402. Thus, the joining strength of the sensor chip 1401 and the transparent substrate 1402 can be improved, thereby preventing voids from remaining in the transparent resin layer 1403. Here, by forming the cross-sectional shape of the groove MZ1 with a smooth curve, the flow of voids along the groove MZ1 can be smoothened, thereby facilitating the discharge of the voids.

### 15. Fifteenth Embodiment

In the above-described fourteenth embodiment, the groove MZ1 having a wavy shape is provided to traverse the transparent substrate 1402 joined to the sensor chip 1401 through the transparent resin layer 1403. In a fifteenth embodiment, a groove having a rectangular shape is provided to traverse a transparent substrate joined to the sensor chip 1401 through a transparent resin layer.

Fig. 22 is a sectional view depicting a configuration example of an electronic device according to the fifteenth embodiment.

In the drawing, an electronic device 1500 includes a layered chip P15 instead of the layered chip P14 of the above-described fourteenth embodiment. Other configurations of the electronic device 1500 of the fifteenth embodiment are the same as the configurations of the electronic device 1400 of the above-described fourteenth embodiment.

The layered chip P15 includes a transparent substrate 1502 and a transparent resin layer 1503 instead of the transparent substrate 1402 and the transparent resin layer 1403 of the above-described fourteenth embodiment. Other configurations of the layered chip P15 of the fifteenth embodiment are the same as the configurations of the layered chip P14 of the above-described fourteenth embodiment.

The transparent substrate 1502 includes a groove MZ2. The cross-sectional shape of the groove MZ2 is a rectangular shape. Other configurations of the groove MZ2 are the same as the configurations of the groove MZ1 of the above-described fourteenth embodiment.

The transparent resin layer 1503 joins the sensor chip 1401 and the transparent substrate 1502 while penetrating into the groove MZ2 of the transparent substrate 1502. Other configurations of the transparent resin layer 1503 are the same as the configurations of the transparent resin layer 1403 of the above-described fourteenth embodiment.

In this manner, in the above-described fifteenth embodiment, the groove MZ2 is provided to traverse the transparent substrate 1502 joined to the sensor chip 1401 through the transparent resin layer 1503. As a result, the joining area of the transparent substrate 1502 and the transparent resin layer 1503 can be increased while allowing the transparent resin layer 1503 to flow to the end portion of the layered chip P15 along the groove MZ2 provided at the transparent substrate 1502. Thus, the joining strength of the sensor chip 1401 and the transparent substrate 1502 can be improved, and the voids can be prevented from remaining in the transparent resin layer 1503. Here, by forming the cross-sectional shape of the groove MZ2 into a rectangular shape, the anchor effect of the groove MZ2 can be increased, thereby improving the joining strength of the sensor chip 1401 and the transparent substrate 1502.

### 16. Sixteenth Embodiment

In the above-described fourteenth embodiment, the groove MZ1 is provided to traverse the transparent substrate 1402 joined to the sensor chip 1401 through the transparent resin layer 1403. In a sixteenth embodiment, a minute groove is provided at the surface of a groove provided to traverse a transparent substrate joined to the sensor chip 1401 through a transparent resin layer.

Fig. 23 is a sectional view depicting a configuration example of an electronic device according to the sixteenth embodiment.

In the drawing, an electronic device 1600 includes a layered chip P16 instead of the layered chip P14 of the above-described fourteenth embodiment. Other configurations of the electronic device 1600 of the sixteenth embodiment are the same as the configurations of the electronic device 1600 of the above-described sixteenth embodiment.

The layered chip P16 includes a transparent substrate 1602 and a transparent resin layer 1603 instead of the transparent substrate 1402 and the transparent resin layer 1403 of the above-described fourteenth embodiment. Other configurations of the layered chip P16 of the sixteenth embodiment are the same as the configurations of the layered chip P14 of the above-described fourteenth embodiment.

The transparent substrate 1602 includes a groove MZ3. A minute groove SM3 is provided at the surface of the groove MZ3. Other configurations of the groove MZ3 are the same as the configurations of the groove MZ1 of the above-described fourteenth embodiment.

The minute groove SM3 may be formed along the groove MZ3. In this case, the minute groove SM3 may be continuously disposed to traverse the transparent substrate 1602. The width of the minute groove SM3 is smaller than the width of the groove MZ3. The width and depth of the minute groove SM3 may be constant. Note that the surface of the groove MZ3 may be roughened instead of providing the minute groove SM3 at the surface of the groove MZ3.

The transparent resin layer 1603 joins the sensor chip 1401 and the transparent substrate 1602 while penetrating into the groove MZ3 of the transparent substrate 1602. Other configurations of the transparent resin layer 1603 are the same as the configurations of the transparent resin layer 1403 of the above-described fourteenth embodiment.

In this manner, in the above-described sixteenth embodiment, the minute groove SM3 is provided at the surface of the groove MZ3 provided to traverse the transparent substrate 1602 joined to the sensor chip 1401 through the transparent resin layer 1603. As a result, the joining area of the transparent substrate 1602 and the transparent resin layer 1603 can be increased while allowing the transparent resin layer 1603 to flow to the end portion of the layered chip P16 along the groove MZ3 provided in the transparent substrate 1602. Thus, the joining strength of the transparent substrate 1602 and the transparent resin layer 1603 can be increased while preventing voids from remaining in the transparent resin layer 1603.

### 17. Seventeenth Embodiment

In the above-described fourteenth embodiment, the groove MZ1 is provided to traverse the transparent substrate 1402 joined to the sensor chip 1401 through the transparent resin layer 1403. In a seventeenth embodiment, a groove is provided to traverse an intermediate resin layer interposed in joining of the sensor chip 1401 and the transparent substrate through the transparent resin layer.

Figs. 24 and 25 are sectional views depicting configuration examples of electronic devices according to the seventeenth embodiment. Note that a in Fig. 24 depicts a first example configuration of an electronic device according to the seventeenth embodiment. b in Fig. 24 depicts a second example configuration of an electronic device according to the seventeenth embodiment. a in Fig. 25 depicts a third example configuration of an electronic device according to the seventeenth embodiment. b in Fig. 25 depicts a fourth example configuration of an electronic device according to the seventeenth embodiment.

In a in Fig. 24, an electronic device 1700 includes a layered chip P17A instead of the layered chip P14 of the above-described fourteenth embodiment. Other configurations of the electronic device 1700 are the same as the configurations of the electronic device 1400 of the above-described fourteenth embodiment.

The layered chip P17A includes a transparent substrate 1702 and a transparent resin layer 1703 instead of the transparent substrate 1402 and the transparent resin layer 1403 of the above-described fourteenth embodiment. In addition, the layered chip P17A is additionally provided with an intermediate resin layer 1704 in the layered chip P14 of the above-described fourteenth embodiment. Other configurations of the layered chip P17A are the same as the configurations of the layered chip P14 of the above-described fourteenth embodiment.

In the transparent substrate 1702, the groove MZ1 is eliminated in the transparent substrate 1402 of the above-described fourteenth embodiment. In this case, the transparent substrate 1702 may be composed of a flat plate. Other configurations of the transparent substrate 1702 are the same as the configurations of the transparent substrate 1402 of the above-described fourteenth embodiment.

The intermediate resin layer 1704 is formed on the transparent substrate 1702. The intermediate resin layer 1704 is located between the transparent substrate 1702 and the transparent resin layer 1703. The material of the intermediate resin layer 1704 may be the same as or different from the material of the transparent resin layer 1703. In this case, as the material of the intermediate resin layer 1704, it is preferable to use a material that has optical properties similar to those of the transparent resin layer 1703 in order to avoid an influence on optical properties due to a groove MZ4A. For example, in the case where the groove MZ4A is disposed on the effective pixel region, it is preferable to set the refractive index difference between the intermediate resin layer 1704 and the transparent resin layer 1703 such that the quality of the image generated by the sensor chip 1401 is not degraded. In this case, the refractive index of the intermediate resin layer 1704 and the refractive index of the transparent resin layer 1703 may be equal to each other. In order to improve the joining strength, the bonding strength of the intermediate resin layer 1704 may be greater than the bonding strength of the transparent resin layer 1703.

The intermediate resin layer 1704 includes the groove MZ4A. The groove MZ4A is disposed to traverse the intermediate resin layer 1704. Here, the groove MZ4A may extend through the intermediate resin layer 1704. In this case, the depth of the groove MZ4A may coincide with the thickness of the intermediate resin layer 1704. The groove MZ4A may be disposed at a position capable of traversing the wafer before the layered chip P17A is singulated. In this case, the groove MZ4A may be disposed on the pixel region RG of the sensor chip 1401. The width and depth of the groove MZ4A may be constant. In this case, the depth of the groove MZ4A may be set to a value equal to or less than the thickness of the transparent resin layer 1703. More preferably, the depth of the groove MZ4A is set to a value equal to or less than 1/2 of the thickness of the transparent resin layer 1703. The cross-sectional shape of the groove MZ4A may include a curve or may include a straight line. For example, the cross-sectional shape of the groove MZ4A may be wavy or rectangular. In addition, the planar shape of the groove MZ4A is preferably configured as a straight line or a smooth curve so as not to obstruct the flow of voids.

The transparent resin layer 1703 joins the sensor chip 1401 and the transparent substrate 1702 while penetrating into the groove MZ4A of the intermediate resin layer 1704. Other configurations of the transparent resin layer 1703 are the same as the configurations of the transparent resin layer 1403 of the above-described fourteenth embodiment.

In b in Fig. 24, an electronic device 1710 includes a layered chip P17B instead of the above-described layered chip P17A. Other configurations of the electronic device 1710 are the same as the configurations of the above-described electronic device 1700.

The layered chip P17B includes a transparent resin layer 1713 and an intermediate resin layer 1714 instead of the above-described transparent resin layer 1703 and the intermediate resin layer 1704. Other configurations of the layered chip P17B are the same as the configurations of the above-described layered chip P17A.

The intermediate resin layer 1714 includes a groove MZ4B instead of the groove MZ4A of the above-described intermediate resin layer 1704. Other configurations of the intermediate resin layer 1714 are the same as the configurations of the above-described intermediate resin layer 1704.

The bottom of the groove MZ4B is located inside the intermediate resin layer 1714. In this case, the depth of the groove MZ4B is smaller than the thickness of the intermediate resin layer 1714. Other configurations of the groove MZ4B are the same as the configurations of the above-described groove MZ4A.

In a in Fig. 25, an electronic device 1720 includes a layered chip P17C instead of the above-described layered chip P17A. Other configurations of the electronic device 1720 are the same as the configurations of the above-described electronic device 1700.

The layered chip P17C includes a transparent resin layer 1723 and an intermediate resin layer 1724 instead of the above-described transparent resin layer 1703 and intermediate resin layer 1704. Other configurations of the layered chip P17C are the same as the configurations of the above-described layered chip P17A.

The intermediate resin layer 1724 is formed on the sensor chip 1401. The intermediate resin layer 1724 is located between the sensor chip 1401 and the transparent resin layer 1723. The material of the intermediate resin layer 1724 may be the same as or different from the material of the transparent resin layer 1723. It should be noted that in the case where a groove MZ4C is disposed on the effective pixel region, it is preferable to set the refractive index difference between the intermediate resin layer 1724 and the transparent resin layer 1723 such that the quality of the image generated by the sensor chip 1401 is not degraded. For example, the refractive index of the intermediate resin layer 1724 and the refractive index of the transparent resin layer 1723 may be equal to each other. In this case, the refractive index of the intermediate resin layer 1724 may be different from the refractive index of the on-chip lens 105.

The intermediate resin layer 1724 includes the groove MZ4C. The groove MZ4C is disposed to traverse the intermediate resin layer 1724. Here, the groove MZ4C may extend through the intermediate resin layer 1724. In this case, the depth of the groove MZ4C may coincide with the thickness of the intermediate resin layer 1724. The groove MZ4C may be disposed at a position capable of traversing the wafer before the layered chip P17C is singulated. In this case, the groove MZ4C may be disposed on the pixel region RG of the sensor chip 1401. The width and depth of the groove MZ4C may be constant. In this case, the depth of the groove MZ4C may be set to a value equal to or less than the thickness of the transparent resin layer 1723. More preferably, the depth of the groove MZ4C is preferably set to a value equal to or less than 1/2 of the thickness of the transparent resin layer 1723. The cross-sectional shape of the groove MZ4C may include a curve or may include a straight line. For example, the cross-sectional shape of the groove MZ4C shape may be wavy or rectangular. In addition, the planar shape of the groove MZ4C is preferably configured as a straight line or a smooth curve so as not to hinder the flow of the transparent resin.

The transparent resin layer 1723 joins the sensor chip 1401 and the transparent substrate 1702 while penetrating into the groove MZ4C of the intermediate resin layer 1724. Other configurations of the transparent resin layer 1723 are the same as the configurations of the transparent resin layer 1403 of the above-described fourteenth embodiment.

In b in Fig. 25, an electronic device 1730 includes a layered chip P17D instead of the above-described layered chip P17C. Other configurations of the electronic device 1730 are the same as the configurations of the above-described electronic device 1720.

The layered chip P17D includes a transparent resin layer 1733 and an intermediate resin layer 1734 instead of the above-described transparent resin layer 1723 and the intermediate resin layer 1724. Other configurations of the layered chip P17D are the same as the configurations of the above-described layered chip P17C.

The intermediate resin layer 1734 includes a groove MZ4D instead of the groove MZ4C of the above-described intermediate resin layer 1724. The intermediate resin layer 1734 is located between the sensor chip 1401 and the transparent resin layer 1733. Other configurations of the intermediate resin layer 1734 are the same as the configurations of the above-described intermediate resin layer 1724.

The bottom of the groove MZ4D is located inside the intermediate resin layer 1734. In this case, the depth of the groove MZ4D is smaller than the thickness of the intermediate resin layer 1734. Other configurations of the groove MZ4D are the same as the configurations of the above-described groove MZ4C.

In this manner, in the above-described seventeenth embodiment, the groove is provided to traverse the intermediate resin layer interposed in the joining of the sensor chip 1401 and the transparent substrate 1702 through a transparent resin layer. As a result, the joining area of the transparent substrate 1702 and transparent resin layer can be increased while allowing the transparent resin layer to flow along the groove provided in the intermediate resin layer. Thus, the joining strength of the sensor chip 1401 and the transparent substrate 1702 can be improved, and voids can be prevented from remaining in the transparent resin layer.

Note that in the above-described layered chips P17C and P17D, the groove MZ1 of the above-described fourteenth embodiment may be formed in the transparent substrate 1702. In addition, in the above-described layered chips P17C and P17D, the intermediate resin layers 1704 and 1714 of the above-described layered chips P17A and P17B may be formed on the transparent substrate 1702.

### 18. Eighteenth Embodiment

In the above-described fourteenth embodiment, the groove MZ1 is provided to traverse the transparent substrate 1402 joined to the sensor chip 1401 through the transparent resin layer 1403. In an eighteenth embodiment, the number or orientation of grooves provided to traverse a transparent substrate joined to the sensor chip 1401 through the transparent resin layer 1403 is varied.

Figs. 26 to 28 are plan views depicting configuration examples of electronic devices according to the eighteenth embodiment. Note that a in Fig. 26 depicts a first example configuration of an electronic device according to the eighteenth embodiment. b in Fig. 26 depicts a second example configuration of an electronic device according to the eighteenth embodiment. a in Fig. 27 depicts a third example configuration of an electronic device according to the eighteenth embodiment. b in Fig. 27 depicts a fourth example configuration of an electronic device according to the eighteenth embodiment. a in Fig. 28 depicts a fifth example configuration of an electronic device according to the eighteenth embodiment. b in Fig. 28 depicts a sixth example configuration of an electronic device according to the eighteenth embodiment.

In a in Fig. 26, an electronic device 1800 includes a transparent substrate 1801 instead of the transparent substrate 1402 of the above-described fourteenth embodiment. Other configurations of the electronic device 1800 are the same as the configurations of the electronic device 1400 of the above-described fourteenth embodiment.

The transparent substrate 1801 includes a groove MZ5A. A plurality of the grooves MZ5A are disposed at the periphery of the pixel region RG. Other configurations of the groove MZ5A are the same as the configurations of the groove MZ1 of the above-described fourteenth embodiment.

In b in Fig. 26, an electronic device 1810 includes a transparent substrate 1811 instead of the transparent substrate 1402 of the above-described fourteenth embodiment. Other configurations of the electronic device 1810 are the same as the configurations of the electronic device 1400 of the above-described fourteenth embodiment.

The transparent substrate 1811 includes a groove MZ5B. A plurality of the grooves MZ5B are disposed across the pixel region RG in parallel to the sides of the transparent substrate 1811. Other configurations of the groove MZ5B are the same as the configurations of the groove MZ1 of the above-described fourteenth embodiment.

In a in Fig. 27, an electronic device 1820 includes a transparent substrate 1821 instead of the transparent substrate 1402 of the above-described fourteenth embodiment. Other configurations of the electronic device 1820 are the same as the configurations of the electronic device 1400 of the above-described fourteenth embodiment.

The transparent substrate 1821 includes a groove MZ5C. A plurality of the grooves MZ5C orthogonal to each other are disposed across the pixel region RG in parallel to the sides of the transparent substrate 1821. Other configurations of the groove MZ5C are the same as the configurations of the groove MZ1 of the above-described fourteenth embodiment.

In b in Fig. 27, an electronic device 1830 includes a transparent substrate 1831 instead of the transparent substrate 1402 of the above-described fourteenth embodiment. Other configurations of the electronic device 1830 are the same as the configurations of the electronic device 1400 of the above-described fourteenth embodiment.

The transparent substrate 1831 includes a groove MZ5D. A plurality of the grooves MZ5D intersecting each other are disposed obliquely to the sides of the transparent substrate 1831 across the pixel region RG. Other configurations of the groove MZ5D are the same as the configurations of the groove MZ1 of the above-described fourteenth embodiment.

In a in Fig. 28, an electronic device 1840 includes a transparent substrate 1841 instead of the transparent substrate 1402 of the above-described fourteenth embodiment. Other configurations of the electronic device 1840 are the same as the configurations of the electronic device 1400 of the above-described fourteenth embodiment.

The transparent substrate 1841 includes a groove MZ5E. A plurality of the grooves MZ5E having a curved shape are disposed across the pixel region RG. Other configurations of the groove MZ5E are the same as the configurations of the groove MZ1 of the above-described fourteenth embodiment.

In b in Fig. 28, an electronic device 1850 includes a transparent substrate 1851 instead of the transparent substrate 1402 of the above-described fourteenth embodiment. Other configurations of the electronic device 1850 are the same as the configurations of the electronic device 1400 of the above-described fourteenth embodiment.

The transparent substrate 1851 includes a groove MZ5F. A plurality of the grooves MZ5F are disposed at the periphery of the pixel region RG in parallel to the sides of the transparent substrate 1851. Other configurations of the groove MZ5F are the same as the configurations of the groove MZ1 of the above-described fourteenth embodiment.

In this manner, in the above-described eighteenth embodiment, two, four or more grooves, which may differ in orientation, are provided to traverse the transparent substrate joined to the sensor chip 1401 through the transparent resin layer 1403. As a result, the arrangement of grooves can be optimized in accordance with the chip size, the viscosity of the transparent resin or the like, and the joining strength can be improved while preventing voids from remaining in the transparent resin layer.

### 19. Nineteenth Embodiment

In the above-described first embodiment, the recess 111 is provided in the joining region R1 of the chip 101, the recess 112 is provided in the joining region R2 of the transparent substrate 102, and the insides of the recesses 111 and 112 are depressurized. In a nineteenth embodiment, a sensor chip and an optical chip where a joining surface including a plurality of surfaces are formed are joined through a joining layer, and a through electrode is formed in the sensor chip.

Fig. 29 is a sectional view depicting a configuration example of an electronic device according to the nineteenth embodiment.

In the drawing, an electronic device 1900 includes a layered chip P19. The layered chip P19 includes a sensor chip P61 and an optical chip P62. The optical chip P62 is layered on the sensor chip P61. In this case, the optical chip P62 is joined to the sensor chip P61 through a joining layer 1951. Here, at least at one joining surface between the optical chip P62 and the sensor chip P61, a plurality of surfaces having different normal directions are formed. For example, the joining surface including a plurality of surfaces may include at least one of a recess, a protrusion, and a rough surface. The joining surface including a plurality of surfaces may include a combination of a recess and a protrusion, a combination of a recess and a rough surface, or a combination of a recess, a protrusion, and a rough surface. The joining surface including a plurality of surfaces may include a combination of a flat surface and a curved surface.

The optical chip P62 is diced into a chip so as to have a size equivalent to that of the sensor chip P61. In this case, the position of the end portion of the optical chip P62 in the horizontal direction may be set to coincide with the position of the end portion of the sensor chip P61 in the horizontal direction. As a result, the sensor chip P61 can make up a WLCSP packaged at the wafer level, and the optical chip P62 can make up wafer level optics (WLO) packaged at the wafer level. Note that the chip size of the sensor chip P61 and the chip size of the optical chip P62 may not be equal to each other, and the chip size of the sensor chip P61 may be greater or smaller than the chip size of the optical chip P62.

A sensor element is formed in the sensor chip P61. The sensor element may be a photoelectric conversion element. In the sensor chip P61, pixels may be arranged in a matrix along the row direction and the column direction. The sensor chip P61 may be a back-irradiation solid-state imaging element. In this case, the sensor chip P61 may be provided with the pixel region RG and a peripheral region RA. A memory such as a dynamic random access memory (DRAM), a signal processing circuit that performs signal processing on a pixel signal output from the effective pixel region or the like may be formed in the sensor chip P61.

The sensor chip P61 includes a supporting substrate 1911, a semiconductor substrate 1921, a wiring layer 1922 and a rear surface wiring layer 1917. On the front surface side of the semiconductor substrate 1921, the wiring layer 1922 is formed. The wiring layer 1922 is provided with a wiring 1941 embedded in the insulating layer. In addition, the wiring layer 1922 is provided with a via 1942 used for interlayer connection.

In the pixel region RG, the color filter 104 is formed for each pixel on the rear surface side of the semiconductor substrate 1921. On the color filter 104, the on-chip lens 105 is formed for each pixel. In this case, a photodiode may be disposed on the rear surface side of the semiconductor substrate 1921.

In addition, a transparent sealing substrate 1923 is joined on the rear surface side of the semiconductor substrate 1921 through the transparent resin layer 1403. The transparent sealing substrate 1923 may be disposed separately from the on-chip lens 105. A recess EA1 may be formed at the transparent sealing substrate 1923. The recess EA1 may be formed at the joining surface with the optical chip P62. In this case, a recess EA21 may be disposed in the peripheral region RA of the sensor chip P61. The cross-sectional shape of the recess EA1 may be a rectangular shape, for example.

The supporting substrate 1911 is joined on the wiring layer 1922. The supporting substrate 1911 and the wiring layer 1922 may be joined using an adhesive agent.

The rear surface wiring layer 1917 is formed on the rear surface side of the supporting substrate 1911. A rear surface wiring 1915 embedded in an insulating layer such as a solder resist is provided in the rear surface wiring layer 1917. A protruding electrode 1916 connected to the rear surface wiring 1915 is formed on the rear surface wiring layer 1917. In addition, in the supporting substrate 1911, a through electrode 1914 extending through the supporting substrate 1911 in the depth direction is formed. The through electrode 1914 is connected to the wiring 1941 and the rear surface wiring 1915.

The material of the semiconductor substrate 1921 may be a semiconductor such as Si, GaAs and InGaAs, for example. The material of the insulating layer used for the wiring layer 1922 and the rear surface wiring layer 1917 may be SiO₂, SiN or SiCN, for example. The material of the wiring 1941, the rear surface wiring 1915 and the via 1942 may be metals such as Al, Cu, AlCu, AlSiCu or Co, for example. The material of the through electrode 1914 may be metals such as Cu, Ti, Ta, Al, W, Ni, Ru, or Co, or a layered structure composed of a plurality of materials, for example. The material of the supporting substrate 1911 may be a semiconductor, glass, or a resin, for example.

An optical system is formed in the optical chip P62. The optical chip P62 may be provided with a light-converging region RL and a peripheral region RB. The optical system may include a lens. The optical system may include a layered structure of a plurality of lensequipped substrates. The optical system may include a transparent substrate, and may include at least one of an aperture, a light-shielding film, a spacer, and an optical filter. The optical system may include an optical component, or a metasurface. The optical system may include a lens, a color splitter, or a deflector composed of a metasurface.

The optical chip P62 includes transparent supporting substrates 1952, 1955, 1958 and 1961 and lenses 1953, 1959 and 1960. The lenses 1953, 1959 and 1960 are formed on substrates 1953', 1959' and 1960', respectively. The lenses 1953, 1959 and 1960 may be disposed in the light-converging region RL. The lens 1953 forms an image on the imaging surface. The lenses 1959 and 1960 perform wide-angle conversion and chromatic aberration correction.

The substrate 1953' in which the lens 1953 is formed is supported over the transparent supporting substrate 1952 such that the lens 1953 is separated from the transparent supporting substrate 1952 through a supporting member 1954. The supporting member 1954 may be disposed in the peripheral region RB of the optical chip P62. A recess EA2 is formed in the transparent supporting substrate 1952. The recess EA2 may be formed at the joining surface with the sensor chip P61. In this case, the recess EA2 may be disposed in the peripheral region RB of the optical chip P62. The cross-sectional shape of the recess EA2 may be a rectangular shape, for example. In addition, the substrate 1953' in which the lens 1953 is formed is supported on the transparent supporting substrate 1955.

The substrate 1959' in which the lens 1959 is formed is supported on the transparent supporting substrate 1958. The substrate 1960' in which the lens 1960 is formed is supported on the transparent supporting substrate 1961. In addition, the substrate 1960' in which the lens 1960 is formed is joined to the substrate 1959' in which the lens 1959 is formed.

The transparent supporting substrates 1955 and 1958 are joined through a joining layer 1957. An aperture 1956 is formed at a position covered with the joining layer 1957 on the transparent supporting substrate 1955.

The joining layer 1951 joins the transparent sealing substrate 1923 and the transparent supporting substrate 1952. In this case, the joining layer 1951 can penetrate into the recesses EA1 and EA2, and be bonded to the opposing surfaces of the transparent sealing substrate 1923 and the transparent supporting substrate 1952 and the side surfaces of the recesses EA1 and EA2.

The material of the lenses 1953, 1959 and 1960 and the substrates 1953', 1959' and 1960' may be transparent organic substrates such as acrylic or polycarbonate, or transparent inorganic materials such as sol-gel glass. In this case, the lenses 1953, 1959 and 1960 may be formed by nanoimprinting. The materials of the lenses 1953, 1959, and 1960 and the substrates 1953', 1959', and 1960' may be the same as each other or may be different from each other.

The material of the transparent supporting substrates 1952, 1955, 1958 and 1961 may be glass, or transparent materials such as sapphire, quartz, or transparent organic substrate in accordance with application. The material of the aperture 1956 may be a black resin, or a metal such as Cr.

The transparent sealing substrate 1923 may be a glass substrate, a quartz substrate, or an acrylic or polycarbonate transparent resin substrate. For the transparent sealing substrate 1923, Al₂O₃, CaF₂, MgF₂, LiF, or the like may be used in accordance with the wavelength detected by the sensor element formed in the sensor chip P61.

The material of the joining layer 1951 may be organic materials such as siloxane resin, acrylic resin, and epoxy resin, for example. For the joining layer 1951, a resin whose optical properties (such as the refractive index and extinction coefficient) are adjusted to favorably receive light in the effective pixel region may be selected. In addition, in order to improve reliability, a filler made of an inorganic or organic material may be contained in the resin of the joining layer 1951, and the joining layer 1951 may be formed only of an inorganic material or a metal material.

Figs. 30 to 32 are sectional views depicting an example of a manufacturing method for the electronic device according to the nineteenth embodiment.

In a in Fig. 30, a divided region 1901R is provided in a semiconductor wafer 1901W. The sensor chip P61 is cut out from each divided region 1901R. Each divided region 1901R is defined along a scribe line 1901D. In each divided region 1901R, a solid-state imaging element is formed. In this case, the sensor chip P61 can configure a WLCSP packaged at the wafer level.

In b in Fig. 30, an optical wafer 1902W is provided with a divided region 1902R. In this case, the divided regions 1901R and 1902R may be superimposed on each other. The optical chip P62 is cut out from each divided region 1902R. Each divided region 1902R is defined along a scribe line 1902D. The optical chip P62 can configure a WLO packaged at the wafer level.

Here, as depicted in a in Fig. 30, the recess EA1 is formed at the transparent sealing substrate 1923. The recess EA1 may be formed by lithography.

For example, as depicted in a in Fig. 31, a transparent sealing substrate wafer 1923W is joined on the rear surface side of a semiconductor wafer 1921W through the transparent resin layer 1403. In this case, the semiconductor wafer 1921W is supported by a supporting substrate wafer 1911W.

Next, as depicted in b in Fig. 31, a resist pattern RP is formed on the transparent sealing substrate wafer 1923W by lithography. In the resist pattern RP, an opening portion KA is formed for each divided region 1901R. The opening portion KA may be disposed in the peripheral region RA for each divided region 1901R.

Next, as depicted in c in Fig. 31, with the resist pattern RP used as an etching mask, the transparent sealing substrate wafer 1923W is etched in the depth direction, and the recess EA1 is formed for each divided region 1901R in the transparent sealing substrate wafer 1923W. This etching may be reactive ion etching (RIE), for example.

Next, as depicted in a in Fig. 32, the resist pattern RP is removed from the transparent sealing substrate wafer 1923W by a method such as ashing.

Next, as depicted in b in Fig. 32, the joining layer 1951 is formed on the transparent sealing substrate wafer 1923W in which the recess EA1 is formed. The joining layer 1951 may be formed by coating of a transparent resin, or bonding of a transparent adhesive sheet.

Figs. 33 to 39 are sectional views depicting other examples of the configuration of the electronic device according to the nineteenth embodiment. Note that in Figs. 33 to 39, the joining layer 1951, the transparent sealing substrate 1923 and the transparent supporting substrate 1952 are excerpted from the configuration of Fig. 29.

In a in Fig. 33, an electronic device 1900A includes recesses EB1 and EB2 instead of the recesses EA1 and EA2 of the above-described electronic device 1900. In this case, the cross-sectional shape of the recesses EB1 and EB2 may be curved, and may be a semicircle, for example. Here, with the recesses EB1 and EB2 having a curved cross-sectional shape, the filling capability of the joining layer 1951 can be improved. Other configurations of the electronic device 1900A are the same as the configurations of the above-described electronic device 1900.

In b in Fig. 33, an electronic device 1900B is additionally provided with minute recesses EB1' and EB2' in the above-described electronic device 1900A. The minute recesses EB1' and EB2' may be provided at the recesses EB1 and EB2, or in regions other than the recesses EB1 and EB2. For example, in order to improve the joining strength, the minute recesses EB1' and EB2' may be provided at the entire joining surface of the transparent sealing substrate 1923 and the entire joining surface of the transparent supporting substrate 1952. In this case, the cross-sectional shape of the minute recesses EB1' and EB2' may be curved, and may be a semicircle, for example. Other configurations of the electronic device 1900B are the same as the configurations of the above-described electronic device 1900.

In a in Fig. 34, an electronic device 1900C includes intermediate resin layers EC1 and EC2 instead of the recesses EA1 and EA2 of the above-described electronic device 1900. The intermediate resin layers EC1 and EC2 are formed on the transparent sealing substrate 1923 and the transparent supporting substrate 1952, respectively. The intermediate resin layers EC1 and EC2 may be embedded in the joining layer 1951. The material of each intermediate resin layers EC1 and EC2 may be the same as or different from the material of the joining layer 1951. In this case, the material of the intermediate resin layers EC1 and EC2 preferably has optical properties similar to those of the joining layer 1951 in order to avoid an influence on optical properties. In this case, the refractive index of the intermediate resin layers EC1 and EC2 and the refractive index of the joining layer 1951 may be equal to each other. In order to improve the joining strength, the bonding strength of the intermediate resin layers EC1 and EC2 may be greater than the bonding strength of the joining layer 1951. Other configurations of the electronic device 1900C are the same as the configurations of the above-described electronic device 1900.

In b in Fig. 34, an electronic device 1900D includes rough surfaces ED1 and ED2 instead of the recesses EA1 and EA2 of the above-described electronic device 1900. In order to improve the joining strength, the rough surfaces ED1 and ED2 may be provided at the entire joining surface of the transparent sealing substrate 1923 and the entire joining surface of the transparent supporting substrate 1952. Other configurations of the electronic device 1900D are the same as the configurations of the above-described electronic device 1900.

In a in Fig. 35, an electronic device 1900E includes a recess EF instead of the recesses EA1 and EA2 of the above-described electronic device 1900. The recess EF may be formed at the joining surface of the transparent supporting substrate 1952. In this case, the recess EF may be disposed in the light-converging region RL of the optical chip P62 in order to reduce an influence on optical properties. Other configurations of the electronic device 1900E are the same as the configurations of the above-described electronic device 1900.

In b in Fig. 35, an electronic device 1900F includes a protrusion EG1 and a recess EG2 instead of the recesses EA1 and EA2 of the above-described electronic device 1900. The protrusion EG1 and the recess EG2 may be formed at the joining surface of the transparent sealing substrate 1923 and the joining surface of the transparent supporting substrate 1952, respectively. The protrusion EG1 can be inserted into the recess EG2 with a gap between the protrusion EG1 and the recess EG2. In this case, the transparent sealing substrate 1923 and the transparent supporting substrate 1952 may be positioned by self-alignment. Other configurations of the electronic device 1900F are the same as the configurations of the above-described electronic device 1900.

In a in Fig. 36, in an electronic device 1900G, the recess EA2 is eliminated in the above-described electronic device 1900. In this case, it is not necessary to form the recess EA2 in the transparent supporting substrate 1952, thereby reducing the number of processes. Other configurations of the electronic device 1900G are the same as the configurations of the above-described electronic device 1900.

In b in Fig. 36, in an electronic device 1900H, the recess EA1 is eliminated in the above-described electronic device 1900. In this case, it is not necessary to form the recess EA1 in the transparent sealing substrate 1923, thereby achieving reduction in the number of processes. Other configurations of the electronic device 1900H are the same as the configurations of the above-described electronic device 1900.

In a in Fig. 37, an electronic device 1900I includes a recess EH instead of the recesses EA1 and EA2 of the above-described electronic device 1900. The recess EH may be provided at the entire joining surface of the transparent supporting substrate 1952 in order to improve the joining strength. In this case, it is not necessary to form the recess EA1 in the transparent sealing substrate 1923, thereby achieving reduction in the number of processes. Other configurations of the electronic device 1900I are the same as the configurations of the above-described electronic device 1900.

In b in Fig. 37, an electronic device 1900J includes a recess ED2 instead of the recess EA2 of the above-described electronic device 1900. Here, by varying the shape, size, or position of the recesses between the transparent sealing substrate 1923 and the transparent supporting substrate 1952, optical properties can be compensated for while improving the joining strength. Other configurations of the electronic device 1900J are the same as the configurations of the above-described electronic device 1900.

In a in Fig. 38, an electronic device 1900K includes joining layers 1951A and 1951B instead of the joining layer 1951 of the above-described electronic device 1900. The joining layer 1951A is disposed at positions of the recesses EA1 and EA2, and the joining layer 1951B is disposed between the joining layers 1951A. The joining layers 1951A and 1951B may be formed with different materials. In this case, by varying the compositions of the joining layers 1951A and 1951B, the bonding force, Young's modulus, curing shrinkage rate, thermal shrinkage rate and the like can be controlled, thereby increasing the joining strength and preventing warpage. Other configurations of the electronic device 1900K are the same as the configurations of the above-described electronic device 1900.

In b in Fig. 38, an electronic device 1900L includes joining layers 1951C and 1951D instead of the joining layer 1951 of the above-described electronic device 1900. In addition, in the electronic device 1900L, the recess EA1 is eliminated in the above-described electronic device 1900. The joining layer 1951D is layered on the joining layer 1951C. In this case, by varying the compositions of the joining layers 1951C and 1951D, the bonding force, Young's modulus, curing shrinkage rate, thermal shrinkage rate and the like can be controlled, thereby increasing the joining strength and preventing warpage. Other configurations of the electronic device 1900L are the same as the configurations of the above-described electronic device 1900.

In a in Fig. 39, an electronic device 1900M is additionally provided with an optical filter layer 1965 in the above-described electronic device 1900. The optical filter layer 1965 is formed on the joining surface of the transparent supporting substrate 1952 so as to cover the side surface and bottom surface of the recess EA2. In this case, the joining layer 1951 is joined to the transparent supporting substrate 1952 through the optical filter layer 1965. The optical filter layer 1965 may be a dielectric multilayer film. Other configurations of the electronic device 1900M are the same as the configurations of the above-described electronic device 1900.

In b in Fig. 39, an electronic device 1900N is additionally provided with a cavity 1966 in the above-described electronic device 1900. The cavity 1966 may be formed in the transparent supporting substrate 1952. In this case, the cavity 1966 may be disposed in the light-converging region RL of the optical chip P62 in order to reduce an influence on optical properties. Other configurations of the electronic device 1900N are the same as the configurations of the above-described electronic device 1900.

In this manner, in the above-described nineteenth embodiment, the sensor chip P61 and the optical chip P62 where the joining surface including a plurality of surfaces is formed are joined through the joining layer 1951. As a result, the joining area of the joining surface of the sensor chip P61 and the optical chip P62 can be increased while suppressing an increase in the size of the electronic device 1900. Thus, size reduction of the electronic device 1900 can be achieved while suppressing a reduction in the reliability of the electronic device 1900.

### 20. Twentieth Embodiment

In the above-described first embodiment, the sensor chip P61 and the optical chip P62 where a joining surface including a plurality of surfaces is formed are joined through the joining layer 1951. In a twentieth embodiment, the number, size, shape, or orientation of recesses or protrusions provided at a joining surface of the sensor chip P61 and the optical chip P62 is varied.

Figs. 40 to 44 are plan views depicting configuration examples of electronic devices according to the twentieth embodiment.

Note that Figs. 40 to 44 depict an example in which a recess is formed at the transparent sealing substrate 1923, but a similar recess may be formed also at the transparent supporting substrate 1952. In addition, a protrusion may be formed at the transparent sealing substrate 1923 instead of forming a recess at the transparent sealing substrate 1923.

In a in Fig. 40, an electronic device 2000A includes a recess EA11. The recess EA11 may be disposed at the four corners of the joining surface of the transparent sealing substrate 1923. The recess EA11 may have a rectangular planar shape. Other configurations of the electronic device 2000A are the same as the configurations of the above-described electronic device 1900.

In b in Fig. 40, an electronic device 2000B includes a recess EA12. The recess EA12 may be disposed at both ends of the joining surface of the transparent sealing substrate 1923. In this case, the recess EA12 may be a groove traversing the transparent sealing substrate 1923. The recess EA12 may be disposed in the vertical direction or the lateral direction. Other configurations of the electronic device 2000B are the same as the configurations of the above-described electronic device 1900.

In a in Fig. 41, an electronic device 2000C includes a recess EA13. The recess EA13 may be disposed at a corner of the joining surface of the transparent sealing substrate 1923. In this case, the recess EA13 may be a groove obliquely traversing a corner of the transparent sealing substrate 1923. Other configurations of the electronic device 2000C are the same as the configurations of the above-described electronic device 1900.

In b in Fig. 41, an electronic device 2000D includes a recess EA14. The recess EA14 may be disposed at the entire joining surface of the transparent sealing substrate 1923 in order to improve the joining strength. In this case, the recess EA14 may be disposed in the pixel region RG and the peripheral region RA. For example, the recess EA14 may be a groove disposed at even intervals in the transparent sealing substrate 1923. The recess EA14 may be disposed in the vertical direction or the lateral direction. Other configurations of the electronic device 2000D are the same as the configurations of the above-described electronic device 1900.

In a in Fig. 42, an electronic device 2000E includes a recess EA15. The recess EA15 may be disposed at the entire joining surface of the transparent sealing substrate 1923 in order to improve the joining strength. In this case, the recess EA15 may be disposed in the pixel region RG and the peripheral region RA. The recess EA15 may be disposed in the vertical direction and the lateral direction. For example, the recess EA15 may be a groove disposed in a grid form. Other configurations of the electronic device 2000E are the same as the configurations of the above-described electronic device 1900.

In b in Fig. 42, an electronic device 2000F includes a recess EA16. The recess EA16 may be disposed at the joining surface of the transparent sealing substrate 1923 at a position overlapping the pixel region RG in order to avoid an influence on optical properties. In this case, the recess EA16 may have a rectangular planar shape. Other configurations of the electronic device 2000F are the same as the configurations of the above-described electronic device 1900.

In a in Fig. 43, an electronic device 2000G includes a recess EA17. The recess EA17 may be disposed along an end portion of the joining surface of the transparent sealing substrate 1923 in order to avoid an influence on optical properties. In this case, the planar shape of the recess EA17 may be set within a range surrounding the pixel region RG so as to be in contact with the end portion of the joining surface of the transparent sealing substrate 1923. Other configurations of the electronic device 2000G are the same as the configurations of the above-described electronic device 1900.

In b in Fig. 43, an electronic device 2000H includes a recess EA18. The recess EA18 may be disposed at the joining surface of the transparent sealing substrate 1923 along the peripheral region RB of the sensor chip P61 in order to avoid an influence on optical properties. In this case, the planar shape of the recess EA18 may be set within a range surrounded with the double line at the periphery of the pixel region RG. Other configurations of the electronic device 2000H are the same as the configurations of the above-described electronic device 1900.

In Fig. 44, an electronic device 2000I includes a recess EA19. The recess EA19 may be disposed at the joining surface of the transparent sealing substrate 1923 along the peripheral region RB of the sensor chip P61 in order to avoid an influence on optical properties. In addition, the recess EA19 is additionally provided with an extension portion TAB. The extension portion TAB extends to the end portion of the joining surface of the sealing substrate 1923. The extension portion TAB may be used to control the amount of resin fill supplied to the joining layer 1951. Other configurations of the electronic device 2000I are the same as the configurations of the above-described electronic device 1900.

In this manner, in the above-described twentieth embodiment, the number, size, shape, or orientation of recesses or protrusions provided at a joining surface of the sensor chip P61 and the optical chip P62 is varied. As a result, it is possible to prevent warpage and optimize the optical properties while adjusting the joining strength in accordance with the chip size.

### 21. Twenty-First Embodiment

In the above-described nineteenth embodiment, the sensor chip P61 and the optical chip P62 where the joining surface including a plurality of surfaces is formed are joined through the joining layer 1951, and the through electrode 1914 is formed in the sensor chip P61. In a twenty-first embodiment, a sensor chip and an optical chip where a joining surface including a plurality of surfaces is formed are joined through a joining layer, and a side contact is formed in a sensor chip.

Fig. 45 is a sectional view depicting a configuration example of an electronic device according to the twenty-first embodiment.

In Fig. 45, an electronic device 2000 includes a layered chip P20 instead of the layered chip P19 of the above-described nineteenth embodiment. The layered chip P20 includes a sensor chip P71 and an optical chip P72 instead of the sensor chip P61 and the optical chip P62 of the above-described nineteenth embodiment. The sensor chip P71 and the optical chip P72 are joined to each other through the joining layer 1951. Note that the chip size of the sensor chip P71 and the chip size of the optical chip P72 may be the same or different.

The sensor chip P71 includes a side wiring 2014 instead of the through electrode 1914 of the above-described nineteenth embodiment. The side wiring 2014 connects the rear surface wiring 1915 to the wiring 1941 through the side surface of the supporting substrate 1911. Other configurations of the layered chip P20 of the twenty-first embodiment are the same as the configurations of the layered chip P19 of the above-described nineteenth embodiment.

The optical chip P72 includes a supporting member 2004 instead of the supporting member 1954 of the above-described nineteenth embodiment. In addition, the optical chip P72 is additionally provided with optical filters 2001 and 2002 and a light-shielding film 2003 in the optical chip P62 of the above-described nineteenth embodiment.

The optical filter 2001 is formed on the transparent supporting substrate 1952. The optical filter 2001 can attenuate unnecessary wavelength components.

The supporting member 2004 supports the substrate 1953' over the transparent supporting substrate 1952 such that the lens 1953 is separated from the optical filter 2001. The supporting member 2004 may be disposed in the peripheral region RB of the optical chip P72. The inner peripheral surface of the supporting member 2004 may be inclined.

The light-shielding film 2003 is formed on the transparent supporting substrate 1961. The light-shielding film 2003 may be disposed in the peripheral region RB of the optical chip P72. The material of the light-shielding film 2003 may be a black resin, or a metal such as Cr.

The optical filter 2002 is formed on the transparent supporting substrate 1961 so as to cover the light-shielding film 2003. The optical filter 2002 can attenuate unnecessary wavelength components.

Fig. 46 is a sectional view depicting an example of a manufacturing method for an electronic device according to the twenty-first embodiment.

As depicted in a in the drawing, the supporting member 2004, on which a transparent supporting substrate wafer 1955W is joined, is joined to a substrate 1953'. In this joining, an adhesive agent may be used. In addition, the joining layer 1951 is formed on the transparent sealing substrate wafer 1923W where the recess EA1 is formed for each divided region 1901R. Note that the side wiring 2014 may be embedded in the supporting substrate wafer 1911W, or may be formed in the side surface of the sensor chip P71 after the sensor chip P71 is singulated. A molded interconnect device (MID) method or 3D printing may be used to form the side wiring 2014 at the side surface of the sensor chip P71.

Next, as depicted in b in the drawing, the transparent sealing substrate wafer 1923W and a transparent supporting substrate wafer 1952W are joined through the joining layer 1951.

Next, as depicted in Fig. 45, the layered wafer joined through the joining layer 1951 is cut, and singulated for each layered chip P21. In this cutting of the layered wafer, blade dicing or by using a laser cutter may be used.

In this manner, in the above-described twenty-first embodiment, the sensor chip P71 and the optical chip P72 where the joining surface including a plurality of surfaces is formed are joined through the joining layer 1951, and the side contact is formed in the sensor chip P71. As a result, the sensor chip P71 can made to contact the outside while eliminating the need to form the through electrode 1914, and the joining strength of the sensor chip P71 and the optical chip P72 can be increased while suppressing an increase in the size of the electronic device 2000.

### 22. Twenty-Second Embodiment

In the above-described nineteenth embodiment, the sensor chip P61 and the optical chip P62 where the joining surface including a plurality of surfaces is formed are joined through the joining layer 1951. In a twenty-second embodiment, a sensor chip and an optical chip are directly joined through a joining surface including a plurality of surfaces.

Fig. 47 is a sectional view depicting a configuration example of an electronic device according to the twenty-second embodiment.

In the drawing, an electronic device 2200 includes a layered chip P22 instead of the layered chip P19 of the above-described nineteenth embodiment. The layered chip P22 includes a sensor chip P81 and an optical chip P82 instead of the sensor chip P61 and the optical chip P62 of the above-described nineteenth embodiment.

The sensor chip P81 includes a protrusion PA1 instead of the recess EA1 of the above-described nineteenth embodiment. The optical chip P82 includes a recess PA2 instead of the recess EA2 of the above-described nineteenth embodiment. The protrusion PA1 can be inserted into the recess PA2. In this case, the position from the side surface of the layered chip P22 to the protrusion PA1 and the position from the side surface of the layered chip P22 to the recess PA2 may be equal to each other. Here, the sensor chip P81 and the optical chip P82 are directly joined, with the protrusion PA1 inserted in the recess PA2. Other configurations of the layered chip P22 of the twenty-second embodiment are the same as the configurations of the layered chip P19 of the above-described nineteenth embodiment.

In the direct joining of the sensor chip P81 and the optical chip P82, pressure joining may be used. In this pressure joining, for example, the joining may be carried out at a temperature of 250 °C or lower with the joining surface activated by plasma. In this plasma activation, SiO2 can be contained in the joining surface. In this case, oxygen plasma or nitrogen plasma may be applied to the joining surface to perform a hydrophilic treatment of the joining surface. Further, the joining surfaces may be brought into intimate contact with each other by hydrogen bonding between OH groups formed on the joining surface by adsorption of moisture in the air. Further, thermal treatment decomposes the OH groups and diffuses the generated hydrogen into the interfacial layer, thereby enabling direct joining based on Si-O-Si bonds mediated by oxygen. Here, by performing plasma activation of the joining surface before the thermal treatment, the moisture adsorption of the joining surface can be improved, and even with thermal treatment at a temperature of 250 °C or lower, joining strength sufficient to ensure the reliability of the solid imaging device can be obtained.

In this manner, in the above-described twenty-second embodiment, the sensor chip P81 and the optical chip P82 are directly joined, with the protrusion PA1 inserted in the recess PA2. As a result, the joining strength of the sensor chip P81 and the optical chip P82 can be improved while relaxing limitations such as the temperature resistance and light transmittance of the joining surface of the sensor chip P81 and the optical chip P82.

### 23. Twenty-Third Embodiment

In the above-described nineteenth embodiment, the sensor chip P61 and the optical chip P62 where the joining surface including a plurality of surfaces is formed are joined through the joining layer 1951. In a twenty-third embodiment, a recess having an internal vacuum is provided at each of a joining surface of a sensor chip and a joining surface of an optical chip.

Fig. 48 is a sectional view depicting a configuration example of an electronic device according to the twenty-third embodiment.

In the drawing, an electronic device 2300 includes a layered chip P23 instead of the layered chip P19 of the above-described nineteenth embodiment. The layered chip P23 includes a sensor chip P91 and an optical chip P92 instead of the sensor chip P61 and the optical chip P62 of the above-described nineteenth embodiment.

The sensor chip P91 includes a recess HA1 instead of the recess EA1 of the above-described nineteenth embodiment. The optical chip P92 includes a recess HA2 instead of the recess EA2 of the above-described nineteenth embodiment. A through hole HA3 is formed in the bonding layer 103. The position of the through hole HA3 in the horizontal direction may be set to coincide with the position of the recess HA1 in the horizontal direction. The recesses HA1 and HA2 and the through hole HA3 may have the same configurations as those of the recesses 111 and 112 and the through hole 113 of the above-described first embodiment, respectively.

The insides of the recesses HA1 and HA2 and the inside of the through hole HA3 are hollowed. In this case, the pressure inside the recesses HA1 and HA2 and the through hole HA3 may be set lower than atmospheric pressure. For example, the pressure inside the recesses HA1 and HA2 and the through hole HA3 may be 1 × 10⁻⁵ Pa or less. In this case, the components inside the recesses HA1 and HA2 and the through hole HA3 may be the same as or different from the components exposed to the atmosphere. The insides of the recesses HA1 and HA2 and the inside of the through hole HA3 may be filled with gas such as O₃.

In this manner, in the above-described twenty-third embodiment, the recesses HA1 and HA2 having an internal vacuum are provided at the joining surface of the sensor chip P91 and the joining surface of the optical chip P92, respectively. As a result, conduction of the heat generated at the periphery of the sensor chip P91 and the optical chip P92 can be suppressed at the position of the recesses HA1 and HA2, thereby making it difficult for heat to be transmitted to the pixel region RG. Thus, thermal damage to the pixel region RG can be suppressed, and alteration of the color filter 104 and the on-chip lens 105 can be prevented.

In addition, by maintaining the insides of the recesses HA1 and HA2 in a vacuum or under low pressure, the optical chip P92 can be pressed against the sensor chip P91 by atmospheric pressure. Thus, the joining strength of the optical chip P92 and the sensor chip P91 can be improved, and the reliability of the electronic device 2300 can be ensured while reducing the chip size.

### 24. Twenty-Fourth Embodiment

In the above-described nineteenth embodiment, the sensor chip P61 and the optical chip P62 where the joining surface including a plurality of surfaces is formed are joined through the joining layer 1951. In a twenty-fourth embodiment, a recess is provided at a joining surface of a transparent sealing substrate of a sensor chip.

Fig. 49 is a sectional view depicting a configuration example of an electronic device according to the twenty-fourth embodiment.

In the drawing, an electronic device 2400 includes a layered chip P24 instead of the layered chip P19 of the above-described nineteenth embodiment. The layered chip P24 includes a sensor chip P101 instead of the sensor chip P61 of the above-described nineteenth embodiment.

The sensor chip P101 includes a transparent sealing substrate 2023 instead of the transparent sealing substrate 1923 of the above-described nineteenth embodiment. The transparent sealing substrate 2023 is additionally provided with a recess TA at the transparent sealing substrate 1923 of the above-described nineteenth embodiment. The recess TA is formed at the bonding surface of the transparent resin layer 1403. The recess TA may be disposed in the peripheral region RA such that the optical properties of the pixel region RG are not affected. The transparent resin layer 1403 may penetrate into the recess TA when the transparent sealing substrate 2023 is joined to the semiconductor substrate 1921 through the transparent resin layer 1403. Other configurations of the sensor chip P101 are the same as the configurations of the sensor chip P61 of the above-described nineteenth embodiment.

In this manner, in the above-described twenty-fourth embodiment, the recess TA is provided at the joining surface of the transparent sealing substrate 2023 of the sensor chip P101. As a result, the joining area of the transparent sealing substrate 2023 can be increased, and the joining strength of the transparent sealing substrate 2023 can be improved without increasing the chip size of the sensor chip P101.

Note that the configuration in which the recess TA is provided at the joining surface of the transparent sealing substrate 2023 of the sensor chip P101 may be applied to any of the electronic devices of the above-described nineteenth to twenty-third embodiments.

### 25. Twenty-Fifth Embodiment

In the above-described nineteenth embodiment, the sensor chip P61 and the optical chip P62 where the joining surface including a plurality of surfaces is formed are joined through the joining layer 1951. In a twenty-fifth embodiment, a recess is provided at a support surface of a transparent supporting substrate of an optical chip.

Fig. 50 is a sectional view depicting a configuration example of an electronic device according to the twenty-fifth embodiment.

In the drawing, an electronic device 2500 includes a layered chip P25 instead of the layered chip P19 of the above-described nineteenth embodiment. The layered chip P25 includes an optical chip P112 instead of the optical chip P62 of the above-described nineteenth embodiment.

The optical chip P112 includes a transparent supporting substrate 2052 and a supporting member 2054 instead of the transparent supporting substrate 1952 and the supporting member 1954 of the above-described nineteenth embodiment. The transparent supporting substrate 2052 is additionally provided with a recess TB in the transparent supporting substrate 1952 of the above-described nineteenth embodiment. The recess TB is formed at the support surface of the transparent supporting substrate 2052. The recess TB may be disposed at a position where a protrusion TC of the supporting member 2054 can be inserted.

The supporting member 2054 is additionally provided with the protrusion TC at the supporting member 1954 of the above-described nineteenth embodiment. The protrusion TC is formed at the joining surface with the transparent supporting substrate 2052. The protrusion TC can be inserted into the recess TB. Other configurations of the optical chip P112 are the same as the configurations of the optical chip P62 of the above-described nineteenth embodiment.

In this manner, in the above-described twenty-fourth embodiment, the recess TB is provided at the support surface of the transparent supporting substrate 2052 of the optical chip P112, and the protrusion TC that can be inserted into the recess TB is provided at the supporting member 2054. As a result, the joining area of the support surface of the transparent supporting substrate 2052 can be increased, and the joining strength of the support surface of the transparent supporting substrate 2052 can be improved without increasing the chip size of the optical chip P112.

Note that the configuration in which the recess TB is provided at the support surface of the transparent supporting substrate 2052 of the optical chip P112 can be applied to any of the electronic devices of the above-described nineteenth to twenty-fourth embodiments.

### 26. Twenty-Sixth Embodiment

In the above-described nineteenth embodiment, the chip size of the sensor chip P61 is equal to the chip size of the optical chip P62. In a twenty-sixth embodiment, the chip size of an optical chip is made smaller than the chip size of the sensor chip P61.

Fig. 51 is a sectional view depicting a configuration example of an electronic device according to the twenty-sixth embodiment.

In the drawing, an electronic device 2600 includes a layered chip P26 instead of the layered chip P19 of the above-described nineteenth embodiment. The layered chip P26 includes an optical chip P122 instead of the optical chip P62 of the above-described nineteenth embodiment.

The chip size of the optical chip P122 is smaller than the chip size of the sensor chip P61. In this case, the position of the end portion of the sensor chip P61 in the horizontal direction may be protruded to the outside from the position of the end portion of the optical chip P122 in the horizontal direction. Other configurations of the optical chip P122 are the same as the configurations of the optical chip P62 of the above-described nineteenth embodiment.

In this manner, in the above-described twenty-sixth embodiment, the chip size of the optical chip P122 is made smaller than the chip size of the sensor chip P61. As a result, the dicing for cutting out the sensor chip P61 and the dicing for cutting out the optical chip P122 can be separately performed. Thus, the limitation on the chip thickness of the layered chip P26 in the dicing can be relaxed.

### 27. Twenty-Seventh Embodiment

In the above-described twenty-sixth embodiment, the chip size of the optical chip P122 is made smaller than the chip size of the sensor chip P61. In a twenty-seventh embodiment, the chip size of the optical chip P122 is made smaller than the chip size of the sensor chip P61 such that the joining layer 1951 protrudes from the side surface of the optical chip P122.

Fig. 52 is a sectional view depicting a configuration example of an electronic device according to the twenty-seventh embodiment.

In the drawing, an electronic device 2700 includes a layered chip P27 instead of the layered chip P19 of the above-described nineteenth embodiment. The layered chip P27 includes the sensor chip P61 and the optical chip P122. The sensor chip P61 is joined to the optical chip P122 through the joining layer 1951. In this case, the joining layer 1951 can protrude from the side surface of the transparent supporting substrate 1952. For example, the joining layer 1951 may extend up along the side surface of the transparent supporting substrate 1952.

In this manner, in the above-described twenty-seventh embodiment, the chip size of the optical chip P122 is made smaller than the chip size of the sensor chip P61 such that the joining layer 1951 protrudes from the side surface of the optical chip P122. As a result, the joining strength of the sensor chip P61 and the optical chip P122 can be increased while relaxing the limitation on the chip thickness of the layered chip P27 in the dicing.

### 28. Twenty-Eighth Embodiment

In the above-described nineteenth embodiment, the sensor chip P61 and the optical chip P62 where the joining surface including a plurality of surfaces is formed are joined through the joining layer 1951. In a twenty-eighth embodiment, in a transparent substrate joined to a sensor chip through the transparent resin layer 1403, the wettability of the opposing region of the sensor chip facing the pixel region RG is made higher than the wettability of an adjacent region adjacent to the opposing region.

Fig. 53 is a diagram depicting a configuration example of an electronic device according to the twenty-eighth embodiment. Note that a in the drawing is a sectional view depicting a configuration example of an electronic device 2800 taken along the vertical direction, and b in the drawing is a plan view depicting a configuration example of a transparent substrate 2801. In a in the drawing, a configuration taken along the line A1-A2 in b in the drawing is depicted.

In the drawing, an electronic device 2800 includes a layered chip P280. The layered chip P280 includes a sensor chip SCP and the transparent substrate 2801. The transparent substrate 2801 is layered on the sensor chip SCP through the transparent resin layer 1403. Here, the transparent substrate 2801 is diced into a chip so as to have a size equivalent to that of the sensor chip SCP. In this case, the position of the end portion of the transparent substrate 2801 in the horizontal direction may be set to coincide with the position of the end portion of the sensor chip SCP in the horizontal direction. As a result, the layered chip P280 can configure a WLCSP packaged at the wafer level.

In the sensor chip SCP, the transparent sealing substrate 1923 is eliminated in the sensor chip P61 of the above-described nineteenth embodiment. Other configurations of the electronic device 2800 are the same as the configurations of the sensor chip P61 of the above-described nineteenth embodiment.

The transparent substrate 2801 includes a plurality of surfaces having different wettabilities. The transparent substrate 2801 includes an opposing region RK and an adjacent region RS. The opposing region RK faces the pixel region RG of the sensor chip SCP. The adjacent region RS is adjacent to the opposing region RK. The adjacent region RS may be disposed at the periphery of the opposing region RK. The wettability of the opposing region RK is higher than the wettability of the adjacent region RS. A deposited film layer 2802 may be formed in the opposing region RK in order to make the wettability of the opposing region RK higher than the wettability of the adjacent region RS. In this case, the wettability of the surface of the deposited film layer 2802 is higher than the wettability of the surface of the transparent substrate 2801. For example, in the case where the material of the transparent substrate 2801 is glass, the material of the deposited film layer 2802 may be SiO₂ or SiN. In this case, by controlling the deposition conditions or composition of SiO₂ or SiN, the wettability of SiO₂ or SiN can be set higher than the wettability of glass.

Fig. 54 is a diagram depicting an example of a manufacturing method for the electronic device according to the twenty-eighth embodiment.

In a in the drawing, a divided region 2801R is provided in a transparent substrate wafer 2801W. The transparent substrate 2801 is cut out from each divided region 2801R. Each divided region 2801R is defined along a scribe line 2801D.

In b in the drawing, a divided region 2800R is provided in a semiconductor wafer 2800W. The sensor chip SCP is cut out from each divided region 2800R. Each divided region 2800R is defined along a scribe line 2800D. In each divided region 2800R, a solid-state imaging element is formed.

The transparent substrate wafer 2801W is layered on the semiconductor wafer 2800W. In this case, the transparent resin layer 1403 is formed at the entire surface on the semiconductor wafer 2800W. The transparent resin layer 1403 may be formed by coating, printing, spin coating, or potting. Further, the transparent substrate wafer 2801W is fixed on the semiconductor wafer 2800W through the transparent resin layer 1403.

After layering the transparent substrate wafer 2801W on the semiconductor wafer 2800W, the protruding electrode 1916 may be formed at the semiconductor wafer 2800W on the rear surface side. Thereafter, the layered wafer of the semiconductor wafer 2800W and the transparent substrate wafer 2801W is cut along the scribe lines 2800D and 2801D, thereby cutting out the layered chip P280.

Fig. 55 is a diagram depicting an example of a manufacturing method for the electronic device according to the twenty-eighth embodiment. Note that a in the drawing is a plan view depicting an example of a manufacturing method for the electronic device 2800, and b and c in the drawing are sectional views depicting examples of a manufacturing method for the electronic device 2800. It should be noted that in the drawing, a joining step of the semiconductor wafer 2800W and the transparent substrate wafer 2801W is depicted in an excerpted manner. In addition, a in the drawing depicts 2 × 2 divided regions 2801R of the transparent substrate wafer 2801W, and b and c in the drawing depict two divided regions 2800R and 2801R adjacent to each other.

In a in the drawing, the deposited film layer 2802 is formed for each divided region 2801R.

In addition, as depicted in b in the drawing, a light reception layer 2803 is provided for each divided region 2800R on the semiconductor wafer 2800W. Each light reception layer 2803 may be disposed in the pixel region RG. In this case, in each light reception layer 2803, pixels are disposed in a matrix in the row direction and the column direction. Further, the transparent substrate wafer 2801W is layered on the semiconductor wafer 2800W through the transparent resin layer 1403.

Here, as depicted in c in the drawing, the surface of the deposited film layer 2802 has a higher wettability than that of the surface of the transparent substrate wafer 2801W, and therefore the transparent resin layer 1403 spreads over the deposited film layer 2802. In this case, the void VOD is expelled from between the deposited film layer 2802 and the transparent resin layer 1403. Thus, the void VOD can be moved between the deposited film layers 2802 to eliminate the void VOD on the light reception layer 2803.

Fig. 56 is a sectional view depicting an example of a manufacturing method for the electronic device according to the twenty-eighth embodiment.

In a in the drawing, the deposited film layer 2802 is formed on the transparent substrate wafer 2801W by a method such as coating, CVD or sputtering.

Next, as depicted in b in the drawing, a resist pattern RPA is formed by lithography technology. The resist pattern RPA can be separated for each divided region 2800R such that the opposing region RK is covered.

Next, as depicted in c in the drawing, with the resist pattern RPA used as an etching mask, the deposited film layer 2802 is etched and separated for each divided region 2800R. Then, the resist pattern RPA is removed by a method such as ashing.

Fig. 57 is a sectional view depicting another example of the manufacturing method for the electronic device according to the twenty-eighth embodiment.

In a in the drawing, the deposited film layer 2802' is formed on the transparent substrate wafer 2801W by a method such as coating, CVD or sputtering. A photosensitive material may be used for the deposited film layer 2802'.

Next, as depicted in b in the drawing, exposure and development of the deposited film layer 2802' are performed to pattern the deposited film layer 2802'. In this case, the deposited film layer 2802' can be separated for each divided region 2800R such that the opposing region RK is covered.

Fig. 58 is a sectional view depicting still another example of the manufacturing method for the electronic device according to the twenty-eighth embodiment.

In the drawing, a deposition material 2802Z is discharged from a nozzle NZL by an inkjet method to form a deposited film layer 2802'' on the transparent substrate wafer 2801W. In this case, the deposited film layer 2802'' can be separated for each divided region 2800R such that the opposing region RK is covered.

Fig. 59 is a plan view depicting another configuration example of the electronic device according to the twenty-eighth embodiment. Note that the drawing depicts 3 × 3 divided regions 2801R in the transparent substrate wafer 2801W.

In a in the drawing, on a transparent substrate wafer 2805W, a deposited film layer 2805 is formed such that the opposing region RK of each divided region 2801R is covered. In this case, in the vertical direction of the transparent substrate wafer 2805W, the deposited film layer 2805 is separated for every three divided regions 2801R. In the lateral direction of the transparent substrate wafer 2805W, the deposited film layer 2805 is separated for each divided region 2801R.

In b in the drawing, a deposited film layer 2806 is formed on a transparent substrate wafer 2806W such that the opposing region RK of each divided region 2801R is covered. In this case, in the lateral direction of the transparent substrate wafer 2806W, the deposited film layer 2806 is separated for every three divided regions 2801R. In the vertical direction of the transparent substrate wafer 2806W, the deposited film layer 2806 is separated for each divided region 2801R.

Note that while Fig. 59 depicts an example in which the deposited film layer is separated for every three divided regions 2801R in the vertical direction or lateral direction of the transparent substrate wafers 2805W and 2806W, the deposited film layer may be separated for every two or more divided regions 2801R in the vertical direction or lateral direction of the transparent substrate wafers 2805W and 2806W.

Fig. 60 is a sectional view depicting still another configuration example of the electronic device according to the twenty-eighth embodiment.

In a in the drawing, an electronic device 2810 includes a layered chip P281. The layered chip P281 includes a transparent substrate 2811 instead of the transparent substrate 2801 of Fig. 53. Other configurations of the layered chip P281 are the same as the configurations of the layered chip P280 of Fig. 53.

The transparent substrate 2811 includes an ion-implanted layer 2812 instead of the deposited film layer 2802 of Fig. 53. Other configurations of the transparent substrate 2811 are the same as the configurations of the transparent substrate 2801 of Fig. 53.

The ion-implanted layer 2812 is formed at the position of the opposing region RK of the transparent substrate 2811. The wettability of the surface of the ion-implanted layer 2812 is higher than the wettability of the surface of the adjacent region RS of the transparent substrate 2811. In this case, the surface of the ion-implanted layer 2812 can have improved hydrophilicity compared to the surface of the transparent substrate 2811.

In b in the drawing, an electronic device 2820 includes a layered chip P282. The layered chip P282 includes a transparent substrate 2821 instead of the transparent substrate 2801 of Fig. 53. Other configurations of the layered chip P282 are the same as the configurations of the layered chip P280 of Fig. 53.

The transparent substrate 2821 includes a surface modification layer 2822 instead of the deposited film layer 2802 of Fig. 53. Other configurations of the transparent substrate 2821 are the same as the configurations of the transparent substrate 2801 of Fig. 53.

The surface modification layer 2822 is formed at the position of the opposing region RK of the transparent substrate 2821. The wettability of the surface of the surface modification layer 2822 is higher than the wettability of the surface of the adjacent region RS of the transparent substrate 2821. In this case, the surface of the surface modification layer 2822 can have improved hydrophilicity compared to the surface of the transparent substrate 2821. The surface modification layer 2822 can, for example, bond a hydrophilic element to the dangling bonds on the surface of the transparent substrate 2821.

In this manner, in the above-described twenty-eighth embodiment, the wettability of the opposing region RK of the transparent substrate 2801 joined to the sensor chip SCP through the transparent resin layer 1403 is made higher than the wettability of the adjacent region RS. As a result, the void VOD generated at the transparent resin layer 1403 during the joining of the sensor chip SCP and the transparent substrate 2801 can be expelled from above the pixel region RG, thereby reducing pixel defects due to the void VOD.

### 29. Twenty-Ninth Embodiment

In the above-described twenty-eighth embodiment, the wettability of the opposing region RK of the transparent substrate 2801 joined to the sensor chip SCP through the transparent resin layer 1403 is made higher than the wettability of the adjacent region RS. In a twenty-ninth embodiment, the wettability of the adjacent region RS of the transparent substrate 2801 joined to the sensor chip SCP through the transparent resin layer 1403 is made lower than the wettability of the opposing region RK.

Fig. 61 is a diagram depicting a configuration example of an electronic device according to the twenty-ninth embodiment. Note that a in the drawing is a sectional view depicting a configuration example of an electronic device 2900 taken along the vertical direction, and b in the drawing is a plan view depicting a configuration example of a transparent substrate 2901. In a in the drawing, a configuration taken along the line A1-A2 in b in the drawing is depicted.

In the drawing, an electronic device 2900 includes a layered chip P290 instead of the layered chip P280 of the above-described twenty-eighth embodiment. The layered chip P290 includes the transparent substrate 2901 instead of the transparent substrate 2801 of the above-described twenty-eighth embodiment. Other configurations of the layered chip P290 are the same as the configurations of the layered chip P280 of the above-described twenty-eighth embodiment.

The transparent substrate 2901 includes a deposited film layer 2902 instead of the deposited film layer 2802 of the above-described twenty-eighth embodiment. Other configurations of the transparent substrate 2901 are the same as the configurations of the transparent substrate 2801 of the above-described twenty-eighth embodiment.

The deposited film layer 2902 is formed at the position of the adjacent region RS of the transparent substrate 2901. The wettability of the surface of the deposited film layer 2902 is lower than the wettability of the surface of the opposing region RK of the transparent substrate 2901. In this case, the surface of the deposited film layer 2902 can have improved hydrophobicity compared to the surface of the transparent substrate 2901. The deposited film layer 2902 may be formed by fluorine coating, for example.

Fig. 62 is a sectional view depicting another configuration example of the electronic device according to the twenty-ninth embodiment.

In a in the drawing, an electronic device 2910 includes a layered chip P291. The layered chip P291 includes a transparent substrate 2911 instead of the transparent substrate 2901 of Fig. 61. Other configurations of the layered chip P291 are the same as the configurations of the layered chip P290 of Fig. 61.

The transparent substrate 2911 includes an ion-implanted layer 2912 instead of the deposited film layer 2902 of Fig. 61. Other configurations of the transparent substrate 2911 are the same as the configurations of the transparent substrate 2901 of Fig. 61.

The ion-implanted layer 2912 is formed at the position of the adjacent region RS of the transparent substrate 2911. The wettability of the surface of the ion-implanted layer 2912 is lower than the wettability of the surface of the opposing region RK of the transparent substrate 2911. In this case, the surface of the ion-implanted layer 2912 can have improved hydrophobicity compared to the surface of the transparent substrate 2911. To improve the hydrophobicity of the ion-implanted layer 2912, ions such as N or C may be implanted.

In b in the drawing, an electronic device 2920 includes a layered chip P292. The layered chip P292 includes a transparent substrate 2921 instead of the transparent substrate 2801 of Fig. 61. Other configurations of the layered chip P292 are the same as the configurations of the layered chip P290 of Fig. 61.

The transparent substrate 2921 includes a surface modification layer 2922 instead of the deposited film layer 2902 of Fig. 61. Other configurations of the transparent substrate 2921 are the same as the configurations of the transparent substrate 2901 of Fig. 61.

The surface modification layer 2922 is formed at the position of the adjacent region RS of the transparent substrate 2921. The wettability of the surface of the surface modification layer 2922 is lower than the wettability of the surface of the opposing region RK of the transparent substrate 2921. In this case, the surface of the surface modification layer 2922 can have improved hydrophobicity compared to the surface of the transparent substrate 2921. The surface modification layer 2922 can, for example, bond a hydrophobic element such as H to the dangling bonds on the surface of the transparent substrate 2921.

In c in the drawing, an electronic device 2930 includes a layered chip P293. The layered chip P293 includes a transparent substrate 2931 instead of the transparent substrate 2801 of Fig. 61. Other configurations of the layered chip P293 are the same as the configurations of the layered chip P290 of Fig. 61.

The transparent substrate 2931 includes a rough surface layer 2932 instead of the deposited film layer 2902 of Fig. 61. Other configurations of the transparent substrate 2931 are the same as the configurations of the transparent substrate 2901 of Fig. 61.

The rough surface layer 2932 is formed at the position of the adjacent region RS of the transparent substrate 2931. The wettability of the surface of the rough surface layer 2932 is lower than the wettability of the surface of the opposing region RK of the transparent substrate 2931. In this case, the surface of the rough surface layer 2932 can have improved hydrophobicity compared to the surface of the transparent substrate 2931. The rough surface layer 2932 may be formed, for example, by a method such as sandblasting. In this case, the roughness of the rough surface layer 2932 may be adjusted by controlling the particle size and kinetic energy of the particles used in the sandblasting.

Fig. 63 is a plan view depicting still another configuration example of the electronic device according to the twenty-ninth embodiment. Note that the drawing depicts 3 × 3 divided regions 2801R in the transparent substrate wafer 2801W.

In a in the drawing, a deposited film layer 2905 is formed on a transparent substrate wafer 2905W such that adjacent region RS of each divided region 2801R is covered. In this case, in the vertical direction of the transparent substrate wafer 2905W, the deposited film layer 2905 is formed such that three divided regions 2801R are continuous. In the lateral direction of the transparent substrate wafer 2805W, the deposited film layer 2905 is formed such that each divided region 2801R is separated.

In b in the drawing, on a transparent substrate wafer 2906W, a deposited film layer 2906 is formed such that the adjacent region RS of each divided region 2801R is covered. In this case, in the lateral direction of the transparent substrate wafer 2906W, the deposited film layer 2906 is formed such that three divided regions 2801R are continuous. In the vertical direction of the transparent substrate wafer 2806W, the deposited film layer 2906 is formed such that each divided region 2801R is separated.

Note that while Fig. 59 depicts an example in which the deposited film layer is formed such that three divided regions 2801R are continuous in the vertical direction or lateral direction of the transparent substrate wafers 2805W and 2806W, the deposited film layer may be formed such that two or more divided regions 2801R are continuous in the vertical direction or lateral direction of the transparent substrate wafers 2805W and 2806W.

In this manner, in the above-described twenty-ninth embodiment, the wettability of the adjacent region RS of the transparent substrate 2801 joined to the sensor chip SCP through the transparent resin layer 1403 is made lower than the wettability of the opposing region RK. As a result, the void VOD generated at the transparent resin layer 1403 during the joining of the sensor chip SCP and the transparent substrate 2801 can be expelled from above the pixel region RG without affecting the optical properties of the pixel region RG of the sensor chip SCP.

### 30. Thirtieth Embodiment

In the above-described twenty-eighth embodiment, the wettability of the opposing region RK of the transparent substrate 2801 joined to the sensor chip SCP through the transparent resin layer 1403 is made higher than the wettability of the adjacent region RS. In a thirtieth embodiment, the wettability of the pixel region RG of the sensor chip SCP joined to the transparent substrate 2801 through the transparent resin layer 1403 is made higher than the wettability of adjacent region RA adjacent to the pixel region RG.

Fig. 64 is a diagram depicting a configuration example of an electronic device according to the thirtieth embodiment. Note that a in the drawing is a sectional view depicting a configuration example of an electronic device 3000 taken along the vertical direction, and b in the drawing is a plan view depicting a configuration example of a planarizing layer 3001 of a sensor chip SCI. In a in the drawing, a configuration taken along the line A1-A2 in b in the drawing is depicted.

In the drawing, an electronic device 3000 includes a layered chip P30. The layered chip P30 includes the sensor chip SCI instead of the sensor chip SCP of the above-described twenty-eighth embodiment. Other configurations of the layered chip P30 are the same as the configurations of the layered chip P280 of the above-described twenty-eighth embodiment.

The sensor chip SCI is additionally provided with the planarizing layer 3001 and a deposited film layer 3002 in the sensor chip SCP of the above-described twenty-eighth embodiment. Other configurations of the sensor chip SCI are the same as the configurations of the sensor chip SCP of the above-described twenty-eighth embodiment.

The planarizing layer 3001 planarizes the rear surface side of the sensor chip SCI. The planarizing layer 3001 is formed on the semiconductor substrate 1921 such that the on-chip lens 105 is covered. The refractive index of the planarizing layer 3001 is set such that the light-converging function of the on-chip lens 105 is not impaired. The material of the planarizing layer 3001 may be SiO₂, SiN or SiCN, for example.

The deposited film layer 3002 is formed at the position of the pixel region RG of the sensor chip SCI. The wettability of the surface of the deposited film layer 3002 is higher than the wettability of the surface of the adjacent region RS of the planarizing layer 3001. In this case, the surface of the deposited film layer 3002 can have improved hydrophilicity compared to the surface of the planarizing layer 3001. The material of the deposited film layer 3002 may be inorganic materials such as SiO₂ and SiN or transparent an organic material.

In this manner, in the above-described thirtieth embodiment, the wettability of the pixel region RG of the sensor chip SCI joined to the transparent substrate 2801 through the transparent resin layer 1403 is made higher than the wettability of adjacent region RA. As a result, the void VOD generated at the transparent resin layer 1403 during the joining of the sensor chip SCI and the transparent substrate 2801 can be expelled from the pixel region RG.

Note that the above-described thirtieth embodiment describes an example in which the deposited film layer 3002 is formed in the pixel region RG of the planarizing layer 3001. As in the above-described twenty-eighth embodiment, in the pixel region RG of the planarizing layer 3001, an ion-implanted layer may be formed, or a surface modification layer may be formed. Alternatively, as in the above-described twenty-ninth embodiment, in the adjacent region RS of the planarizing layer 3001, an ion-implanted layer may be formed, a surface modification layer may be formed, or a rough surface layer may be formed.

### 31. Thirty-First Embodiment

In the above-described thirtieth embodiment, the wettability of the pixel region RG of the sensor chip SCI joined to the transparent substrate 2801 through the transparent resin layer 1403 is made higher than the wettability of adjacent region RA. In a thirty-first embodiment, the wettability of the pixel region RG of the sensor chip SCI where the pixel region RG is sealed with a transparent resin layer is made higher than the wettability of adjacent region RA.

Fig. 65 is a sectional view depicting a configuration example of an electronic device according to the thirty-first embodiment.

In the drawing, an electronic device 3100 includes a transparent resin layer 3101 instead of the transparent resin layer 1403 of the above-described thirtieth embodiment. In addition, in the electronic device 3100, the transparent substrate 2801 is eliminated in the layered chip P30 of the above-described thirtieth embodiment. In this case, the electronic device 3100 may have a glassless configuration to seal the rear surface side of the sensor chip SCI. Other configurations of the electronic device 3100 are the same as the configurations of the electronic device 3000 of the above-described thirtieth embodiment.

The transparent resin layer 3101 seals the rear surface side of the sensor chip SCI. The material of the transparent resin layer 3101 may be transparent resins such as a siloxane resin, an acrylic resin, and an epoxy resin. The transparent resin layer 3101 may contain a filler made of an inorganic or organic material to improve reliability.

In this manner, in the above-described thirty-first embodiment, the wettability of the pixel region RG of the sensor chip SCI where the pixel region RG is sealed with the transparent resin layer 3101 is made higher than the wettability of adjacent region RA. As a result, the void VOD generated at the transparent resin layer 3101 can be expelled from above the pixel region RG while sealing the pixel region RG of the sensor chip SCI with the transparent resin layer 3101.

Note that the above-described thirty-first embodiment describes an example in which the deposited film layer 3002 is formed in the pixel region RG of the planarizing layer 3001. As in the above-described twenty-eighth embodiment, in the pixel region RG of the planarizing layer 3001, an ion-implanted layer may be formed, or a surface modification layer may be formed. Alternatively, as in the above-described twenty-ninth embodiment, in the adjacent region RS of the planarizing layer 3001, an ion-implanted layer may be formed, a surface modification layer may be formed, or a rough surface layer may be formed.

### 32. Thirty-Second Embodiment

In the above-described second embodiment, the recess 112 is provided in the joining region R2 of the transparent substrate 102. In a thirty-second embodiment, a film is formed at the joining surface of the transparent substrate 102 joined through the bonding layer 103 or the inner surface of the recess 112 provided at the joining surface of the chip 101.

Fig. 66 is a sectional view depicting a configuration example of a recess of the electronic device according to the thirty-second embodiment. The drawing depicts a portion corresponding to the region ER1 of Fig. 5 in an enlarged manner.

In the drawing, this electronic device is additionally provided with a film 3201 in the electronic device 200 of the above-described second embodiment. Other configurations of this electronic device are the same as the configurations of the electronic device 200 of the above-described second embodiment.

The film 3201 is formed at the inner surface of the recess 112. The film 3201 may be an adsorption film having better adsorptivity than the transparent substrate 102. In this case, the specific surface area of the film 3201 may be greater than the specific surface area of the inner surface of the recess 112. For example, the film 3201 may be a porous film.

In this case, the film 3201 can adsorb the degassed gas released from the bonding layer 103. As a result, a decrease in the degree of vacuum in the recess 112 due to the degassed gas from the bonding layer 103 can be suppressed, and a decrease in the joining strength of the chip 101 and the transparent substrate 102 can be suppressed.

Alternatively, the film 3201 may be a heat conductive film having better thermal conductivity than the transparent substrate 102. Alternatively, the film 3201 may be a stress relaxation film that relaxes the stress applied to the transparent substrate 102 or the chip 201. Alternatively, the film 3201 may be an absorbance film that absorbs light of a specific wavelength. For example, for blue light reduction, the film 3201 may absorb light with a wavelength around 450 nm. Note that the film 3201 may have two or more of these functions, and may also have light-shielding properties.

The material of the film 3201 may be, for example, a metal oxide film such as zeolite, mesoporous silica, silica gel, or Al₂O₃, an inorganic film such as carbon black, tetraethyl orthosilicate (TEOS), or SiN, or a metal such as Al, Pt, or Cu, and a plurality of these materials may be layered. Here, in the case of the film 3201 made of a material such as Al that is easily oxidized, it can react with the degassed gas generated by the heat of the chip 101 to maintain the degree of vacuum in the recess 112. Further, by utilizing the stress of the film 3201, the stress applied to the transparent substrate 102 or the chip 201 can be adjusted, and the joining strength through the recess 112 can be improved.

Fig. 67 is a sectional view depicting an example of a manufacturing method for a recess of the electronic device according to the thirty-second embodiment.

In a in the drawing, by selectively etching the transparent substrate wafer 102W, the recess 112 is formed in the joining region R2 of the transparent substrate wafer 102W.

Next, as depicted in b in the drawing, the film 3201 is formed on the transparent substrate wafer 102W, including the inner surface of the recess 112. The film 3201 may be formed by CVD, sputtering, vapor deposition or the like.

Next, as depicted in c in the drawing, the surface of the transparent substrate wafer 102W is thinned by a method such as CMP to remove the film 3201 on the transparent substrate wafer 102W. In this case, the film 3201 may be left on the inner surface of the recess 112.

Fig. 68 is a sectional view depicting another configuration example of a recess of the electronic device according to the thirty-second embodiment. The drawing depicts a portion corresponding to the region ER1 of Fig. 5 in an enlarged manner.

In the drawing, this electronic device is additionally provided with a film 3202 in the electronic device 200 of the above-described second embodiment. Other configurations of this electronic device are the same as the configurations of the electronic device 200 of the above-described second embodiment.

The film 3202 is formed at the side surface of the recess 112. In this case, the film 3202 may not be formed at the bottom surface of the recess 112. Other configurations of the film 3202 are the same as the configurations of the film 3201.

Fig. 69 is a sectional view depicting another example of the manufacturing method for a recess of the electronic device according to the thirty-second embodiment.

In a in the drawing, by selectively etching the transparent substrate wafer 102W, the recess 112 is formed in the joining region R2 of the transparent substrate wafer 102W.

Next, as depicted in b in the drawing, the film 3202 is formed on the transparent substrate wafer 102W, including the inner surface of the recess 112.

Next, as depicted in c in the drawing, the film 3202 on the transparent substrate wafer 102W and the bottom surface of the recess 112 is removed by a method such as etch back. In this case, the film 3202 may be left on the side surface of the recess 112.

Fig. 70 is a sectional view depicting still another configuration example of a recess of the electronic device according to the thirty-second embodiment. The drawing depicts a portion corresponding to the region ER1 of Fig. 5 in an enlarged manner.

In the drawing, this electronic device is additionally provided with a film 3203 in the electronic device 200 of the above-described second embodiment. Other configurations of this electronic device are the same as the configurations of the electronic device 200 of the above-described second embodiment.

The film 3203 is formed at the inner surface of the recess 112. Irregularities are formed at the surface of the film 3203. In this case, the specific surface area of the film 3203 may be set greater than the specific surface area of the film 3201. The irregularities of the surface of the film 3203 may be formed by laser irradiation or plasma treatment. The irregularities may be formed also at the interface between the film 3203 and the recess 112. In this case, the irregularities may be formed at the inner surface of the recess 112 before forming the film 3203 at the inner surface of the recess 112. Other configurations of the film 3203 are the same as the configurations of the film 3201.

Fig. 71 is a sectional view depicting still another configuration example of a recess of the electronic device according to the thirty-second embodiment. The drawing depicts a portion corresponding to the region ER2 of Fig. 6 in an enlarged manner.

In the drawing, this electronic device is additionally provided with a film 3204 in the electronic device 300 of the above-described third embodiment. Other configurations of this electronic device are the same as the configurations of the electronic device 300 of the above-described third embodiment.

The film 3204 is formed at the inner surface of the recess 111. Other configurations of the film 3204 are the same as the configurations of the film 3201.

Fig. 72 is a sectional view depicting still another configuration example of a recess of the electronic device according to the thirty-second embodiment. The drawing depicts a portion corresponding to the region ER3 of Fig. 9 in an enlarged manner.

In the drawing, this electronic device is additionally provided with a film 3205 in the electronic device 600 of the above-described sixth embodiment. Other configurations of this electronic device are the same as the configurations of the electronic device 600 of the above-described sixth embodiment.

The film 3205 is formed at the inner surface of the recess 111 and the side surfaces of the through holes 113 and 612. In this case, the film 3205 is continuously formed from the recess 111 to the through hole 612. Other configurations of the film 3205 are the same as the configurations of the film 3201.

In this manner, in the above-described thirty-second embodiment, the film 3201 is formed at the joining surface of the transparent substrate 102 of joined through the bonding layer 103 or the inner surface of the recess 112 provided at the joining surface of the chip 101. As a result, the functions such as adsorptivity, thermal conductivity, wavelength selectivity, and stress relaxation can be provided to the recess 112 while improving the joining strength of the transparent substrate 102 and the chip 101.

### 33. Thirty-Third Embodiment

In the above-described second embodiment, the recess 112 is provided in the joining region R2 of the transparent substrate 102. In a thirty-third embodiment, irregularities are formed at the inner surface of the recess provided in the joining region R2 of the transparent substrate 102.

Fig. 73 is a sectional view depicting a configuration example of a recess of the electronic device according to the thirty-third embodiment.

In the drawing, this electronic device includes a recess 3301 instead of the recess 112 of the above-described second embodiment. Other configurations of this electronic device are the same as the configurations of the electronic device 200 of the above-described second embodiment.

The recess 3301 is provided in the joining region R2 of the transparent substrate 102. Irregularities 3302 are formed at the inner surface of the recess 3301. In this case, the specific surface area of the inner surface of the recess 3301 may be greater than the specific surface area of the inner surface of the recess 112. In addition, the inner surface of the recess 3301 can be made opaque by forming the irregularities 3302 at the inner surface of the recess 3301, thereby preventing light transmission. The irregularities 3302 may be formed at the inner surface of the recess 3301 by laser irradiation or plasma treatment. Other configurations of the recess 3301 are the same as the configurations of the recess 112.

Fig. 74 is a sectional view depicting another configuration example of a recess of the electronic device according to the thirty-third embodiment.

In the drawing, this electronic device includes a transparent substrate 3300 instead of the transparent substrate 102 of Fig. 73. Other configurations of this electronic device are the same as the configurations of the electronic device of Fig. 73.

The transparent substrate 3300 includes the recess 3301. The irregularities 3302 are formed at the inner surface of the recess 3301. In addition, irregularities 3303 are formed at the joining surface of the transparent substrate 3300. Here, the irregularities 3303 may be located at the boundary between the joining surface of the transparent substrate 3300 and the bonding layer 203. In this case, the irregularities 3303 are embedded in the bonding layer 203. Here, by forming the irregularities 3303 at the joining surface of the transparent substrate 3300, the joining area of the joining surface of the transparent substrate 3300 can be increased, and the joining strength of the transparent substrate 3300 can be improved. In addition, the inner surface of the recess 3301 can be made opaque by forming the irregularities 3302 at the inner surface of the recess 3301, thereby preventing light transmission. The irregularities 3303 may be formed at the joining surface of the transparent substrate 3300 by laser irradiation or plasma treatment. Other configurations of the transparent substrate 3300 are the same as the configurations of the transparent substrate 102.

In this manner, in the above-described thirty-third embodiment, the irregularities 3302 are formed at the inner surface of the recess 3301 provided in the joining region R2 of the transparent substrate 102. As a result, the specific surface area of the inner surface of the recess 3301 provided in the joining region R2 of the transparent substrate 102 can be increased, and the adsorptivity of the inner surface of the recess 3301 can be improved. Thus, a decrease in the degree of vacuum in the recess 3301 due to the degassed gas from the bonding layer 103 can be suppressed, and a decrease in the joining strength of the chip 201 and the transparent substrate 102 can be suppressed.

### 34. Thirty-Fourth Embodiment

In the above-described second embodiment, the recess 112 is provided in the joining region R2 of the transparent substrate 102. In a thirty-fourth embodiment, the film formed at the inner surface of the recess 112 provided in the joining region R2 of the transparent substrate 102 is extended to the outside of the bottom surface of the recess 112.

Fig. 75 is a diagram depicting a configuration example of a recess of an electronic device according to the thirty-fourth embodiment. Note that a in the drawing is a sectional view depicting a configuration example of a joining region of the electronic device taken along the vertical direction, b in the drawing is a plan view depicting a configuration example of the electronic device, and c in the drawing is a plan view depicting another configuration example of the electronic device. a in the drawing depicts a portion corresponding to the region ER1 of Fig. 5 in an enlarged manner.

In the drawing, this electronic device is additionally provided with a film 3401 in the electronic device 200 of the above-described second embodiment. Other configurations of this electronic device are the same as the configurations of the electronic device 200 of the above-described second embodiment.

The film 3401 is formed at the inner surface of the recess 112, and extended to the outside of the bottom surface of the recess 112. In this case, the position of the end portion of the film 3401 may coincide with the position of the end surface of the transparent substrate 102, or may be located inside the position of the end surface of the transparent substrate 102. As depicted in b in the drawing, the film 3401 may be discretely disposed at the periphery of the transparent substrate 102. Other configurations of the film 3401 are the same as the configurations of the film 3201.

Alternatively, as depicted in c in the drawing, a film 3401' may be provided instead of the film 3401. In this case, the transparent substrate 102 is provided with the recess 112' instead of the recess 112. The recess 112' is formed in a ring pattern at the periphery of the transparent substrate 102. The film 3401' is formed at the inner surface of the recess 112', and extended to the outside of the bottom surface of the recess 112'. In this case, as depicted in c in the drawing, the film 3401' may be extended in a fin shape to the outside of the bottom surface of the recess 112'. Other configurations of the film 3401' are the same as the configurations of the film 3401.

Figs. 76 to 78 are sectional views depicting an example of a manufacturing method for a recess of the electronic device according to the thirty-fourth embodiment.

As depicted in a in Fig. 76, a resist pattern 3421 is formed on the transparent substrate wafer 102W by lithography. In the resist pattern 3421, an opening portion 3422 is formed for each divided region 102R. The opening portion 3422 may be disposed at the position of the extended portion of the film 3401.

Next, as depicted in b in Fig. 76, with the resist pattern 3421 used as an etching mask, the transparent substrate wafer 102W is etched in the depth direction, and a step 3423 is formed in the transparent substrate wafer 102W for each divided region 102R.

Next, as depicted in c in Fig. 76, a resist pattern 3424 is formed on the transparent substrate wafer 102W by lithography. In the resist pattern 3424, an opening portion 3425 is formed for each divided region 102R. The opening portion 3425 may be formed at the arrangement position the recess 112.

Next, as depicted in a in Fig. 77, with the resist pattern 3424 used as an etching mask, the transparent substrate wafer 102W is etched in the depth direction, and a through hole 112A is formed in the transparent substrate wafer 102W for each divided region 102R. The through hole 112A is formed at the position of the recess 112.

Next, as depicted in b in Fig. 77, the film 3401 is formed on the transparent substrate wafer 102W such that the side surface of the through hole 112A is covered.

Next, as depicted in c in Fig. 77, the surface of the transparent substrate wafer 102W is thinned by a method such as CMP, and the film 3401 on the transparent substrate wafer 102W in the region inside the through hole 112A is removed. Here, the position of the surface of the transparent substrate wafer 102W in the height direction in the region inside the through hole 112A and the position of the surface of the film 3401 in the height direction in the region outside the through hole 112A may be set to coincide with each other. In this case, the film 3401 on the side surface of the through hole 112A and the transparent substrate wafer 102W in the region outside the through hole 112A may be left.

Next, as depicted in a in Fig. 78, the transparent substrate wafer 102W' is joined on the transparent substrate wafer 102W, and the recess 112 is formed. The transparent substrate wafers 102W and 102W' may be joined using a bonding layer 3406. In this case, the transparent substrate wafer 102W' may be used as a lid that closes the bottom of the recess 112.

Alternatively, as depicted in b in Fig. 78, it is possible to form the filter layer 604 on the transparent substrate wafer 102W, and form the recess 112. In this case, the filter layer 604 may be used as a lid that closes the bottom of the recess 112.

In this manner, in the above-described thirty-fourth embodiment, the film 3401 formed at the inner surface of the recess 112 provided in the joining region R2 of the transparent substrate 102 is extended to the outside of the bottom surface of the recess 112. As a result, the film 3401 may be disposed outside the recess 112 while forming the film 3401 at the inner surface of the recess 112. Thus, the joining strength of the transparent substrate 102 and the chip 201 can be improved while improving heat dissipation performance through the transparent substrate 102, and the functions such as adsorptivity, thermal conductivity, wavelength selectivity, and stress relaxation can be provided to the recess 112.

### 35. Thirty-Fifth Embodiment

In the above-described second embodiment, the recess 112 is provided in the joining region R2 of the transparent substrate 102. In a thirty-fifth embodiment, the film formed at the inner surface of the recess 112 provided in the joining region R2 of the transparent substrate 102 is extended to the outside of the opening of the recess 112.

Fig. 79 is a sectional view depicting a configuration example of a recess of the electronic device according to the thirty-fifth embodiment.

In the drawing, this electronic device is additionally provided with a film 3501 in the electronic device 200 of the above-described second embodiment. Other configurations of this electronic device are the same as the configurations of the electronic device 200 of the above-described second embodiment.

The film 3501 is formed at the inner surface of the recess 112, and extended to the outside of the opening of the recess 112. In this case, the position of the end portion of the film 3501 may coincide with the position of the end surface of the transparent substrate 102, or may be located inside the position of the end surface of the transparent substrate 102. Other configurations of this electronic device are the same as the configurations of the electronic device 200 of the above-described second embodiment.

Fig. 80 is a sectional view depicting an example of a manufacturing method for a recess of the electronic device according to the thirty-fifth embodiment.

In a in the drawing, after the step of Fig. 76, with the resist pattern 3424 used as an etching mask, the transparent substrate wafer 102W is etched in the depth direction, and the recess 112 is formed in the transparent substrate wafer 102W for each divided region 102R.

Next, as depicted in b in the drawing, the film 3501 is formed on the transparent substrate wafer 102W such that the inner surface of the recess 112 is covered.

Next, as depicted in c in the drawing, the surface of the transparent substrate wafer 102W is thinned by a method such as CMP, and the film 3501 on the transparent substrate wafer 102W in the region inside the recess 112 is removed. Here, the position of the surface of the transparent substrate wafer 102W in the height direction in the region inside the recess 112 and the position of the surface of the film 3501 in the height direction in the region outside the recess 112 may be set to coincide with each other. In this case, the film 3501 on the inner surface of the recess 112 and the transparent substrate wafer 102W in the region outside the recess 112 may be left.

In this manner, in the above-described thirty-fifth embodiment, the film 3501 formed at the inner surface of the recess 112 provided in the joining region R2 of the transparent substrate 102 is extended to the outside of the opening of the recess 112. As a result, the film 3501 may be disposed outside the recess 112 while forming the film 3501 at the inner surface of the recess 112. Thus, the joining strength of the transparent substrate 102 and the chip 201 can be improved while improving heat dissipation performance through the transparent substrate 102, and the functions such as adsorptivity, thermal conductivity, wavelength selectivity, and stress relaxation can be provided to the recess 112.

### 36. Thirty-Sixth Embodiment

In the above-described second embodiment, the recess 112 is provided in the joining region R2 of the transparent substrate 102. In a thirty-sixth embodiment, the recess 112' is provided in the joining region R2 of the transparent substrate 102, and an embedded layer embedded outside the recess 112' is extended to the outside of the bottom surface of the recess 112'.

Fig. 81 is a diagram depicting a configuration example of a recess of an electronic device according to the thirty-sixth embodiment. Note that a in the drawing is a sectional view depicting a configuration example of a joining region of the electronic device taken along the vertical direction, b in the drawing is a plan view depicting a configuration example of the electronic device, and c in the drawing is a plan view depicting another configuration example of the electronic device. a in the drawing depicts a portion corresponding to the region ER1 of Fig. 5 in an enlarged manner.

In the drawing, this electronic device in the electronic device 200 of the above-described second embodiment is additionally provided with an embedded layer 3601. Other configurations of this electronic device are the same as the configurations of the electronic device 200 of the above-described second embodiment.

The embedded layer 3601 is formed outside the recess 112', and extended to the outside of the bottom surface of the recess 112'. In this case, the position of the end portion of the embedded layer 3601 may coincide with the position of the end surface of the transparent substrate 102, or may be located inside the position of the end surface of the transparent substrate 102. As depicted in b in the drawing, the embedded layer 3601 may be discretely disposed at the periphery of the transparent substrate 102. Other configurations of the embedded layer 3601 are the same as the configurations of the film 3201.

Alternatively, as depicted in c in the drawing, the embedded layer 3601' may be provided instead of the embedded layer 3601. The embedded layer 3601' is formed outside the recess 112', and extended to the outside of the bottom surface of the recess 112'. In this case, the embedded layer 3601' may be extended in a fin shape to the outside of the bottom surface of the recess 112'. Other configurations of the embedded layer 3601' are the same as the configurations of the embedded layer 3601.

In this manner, in the above-described thirty-sixth embodiment, the recess 112' is provided in the joining region R2 of the transparent substrate 102, and the embedded layer 3601 embedded outside the recess 112' is extended to the outside of the bottom surface of the recess 112'. As a result, the joining strength of the transparent substrate 102 and the chip 201 can be improved while improving heat dissipation performance through the transparent substrate 102.

### 37. Thirty-Seventh Embodiment

In the above-described second embodiment, the recess 112 is provided in the joining region R2 of the transparent substrate 102. In a thirty-seventh embodiment, the recess 112' is provided in the joining region R2 of the transparent substrate 102, and an embedded layer embedded outside the recess 112' is extended to the outside of the opening of the recess 112'.

Fig. 82 is a sectional view depicting a configuration example of a recess of the electronic device according to the thirty-seventh embodiment.

In the drawing, this electronic device in the electronic device 200 of the above-described second embodiment is additionally provided with an embedded layer 3701. Other configurations of this electronic device are the same as the configurations of the electronic device 200 of the above-described second embodiment.

The embedded layer 3701 is formed outside the recess 112', and extended to the outside of the opening of the recess 112'. In this case, the position of the end portion of the embedded layer 3701 may coincide with the position of the end surface of the transparent substrate 102, or may be located inside the position of the end surface of the transparent substrate 102. Other configurations of the embedded layer 3701 are the same as the configurations of the film 3201.

Figs. 83 and 84 are sectional views depicting an example of a manufacturing method for a recess of the electronic device according to the thirty-seventh embodiment.

In a in Fig. 83, the transparent substrate wafer 102W is selectively etched in the depth direction, and a recess 3702 is formed in the transparent substrate wafer 102W for each divided region 102R. The recess 3702 is formed at the embedded position of the embedded layer 3701.

Next, as depicted in b in Fig. 83, the transparent substrate wafer 102W on the outside of the recess 3702 is selectively etched in the depth direction, and the transparent substrate wafer 102W on the outside of the recess 3702 is thinned. In this case, the difference between the height of the recess 3702 on the outside of the transparent substrate wafer 102W and the height of the transparent substrate wafer 102W on the inside of the recess 3702 may correspond to the thickness of the extended portion on the outside of the embedded layer 3701.

Next, as depicted in c in Fig. 83, the embedded layer 3701 is formed on the transparent substrate wafer 102W so as to fill the recess 3702.

Next, as depicted in a in Fig. 84, the surface of the embedded layer 3701 is thinned by a method such as CMP, and the embedded layer 3701 in the region inside the recess 3702 is removed. Here, the position of the surface of the transparent substrate wafer 102W in the height direction in the region inside the embedded layer 3701 and the position of the surface of the embedded layer 3701 in the height direction may be set to coincide with each other.

Next, as depicted in b in Fig. 84, a resist pattern 3721 is formed on the transparent substrate wafer 102W by lithography. In the resist pattern 3721, an opening portion 3722 is formed for each divided region 102R. The opening portion 3722 may be disposed at the position of the recess 112'.

Next, as depicted in c in Fig. 84, with the resist pattern 3721 used as an etching mask, the transparent substrate wafer 102W is etched in the depth direction, and the recess 112' is formed in the transparent substrate wafer 102W for each divided region 102R.

In this manner, in the above-described thirty-seventh embodiment, the recess 112' is provided in the joining region R2 of the transparent substrate 102, and the embedded layer 3701 embedded outside the recess 112' is extended to the outside of the opening of the recess 112'. As a result, the joining strength of the transparent substrate 102 and the chip 201 can be improved while improving heat dissipation performance through the transparent substrate 102.

### 38. Thirty-Eighth Embodiment

In the above-described second embodiment, the recess 112 is provided in the joining region R2 of the transparent substrate 102. In a thirty-eighth embodiment, a lid that closes the bottom surface of the recess 112 is provided in the joining region R2 of the transparent substrate 102.

Fig. 85 is a diagram depicting a configuration example of a recess of an electronic device according to the thirty-eighth embodiment. Note that a in the drawing is a sectional view depicting a configuration example of a joining region of the electronic device taken along the vertical direction, and b in the drawing is a plan view depicting a configuration example of the electronic device. a in the drawing depicts a portion corresponding to the region ER1 of Fig. 5 in an enlarged manner.

In the drawing, this electronic device includes a through hole 3812 instead of the recess 112 of the above-described second embodiment. In addition, this electronic device is additionally provided with a lid 3801 in the electronic device 200 of the above-described second embodiment. Other configurations of this electronic device are the same as the configurations of the electronic device 200 of the above-described second embodiment.

The through hole 3812 extends through the transparent substrate 102 in the thickness direction in the joining region R2 of the transparent substrate 102. The through hole 3812 may be formed at the position of the recess 112 of the above-described first embodiment, or at the position of the recess 112'. The irregularities 3302 of the above-described thirty-third embodiment may be provided at the side surface of the through hole 3812.

The lid 3801 is formed on the transparent substrate 102 so as to close the through hole 3812. The recess 112 can be formed in the transparent substrate 102 by closing the through hole 3812 with the lid 3801. The lid 3801 may be extended to the position of the end portion of the transparent substrate 102. The material of the lid 3801 may be the same as the material of the film 3201 of the above-described thirty-second embodiment. In this case, the lid 3801 may be provided with functions such as adsorptivity, thermal conductivity, wavelength selectivity, stress relaxation, and light-shielding properties.

Fig. 86 is a sectional view depicting an example of a manufacturing method for a recess of the electronic device according to the thirty-eighth embodiment.

In a in Fig. 86, a resist pattern 3821 is formed on the transparent substrate wafer 102W by lithography. In the resist pattern 3821, an opening portion 3822 is formed for each divided region 102R. The opening portion 3822 may be disposed at the position of the through hole 3812.

Next, as depicted in b in Fig. 86, with the resist pattern 3821 used as an etching mask, the transparent substrate wafer 102W is etched in the depth direction, and the through hole 3812 is formed in the transparent substrate wafer 102W for each divided region 102R.

Next, as depicted in c in Fig. 86, the lid 3801 is formed on the transparent substrate wafer 102W such that the through hole 3812 is sealed.

Fig. 87 is a sectional view depicting another example of the manufacturing method for a recess of the electronic device according to the thirty-eighth embodiment.

In a in Fig. 87, a lid member 3801' is layered on the transparent substrate wafer 102W. The lid member 3801' may be layered by CVD or sputtering, or the lid member 3801' may be bonded onto the transparent substrate wafer 102W.

Next, as depicted in b in Fig. 87, the lid member 3801' is patterned, and the lid 3801 is formed on the transparent substrate wafer 102W for each divided region 102R.

Next, as depicted in c in Fig. 87, the transparent substrate wafer 102W is selectively etched in the thickness direction from the rear surface side of the transparent substrate wafer 102W, and the through hole 3812 whose bottom surface is closed with the lid 3801 is formed. In this case, the lid 3801 may be used as an etching stopper for etching the transparent substrate wafer 102W.

In this manner, in the above-described thirty-eighth embodiment, the lid 3801 that closes the bottom surface of the recess 112 is provided in the joining region R2 of the transparent substrate 102. As a result, the joining strength of the transparent substrate 102 and the chip 201 can be improved while suppressing an increase in the number of steps, and the functions such as adsorptivity, thermal conductivity, wavelength selectivity, and stress relaxation can be provided to the recess 112 while improving heat dissipation performance through the transparent substrate 102.

### 39. Thirty-Ninth Embodiment

In the above-described second embodiment, the rectangular recess 112 is provided in the joining region R2 of the transparent substrate 102. In a thirty-ninth embodiment, a tapered recess is provided in the joining region R2 of the transparent substrate 102.

Fig. 88 is a diagram depicting a configuration example of an electronic device according to the thirty-ninth embodiment. Note that a in the drawing is a sectional view depicting a configuration example of an electronic device 3900 taken along the vertical direction, and b in the drawing is a plan view depicting a configuration example of the electronic device 3900. a in the drawing is taken along line A1-A2 in b in the drawing.

In the drawing, the electronic device 3900 includes a layered chip P39 instead of the layered chip P2 of the above-described second embodiment. Other configurations of the electronic device 200 of the thirty-ninth embodiment are the same as the configurations of the electronic device 200 of the above-described second embodiment.

The layered chip P39 includes a recess 3912 instead of the recess 112 of the above-described second embodiment. Other configurations of the layered chip P39 are the same as the configurations of the layered chip P2 of the above-described second embodiment.

The recess 3912 is provided in the joining region R2 of the transparent substrate 102. The recess 3912 may have a tapered cross-sectional shape. The recess 3912 may have a wedge cross-sectional shape. In this case, the inner peripheral surface of the recess 3912 may include an inclined surface. The inclined surface may include a flat surface or a curved surface. The position of the inclined surface of the recess 3912 may be set so as to relax the stress applied to the transparent substrate 102. The arrangement position of the recess 3912 may be the same as the arrangement position of the recess 112 of the above-described second embodiment.

Figs. 89 and 90 are sectional views depicting an example of a manufacturing method for the electronic device according to the thirty-ninth embodiment.

In a in Fig. 89, a resist pattern 3921 is formed on the transparent substrate wafer 102W by lithography. In the resist pattern 3921, an opening portion 3922 is formed for each divided region 102R. The opening portion 3922 may be provided at the arrangement position of the recess 3912. In this case, the interval of the opening portion 3922 may be changed along the formation position of the inclination surface of the recess 3912. For example, at a position where the depth of the recess 3912 is small, the interval of the opening portion 3922 may be set smaller compared to a position where the depth is large. Here, the etching amount of the transparent substrate wafer 102W in the depth direction can be reduced by reducing the interval of the opening portion 3922.

Next, as depicted in b in Fig. 89, with the resist pattern 3921 used as an etching mask, the transparent substrate wafer 102W is etched in the depth direction, and the recess 3912 is formed in the transparent substrate wafer 102W for each divided region 102R.

Next, as depicted in c in Fig. 89, the bonding layer 203 is formed on a semiconductor wafer 201W. Then, the transparent substrate wafer 102W is positioned on the semiconductor wafer 201W such that the recess 3912 faces the bonding layer 203.

Next, as depicted in a in Fig. 90, the transparent substrate wafer 102W and the semiconductor wafer 201W are joined, with the joining regions R1 and R2 facing each other through the bonding layer 103.

Next, as depicted in b in Fig. 90, the transparent substrate wafer 102W is thinned from the front surface side. The transparent substrate wafer 102W may be thinned by CMP or etch back.

Next, as depicted in c in Fig. 90, the semiconductor wafer 201W is thinned from the front surface side. The semiconductor wafer 201W may be thinned by CMP or etch back.

Next, as depicted in Fig. 88, the protruding electrode 106 is formed for each divided region 101R on the front surface side of the semiconductor wafer 201W. Then, the layered structure of the semiconductor wafer 201W and the transparent substrate wafer 102W is cut for each divided region 102R, thereby cutting out the layered chip P39.

Fig. 91 is a perspective view depicting a configuration example of a recess of the electronic device according to the thirty-ninth embodiment, and Fig. 92 is a plan view depicting a configuration example of an electronic device according to the thirty-ninth embodiment.

In a in Fig. 91, the recess 3912 is disposed along the outer periphery of the transparent substrate 102. In this case, each recess 3912 includes an inclined surface in one direction. The inclination surface of each recess 3912 may face outward.

In b in Fig. 91 and in Fig. 92, the recesses 3912A and 3912B may be alternately disposed along the outer periphery of the transparent substrate 102. In this case, each of the recesses 3912A and 3912B includes an inclined surface in one direction. The inclination surface of the recess 3912A may face inward. The inclination surface of the recess 3912B may face outward. As a result, it is possible to disperse the stress applied to the transparent substrate 102 through the bonding layer 203, thereby preventing stress concentration.

In c in Fig. 91, a recess 3912C is disposed along the outer periphery of the transparent substrate 102. In this case, the recess 3912C may have a conical shape.

In this manner, in the above-described thirty-ninth embodiment, the recess 3912 having a tapered shape is provided in the joining region R2 of the transparent substrate 102. As a result, the joining strength of the chip 101 and the transparent substrate 102 can be improved while relaxing the stress applied to the transparent substrate 102 through the bonding layer 203.

### 40. Fortieth Embodiment

In the above-described second embodiment, the recess 112 is provided in the joining region R2 of the transparent substrate 102. In a fortieth embodiment, a recess disposed in a shifted manner is provided in the joining region R2 of the transparent substrate 102.

Fig. 93 is a diagram depicting a configuration example of an electronic device according to the fortieth embodiment. Note that a in the drawing is a sectional view depicting a configuration example of an electronic device 4000A taken along the vertical direction, and b in the drawing is a plan view depicting a configuration example of the electronic device 4000A. a in the drawing is taken along line A1-A2 in b in the drawing.

In the drawing, the electronic device 4000A includes a layered chip P40A instead of the layered chip P2 of the above-described second embodiment. Other configurations of the electronic device 4000A of the fortieth embodiment are the same as the configurations of the electronic device 200 of the above-described second embodiment.

The layered chip P40A includes a recess 4012A instead of the recess 112 of the above-described second embodiment. Other configurations of the layered chip P40A are the same as the configurations of the layered chip P2 of the above-described second embodiment.

The recess 4012A is provided in the joining region R2 of the transparent substrate 102. The recess 4012A is disposed in a shifted manner in the joining region R2. For example, the recess 4012A may be disposed in a staggered manner in the joining region R2.

Fig. 94 is a diagram depicting another configuration example of an electronic device according to the fortieth embodiment. Note that a in the drawing is a sectional view depicting a configuration example of an electronic device 4000B taken along the vertical direction, and b in the drawing is a plan view depicting a configuration example of the electronic device 4000B. a in the drawing is taken along line A1-A2 in b in the drawing.

In the drawing, the electronic device 4000B includes a layered chip P40B instead of the layered chip P2 of the above-described second embodiment. Other configurations of the electronic device 4000B of the fortieth embodiment are the same as the configurations of the electronic device 200 of the above-described second embodiment.

The layered chip P40B includes a recess 4012B instead of the recess 112 of the above-described second embodiment. Other configurations of the layered chip P40B are the same as the configurations of the layered chip P2 of the above-described second embodiment.

The recess 4012B is provided in the joining region R2 of the transparent substrate 102. The recess 4012B is disposed in a shifted manner in the joining region R2. For example, the recess 4012B may be disposed in a closest manner in the joining region R2.

Fig. 95 is a diagram depicting still another configuration example of the electronic device according to the fortieth embodiment. Note that a in the drawing is a sectional view depicting a configuration example of an electronic device 4000C taken along the vertical direction, and b in the drawing is a plan view depicting a configuration example of the electronic device 4000C. a in the drawing is taken along line A1-A2 in b in the drawing.

In the drawing, the electronic device 4000C includes a layered chip P40C instead of the layered chip P2 of the above-described second embodiment. Other configurations of the electronic device 4000C of the fortieth embodiment are the same as the configurations of the electronic device 200 of the above-described second embodiment.

The layered chip P40C includes a recess 4012C instead of the recess 112 of the above-described second embodiment. Other configurations of the layered chip P40C are the same as the configurations of the layered chip P2 of the above-described second embodiment.

The recess 4012C is provided in the joining region R2 of the transparent substrate 102. The recess 4012C is disposed in a shifted manner in the joining region R2. For example, the recess 4012C may be disposed in a honeycomb pattern in the joining region R2.

Figs. 96 and 97 are sectional views depicting an example of a manufacturing method for the electronic device according to the fortieth embodiment. Note that in Figs. 96 and 97, a manufacturing method for the recess 4012C of Fig. 95 is taken as an example, but the same manufacturing method may be applied to the manufacturing methods for the recess 4012A of Fig. 93 and the recess 4012B of Fig. 94.

In a in Fig. 96, a resist pattern 4021 is formed on the transparent substrate wafer 102W by lithography. In the resist pattern 4021, an opening portion 4022 is formed for each divided region 102R. The opening portion 4022 may be provided at the arrangement position of the recess 4012C.

Next, as depicted in b in Fig. 96, with the resist pattern 4021 used as an etching mask, the transparent substrate wafer 102W is etched in the depth direction, and the recess 4012C is formed in the transparent substrate wafer 102W for each divided region 102R.

Next, as depicted in c in Fig. 96, the bonding layer 203 is formed on the semiconductor wafer 201W. Then, the transparent substrate wafer 102W is positioned on the semiconductor wafer 201W, with the recess 4012C facing the bonding layer 203.

Next, as depicted in a in Fig. 97, the transparent substrate wafer 102W and the semiconductor wafer 201W are joined, with the joining regions R1 and R2 facing each other through the bonding layer 203.

Next, as depicted in b in Fig. 97, the transparent substrate wafer 102W is thinned from the front surface side.

Next, as depicted in c in Fig. 97, the semiconductor wafer 201W is thinned from the front surface side.

Next, as depicted in Fig. 95, the protruding electrode 106 is formed for each divided region 101R on the front surface side of the semiconductor wafer 201W. Then, the layered structure of the semiconductor wafer 201W and the transparent substrate wafer 102W is cut for each divided region 102R, thereby cutting out the layered chip P40C.

In this manner, in the above-described fortieth embodiment, the recess 4012 disposed in a shifted manner in the joining region R2 of the transparent substrate 102 is provided. As a result, the arrangement density of the recess 4012 can be improved, and the thermal insulating property for heat from the outside can be improved.

### 41. Forty-First Embodiment

In the above-described second embodiment, the recess 112 is provided in the joining region R2 of the transparent substrate 102. In a forty-first embodiment, recesses provided in the joining region R1 of the chip 101 and the joining region R2 of the transparent substrate 102 are disposed in a non-overlapping manner.

Fig. 98 is a diagram depicting a configuration example of an electronic device according to the forty-first embodiment. Note that a in the drawing is a sectional view depicting a configuration example of an electronic device 4100 taken along the vertical direction, and b in the drawing is a plan view depicting a configuration example of the electronic device 4100. a in the drawing is taken along line A1-A2 in b in the drawing.

In the drawing, the electronic device 4100 includes the layered chip P41 instead of the layered chip P4 of the above-described fourth embodiment. Other configurations of the electronic device 4100 of the forty-first embodiment are the same as the configurations of the electronic device 400 of the above-described fourth embodiment.

The layered chip P41 includes recesses 4111 and 4112 instead of the recesses 111 and 112 of the above-described fourth embodiment. Other configurations of the layered chip P41 are the same as the configurations of the layered chip P4 of the above-described fourth embodiment.

The recess 4111 is provided in the joining region R1 of the chip 101. The recess 4112 is provided in the joining region R2 of the transparent substrate 102. In this case, the recesses 4111 and 4112 are disposed in a non-overlapping manner.

Fig. 99 is a sectional view depicting an example of a manufacturing method for an electronic device according to the forty-first embodiment.

In a in Fig. 99, a resist pattern 4121 is formed on the semiconductor wafer 101W by lithography. In the resist pattern 4121, an opening portion 4122 is formed for each divided region 102R. The opening portion 4122 may be provided at the arrangement position of the recess 4111. Here, the position coordinates of the opening portion 4122 can be determined with reference to the alignment mark of the color filter 104 formed in the semiconductor wafer 101W. In addition, a resist pattern 4123 is formed on the transparent substrate wafer 102W by lithography. In the resist pattern 4123, an opening portion 4124 is formed for each divided region 102R. The opening portion 4124 may be provided at the arrangement position of the recess 4112.

Next, as depicted in b in Fig. 99, with the resist pattern 4121 used as an etching mask, the semiconductor wafer 101W is etched in the depth direction, and the recess 4111 is formed in the transparent substrate wafer 102W for each divided region 102R. In addition, with the resist pattern 4123 used as an etching mask, the transparent substrate wafer 102W is etched in the depth direction, and the recess 4112 is formed in the transparent substrate wafer 102W for each divided region 102R.

Next, as depicted in c in Fig. 99, the bonding layer 203 is formed on the semiconductor wafer 101W. Then, the transparent substrate wafer 102W is positioned on the semiconductor wafer 101W such that the recess 4112 faces the bonding layer 203. Here, with reference to the alignment mark formed on the semiconductor wafer 101W and the alignment mark formed on the transparent substrate wafer 102W, the transparent substrate wafer 102W can be positioned on the semiconductor wafer 101W.

Next, as depicted in Fig. 98, the transparent substrate wafer 102W and the semiconductor wafer 101W are joined, with the joining regions R1 and R2 facing each other through the bonding layer 103. Then, the protruding electrode 106 is formed for each divided region 101R on the front surface side of the semiconductor wafer 101W. Thereafter, the layered structure of the semiconductor wafer 101W and the transparent substrate wafer 102W is cut for each divided region 102R, thereby cutting out the layered chip P41.

In this manner, in the above-described forty-first embodiment, the recesses 4111 and 4112 provided in the joining region R1 of the chip 101 and the joining region R2 of the transparent substrate 102 are disposed in a non-overlapping manner. As a result, even in the case where different negative pressures are applied to the top and bottom surfaces of the bonding layer 103 through the recesses 4111 and 4112, it is possible to prevent bending of the bonding layer 103 and fracture of the bonding layer 103.

### 42. Forty-Second Embodiment

In the above-described second embodiment, the recess 112 is provided in the joining region R2 of the transparent substrate 102. In a forty-second embodiment, a recess and a through hole disposed in the joining region R2 of the transparent substrate 102 are alternately provided.

Fig. 100 is a diagram depicting a configuration example of an electronic device according to the forty-second embodiment. Note that a in the drawing is a sectional view depicting a configuration example of an electronic device 4200 taken along the vertical direction, and b in the drawing is a plan view depicting a configuration example of the electronic device 4200. a in the drawing is taken along line A1-A2 in b in the drawing.

In the drawing, the electronic device 4200 includes a layered chip P42 instead of the layered chip P2 of the above-described second embodiment. Other configurations of the electronic device 4200 of the forty-second embodiment are the same as the configurations of the electronic device 200 of the above-described second embodiment.

The layered chip P42 includes a recess 4212 instead of the recess 112 of the above-described second embodiment. In addition, the layered chip P42 is additionally provided with a through hole 4213 in the layered chip P2 of the above-described second embodiment. Other configurations of the layered chip P42 are the same as the configurations of the layered chip P2 of the above-described second embodiment.

The recess 4212 and the through hole 4213 are provided in the joining region R2 of the transparent substrate 102. The through hole 4213 extends through the transparent substrate 102 in the thickness direction. In this case, the bonding layer 103 can be exposed to the atmosphere through the through hole 4213. The recess 4212 and the through hole 4213 may be alternately disposed in the joining region R2 of the transparent substrate 102. The planar shape of the recess 4212 and the planar shape of the through hole 4213 may be different from each other.

Figs. 101 and 102 are sectional views depicting an example of a manufacturing method for the electronic device according to the forty-second embodiment.

In a in Fig. 101, a resist pattern 4221 is formed on the transparent substrate wafer 102W by lithography. In the resist pattern 4221, an opening portion 4222 and a through hole 4223 are formed for each divided region 102R. The opening portion 4222 may be provided at the arrangement position of the recess 4212. The through hole 4223 may be provided at the arrangement position of the through hole 4213.

Next, as depicted in b in Fig. 101, with the resist pattern 4221 used as an etching mask, the transparent substrate wafer 102W is etched in the depth direction, and the recess 4212 and the through hole 4213 are formed in the transparent substrate wafer 102W for each divided region 102R.

Next, as depicted in c in Fig. 101, the bonding layer 203 is formed on the semiconductor wafer 201W. Then, the transparent substrate wafer 102W is positioned on the semiconductor wafer 201W such that the recess 4212 faces the bonding layer 203.

Next, as depicted in a in Fig. 102, the transparent substrate wafer 102W and the semiconductor wafer 201W are joined, with the joining regions R1 and R2 facing each other through the bonding layer 103.

Next, as depicted in b in Fig. 102, the transparent substrate wafer 102W is thinned from the front surface side.

Next, as depicted in c in Fig. 102, the semiconductor wafer 201W is thinned from the front surface side.

Next, as depicted in Fig. 100, the protruding electrode 106 is formed for each divided region 101R on the front surface side of the semiconductor wafer 201W. Then, the layered structure of the semiconductor wafer 201W and the transparent substrate wafer 102W is cut for each divided region 102R, thereby cutting out the layered chip P42.

In this manner, in the above-described forty-second embodiment, the recess 4212 and the through hole 4213 disposed in the joining region R2 of the transparent substrate 102 are alternately provided. As a result, the degassed gas from the bonding layer 103 can be dissipated through the through hole 4213, and a decrease in the degree of vacuum of the recess 4212 due to the degassed gas from the bonding layer 103 can be suppressed, thereby suppressing a decrease in the joining strength of the transparent substrate 102.

### 43. Forty-Third Embodiment

In the above-described second embodiment, the recess 112 is provided in the joining region R2 of the transparent substrate 102. In a forty-third embodiment, a recess is disposed in a multiple ring pattern in the joining region R2 of the transparent substrate 102.

Fig. 103 is a diagram depicting a configuration example of an electronic device according to the forty-third embodiment. Note that a in the drawing is a sectional view depicting a configuration example of an electronic device 4300 taken along the vertical direction, and b in the drawing is a plan view depicting a configuration example of the electronic device 4300. a in the drawing is taken along line A1-A2 in b in the drawing.

In the drawing, the electronic device 4300 includes a layered chip P43 instead of the layered chip P2 of the above-described second embodiment. Other configurations of the electronic device 4300 of the forty-third embodiment are the same as the configurations of the electronic device 200 of the above-described second embodiment.

The layered chip P43 includes a recess 4312 instead of the recess 112 of the above-described second embodiment. Other configurations of the layered chip P43 are the same as the configurations of the layered chip P2 of the above-described second embodiment.

The recess 4312 is provided in the joining region R2 of the transparent substrate 102. The recess 4312 is disposed in a multiple ring pattern in the joining region R2 of the transparent substrate 102. The number of turns of the recess 4312 only needs to be two or more.

In this manner, in the above-described forty-third embodiment, the recess 4312 is disposed in a multiple ring pattern in the joining region R2 of the transparent substrate 102. As a result, the joining area of the recess 4312 can be increased, and the joining strength of the transparent substrate 102 can be improved, while increasing the thermal insulating property of the transparent substrate 102.

### 44. Forty-Fourth Embodiment

In the above-described second embodiment, the recess 112 is provided in the joining region R2 of the transparent substrate 102. In a forty-fourth embodiment, a recess is provided in the joining region R2 of the transparent substrate 102, and an embedded layer is embedded outside the recess.

Fig. 104 is a diagram depicting a configuration example of an electronic device according to the forty-fourth embodiment. Note that a in the drawing is a sectional view depicting a configuration example of an electronic device 4400 taken along the vertical direction, and b in the drawing is a plan view depicting a configuration example of the electronic device 4400. a in the drawing is taken along line A1-A2 in b in the drawing.

In the drawing, the electronic device 4400 includes a layered chip P44 instead of the layered chip P2 of the above-described second embodiment. Other configurations of the electronic device 4400 of the forty-fourth embodiment are the same as the configurations of the electronic device 200 of the above-described second embodiment.

The layered chip P44 includes a recess 4412 instead of the recess 112 of the above-described second embodiment. In addition, the layered chip P44 is additionally provided with an embedded layer 4413 in the electronic device 200 of the above-described second embodiment. Other configurations of the layered chip P44 are the same as the configurations of the layered chip P2 of the above-described second embodiment.

The recess 4412 is provided in the joining region R2 of the transparent substrate 102. The recess 4412 may also be disposed in a multiple ring pattern in the joining region R2 of the transparent substrate 102.

The embedded layer 4413 is formed outside the recess 4412. In this case, the outer periphery of the embedded layer 4413 may be extended in a fin shape. The position of the end portion of the embedded layer 4413 may coincide with the position of the end surface of the transparent substrate 102, or may be located inside the position of the end surface of the transparent substrate 102. As the material of the embedded layer 4413, a material with a better thermal conductivity than the material of the transparent substrate 102 may be used. For example, the material of the embedded layer 4413 may be a metal such as Cu and A1, a semiconductor such as Si, or an insulator such as SiC and AlN. The embedded layer 4413 may have light-shielding properties.

Figs. 105 to 107 are sectional views depicting an example of a manufacturing method for the electronic device according to the forty-fourth embodiment.

In a in Fig. 105, a resist pattern 4421 is formed on the transparent substrate wafer 102W by lithography. In the resist pattern 4421, opening portions 4422 and 4423 are formed for each divided region 102R. The opening portion 4422 may be provided at the arrangement position of the recess 4412. The opening portion 4423 may be provided at the arrangement position of the embedded layer 4413.

Next, as depicted in b in Fig. 105, with the resist pattern 4421 used as an etching mask, the transparent substrate wafer 102W is etched in the depth direction, and the recesses 4412 and 4414 are formed in the transparent substrate wafer 102W for each divided region 102R. The recess 4414 may be provided at the arrangement position of the embedded layer 4413.

Next, as depicted in c in Fig. 105, an embedding member 4413' is formed on the transparent substrate wafer 102W so as to fill the recesses 4412 and 4414.

Next, as depicted in a in Fig. 106, the embedding member 4413' is thinned, and the surface of the transparent substrate wafer 102W is exposed. In this case, the embedded layer 4413 is formed in each of the recesses 4412 and 4414.

Next, as depicted in b in Fig. 106, a resist pattern 4431 is formed on the transparent substrate wafer 102W by lithography. In the resist pattern 4431, an opening portion 4432 is formed for each divided region 102R. The opening portion 4432 may be provided at the arrangement position of the recess 4412.

Next, as depicted in c in Fig. 106, with the resist pattern 4431 used as an etching mask, the embedded layer 4413 is selectively etched, and the embedded layer 4413 in the recess 4412 is removed. In this case, the embedded layer 4413 in the recess 4414 may be left.

Next, as depicted in a in Fig. 107, the resist pattern 4431 on the transparent substrate wafer 102W is removed by a method such as ashing.

Next, as depicted in b in Fig. 107, the bonding layer 203 is formed on the semiconductor wafer 201W. Then, the transparent substrate wafer 102W and the semiconductor wafer 101W are joined, with the joining regions R1 and R2 facing each other through the bonding layer 103.

Next, as depicted in c in Fig. 107, the semiconductor wafer 201W is thinned from the front surface side.

Next, as depicted in Fig. 104, the protruding electrode 106 is formed for each divided region 101R on the front surface side of the semiconductor wafer 201W. Then, the layered structure of the semiconductor wafer 201W and the transparent substrate wafer 102W is cut for each divided region 102R, thereby cutting out the layered chip P44.

In this manner, in the above-described forty-fourth embodiment, the recess 4412 is provided in the joining region R2 of the transparent substrate 102, and the embedded layer 4413 is embedded outside the recess 4412. As a result, the joining strength of the transparent substrate 102 and the chip 201 can be improved while improving heat dissipation performance through the transparent substrate 102.

### 45. Forty-Fifth Embodiment

In the above-described second embodiment, the recess 112 is provided in the joining region R2 of the transparent substrate 102. In a forty-fifth embodiment, a recess is provided in the joining region R2 of the transparent substrate 102, and minute grooves are provided on both sides of the recess.

Fig. 108 is a sectional view depicting a configuration example of an electronic device according to the forty-fifth embodiment. Note that a in the drawing is a sectional view depicting a configuration example of an electronic device 4500 taken along the vertical direction, and b in the drawing is a plan view depicting a configuration example of the electronic device 4500. a in the drawing is taken along line A1-A2 in b in the drawing.

In the drawing, the electronic device 4500 includes a layered chip P45 instead of the layered chip P2 of the above-described second embodiment. Other configurations of the electronic device 4500 of the forty-fifth embodiment are the same as the configurations of the electronic device 200 of the above-described second embodiment.

The layered chip P45 includes a recess 4512 instead of the recess 112 of the above-described second embodiment. In addition, the layered chip P45 is additionally provided with a minute groove 4513 in the electronic device 200 of the above-described second embodiment. Other configurations of the layered chip P45 are the same as the configurations of the layered chip P2 of the above-described second embodiment.

The recess 4512 is provided in the joining region R2 of the transparent substrate 102. The recess 4512 may be provided in a ring pattern in the joining region R2 of the transparent substrate 102. The minute groove 4513 is provided on both sides of the recess 4512. The depth of the minute groove 4513 may be smaller than the depth of the recess 4512. In this case, the bonding layer 203 is embedded in the minute groove 4513.

Figs. 109 and 110 are sectional views depicting an example of a manufacturing method for the electronic device according to the forty-fifth embodiment.

In a in Fig. 109, a resist pattern 4521 is formed on the transparent substrate wafer 102W by lithography. In the resist pattern 4521, opening portions 4522 and 4523 are formed for each divided region 102R. The opening portion 4522 may be provided at the arrangement position of the recess 4512. The opening portion 4523 may be provided at the arrangement position of the minute groove 4513. The depth of the opening portion 4523 may be smaller than the depth of the opening portion 4522.

Next, as depicted in b in Fig. 109, with the resist pattern 4521 used as an etching mask, the transparent substrate wafer 102W is etched in the depth direction, and the recess 4512 and the minute groove 4513 are formed in the transparent substrate wafer 102W for each divided region 102R.

Next, as depicted in c in Fig. 109, the bonding layer 203 is formed on the semiconductor wafer 201W. Then, the transparent substrate wafer 102W is positioned on the semiconductor wafer 201W, with the recess 4512 and the minute groove 4513 facing the bonding layer 203.

Next, as depicted in a in Fig. 110, the transparent substrate wafer 102W and the semiconductor wafer 201W are joined, with the joining regions R1 and R2 facing each other through the bonding layer 103.

Next, as depicted in b in Fig. 110, the transparent substrate wafer 102W is thinned from the front surface side.

Next, as depicted in c in Fig. 110, the semiconductor wafer 201W is thinned from the front surface side.

Next, as depicted in Fig. 108, the protruding electrode 106 is formed for each divided region 101R on the front surface side of the semiconductor wafer 201W. Then, the layered structure of the semiconductor wafer 201W and the transparent substrate wafer 102W is cut for each divided region 102R, thereby cutting out the layered chip P45.

In this manner, in the above-described forty-fifth embodiment, the recess 4512 is provided in the joining region R2 of the transparent substrate 102, and the minute groove 4513 is provided on both sides of the recess 4512. As a result, the path to the recess 4512 through the interface between the transparent substrate 102 and the bonding layer 203 can be lengthened. Thus, the air ingress path to the recess 4512 can be lengthened, and a decrease in the degree of vacuum in the recess 4512 can be suppressed.

### 46. Forty-Sixth Embodiment

In the above-described second embodiment, the recess 112 is provided in the joining region R2 of the transparent substrate 102. In a forty-sixth embodiment, a recess having a widened end is provided in the joining region R2 of the transparent substrate 102.

Fig. 111 is a sectional view depicting a configuration example of an electronic device according to the forty-sixth embodiment. Note that a in the drawing is a sectional view depicting a configuration example of an electronic device 4600 taken along the vertical direction, and b in the drawing is a plan view depicting a configuration example of the electronic device 4600. a in the drawing is taken along line A1-A2 in b in the drawing.

In the drawing, the electronic device 4600 includes a layered chip P46 instead of the layered chip P2 of the above-described second embodiment. Other configurations of the electronic device 4600 of the forty-sixth embodiment are the same as the configurations of the electronic device 200 of the above-described second embodiment.

The layered chip P46 includes a recess 4612 instead of the recess 112 of the above-described second embodiment. Other configurations of the layered chip P46 are the same as the configurations of the layered chip P2 of the above-described second embodiment.

The recess 4612 is provided in the joining region R2 of the transparent substrate 102. The end of the recess 4612 is widened. In this case, a flared portion 4613 may be provided at the end of the recess 4612. The shape of the flared portion 4613 may be a flare shape or a funnel shape. The bonding layer 203 may be embedded in the flared portion 4613.

Figs. 112 and 113 are sectional views depicting an example of a manufacturing method for the electronic device according to the forty-sixth embodiment.

In a in Fig. 112, a resist pattern 4621 is formed on the transparent substrate wafer 102W by lithography. In the resist pattern 4621, an opening portion 4622 is formed for each divided region 102R. The opening portion 4622 may be provided at the arrangement position of the recess 4612. In addition, an opening portion 4623 is formed over the opening portion 4622. The width of the opening portion 4623 may be greater than the width of the opening portion 4622. The opening portion 4623 may be provided at the arrangement position of the flared portion 4613.

Next, as depicted in b in Fig. 112, with the resist pattern 4621 used as an etching mask, the transparent substrate wafer 102W is etched in the depth direction, and the recess 4612 and the flared portion 4613 are formed in the transparent substrate wafer 102W for each divided region 102R.

Next, as depicted in c in Fig. 112, the bonding layer 203 is formed on the semiconductor wafer 201W. Then, the transparent substrate wafer 102W is positioned on the semiconductor wafer 201W, with the recess 4612 facing the bonding layer 203.

Next, as depicted in a in Fig. 113, the transparent substrate wafer 102W and the semiconductor wafer 201W are joined, with the joining regions R1 and R2 facing each other through the bonding layer 103.

Next, as depicted in b in Fig. 113, the transparent substrate wafer 102W is thinned from the front surface side.

Next, as depicted in c in Fig. 113, the semiconductor wafer 201W is thinned from the front surface side.

Next, as depicted in Fig. 111, the protruding electrode 106 is formed for each divided region 101R on the front surface side of the semiconductor wafer 201W. Then, the layered structure of the semiconductor wafer 201W and the transparent substrate wafer 102W is cut for each divided region 102R, thereby cutting out the layered chip P46.

In this manner, in the above-described forty-sixth embodiment, the recess 4612 having a widened end is provided in the joining region R2 of the transparent substrate 102. As a result, the joining area of the transparent substrate 102 and the bonding layer 203 can be increased while enabling vacuum suction through the recess 4612, and the joining strength of the transparent substrate 102 can be improved.

### 47. Forty-Seventh Embodiment

In the above-described second embodiment, the recess 112 is provided in the joining region R2 of the transparent substrate 102. In a forty-seventh embodiment, a recess is provided in the joining region R2 of the transparent substrate 102, and a jaggy is provided on the inside at the inner surface of the recess.

Fig. 114 is a sectional view depicting a configuration example of an electronic device according to the forty-seventh embodiment. Note that a in the drawing is a sectional view depicting a configuration example of an electronic device 4700 taken along the vertical direction, b in the drawing is a plan view depicting a configuration example of the electronic device 4700, and c in the drawing is a plan view depicting a configuration example of an electronic device 4700'. a in the drawing is a view taken along line A1-A2 in b and c in the drawing.

In the drawing, the electronic device 4700 includes a layered chip P47 instead of the layered chip P2 of the above-described second embodiment. Other configurations of the electronic device 4700 of the forty-seventh embodiment are the same as the configurations of the electronic device 200 of the above-described second embodiment.

The layered chip P47 includes a recess 4712 instead of the recess 112 of the above-described second embodiment. Other configurations of the layered chip P47 are the same as the configurations of the layered chip P2 of the above-described second embodiment.

The recess 4712 is provided in the joining region R2 of the transparent substrate 102. The recess 4712 includes a jaggy 4713 on the inside at its inner surface. The orientation of the jaggy 4713 may be set to the thickness direction of the transparent substrate 102. The jaggy 4713 may have a serrated shape. In this case, as depicted in b in the drawing, the recess 4712 may be discretely disposed at the periphery of the transparent substrate 102. Alternatively, as depicted in c in the drawing, a recess 4712' may be provided instead of the recess 4712. In this case, the recess 4712' is formed in a ring pattern at the periphery of the transparent substrate 102. A jaggy 4713' is formed on the inside at the inner surface of the recess 4712'.

Figs. 115 and 116 are sectional views depicting an example of a manufacturing method for the electronic device according to the forty-seventh embodiment.

In a in Fig. 115, a resist pattern 4821 is formed on the transparent substrate wafer 102W by lithography. In the resist pattern 4821, an opening portion 4822 is formed for each divided region 102R. The opening portion 4822 may be provided corresponding to the arrangement position on the inside of the inner surface the recess 4712.

Next, as depicted in b in Fig. 115, with the resist pattern 4821 used as an etching mask, the transparent substrate wafer 102W is etched in the depth direction, and a recess 4831 is formed in the transparent substrate wafer 102W for each divided region 102R. The recess 4831 may be provided at a position on the inside of the recess 4712.

In addition, as depicted in c in Fig. 115, a taper 4833 is formed at the end portion of a transparent plate 4832. The shape of the taper 4833 may correspond to the shape between turning points of the jaggy 4713. The thickness of the transparent plate 4832 may correspond to the thickness between turning points of the jaggy 4713. The material of the transparent plate 4832 may be glass, or a transparent resin such as acrylic. Then, the transparent plate 4832 in which the taper 4833 is formed is sequentially layered until it coincides with the depth of the recess 4831.

Next, as depicted in a in Fig. 116, the layered structure of the transparent plate 4832 in which the taper 4833 is formed is joined inside the recess 4831. In this case, the recess 4712 may be formed between the layered structure of the transparent plate 4832 in which the taper 4833 is formed and the recess 4831 of the transparent substrate wafer 102W. The jaggy 4713 composed of the taper 4833 may be provided inside the inner surface of the recess 4712.

Next, as depicted in b in Fig. 116, the bonding layer 203 is formed on the semiconductor wafer 201W. Then, the transparent substrate wafer 102W is positioned on the semiconductor wafer 201W, with the recess 4712 facing the bonding layer 203.

Next, as depicted in Fig. 114, the transparent substrate wafer 102W and the semiconductor wafer 201W are joined, with the joining regions R1 and R2 facing each other through the bonding layer 103. Then, the protruding electrode 106 is formed for each divided region 101R on the front surface side of the semiconductor wafer 201W. Thereafter, the layered structure of the semiconductor wafer 201W and the transparent substrate wafer 102W is cut for each divided region 102R, thereby cutting out the layered chip P47.

Fig. 117 is a sectional view depicting a configuration example of a jaggy of the electronic device according to the forty-seventh embodiment.

In a in the drawing, in the case where the jaggy 4713 is not provided, reflection light RLI from the light reception region R0 is totally reflected at a critical angle θ, and returns to the light reception region R0. On the other hand, in the case where the jaggy 4713 is provided, the reflection light RLI from the light reception region R0 is not totally reflected even at the critical angle θ, and does not return to the light reception region R0.

In this case, as depicted in b in the drawing, by setting an angle θ' of the jaggy 4713 such that the reflection light RLI entering the transparent substrate 102 at the critical angle θ is reflected straight downward at the jaggy 4713, the light does not return to the light reception region R0. To reflect the light straight downward at the jaggy 4713, it suffices to set θ' = θ according to the relationship θ' + (90° - 2θ) + θ = 90°.

In this manner, in the above-described forty-seventh embodiment, the recess 4712 is provided in the joining region R2 of the transparent substrate 102, and the jaggy 4713 is provided on the inside at the inner surface of the recess 4712. As a result, the joining strength of the transparent substrate 102 can be improved while reducing entry of stray light into the light reception region R0.

### 48. Forty-Eighth Embodiment

In the above-described second embodiment, the recess 112 is provided in the joining region R2 of the transparent substrate 102. In a forty-eighth embodiment, the recess 112 is provided in the joining region R2 of the transparent substrate 102, and a moth-eye structure is provided further inward than the recess 112.

Fig. 118 is a sectional view depicting a configuration example of an electronic device according to the forty-eighth embodiment. Note that a in the drawing is a sectional view depicting a configuration example of an electronic device 4800 taken along the vertical direction, b in the drawing is a plan view depicting a configuration example of the electronic device 4800, and c in the drawing is a plan view depicting a configuration example of an electronic device 4800'. a in the drawing is a view taken along line A1-A2 in b and c in the drawing.

In the drawing, the electronic device 4800 includes a layered chip P48 instead of the layered chip P2 of the above-described second embodiment. Other configurations of the electronic device 4800 of the forty-eighth embodiment are the same as the configurations of the electronic device 200 of the above-described second embodiment.

The layered chip P48 is additionally provided with a moth-eye structure 4811 in the electronic device 200 of the above-described second embodiment. Other configurations of the layered chip P48 are the same as the configurations of the layered chip P2 of the above-described second embodiment.

The moth-eye structure 4811 is disposed further inward than the recess 112 of the transparent substrate 102. In this case, the moth-eye structure 4811 may be provided on the light reception region R0. The bonding layer 203 is embedded in the moth-eye structure 4811. An anti-reflection function may be provided. In this case, in the moth-eye structure 4811, irregularities with height and pitch of 1 nm to 1 mm may be formed. For example, in the case of visible light, irregularities smaller than the wavelength range of 380 to 780 nm may be formed in the moth-eye structure 4811. In this case, as depicted in b in the drawing, the recess 112 may be discretely disposed at the periphery of the transparent substrate 102. Alternatively, as depicted in c in the drawing, the recess 112' may be provided instead of the recess 112. In this case, the recess 112' is formed in a ring pattern at the periphery of the transparent substrate 102.

Figs. 119 and 120 are sectional views depicting an example of a manufacturing method for the electronic device according to the forty-eighth embodiment.

In a in Fig. 119, the resist pattern 4821 is formed on the transparent substrate wafer 102W by lithography. In the resist pattern 4821, opening portions 4822 and 4823 are formed for each divided region 102R. The opening portion 4822 may be provided at the arrangement position of the recess 112. The opening portion 4823 may be provided at the arrangement position of the moth-eye structure 4811. The depth and width of the opening portion 4823 may be smaller than the depth and width of the opening portion 4822.

Next, as depicted in b in Fig. 119, with the resist pattern 4821 used as an etching mask, the transparent substrate wafer 102W is etched in the depth direction, and the recess 112 and the moth-eye structure 4811 are formed in the transparent substrate wafer 102W for each divided region 102R.

Next, as depicted in c in Fig. 119, the bonding layer 203 is formed on the semiconductor wafer 201W. Then, the transparent substrate wafer 102W is positioned on the semiconductor wafer 201W, with the recess 112 and the moth-eye structure 4811 facing the bonding layer 203.

Next, as depicted in a in Fig. 120, the transparent substrate wafer 102W and the semiconductor wafer 201W are joined, with the joining regions R1 and R2 facing each other through the bonding layer 103.

Next, as depicted in b in Fig. 120, the transparent substrate wafer 102W is thinned from the front surface side.

Next, as depicted in c in Fig. 120, the semiconductor wafer 201W is thinned from the front surface side.

Next, as depicted in Fig. 118, the protruding electrode 106 is formed for each divided region 101R on the front surface side of the semiconductor wafer 201W. Then, the layered structure of the semiconductor wafer 201W and the transparent substrate wafer 102W is cut for each divided region 102R, thereby cutting out the layered chip P48.

In this manner, in the above-described forty-eighth embodiment, the recess 112 is provided in the joining region R2 of the transparent substrate 102, and the moth-eye structure 4811 is provided further inward than the recess 112. As a result, the joining area of the transparent substrate 102 can be increased, the joining strength of the transparent substrate 102 can be improved, and the transparent substrate 102 can be provided with an anti-reflection function.

### 49. Forty-Ninth Embodiment

In the above-described second embodiment, the recess 112 is provided in the joining region R2 of the transparent substrate 102. In a forty-ninth embodiment, a recess is provided in the joining region R2 of the transparent substrate 102, and a sealing layer is formed from the side surface of the chip 201 to the side surface of the transparent substrate 102 through the side surface of the bonding layer 203.

Fig. 121 is a diagram depicting a configuration example of an electronic device according to the forty-ninth embodiment. Note that a in the drawing is a sectional view depicting a configuration example of an electronic device 4900 taken along the vertical direction, b in the drawing is a plan view depicting a configuration example of the electronic device 4900, and c in the drawing is a plan view depicting a configuration example of an electronic device 4900'. a in the drawing is a view taken along line A1-A2 in b and c in the drawing.

In the drawing, the electronic device 4900 includes a layered chip P49 instead of the layered chip P2 of the above-described second embodiment. Other configurations of the electronic device 4900 of the forty-ninth embodiment are the same as the configurations of the electronic device 200 of the above-described second embodiment.

The layered chip P49 is additionally provided with a sealing layer 4901 in the electronic device 200 of the above-described second embodiment. Other configurations of the layered chip P49 are the same as the configurations of the layered chip P2 of the above-described second embodiment.

The sealing layer 4901 is formed from the side surface of the chip 201 to the side surface of the transparent substrate 102 through the side surface of the bonding layer 203. The sealing layer 4901 is joined to the side surface of the chip 201 and the side surface of the transparent substrate 102. The material of the sealing layer 4901 may be an inorganic Si-based film containing O, C, and N (such as SiOx, SiNx, SiC, SiCN, SiON, or SiCO), an organic film such as a polyimidebased or silicone-based film, or a resin such as an epoxy resin. In this case, as depicted in b and c in the drawing, the sealing layer 4901 may be formed in a ring pattern at the periphery of the transparent substrate 102, the bonding layer 203 and the chip 201. The sealing layer 4901 may be formed by inkjet, dispensing, or coating. In this case, it is possible to adjust the viscosity of the uncured sealing layer 4901 in order to prevent dripping during the formation of the sealing layer 4901.

In this manner, in the above-described forty-ninth embodiment, the recess 112 is provided in the joining region R2 of the transparent substrate 102, and the sealing layer 4901 is formed from the side surface of the chip 201 to the side surface of the transparent substrate 102 through the side surface of the bonding layer 203. As a result, the joining of the chip 201 and the transparent substrate 102 through the sealing layer 4901 can be reinforced, and the joining strength of the chip 201 and the transparent substrate 102 can be improved.

### 50. Fiftieth Embodiment

In the above-described forty-ninth embodiment, the recess 112 is provided in the joining region R2 of the transparent substrate 102, and the sealing layer 4901 is formed from the side surface of the chip 201 to the side surface of the transparent substrate 102 through the side surface of the bonding layer 203. In a fiftieth embodiment, the recess 112 is provided in the joining region R2 of the transparent substrate 102, and a sealing layer is formed from the side surface of the chip 201 to the side surface of the transparent substrate 102 through the side surface of the bonding layer 203 up to a position higher than the recess 112.

Fig. 122 is a sectional view depicting a configuration example of an electronic device according to the fiftieth embodiment.

In the drawing, an electronic device 5000 includes a layered chip P50 instead of the layered chip P49 of the above-described forty-ninth embodiment. Other configurations of the electronic device 5000 of the fiftieth embodiment are the same as the configurations of the electronic device 4900 of the above-described forty-ninth embodiment.

The layered chip P50 includes a sealing layer 5001 instead of the sealing layer 4901 of the above-described forty-ninth embodiment. Other configurations of the layered chip P50 are the same as the configurations of the layered chip P49 of the above-described forty-ninth embodiment.

The sealing layer 5001 is formed from the side surface of the chip 201 to the side surface of the transparent substrate 102 through the side surface of the bonding layer 203 up to a position higher than the recess 112. The sealing layer 5001 is joined to the side surface of the chip 201 and the side surface of the transparent substrate 102. Other configurations of the sealing layer 5001 are the same as the configurations of the sealing layer 4901 of the above-described forty-ninth embodiment.

In this manner, in the above-described fiftieth embodiment, the recess 112 is provided in the joining region R2 of the transparent substrate 102, and the sealing layer 5001 is formed from the side surface of the chip 201 to the side surface of the transparent substrate 102 through the side surface of the bonding layer 203 up to a position higher than the recess 112. As a result, it is possible to reinforce the joining of the chip 201 and the transparent substrate 102 through the sealing layer 5001, and improve the joining strength of the chip 201 and the transparent substrate 102.

### 51. Fifty-First Embodiment

In the above-described forty-ninth embodiment, the recess 112 is provided in the joining region R2 of the transparent substrate 102, and the sealing layer 4901 is formed from the side surface of the chip 201 to the side surface of the transparent substrate 102 through the side surface of the bonding layer 203. In a fifty-first embodiment, the recess 112 is provided in the joining region R2 of the transparent substrate 102, a sealing layer is formed from the side surface of the chip 201 to the side surface of the transparent substrate 102 through the side surface of the bonding layer 203, and the sealing layer is caused to penetrate inward from the side surface of the bonding layer 203.

Fig. 123 is a sectional view depicting a configuration example of an electronic device according to the fifty-first embodiment.

In the drawing, an electronic device 5100 includes a layered chip P51 instead of the layered chip P49 of the above-described forty-ninth embodiment. Other configurations of the electronic device 5100 of the fifty-first embodiment are the same as the configurations of the electronic device 4900 of the above-described forty-ninth embodiment.

The layered chip P51 includes a sealing layer 5101 instead of the sealing layer 4901 of the above-described forty-ninth embodiment. Other configurations of the layered chip P51 are the same as the configurations of the layered chip P49 of the above-described forty-ninth embodiment.

The sealing layer 5101 is formed from the side surface of the chip 201 to the side surface of the transparent substrate 102 through the side surface of the bonding layer 203. In this case, the sealing layer 5101 penetrates inward from the side surface of the bonding layer 203. Here, the penetration position of the sealing layer 5101 into the bonding layer 203 is set outside the light reception region R0. The sealing layer 5101 is joined to the side surface of the chip 201 and the side surface of the transparent substrate 102, and joined to the end portion of the top surface of the chip 201 and the end portion of the bottom surface of the transparent substrate 102. To cause the sealing layer 5101 to penetrate inward from the side surface of the bonding layer 203, the side surface of the bonding layer 203 may be retracted relative to the side surface of the chip 201 and the side surface of the transparent substrate 102. In this case, the side surface of the bonding layer 203 may be retracted by a cleaning process during dicing for cutting out the layered chip P51. Other configurations of the sealing layer 5101 are the same as the configurations of the sealing layer 4901 of the above-described forty-ninth embodiment.

In this manner, in the above-described fifty-first embodiment, the recess 112 is provided in the joining region R2 of the transparent substrate 102, the sealing layer 5101 is formed from the side surface of the chip 201 to the side surface of the transparent substrate 102 through the side surface of the bonding layer 203, and the sealing layer 5101 is caused to penetrate inward from the side surface of the bonding layer 203. As a result, it is possible to reinforce the joining of the chip 201 and the transparent substrate 102 through the sealing layer 5101, and improve the joining strength of the chip 201 and the transparent substrate 102.

### 52. Fifty-Second Embodiment

In the above-described forty-ninth embodiment, the recess 112 is provided in the joining region R2 of the transparent substrate 102, and the sealing layer 4901 is formed from the side surface of the chip 201 to the side surface of the transparent substrate 102 through the side surface of the bonding layer 203. In a fifty-second embodiment, the recess 112 is provided in the joining region R2 of the transparent substrate 102, a sealing layer is formed from the side surface of the chip 201 to the side surface of the transparent substrate 102 through the side surface of the bonding layer 203, and the sealing layer is used also as an underfill.

Fig. 124 is a sectional view depicting a configuration example of an electronic device according to the fifty-second embodiment.

In the drawing, an electronic device 5200 includes a layered chip P52 instead of the layered chip P49 of the above-described forty-ninth embodiment. Other configurations of the electronic device 5200 of the fifty-second embodiment are the same as the configurations of the electronic device 4900 of the above-described forty-ninth embodiment.

The layered chip P52 includes a sealing layer 5201 instead of the sealing layer 4901 of the above-described forty-ninth embodiment. Other configurations of the layered chip P52 are the same as the configurations of the layered chip P49 of the above-described forty-ninth embodiment.

The layered chip P52 is mounted on a mounting board 5210. A land electrode 5211 is formed on the mounting board 5210. In this case, the protruding electrode 106 is joined to the land electrode 5211. Wirings, vias, and the like connected to the land electrode 5211 may be formed in the mounting board 5210. The mounting board 5210 may be a multilayer print wiring board.

The sealing layer 5201 is formed from the side surface of the chip 201 to the side surface of the transparent substrate 102 through the side surface of the bonding layer 203. In addition, the sealing layer 5201 is supplied between the chip 201 and the mounting board 5210 such that the periphery of the protruding electrode 106 is covered. In this case, the sealing layer 5201 is used also as an underfill. Here, the sealing layer 5201 is joined to the side surface of the chip 201 and the side surface of the transparent substrate 102, and joined to the bottom surface of the chip 201 and the top surface of the mounting board 5210. Other configurations of the sealing layer 5201 are the same as the configurations of the sealing layer 4901 of the above-described forty-ninth embodiment.

In this manner, in the above-described fifty-second embodiment, the recess 112 is provided in the joining region R2 of the transparent substrate 102, the sealing layer 5201 is formed from the side surface of the chip 201 to the side surface of the transparent substrate 102 through the side surface of the bonding layer 203, and the sealing layer 5201 is used also as an underfill. As a result, it is possible to reinforce the joining of the chip 201 and the transparent substrate 102 through the sealing layer 5201, and improve the sealing reliability of the flip-chip mounting of the chip 201 while suppressing an increase in the number of steps.

Note that in the above-described forty-ninth to fifty-second embodiments, the configuration in which a sealing layer is formed from the side surface of the chip 201 to the side surface of the transparent substrate 102 through the side surface of the bonding layer 203 is applied to the above-described second embodiment. In addition to this, the configuration in which a sealing layer is formed from the side surface of the semiconductor chip to the side surface of the transparent substrate through the side surface of the bonding layer may be applied to the above-described first embodiment, or any of the above-described third to forty-eighth embodiments.

### 53. Fifty-Third Embodiment

In the above-described forty-ninth embodiment, the recess 112 is provided in the joining region R2 of the transparent substrate 102, and the sealing layer 4901 is formed from the side surface of the chip 201 to the side surface of the transparent substrate 102 through the side surface of the bonding layer 203. In a fifty-third embodiment, in a configuration in which the recess 112 is not provided in the joining region R2 of the transparent substrate 102, the sealing layer 4901 is formed from the side surface of the chip 201 to the side surface of the transparent substrate 102 through the side surface of the bonding layer 203.

Fig. 125 is a diagram depicting a configuration example of an electronic device according to the fifty-third embodiment. Note that a in the drawing is a sectional view depicting a configuration example of an electronic device 5300 taken along the vertical direction, and b in the drawing is a plan view depicting a configuration example of the electronic device 5300. a in the drawing is taken along line A1-A2 in b in the drawing.

In the drawing, the electronic device 5300 includes a layered chip P53 instead of the layered chip P49 of the above-described forty-ninth embodiment. Other configurations of the electronic device 5300 of the fifty-third embodiment are the same as the configurations of the electronic device 4900 of the above-described forty-ninth embodiment.

In the layered chip P53, the recess 112 is eliminated in the layered chip P49 of the above-described forty-ninth embodiment. In this case, the chip 201 and the transparent substrate 102 may have their planar size reduced by an area corresponding to the area required for forming the recess 112. Other configurations of the layered chip P53 are the same as the configurations of the layered chip P49 of the above-described forty-ninth embodiment.

In this manner, in the above-described fifty-third embodiment, the sealing layer 5001 is formed from the side surface of the chip 201 to the side surface of the transparent substrate 102 through the side surface of the bonding layer 203. As a result, the joining of the chip 201 and the transparent substrate 102 through the sealing layer 4901 can be reinforced, and the joining strength of the chip 201 and the transparent substrate 102 can be improved.

### 54. Fifty-Fourth Embodiment

In the above-described fifty-third embodiment, the sealing layer 4901 is formed from the side surface of the chip 201 to the side surface of the transparent substrate 102 through the side surface of the bonding layer 203. In a fifty-fourth embodiment, in a configuration in which the recess 112 is not provided in the joining region R2 of the transparent substrate 102, the sealing layer 5101 is formed from the side surface of the chip 201 to the side surface of the transparent substrate 102 through the side surface of the bonding layer 203, and the sealing layer 5101 is caused to penetrate inward from the side surface of the bonding layer 203.

Fig. 126 is a sectional view depicting a configuration example of an electronic device according to the fifty-fourth embodiment.

In the drawing, an electronic device 5400 includes a layered chip P54 instead of the layered chip P51 of the above-described fifty-first embodiment. Other configurations of the electronic device 5400 of the fifty-fourth embodiment are the same as the configurations of the electronic device 5100 of the above-described fifty-first embodiment.

In the layered chip P54, the recess 112 is eliminated in the layered chip P51 of the above-described fifty-first embodiment. In this case, the chip 201 and the transparent substrate 102 may have their planar size reduced by an area corresponding to the area required for forming the recess 112. Other configurations of the layered chip P54 are the same as the configurations of the layered chip P51 of the above-described fifty-first embodiment.

In this manner, in the above-described fifty-fourth embodiment, the sealing layer 5101 is formed from the side surface of the chip 201 to the side surface of the transparent substrate 102 through the side surface of the bonding layer 203, and the sealing layer 5101 is caused to penetrate inward from the side surface of the bonding layer 203. As a result, it is possible to reinforce the joining of the chip 201 and the transparent substrate 102 through the sealing layer 5101, and improve the joining strength of the chip 201 and the transparent substrate 102.

### 55. Fifty-fifth embodiment

In the above-described fifty-third embodiment, the sealing layer 4901 is formed from the side surface of the chip 201 to the side surface of the transparent substrate 102 through the side surface of the bonding layer 203. In a fifty-fifth embodiment, in a configuration in which the recess 112 is not provided in the joining region R2 of the transparent substrate 102, a sealing layer is formed from the side surface of the chip 201 to the side surface of the transparent substrate 102 through the side surface of the bonding layer 203 so as to cover the end portion of the top surface of the transparent substrate 102.

Fig. 127 is a sectional view depicting a configuration example of an electronic device according to the fifty-fifth embodiment.

In the drawing, an electronic device 5500 includes a layered chip P55 instead of the layered chip P53 of the above-described fifty-third embodiment. Other configurations of the electronic device 5500 of the fifty-fifth embodiment are the same as the configurations of the electronic device 5300 of the above-described fifty-third embodiment.

The layered chip P55 includes a sealing layer 5501 instead of the sealing layer 4901 of the above-described fifty-third embodiment. Other configurations of the layered chip P55 are the same as the configurations of the layered chip P53 of the above-described fifty-third embodiment.

The sealing layer 5501 is formed from the side surface of the chip 201 to the side surface of the transparent substrate 102 through the side surface of the bonding layer 203 so as to cover the end portion of the top surface of the transparent substrate 102. The sealing layer 5001 is joined to the side surface of the chip 201 and the side surface of the transparent substrate 102, and joined to the end portion of the top surface of the transparent substrate 102. At the top surface of the transparent substrate 102, the sealing layer 5501 may be disposed without overlapping the light reception region R0. Other configurations of the sealing layer 5501 are the same as the configurations of the sealing layer 4901 of the above-described fifty-third embodiment.

In this manner, in the above-described fifty-fifth embodiment, the sealing layer 5501 is formed from the side surface of the chip 201 to the side surface of the transparent substrate 102 through the side surface of the bonding layer 203 so as to cover the end portion of the top surface of the transparent substrate 102. As a result, it is possible to reinforce the joining of the chip 201 and the transparent substrate 102 through the sealing layer 5501, and improve the joining strength of the chip 201 and the transparent substrate 102. In addition, the corners of the top surface of the transparent substrate 102 can be protected by the sealing layer 5501, and cracks or chipping of the transparent substrate 102 can be prevented while suppressing an increase in the number of steps.

### 56. Application Example to Mobile Body

The technology according to the present disclosure (present technology) can be applied to various products. For example, the technology according to the present disclosure may be implemented as a device mounted on any type of mobile bodies such as a vehicle, an electric vehicle, a hybrid electric vehicle, a motorcycle, a bicycle, a personal mobility, an airplane, a drone, a ship, and a robot.

Fig. 128 is a block diagram depicting an example of schematic configuration of a vehicle control system as an example of a mobile body control system to which the technology according to an embodiment of the present disclosure can be applied.

A vehicle control system 12000 includes a plurality of electronic control units connected to each other via a communication network 12001. In the example depicted in Fig. 128, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 128, an audio speaker 12061, a display section 12062, and an instrument panel 12063 are illustrated as the output device. The display section 12062 may, for example, include at least one of an on-board display and a head-up display.

Fig. 129 is a diagram depicting an example of the installation position of the imaging section 12031.

In Fig. 129, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, Fig. 129 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to an embodiment of the present disclosure is applicable to the driving system control unit 12010, the body system control unit 12020, the outside-vehicle information detecting unit 12030, the in-vehicle information detecting unit 12040, the integrated control unit 12050, and the imaging section 12031 among the above-described configurations. Specifically, for example, the above-described electronic device 100 is applicable to the imaging section 12031, and the above-described electronic device 1000 is applicable to the driving system control unit 12010, the body system control unit 12020, the outside-vehicle information detecting unit 12030, the in-vehicle information detecting unit 12040, and the integrated control unit 12050. By applying the technology according to the embodiment of the present disclosure to the vehicle control system 12000, size reduction can be achieved while suppressing a reduction in the reliability.

Note that the above-described embodiments are examples for embodying the present technology, and the matters according to the embodiments and the matters specifying the invention in the scope of claims have correspondence relationships, respectively. Similarly, the matters specifying the invention in the scope of claims and the matters in the embodiments of the present technology to which the same names are given have correspondence relationships, respectively. However, the present technology is not limited to the embodiments, and can be embodied by applying various modifications to the embodiments without departing from the gist of the present technology. Further, the effects described in the present specification are merely examples and are not limited, and other effects may be provided.

Note that the present technology may also have the following configurations.
(1) An electronic device including:
   a first chip including a first joining region, and a first recess formed in a part of the first joining region; and
   a second chip joined to the first chip through a second joining region facing the first joining region.
(2) The electronic device according to (1), in which the first recess is discretely disposed at a periphery of the first chip.
(3) The electronic device according to (1) or (2), in which the first recess includes a taper in a depth direction.
(4) The electronic device according to (3), in which a plurality of the first recesses are provided such that the orientations of the tapers alternate.
(5) The electronic device according to any one of (1) to (4), in which the plan arrangement of the first recess is a staggered arrangement, a closest arrangement, or a honeycomb arrangement.
(6) The electronic device according to any one of (1) to (5), further including a jaggy formed at the side surface of the first recess.
(7) The electronic device according to any one of (1) to (6), further including a through hole formed in a part of the first joining region, and extended through the first chip.
(8) The electronic device according to (1), in which the first recess is a groove continuously formed at a periphery of the first chip.
(9) The electronic device according to (8), further including a fin located outside the groove.
(10) The electronic device according to (8), in which a plurality of the grooves are provided in parallel.
(11) The electronic device according to any one of (8) to (10), in which the width of the opening surface of the groove is greater than the width of the bottom of the groove.
(12) The electronic device according to any one of (1) to (11), further including a bonding layer interposed between the first chip and the second chip.
(13) The electronic device according to (12), further including a moth-eye structure formed between the first chip and the bonding layer.
(14) The electronic device according to (12) or (13), further including a hard layer formed at a surface of the bonding layer in a manner corresponding to an opening position of the first recess.
(15) The electronic device according to any one of (12) to (14), further including a sealing layer formed from the side surface of the first chip to the side surface of the second chip through the side surface of the bonding layer.
(16) The electronic device according to any one of (1) to (15), in which the first chip and the second chip are directly joined.
(17) The electronic device according to any one of (1) to (16), further including a film formed at an inner surface of the first recess.
(18) The electronic device according to (17), in which the specific surface area of the film is greater than the specific surface area of the inner surface of the first recess.
(19) The electronic device according to (17) or (18), in which the film is a light-shielding film.
(20) The electronic device according to any one of (17) to (19), in which the film is a porous film.
(21) The electronic device according to any one of (1) to (20), in which the first chip includes a lid configured to close the bottom of the first recess.
(22) The electronic device according to any one of (1) to (21), in which a pressure inside the first recess is lower than atmospheric pressure.
(23) The electronic device according to any one of (1) to (22), further including gas sealed inside the first recess.
(24) The electronic device according to any one of (1) to (23), in which a transparent substrate is used for the first chip, and a semiconductor substrate is used for the second chip.
(25) The electronic device according to (24), further including a filter layer formed on the first chip.
(26) The electronic device according to any one of (1) to (25), further including a cavity formed inside the second joining region.
(27) The electronic device according to any one of (1) to (26), in which the second chip includes a second recess formed in a part of the second joining region.
(28) The electronic device according to (27), in which the first recess and the second recess are disposed at positions not overlapping each other.
(29) The electronic device according to any one of (1) to (29), in which the second chip includes a device region located inside the second joining region.
(30) The electronic device according to any one of (27) to (29), in which
   the second chip includes:
   a third chip in which a first wiring layer is formed on a first semiconductor substrate;
   a fourth chip in which a second wiring layer is formed on a second semiconductor substrate, the fourth chip being layered on the third chip with the first wiring layer and the second wiring layer facing each other; and
   a through electrode extending through the first semiconductor substrate and connected to the first wiring layer.
(31) The electronic device according to (30), in which the second recess extends through the fourth chip and the first wiring layer and is formed at the first semiconductor substrate.
(32) The electronic device according to (30) or (31), in which the through electrode is provided at a position different from a position of the second recess in a horizontal direction.
(33) The electronic device according to any one of (1) to (32), in which
   the second chip includes:
   a third chip in which a first wiring layer is formed on a first semiconductor substrate;
   a fourth chip in which a second wiring layer is formed on a second semiconductor substrate, the fourth chip being layered on the third chip with the first wiring layer and the second wiring layer facing each other; and
   a through electrode extending through the first semiconductor substrate and connected to the first wiring layer, and
   the through electrode is formed so as to at least partially overlap the first recess.
(34) An electronic device including:
   an optical chip provided with an optical system; and
   a sensor chip provided with a sensor element, in which
   the optical chip and the sensor chip are joined through a joining surface including a plurality of surfaces.
(35) The electronic device according to (34), in which
   the optical chip includes a transparent substrate layered on the sensor chip, and
   the electronic device further includes a groove continuously provided from a first end portion to a second end portion of a layered chip of the sensor chip and the transparent substrate between the sensor chip and the transparent substrate.
(36) The electronic device according to (35), in which the groove is provided at the transparent substrate.
(37) The electronic device according to (35), further including:
   a transparent resin layer configured to join the optical chip and the sensor chip; and
   an intermediate resin layer provided between the transparent substrate and the transparent resin layer or between the transparent resin layer and the sensor chip, in which
   the groove is provided at the intermediate resin layer.
(38) The electronic device according to (37), in which a refractive index of the transparent resin layer and a refractive index of the intermediate resin layer are equal to each other.
(39) The electronic device according to any one of (35) to (38), in which the groove is disposed at a position capable of traversing a wafer before the layered chip of the sensor chip and the transparent substrate is singulated.
(40) The electronic device according to any one of (35) to (39), in which one or a plurality of the grooves are provided at the layered chip of the sensor chip and the transparent substrate.
(41) The electronic device according to any one of (35) to (40), in which the groove is disposed on an effective pixel region, or on a peripheral region, or, on both the effective pixel region and the peripheral region of the sensor chip.
(42) The electronic device according to any one of (35) to (41), in which a depth of the groove is equal to or less than a thickness of the transparent resin layer.
(43) The electronic device according to (34), in which
   the optical chip is packaged based on wafer level optics, and
   the sensor chip is packaged based on a wafer level chip size package.
(44) The electronic device according to any one of (34) to (43), in which the optical system includes a lens.
(45) The electronic device according to any one of (34) to (44), in which the optical system includes a layered structure of a plurality of lens-equipped substrates.
(46) The electronic device according to (45), in which the plurality of lens-equipped substrates include:
   a lens; and
   a substrate at which the lens is formed, and
   the lens and the substrate are composed of the same material or different materials.
(47) The electronic device according to any one of (34) to (46), in which the optical system includes at least one of an aperture, a light-shielding film, a spacer, and an optical filter.
(48) The electronic device according to any one of (34) to (47), further including a joining layer configured to join the optical chip and the sensor chip.
(49) The electronic device according to (48), in which the joining layer is composed of one or a plurality of materials.
(50) The electronic device according to any one of (34) to (49), in which the joining surface includes at least one of a recess, a protrusion, and a rough surface.
(51) The electronic device according to (50), in which the at least one of a recess, a protrusion, and a rough surface is located on a sensor surface of the sensor chip.
(52) The electronic device according to any one of (34) to (51), in which the joining surface including the plurality of surfaces is provided at least at one of the optical chip and the sensor chip.
(53) The electronic device according to any one of (34) to (52), in which the sensor element is a photoelectric conversion element.
(54) The electronic device according to any one of (34) to (53), in which
   the sensor chip includes:
   a semiconductor substrate at which the sensor element is formed; and
   a transparent sealing substrate joined to the semiconductor substrate.
(55) The electronic device according to (54), in which the optical chip includes a transparent supporting substrate configured to support the optical system, and the joining surface including the plurality of surfaces is provided at least at one of the transparent sealing substrate and the transparent supporting substrate.
(56) The electronic device according to any one of (34) to (55), in which the plurality of surfaces include surfaces having different wettabilities.
(57) The electronic device according to (56), in which
   the optical chip includes a transparent substrate layered on the sensor chip through a transparent resin layer,
   the transparent substrate includes:
      an opposing region facing a sensor region of the sensor chip; and
      an adjacent region adjacent to the opposing region, and
      a wettability of the opposing region is higher than a wettability of the adjacent region.
(58) The electronic device according to (57), in which the opposing region includes a deposited film layer, a surface modification layer, or an ion-implanted layer with a higher wettability than a surface of the adjacent region.
(59) The electronic device according to (56) or (57), in which the adjacent region includes a deposited film layer, a surface modification layer, an ion-implanted layer, or a rough surface layer with a lower wettability than a surface of the opposing region.
(60) The electronic device according to any one of (56) to (59), in which
   the sensor chip includes:
   a sensor region; and
   an adjacent region adjacent to the sensor region, and
   a wettability of the sensor region is higher than a wettability of the adjacent region.
(61) The electronic device according to (60), in which the sensor region includes a deposited film layer, a surface modification layer, or an ion-implanted layer with a higher wettability than a surface of the adjacent region.
(62) The electronic device according to (60) or (61), in which the adjacent region includes a deposited film layer, a surface modification layer, an ion-implanted layer, or a rough surface layer with a lower wettability than a surface of the sensor region.
(63) A manufacturing method for an electronic device, including:
   forming a first recess in a first joining region provided for each divided region of a first wafer;
   joining a second wafer to the first wafer through a second joining region provided at a position facing the first joining region; and
   singulating a layered wafer in which the first wafer and the second wafer are joined for each divided region.
(64) The manufacturing method for the electronic device according to (63), in which the second wafer is joined to the first wafer under reduced pressure or in an atmospheric gas environment.

### Reference Signs List

100 Electronic device
101 Chip
102 Transparent substrate
103 Bonding layer
104 Color filter
105 On-chip lens
106 Protruding electrode
111, 112 Recess
113 Through hole
P1 Layered chip
R0 Light reception region
R1, R2 Joining region

## Claims

1. An electronic device comprising:
a first chip including a first joining region, and a first recess formed in a part of the first joining region; and
a second chip joined to the first chip through a second joining region facing the first joining region.

2. The electronic device according to claim 1, wherein the first recess is discretely disposed at a periphery of the first chip.

3. The electronic device according to claim 1, wherein the first recess is a groove continuously formed at a periphery of the first chip.

4. The electronic device according to claim 1, further comprising a bonding layer interposed between the first chip and the second chip.

5. The electronic device according to claim 4, further comprising a hard layer formed at a surface of the bonding layer in a manner corresponding to an opening position of the first recess.

6. The electronic device according to claim 1, wherein the first chip and the second chip are directly joined.

7. The electronic device according to claim 1, further comprising a light-shielding film formed at an inner surface of the first recess.

8. The electronic device according to claim 1, wherein a pressure inside the first recess is lower than atmospheric pressure.

9. The electronic device according to claim 1, further comprising gas sealed inside the first recess.

10. The electronic device according to claim 1, wherein a transparent substrate is used for the first chip, and a semiconductor substrate is used for the second chip.

11. The electronic device according to claim 10, further comprising a filter layer formed on the first chip.

12. The electronic device according to claim 1, further comprising a cavity formed inside the second joining region.

13. The electronic device according to claim 1, wherein the second chip includes a second recess formed in a part of the second joining region.

14. The electronic device according to claim 1, wherein the second chip includes a device region located inside the second joining region.

15. The electronic device according to claim 13, wherein
the second chip includes:
a third chip in which a first wiring layer is formed on a first semiconductor substrate;
a fourth chip in which a second wiring layer is formed on a second semiconductor substrate, the fourth chip being layered on the third chip with the first wiring layer and the second wiring layer facing each other; and
a through electrode extending through the first semiconductor substrate and connected to the first wiring layer.

16. The electronic device according to claim 15, wherein the second recess extends through the fourth chip and the first wiring layer and is formed at the first semiconductor substrate.

17. The electronic device according to claim 16, wherein the through electrode is provided at a position different from a position of the second recess in a horizontal direction.

18. The electronic device according to claim 1, wherein
the second chip includes:
a third chip in which a first wiring layer is formed on a first semiconductor substrate;
a fourth chip in which a second wiring layer is formed on a second semiconductor substrate, the fourth chip being layered on the third chip with the first wiring layer and the second wiring layer facing each other; and
a through electrode extending through the first semiconductor substrate and connected to the first wiring layer, and
the through electrode is formed so as to at least partially overlap the first recess.

19. An electronic device comprising:
an optical chip provided with an optical system; and
a sensor chip provided with a sensor element, wherein
the optical chip and the sensor chip are joined through a joining surface including a plurality of surfaces.

20. The electronic device according to claim 19, wherein
the optical chip includes a transparent substrate layered on the sensor chip, and
the electronic device further comprises a groove continuously provided from a first end portion to a second end portion of a layered chip of the sensor chip and the transparent substrate between the sensor chip and the transparent substrate.

21. The electronic device according to claim 20, wherein the groove is provided at the transparent substrate.

22. The electronic device according to claim 20, further comprising:
a transparent resin layer configured to join the optical chip and the sensor chip; and
an intermediate resin layer provided between the transparent substrate and the transparent resin layer or between the transparent resin layer and the sensor chip, wherein
the groove is provided at the intermediate resin layer.

23. The electronic device according to claim 22, wherein a refractive index of the transparent resin layer and a refractive index of the intermediate resin layer are equal to each other.

24. The electronic device according to claim 20, wherein the groove is disposed at a position capable of traversing a wafer before the layered chip of the sensor chip and the transparent substrate is singulated.

25. The electronic device according to claim 20, wherein one or a plurality of the grooves are provided at the layered chip of the sensor chip and the transparent substrate.

26. The electronic device according to claim 20, wherein the groove is disposed on an effective pixel region, or on a peripheral region, or, on both the effective pixel region and the peripheral region of the sensor chip.

27. The electronic device according to claim 20, wherein a depth of the groove is equal to or less than a thickness of the transparent resin layer.

28. The electronic device according to claim 19, wherein
the optical chip is packaged based on wafer level optics, and
the sensor chip is packaged based on a wafer level chip size package.

29. The electronic device according to claim 19, wherein the optical system includes a lens.

30. The electronic device according to claim 19, wherein the optical system includes a layered structure of a plurality of lens-equipped substrates.

31. The electronic device according to claim 30, wherein
the plurality of lens-equipped substrates include:
a lens; and
a substrate at which the lens is formed, and
the lens and the substrate are composed of the same material or different materials.

32. The electronic device according to claim 19, wherein the optical system includes at least one of an aperture, a light-shielding film, a spacer, and an optical filter.

33. The electronic device according to claim 19, further comprising a joining layer configured to join the optical chip and the sensor chip.

34. The electronic device according to claim 33, wherein the joining layer is composed of one or a plurality of materials.

35. The electronic device according to claim 19, wherein the joining surface includes at least one of a recess, a protrusion, and a rough surface.

36. The electronic device according to claim 35, wherein the at least one of a recess, a protrusion, and a rough surface is located on a sensor surface of the sensor chip.

37. The electronic device according to claim 19, wherein the joining surface including the plurality of surfaces is provided at least at one of the optical chip and the sensor chip.

38. The electronic device according to claim 19, wherein the sensor element is a photoelectric conversion element.

39. The electronic device according to claim 28, wherein
the sensor chip includes:
a semiconductor substrate at which the sensor element is formed; and
a transparent sealing substrate joined to the semiconductor substrate.

40. The electronic device according to claim 39, wherein
the optical chip includes a transparent supporting substrate configured to support the optical system, and
the joining surface including the plurality of surfaces is provided at least at one of the transparent sealing substrate and the transparent supporting substrate.

41. The electronic device according to claim 19, wherein the plurality of surfaces include surfaces having different wettabilities.

42. The electronic device according to claim 41, wherein
the optical chip includes a transparent substrate layered on the sensor chip through a transparent resin layer,
the transparent substrate includes:
an opposing region facing a sensor region of the sensor chip; and
an adjacent region adjacent to the opposing region, and
a wettability of the opposing region is higher than a wettability of the adjacent region.

43. The electronic device according to claim 42, wherein the opposing region includes a deposited film layer, a surface modification layer, or an ion-implanted layer with a higher wettability than a surface of the peripheral region.

44. The electronic device according to claim 42, wherein the adjacent region includes a deposited film layer, a surface modification layer, an ion-implanted layer, or a rough surface layer with a lower wettability than a surface of the opposing region.

45. The electronic device according to claim 41, wherein
the sensor chip includes:
a sensor region; and
an adjacent region adjacent to the sensor region, and
a wettability of the sensor region is higher than a wettability of the adjacent region.

46. The electronic device according to claim 45, wherein the sensor region includes a deposited film layer, a surface modification layer, or an ion-implanted layer with a higher wettability than a surface of the adjacent region.

47. The electronic device according to claim 45, wherein the adjacent region includes a deposited film layer, a surface modification layer, an ion-implanted layer, or a rough surface layer with a lower wettability than a surface of the sensor region.

48. A manufacturing method for an electronic device, comprising:
forming a first recess in a first joining region provided for each divided region of a first wafer;
joining a second wafer to the first wafer through a second joining region provided at a position facing the first joining region; and
singulating a layered wafer in which the first wafer and the second wafer are joined for each divided region.

49. The manufacturing method for the electronic device according to claim 48, wherein the second wafer is joined to the first wafer under reduced pressure or in an atmospheric gas environment.
